# EUROPEAN PATENT APPLICATION

(11) **EP 4 663 642 A1**
(43) Date of publication of application: **17.12.2025**
(21) Application number: 24753356.5
(22) Date of filing: 06.02.2024
(51) Int. Cl.: C07F 5/02, C09K 11/06, G02B 5/20, H10K 50/12, H10K 50/30, H10K 59/10, H10K 85/60

(54) **POLYCYCLIC AROMATIC COMPOUND**

(30) Priority: 07.02.2023 JP 2023016536
(71) Applicant: Kyoto University, Kyoto-shi, Kyoto 606-8501 (JP); SK Materials JNC Co., Ltd., Hwaseong-si, Gyeonggi-do 18469 (KR)
(72) Inventor: HATAKEYAMA, Takuji, Kyoto-shi, Kyoto 606-8501 (JP); HIGASHI, Makoto, Ichihara-shi, Chiba 290-8551 (JP); MINAMI, Ryo, Ichihara-shi, Chiba 290-8551 (JP); TANAKA, Hiroyuki, Ichihara-shi, Chiba 290-8551 (JP); BABA, Daisuke, Ichihara-shi, Chiba 290-8551 (JP)
(74) Representative: J A Kemp LLP
(86) International application number: PCT/JP2024/003949
(87) International publication number: WO 2024/166913

(57) **Abstract**

Provided are a novel polycyclic aromatic compound and an organic EL device using the same. A polycyclic aromatic compound represented by the general formula (A-1) increases options of a material for an organic device. An excellent device is also provided, for example, by preparing an organic EL device using this novel material.

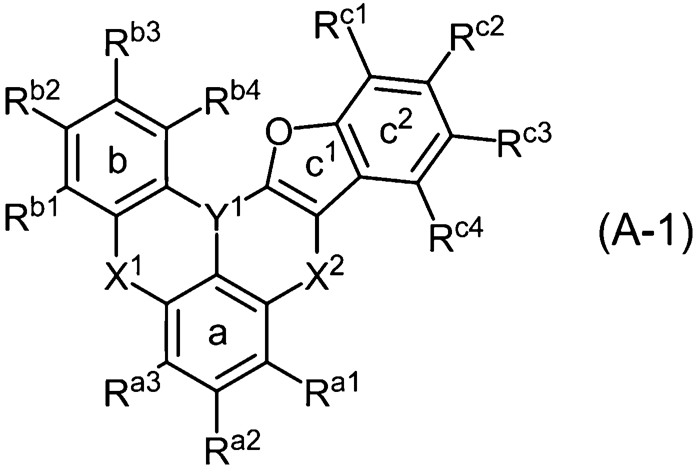

In the formula (A-1), R^{a1} to R^{a3}, R^{b1} to R^{b4}, and R^{c1} to R^{c4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, on the proviso that at least one of R^{a1} to R^{a3} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent; Y¹ is B, P, P=O, P=S, Al, Ga, As, Si-R, or Ge-R; and X¹ and X² are each independently O, N-R, C(-R)₂, Si(-R)₂, S, or Se, on the proviso that at least one of X¹ and X² is N-R, wherein the R moiety of the N-R is a group represented by the formula (G-1).

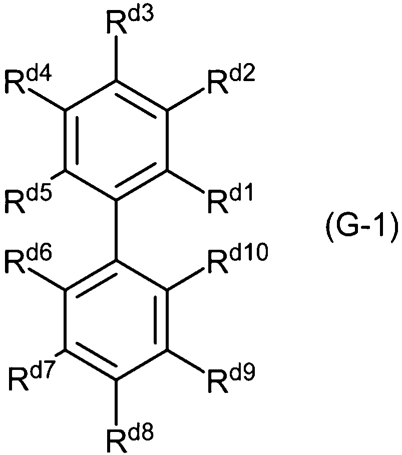

## Description

### Technical Field

The present invention relates to a polycyclic aromatic compound and a multimer thereof, an organic device such as an organic electroluminescent device, an organic field-effect transistor, an organic photovoltaic, and a wavelength conversion filter using the same, and a display and a lighting. In the present specification, the "polycyclic aromatic compound" and the "multimer" thereof are also collectively referred to as a "polycyclic aromatic compound", and the "organic electroluminescent device" is also referred to as an "organic EL device" or simply as a "device".

### Background Art

Displays using a luminescent device that emits electroluminescence have heretofore been variously studied because power saving or thinning is possible. Organic electroluminescent devices made of an organic material have been actively discussed because weight reduction or increase in size is easy. Particularly, active research has been made, irrespective of polymer compounds or low-molecular compounds, on the development of organic materials having luminescence characteristics of, for example, blue color, one of the three primary colors of light, and the development of organic materials having the ability to transport charge such as holes or electrons (having the potential to become semiconductors or superconductors).

The organic EL device has a structure composed of a pair of electrodes consisting of a positive electrode and a negative electrode, and one or more layers containing an organic compound, the layers being disposed between the pair of electrodes. The layers containing an organic compound include a luminescent layer, a charge transport/injection layer which transports or injects charge such as holes or electrons, and the like. Various organic materials appropriate for these layers have been developed.

For example, a material improved from a triphenylamine derivative has also been reported as a material for use in organic EL devices or organic photovoltaics (International Publication No. WO 2012/118164). This material is a material characterized in that its planarity is enhanced while nitrogen is positioned at the center of a ring structure by linking aromatic rings constituting triphenylamine, with reference to N,N'-diphenyl-N,N'-bis(3-methylphenyl)-1,1'-biphenyl-4,4'-diamine (TPD) already put into practical use. In this literature, for example, the charge transport characteristics of an NO-linked compound (compound 1 of page 63) have been evaluated. However, no mention has been made about a method for producing a material other than the NO-linked compound. The electron state of the whole compound differs among different elements to be linked. Therefore, characteristics obtained from a material other than the NO-linked compound have not been known.

A host material for organic EL devices is generally a molecule having a plurality of known aromatic rings such as benzene or carbazole linked through a single bond, a phosphorus atom, or a silicon atom. This is because a large HOMO-LUMO gap (band gap Eg in a thin film) necessary for the host material is secured by linking a large number of aromatic rings having a relatively small conjugated system. A host material for organic EL devices using a phosphorescent material or a thermally activated delayed fluorescence material is further required to also have high triplet excitation energy (E_{T}). SOMO1 and SOMO2 in a triplet excited state (T1) are localized by linking a donor or acceptor aromatic ring or substituent to a molecule, and the triplet excitation energy (E_{T}) can be improved by decreasing the exchange interaction between both the orbitals. However, aromatic rings having a small conjugated system have insufficient redox stability, and devices using a molecule with known aromatic rings linked as a host material have insufficient lifetime. On the other hand, polycyclic aromatic compounds having an expanded π conjugated system have generally been considered unsuitable for host materials due to a low HOMO-LUMO gap (band gap Eg in a thin film) or triplet excitation energy (E_{T}), though being excellent in redox stability.

Under these circumstances, a compound having a plurality of aromatic rings condensed with boron or the like as a central atom has also been reported in recent years (International Publication No. WO 2015/102118). In this literature, an organic EL device using the compound having a plurality of aromatic rings condensed as a dopant material for a luminescent layer has been evaluated. Also, a multimerized form of such a compound (International Publication No. WO 2018/212169) and a form having a conjugated system expanded through a linking group in a molecule have been reported (Korean Patent Publication No. 10-2020-0121228 and International Publication No. WO 2020/217229).

### Citation List

### Patent Literature

Patent Literature 1: International Publication No. WO 2012/118164
Patent Literature 2: International Publication No. WO 2015/102118
Patent Literature 3: International Publication No. WO 2018/212169
Patent Literature 4: Korean Patent Publication No. 10-2020-0121228
Patent Literature 5: International Publication No. WO 2020/217229

### Summary of Invention

### Technical Problem

As reported in Patent Literatures 1 to 5, various materials have been developed as materials for use in organic EL devices. However, there has been a demand for the development of materials made of non-traditional compounds in order to increase options of materials for organic EL devices. Particularly, it is beneficial to find organic EL characteristics obtained from a material other than an NO-linked compound with nitrogen positioned at the center of a ring structure, and a method for producing the same.

Patent Literatures 2 to 5 have each reported a polycyclic aromatic compound containing boron, and an organic EL device using the same. However, the literatures disclose exceedingly many compounds. It is beneficial to find a material for a luminescent layer, particularly, a dopant material, which can improve organic EL characteristics such as luminescence efficiency and device lifetime, in order to further improve device characteristics.

A vacuum deposition method as well as a wet film formation method is currently used as a method for forming an organic layer constituting an organic EL device. Therefore, ink materials for wet film formation, particularly, for forming a hole injection layer, a hole transport layer, and a luminescent layer, are under active development. It is also beneficial to find such an ink material.

### Solution to Problem

The present inventors have conducted diligent studies to solve the problems described above and consequently completed the present invention by finding that an excellent organic EL device can be obtained by disposing a layer containing a polycyclic aromatic compound having a novel structure between a pair of electrodes and thereby constituting the organic EL device, for example. Specifically, the present invention provides a polycyclic aromatic compound as described below and further provides a material for an organic device such as a material for an organic EL device, comprising the polycyclic aromatic compound as described below.

In the present specification, a chemical structure or a substituent may be indicated by the number of carbon atoms. For example, when a chemical structure is substituted by a substituent or when the substituent is further substituted by a substituent, the number of carbon atoms means the number of carbon atoms in each individual chemical structure or substituent and does not mean the total number of carbon atoms in the chemical structure and the substituent or the total number of carbon atoms in the substituent and the substituent. For example, a "substituent B having Y carbon atoms substituted by a substituent A having X carbon atoms" means that the substituent B having Y carbon atoms" is substituted by the "substituent A having X carbon atoms", and the number Y of carbon atoms is not the total number of carbon atoms in the substituent A and the substituent B. For example, a "substituent B having Y carbon atoms substituted by a substituent A" means that the "substituent B having Y carbon atoms" is substituted by the "substituent A (which is not limited by the number of carbon atoms)", and the number Y of carbon atoms is not the total number of carbon atoms in the substituent A and the substituent B.
[1] A polycyclic aromatic compound represented by the following formula (A-1), or a multimer of the polycyclic aromatic compound having at least two unit structures represented by the formula (A-1): 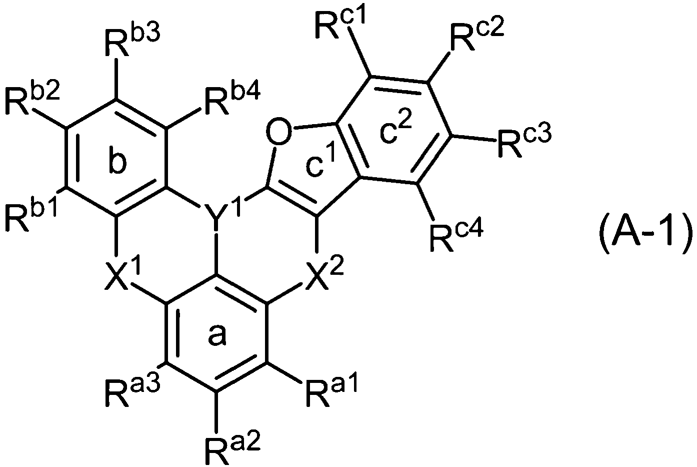 Wherein
   R^{a1} to R^{a3}, R^{b1} to R^{b4}, and R^{c1} to R^{c4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group, and
   two adjacent groups of R^{a1} to R^{a3}, R^{b1} to R^{b4}, and R^{c1} to R^{c4} are optionally bonded to each other to form an aryl ring or a heteroaryl ring, and at least one hydrogen atom of the formed aryl ring and heteroaryl ring is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
   on the proviso that at least one of R^{a1} to R^{a3} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent;
   Y¹ is B, P, P=O, P=S, Al, Ga, As, Si-R, or Ge-R, wherein the R moieties of the Si-R and the Ge-R are each independently substituted or unsubstituted aryl, substituted or unsubstituted heteroaryl, substituted or unsubstituted alkyl, or substituted or unsubstituted cycloalkyl;
   X¹ and X² are each independently O, N-R, C(-R)₂, Si(-R)₂, S, or Se, wherein the R moiety of the N-R is hydrogen, aryl substituted by alkyl, substituted or unsubstituted heteroaryl, substituted or unsubstituted alkyl, substituted or unsubstituted cycloalkyl, or a group represented by the formula (G-1), the R moieties of the C(-R)₂ and the Si(-R)₂ are each independently hydrogen, substituted or unsubstituted aryl, substituted or unsubstituted heteroaryl, substituted or unsubstituted alkyl, or substituted or unsubstituted cycloalkyl, two R moieties of the C(-R)₂ and the Si(-R)₂ are optionally bonded to each other to form a ring, and the R moiety of the N-R and/or the R moiety of the C(-R)₂ is optionally bonded to the ring a and/or the ring b or to the ring a and/or the ring c² through a linking group,
   on the proviso that at least one of X¹ and X² is N-R, wherein the R moiety of the N-R is a group represented by the formula (G-1): 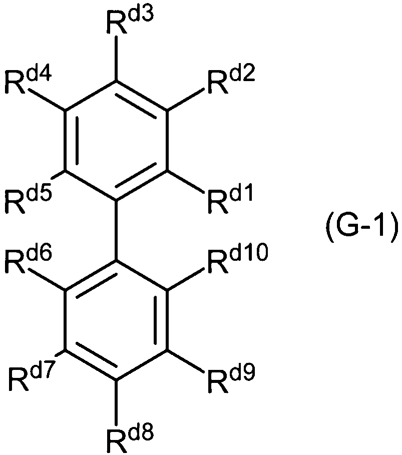 wherein
      R^{d1} to R^{d10} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
      two adjacent groups of R^{d1} to R^{d10} are optionally bonded to each other to form a cycloalkane-condensed structure, and at least one hydrogen atom of the cycloalkane is optionally replaced,
      on the proviso that at least one of R^{d6} to R^{d10} is alkyl, or two adjacent groups of Rd⁶ to Rd¹⁰ are bonded to each other to form a cycloalkane-condensed structure, and
      any one of R^{d1} to R^{d5} is a bond to a nitrogen atom;
   in the compound or the unit structure represented by the formula (A-1), at least one of the ring a, the ring b, the ring c², the aryl ring, and the heteroaryl ring is optionally condensed with at least one cycloalkane, at least one hydrogen atom in the cycloalkane is optionally replaced, and at least one -CH₂- moiety in the cycloalkane is optionally substituted by -O-;
   at least one hydrogen atom in the compound or the unit structure represented by the formula (A-1) is optionally replaced with cyano or halogen; and
   in the compound or the unit structure represented by the formula (A-1), at least one hydrogen atom is optionally replaced with deuterium, at least one nitrogen atom is optionally replaced with nitrogen-15 (¹⁵N), at least one sulfur atom is optionally replaced with sulfur-33 (³³S), sulfur-34 (³⁴S), or sulfur-36 (³⁶S), at least one oxygen atom is optionally replaced with oxygen-17 (¹⁷O) or oxygen-18 (¹⁸O), at least one carbon atom is optionally replaced with carbon-13 (¹³C), and at least one boron atom is optionally replaced with boron-11 (¹¹B).
[2] The polycyclic aromatic compound or the multimer thereof according to [1], wherein the formula (G-1) represents a group represented by any of the formula (G-2) to the formula (G-21): 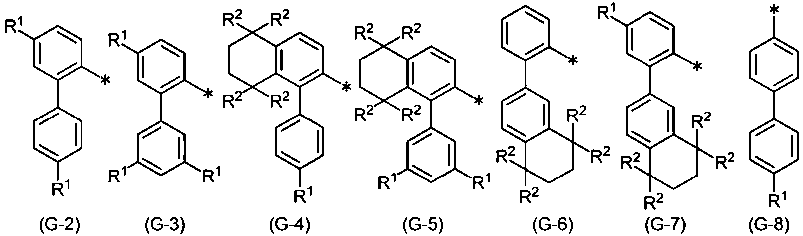 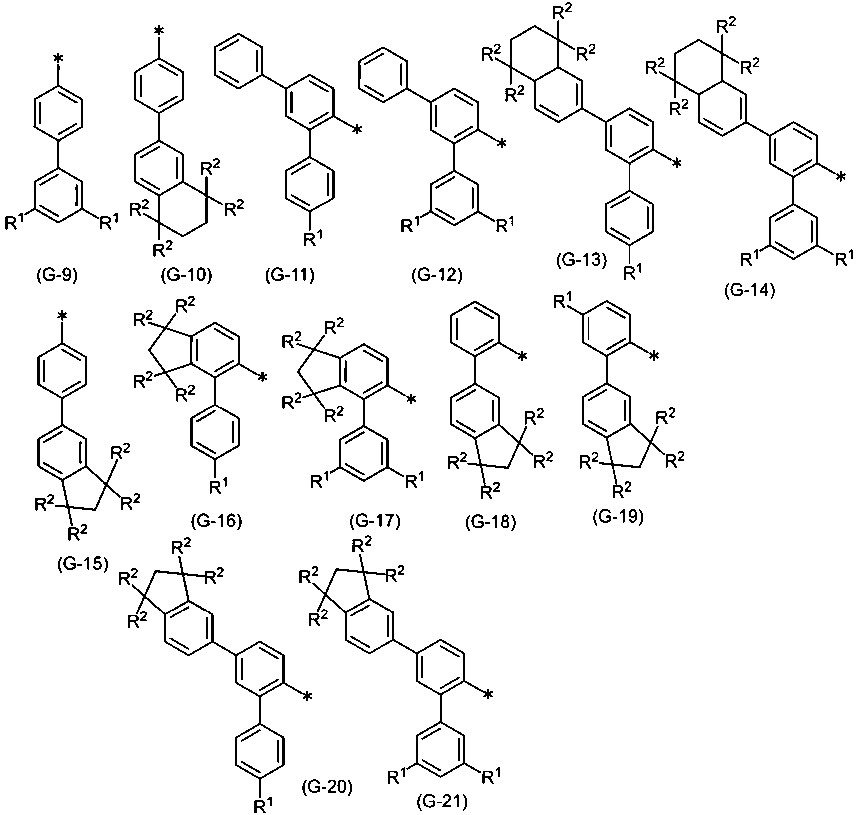 wherein
   each R¹ is independently alkyl,
   each R² is independently hydrogen or alkyl, and
   * is a bond to a nitrogen atom.
[3] The polycyclic aromatic compound or the multimer thereof according to [1] or [2], wherein the formula (A-1) is represented by any of the following formulas (A-2) to (A-12): 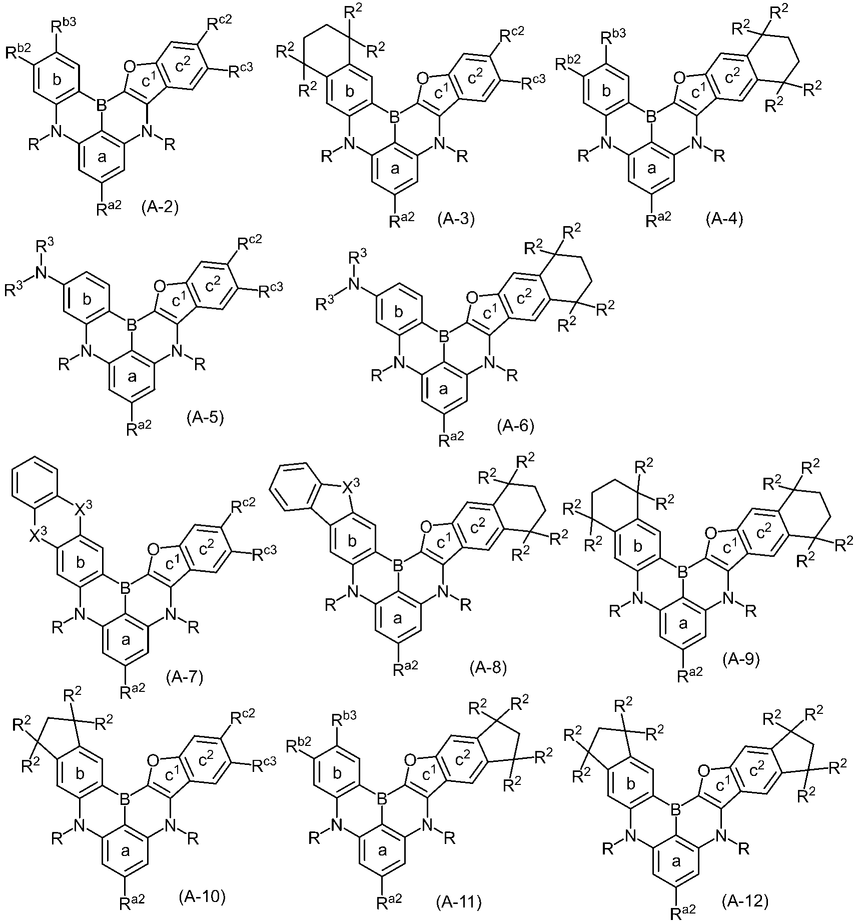 wherein
   R^{a2} is substituted aryl with substituted or unsubstituted diarylamino, substituted or unsubstituted carbazolyl, substituted or unsubstituted alkyl, substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent, wherein the aryl ring of the substituted aryl or the heteroaryl ring of the substituted heteroaryl is optionally condensed with at least one cycloalkane, and at least one hydrogen atom in the cycloalkane is optionally replaced,
   R^{b2} and R^{b3} or R^{c2} and R^{c3} are each independently hydrogen, substituted or unsubstituted alkyl, or substituted or unsubstituted cycloalkyl,
   one of two R moieties is a group represented by the formula (G-1), and the other moiety is aryl substituted by alkyl, substituted or unsubstituted heteroaryl, aryl condensed with cycloalkane, heteroaryl condensed with cycloalkane, or a group represented by the formula (G-1),
   each R² is independently hydrogen or alkyl,
   each R³ is independently substituted or unsubstituted aryl or substituted or unsubstituted heteroaryl,
   each X³ is independently O, N-R⁴, or C(-R⁴)₂, and
   each R⁴ is independently alkyl or substituted or unsubstituted aryl.
[4] The polycyclic aromatic compound or the multimer thereof according to [3], wherein
   in the formulas (A-2) to (A-12),
   R^{a2} is diarylamino optionally substituted by methyl, t-amyl, or t-butyl, or substituted aryl with alkyl as a substituent,
   one of R^{b2} and R^{b3} is hydrogen, and the other moiety is methyl, t-butyl, or t-amyl,
   one of R^{c2} and R^{c3} is hydrogen, and the other moiety is methyl, t-butyl, adamantyl, or 3,5-dimethyl-1-adamantyl,
   one of two R moieties is a group represented by the following formula (G-1), and the other moiety is aryl substituted by alkyl, aryl condensed with cycloalkane, or a group represented by the formula (G-1),
   each R² is independently methyl, and
   each R³ is independently a group represented by any of the following formulas (R³-1) to (R³-11): 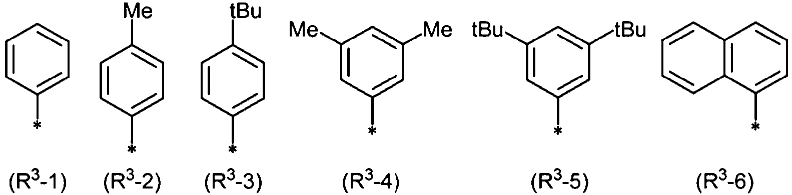 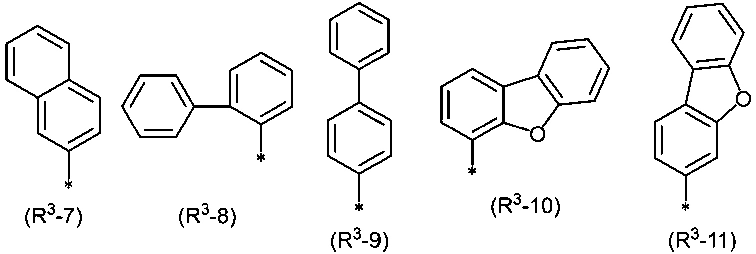 wherein * represents a bond to a nitrogen atom, and
   X³ is O, N-bis(4-t-butylphenyl), or C(Me)₂.
[5] The polycyclic aromatic compound or the multimer thereof according to any of [1] to [4], wherein the polycyclic aromatic compound is represented by any one of the following formulas: 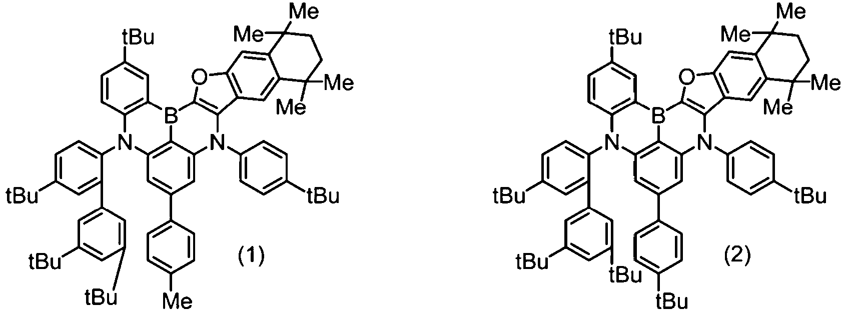 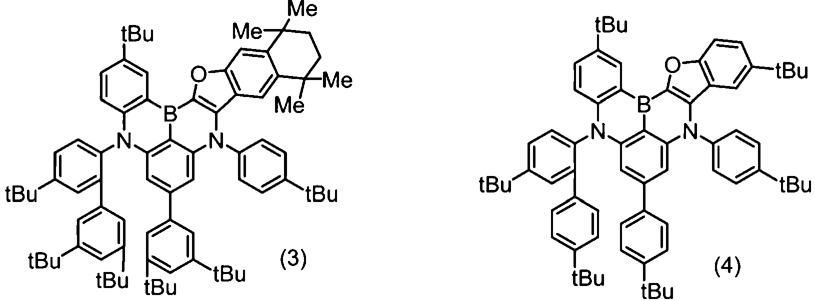 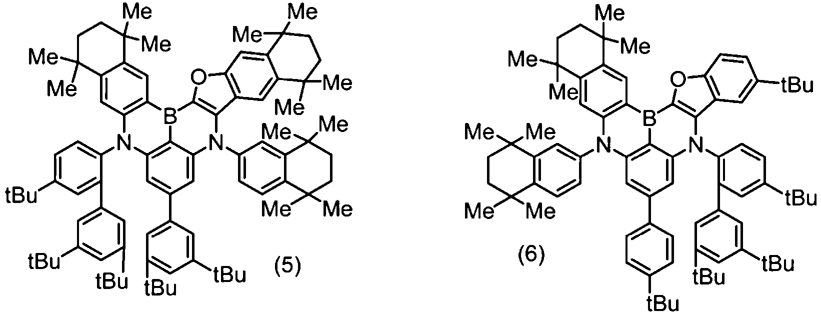 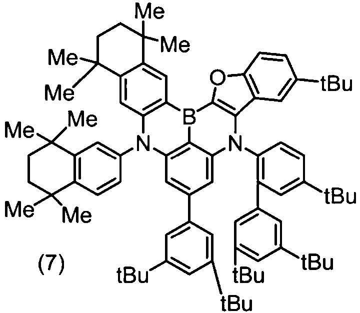 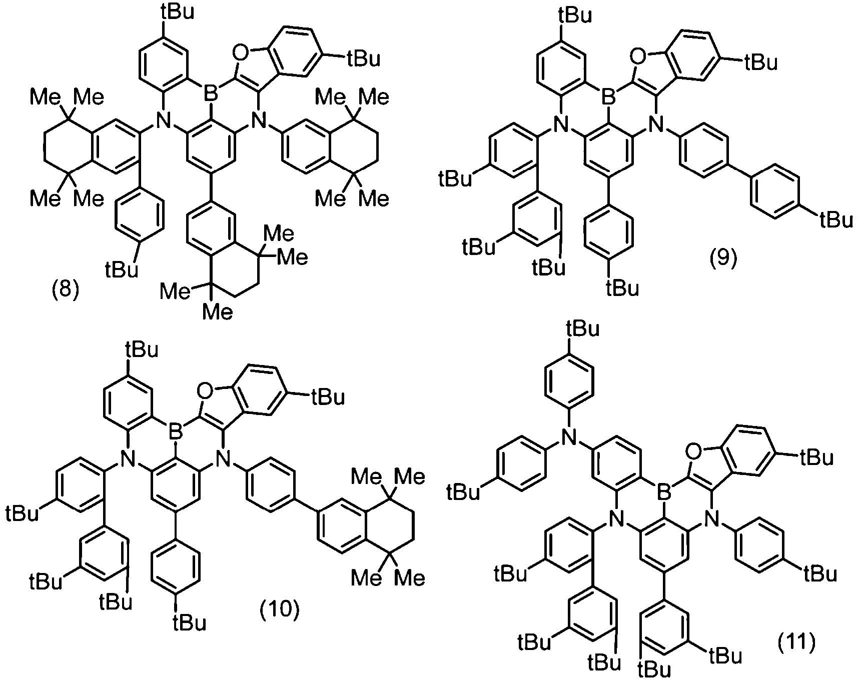 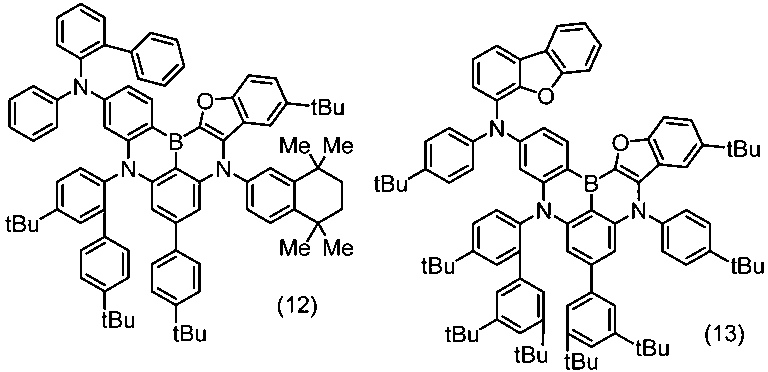 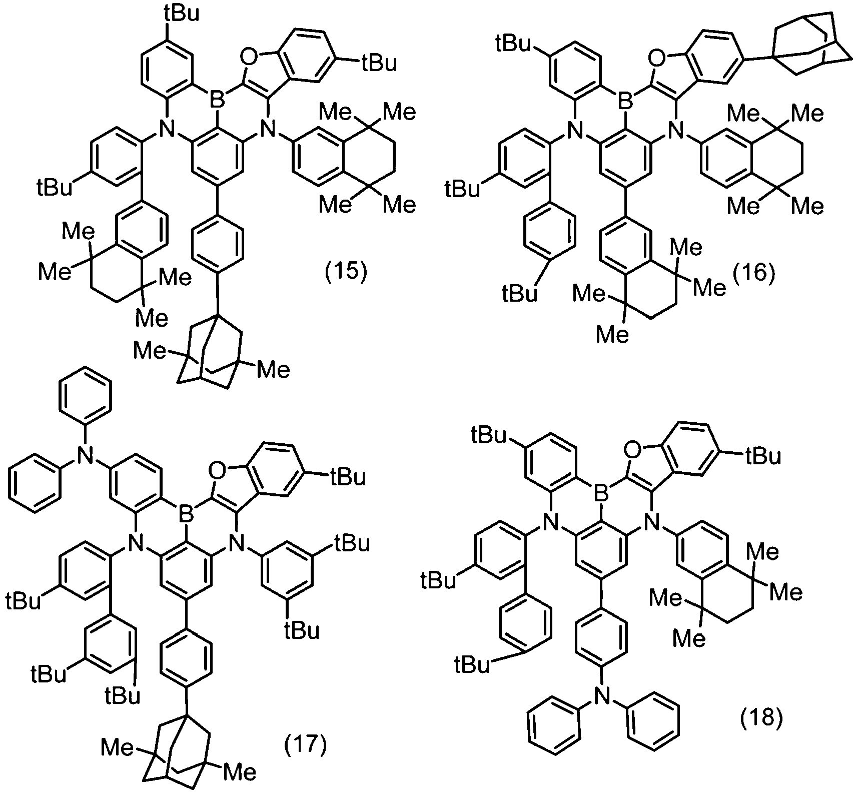 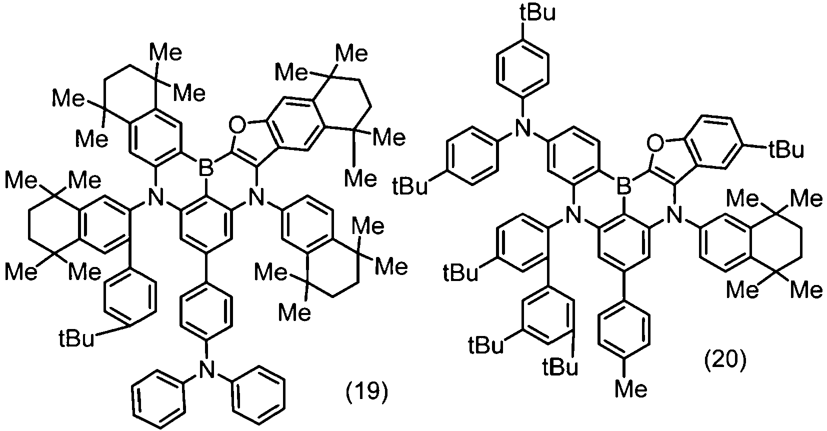 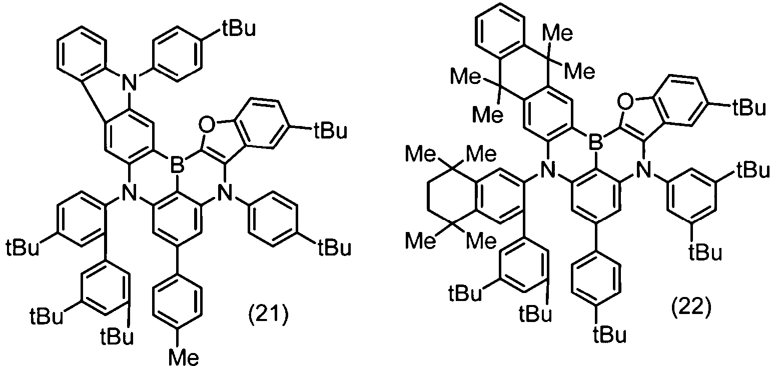 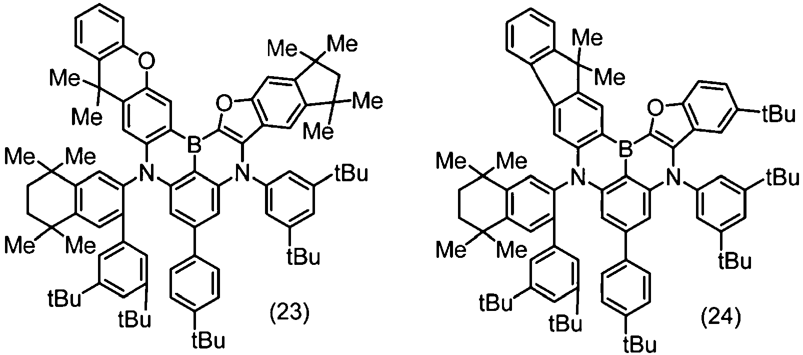 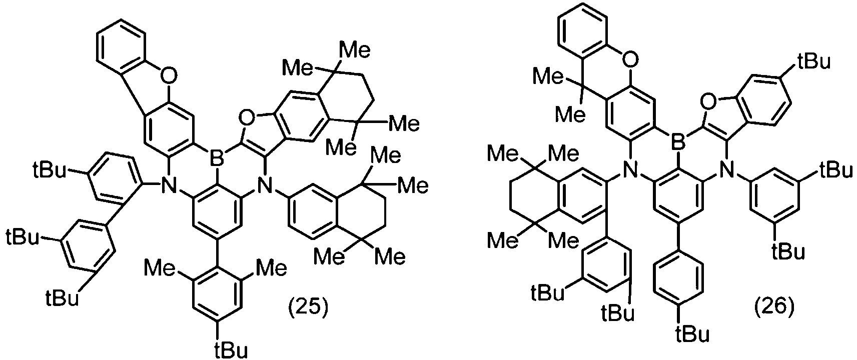 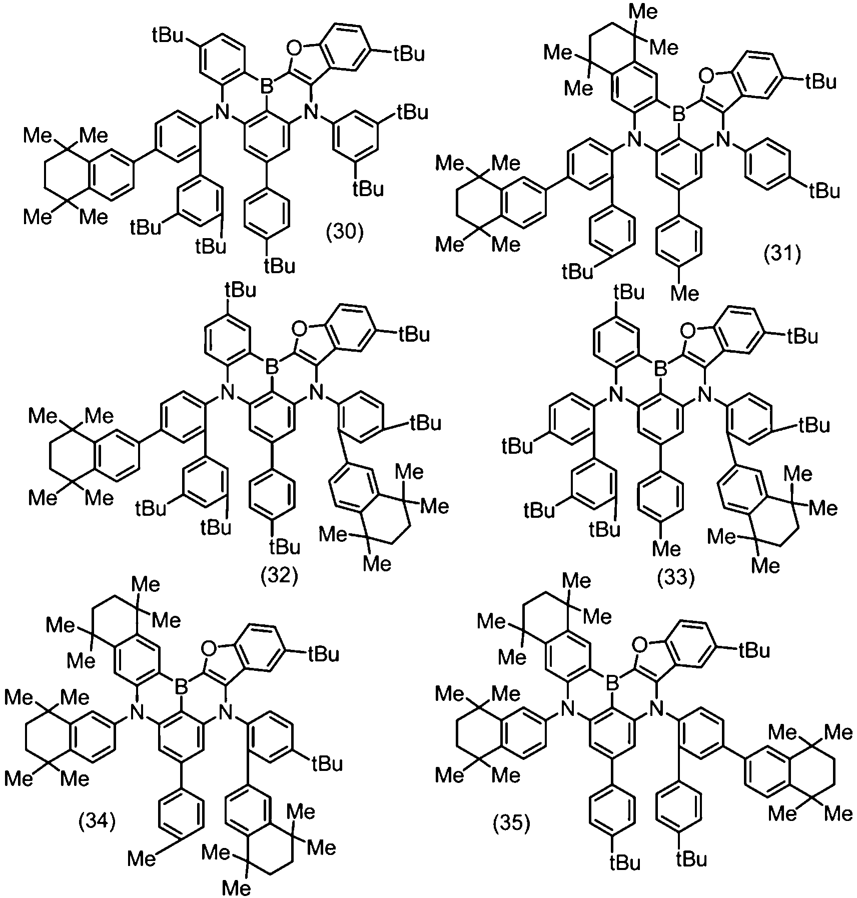 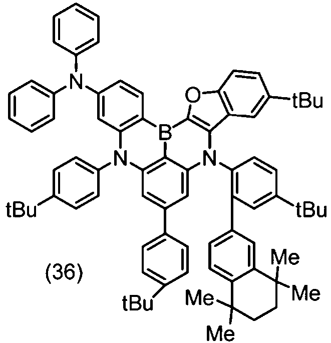 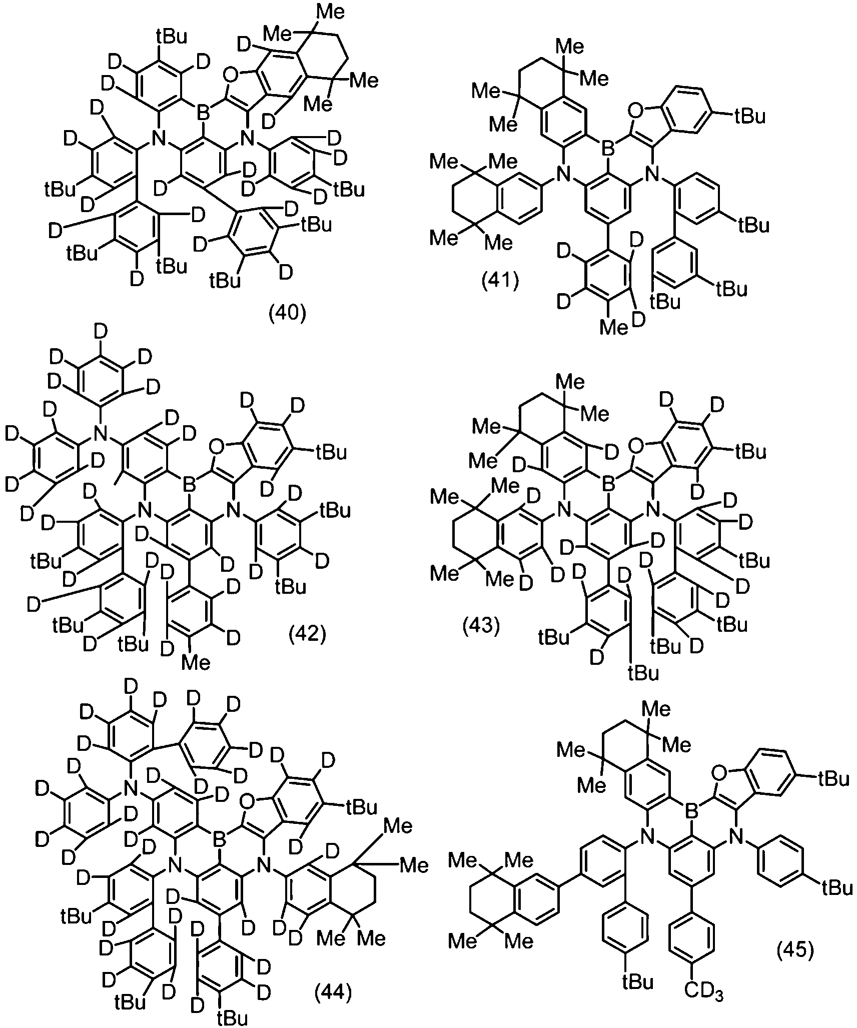 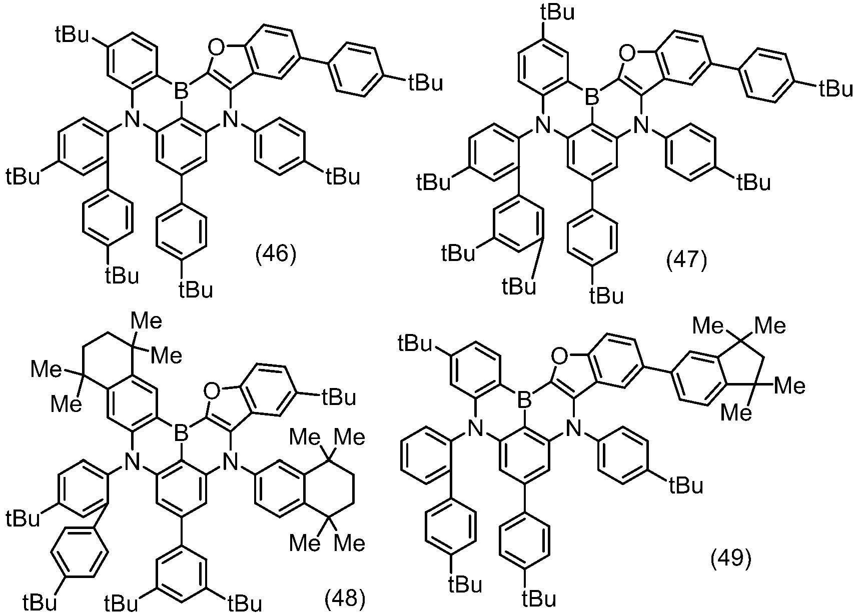 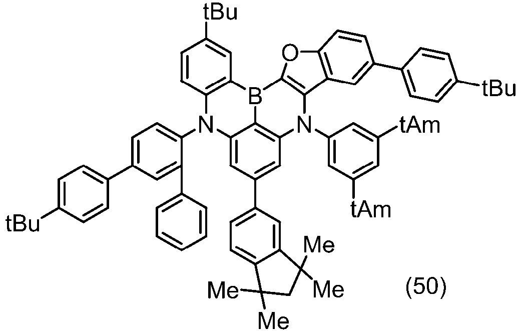 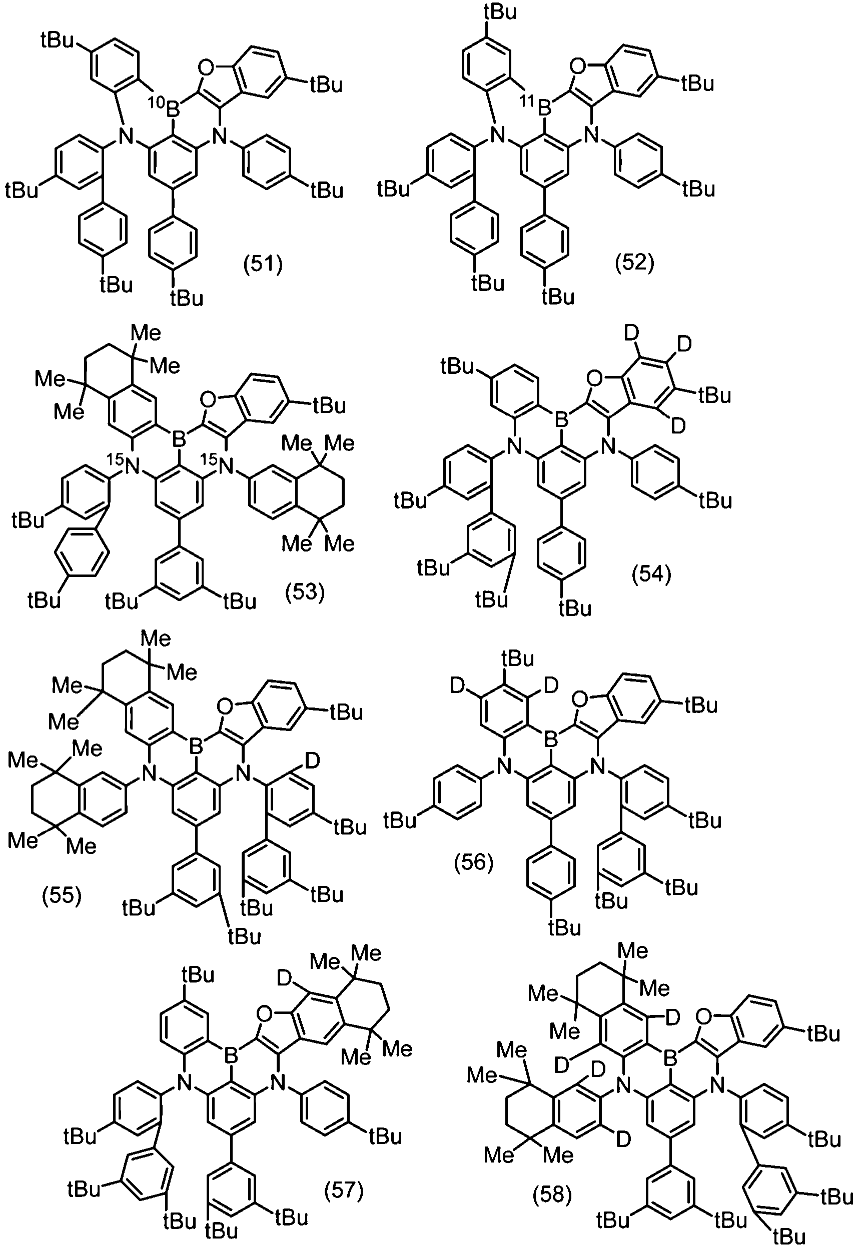 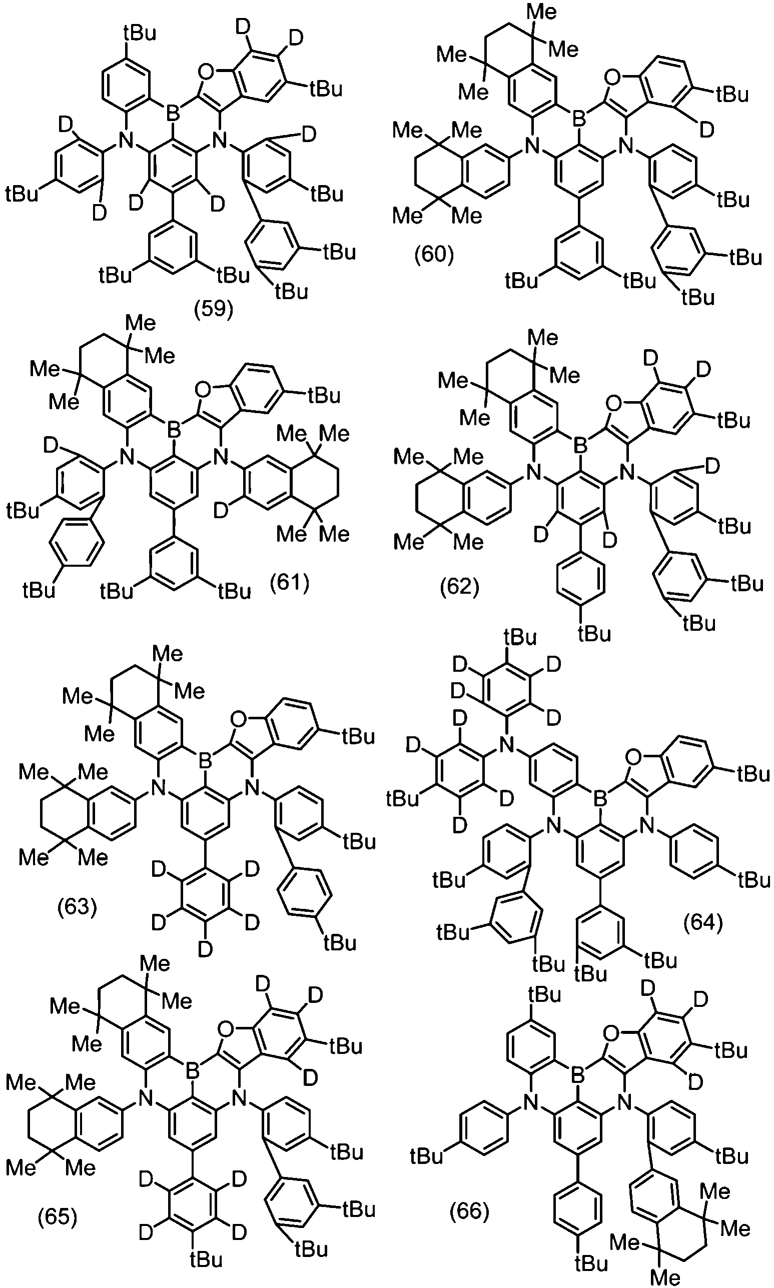 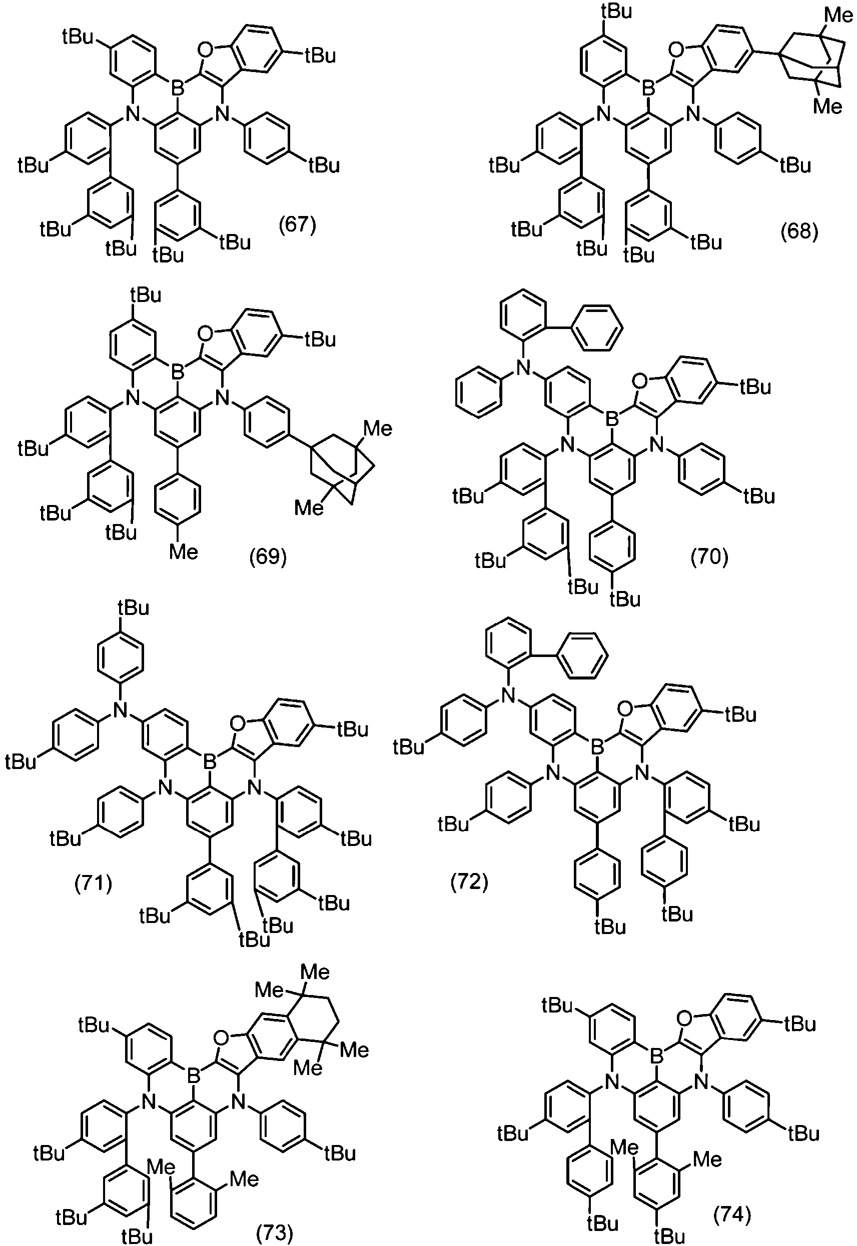 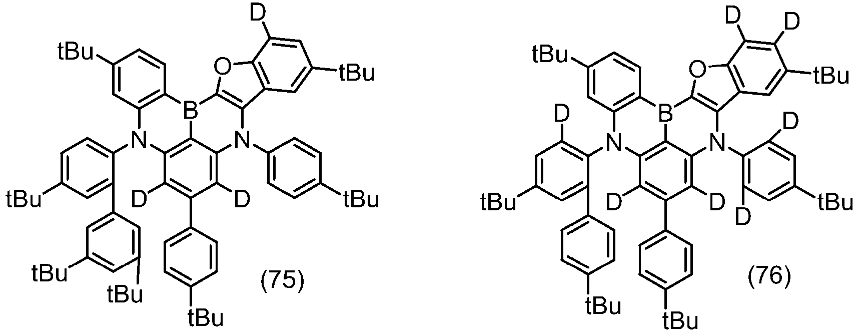 wherein Me is methyl, tBu is t-butyl, t-Am is t-amyl, and D is deuterium.
[6] The polycyclic aromatic compound or the multimer thereof according to [5], wherein the polycyclic aromatic compound is represented by any one of the formulas (1) to (13), the formulas (15) and (16), the formula (18), the formulas (21) to (26), the formulas (31) to (35), the formulas (40) and (41), the formulas (45) to (52), the formula (55), the formula (57), the formula (59), the formula (60), the formula (64), and the formulas (67) to (76).
[7] A material for an organic device, comprising a polycyclic aromatic compound or a multimer thereof according to any of [1] to [6].
[8] The material for an organic device according to [7], wherein the material is a material for an organic electroluminescent device, a material for an organic field-effect transistor, a material for an organic photovoltaic, or a material for a wavelength conversion filter.
[9] The material for an organic device according to [8], wherein the material for an organic electroluminescent device is a material for a luminescent layer.
[10] An organic electroluminescent device having a pair of electrodes consisting of a positive electrode and a negative electrode, and an organic layer containing a polycyclic aromatic compound or a multimer thereof according to any of [1] to [6], the organic layer being disposed between the pair of electrodes.
[11] The organic electroluminescent device according to [10], wherein the organic layer is a luminescent layer.
[12] The organic electroluminescent device according to [11], wherein the luminescent layer comprises a dopant which is the polycyclic aromatic compound or the multimer thereof according to any of [1] to [6], and a host.
[13] The organic electroluminescent device according to [12], wherein the host is an anthracene compound, a fluorene compound, or a dibenzochrysene compound.
[14] A display or a lighting comprising an organic electroluminescent device according to [10].
[15] A wavelength conversion filter comprising a material for a wavelength conversion filter according to [8].

### Advantageous Effects of Invention

A preferred aspect of the present invention can provide, for example, a polycyclic aromatic compound having a novel structure that can be used as a material for an organic device such as a material for an organic EL device. Use of this polycyclic aromatic compound can provide an excellent organic device such as an organic EL device.

Specifically, the present inventors have found that a polycyclic aromatic compound having aromatic rings linked through a hetero element such as boron, nitrogen, oxygen, or sulfur has a large HOMO-LUMO gap (band gap Eg in a thin film). This is because a 6-membered ring containing a hetero element had low aromaticity and suppressed decrease in HOMO-LUMO gap associated with the expansion of a conjugated system. The present inventors have also found that the HOMO-LUMO gap can be arbitrarily changed depending on the type of the hetero element and a linking method. This is presumably because the HOMO or LUMO energy can be arbitrarily shifted depending on the unoccupied orbital of the hetero element or the spatial distribution of lone pairs and energy.

Such a polycyclic aromatic compound has a narrow half width of a fluorescence emission peak through SOMO1 and SOMO2 in an excited state localized on each atom by electronic perturbation of the hetero element, and produces luminescence with high color purity when used as a dopant for an organic EL device. For the same reasons as above, the polycyclic aromatic compound exhibits thermally activated delayed fluorescence owing to a small energy difference (ΔS¹T¹) between singlet energy (S¹) and triplet energy (T¹), and can produce high efficiency when used as an emitting dopant for an organic EL device.

Furthermore, HOMO or LUMO energy can be arbitrarily shifted by the introduction of a substituent. Therefore, ionization potential or electron affinity can be optimized depending on a peripheral material. However, the present invention is not particularly limited by these principles.

### Brief Description of Drawing

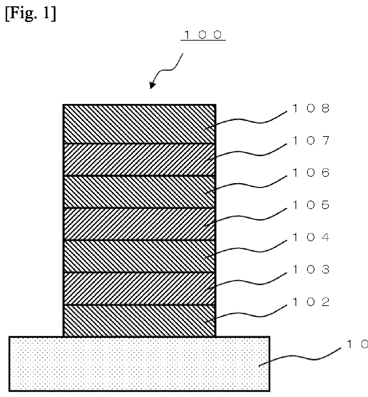

[Fig. 1] Fig. 1 is a schematic cross-sectional view showing the organic EL device according to the present embodiment.

### Description of Embodiments

### 1. Polycyclic aromatic compound

### <Description of whole structure of compound>

The present invention provides a polycyclic aromatic compound represented by the following general formula (A-1) or a multimer of the polycyclic aromatic compound having at least two unit structures represented by the general formula (A-1):

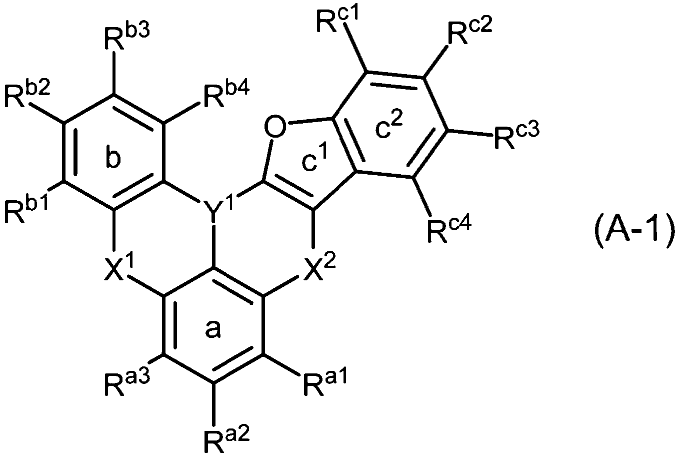

In the general formula (A-1), at least one of R^{a1} to R^{a3} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent.
Y¹ is B, P, P=O, P=S, Al, Ga, As, Si-R, or Ge-R.
X¹ and X² are each independently O, N-R, C(-R)₂, Si(-R)₂, S, or Se, on the proviso that at least one of X¹ and X² is N-R, wherein the R moiety of the N-R is a group represented by the formula (G-1):

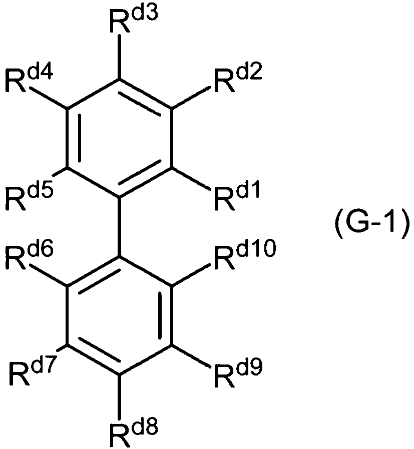

Symbols in structural formulas given below are defined as mentioned above. Symbols in all structural formulas shown in this and subsequent paragraphs are defined as mentioned above. In the present specification, "Me" in the structural formulas or the description thereof represents a methyl group, "tBu" represents a t-butyl group, "tAm" represents a t-amyl group, and "D" represents deuterium, unless otherwise specified.

### <Description of substituent in compound>

In the general formula (A-1), R^{a1} to R^{a3}, R^{b1} to R^{b4}, and R^{c1} to R^{c4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl. Details thereof will be mentioned later. Details of the rings and the substituents listed here will be collectively mentioned later. In the present specification, the term "substituted or unsubstituted " means that the substituent may further have a substituent, unless otherwise specified. In this respect, examples of the substituent that may be carried by the substituent include aryl, heteroaryl, diarylamino, diheteroarylamino, arylheteroarylamino, diarylboryl, alkyl, cycloalkyl, alkenyl, alkoxy, aryloxy, arylthio, and substituted silyl and preferably include aryl, heteroaryl, alkyl, and cycloalkyl. At least one hydrogen atom of the aryl and the heteroaryl in the diarylamino, the diheteroarylamino, the arylheteroarylamino, the diarylboryl, the aryloxy, and the arylthio is optionally replaced with alkyl or cycloalkyl. Each of R^{a2} and R^{b2} is more preferably substituted or unsubstituted diarylamino, substituted or unsubstituted diheteroarylamino, or substituted or unsubstituted arylheteroarylamino, further preferably diarylamino optionally substituted by alkyl.

Two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group. Details of this linking group and bonded modes will be collectively mentioned later. In the present specification, the "linking group" means a single bond, alkylene, alkenylene, alkynylene, -N(-R)-, -O-, -S-, -Si(-R)₂-, or -Se-. In this respect, examples of the alkylene include -CH₂-, -CH₂-CH₂-, -CHR-CHR-, -CR₂-CR₂-, and -C(-R)₂-. Examples of the alkenylene include -CH=CH-, -CH=CR-, - CR=CR-, -CH=CH-CH₂-, and -CH₂-CH=CH-. Examples of the alkynylene include -C≡C-, -C≡C-CH₂-, and -CH₂-C≡C-. In this respect, the R moieties are each independently hydrogen, aryl, heteroaryl, alkyl, alkenyl, alkynyl, or cycloalkyl, and at least one hydrogen atom of the R moiety is optionally replaced with alkyl or cycloalkyl. Two R moieties bonded to the same carbon atom, two R moieties bonded to the same silicon atom, or two R moieties bonded to adjacent carbon atoms (e.g., two R moieties in -CHR-CHR-, -CR₂-CR₂-, -CR=CR-, -C(-R)₂-, or -Si(-R)₂-) are optionally bonded to each other to form a cycloalkylene ring, an arylene ring, and a heteroarylene ring. Details of R listed here will be mentioned later.

For example, two aryl moieties of diarylamino form carbazolyl when bonded to each other via a single bond; two aryl moieties of diarylamino form phenoxazinyl when bonded to each other via -O-; and two aryl moieties of diarylamino form phenothiazinyl when bonded to each other via -S-.

### <Description of R^{a1} to R^{a3} in compound>

R^{a1} to R^{a3} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl. In this respect, two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group.

Among them, R^{a1} to R^{a3} are each independently preferably hydrogen, substituted or unsubstituted aryl, substituted or unsubstituted heteroaryl, substituted or unsubstituted diarylamino, substituted or unsubstituted arylheteroarylamino, substituted or unsubstituted alkyl, substituted or unsubstituted cycloalkyl, or substituted or unsubstituted carbazolyl (wherein the substituent is at least one member selected from the group consisting of alkyl, cycloalkyl, and alkyl-substituted or unsubstituted cycloalkyl), more preferably hydrogen, substituted or unsubstituted phenyl, substituted or unsubstituted diphenylamino, substituted or unsubstituted phenylnaphthylamino, substituted or unsubstituted phenylbiphenylamino, substituted or unsubstituted phenyldibenzofuranylamino, substituted or unsubstituted biphenyldibenzofuranylamino, substituted or unsubstituted naphthyldibenzofuranylamino, methyl, t-butyl, t-amyl, substituted or unsubstituted adamantyl, or substituted or unsubstituted carbazolyl (wherein the substituent is at least one member selected from the group consisting of methyl, t-butyl, t-amyl, and adamantyl (optionally substituted by methyl)), further preferably hydrogen, t-butyl, diphenylamino, or carbazolyl, particularly preferably hydrogen or t-butyl.

In one embodiment, at least one of R^{a1} to R^{a3} is preferably substituted or unsubstituted aryl, substituted or unsubstituted heteroaryl, substituted or unsubstituted diarylamino, substituted or unsubstituted arylheteroarylamino, substituted or unsubstituted alkyl, substituted or unsubstituted cycloalkyl, or substituted or unsubstituted carbazolyl (wherein the substituent is at least one member selected from the group consisting of alkyl, cycloalkyl, and alkyl-substituted or unsubstituted cycloalkyl), more preferably substituted or unsubstituted phenyl, substituted or unsubstituted diphenylamino, substituted or unsubstituted phenylnaphthylamino, substituted or unsubstituted phenylbiphenylamino, substituted or unsubstituted phenyldibenzofuranylamino, substituted or unsubstituted biphenyldibenzofuranylamino, substituted or unsubstituted naphthyldibenzofuranylamino, methyl, t-butyl, t-amyl, substituted or unsubstituted adamantyl, or substituted or unsubstituted carbazolyl (wherein the substituent is at least one member selected from the group consisting of methyl, t-butyl, t-amyl, and adamantyl (optionally substituted by methyl)), further preferably t-butyl, diphenylamino, or carbazolyl, particularly preferably t-butyl.

The aryl or the heteroaryl constituting the substituted or unsubstituted aryl, the substituted or unsubstituted heteroaryl, the substituted or unsubstituted diarylamino, the substituted or unsubstituted diheteroarylamino, the substituted or unsubstituted arylheteroarylamino, the substituted or unsubstituted diarylboryl, the substituted or unsubstituted aryloxy, or the substituted or unsubstituted arylthio represented by R^{a1} to R^{a3} is optionally condensed with at least one cycloalkane, at least one hydrogen atom in the cycloalkane is optionally replaced, and at least one - CH₂- moiety in the cycloalkane is optionally substituted by -O-.

In one embodiment, at least one of R^{a1} to R^{a3} is preferably aryl condensed with cycloalkane, more preferably 1,2,3,4-tetrahydro-1,1,4,4-tetramethylnaphthalen-6-yl or 1,1,3,3-tetramethyl-2,3-dihydro-1H-inden-5-yl.

However, at least one of R^{a1} to R^{a3} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent.

The aryl of the substituted aryl is preferably phenyl, biphenyl, terphenyl, naphthyl, phenanthrenyl, or triphenyl, more preferably phenyl, biphenyl, or terphenyl, further preferably phenyl.

The heteroaryl of the substituted heteroaryl is preferably dibenzofuranyl, dibenzothiophenyl, or carbazolyl, more preferably dibenzofuranyl.

The substituent on each of the substituted aryl and the substituted heteroaryl is preferably unsubstituted alkyl or substituted or unsubstituted cycloalkyl, more preferably unsubstituted alkyl.

In this respect, the alkyl is preferably methyl, t-butyl, or t-amyl, more preferably t-butyl.

The substituted or unsubstituted cycloalkyl is preferably adamantyl or 3,5-dimethyl-1-adamantyl, more preferably 3,5-dimethyl-1-adamantyl.

In one embodiment, at least one of R^{a1} to R^{a3} is preferably substituted aryl, more preferably 4-methylphenyl, 4-t-butylphenyl, 3,5-di-t-butylphenyl, 1,5-dimethyl-4-t-butylphenyl, p-(3,5-dimethyl-1-adamantyl)phenyl, 4-diphenylaminophenyl, 1,2,3,4-tetrahydro-1,1,4,4-tetramethylnaphthalen-6-yl, or 1,1,3,3-tetramethyl-2,3-dihydro-1H-inden-5-yl.

Among R^{a1} to R^{a3}, preferably, R^{a2} is the substituted aryl or the substituted heteroaryl, and each of R^{a1} and R^{a3} is hydrogen.

### <Description of R^{b1} to R^{b4} in compound>

R^{b1} to R^{b4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl. In this respect, two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group.

Among them, each of R^{b1} to R^{b4} is preferably hydrogen, substituted or unsubstituted aryl, substituted or unsubstituted heteroaryl, substituted or unsubstituted diarylamino, substituted or unsubstituted arylheteroarylamino, substituted or unsubstituted alkyl, substituted or unsubstituted cycloalkyl, or substituted or unsubstituted carbazolyl (wherein the substituent is at least one member selected from the group consisting of alkyl, cycloalkyl, and alkyl-substituted or unsubstituted cycloalkyl), more preferably hydrogen, substituted or unsubstituted phenyl, substituted or unsubstituted diphenylamino, substituted or unsubstituted phenylnaphthylamino, substituted or unsubstituted phenylbiphenylamino, substituted or unsubstituted phenyldibenzofuranylamino, substituted or unsubstituted biphenyldibenzofuranylamino, substituted or unsubstituted naphthyldibenzofuranylamino, methyl, t-butyl, t-amyl, substituted or unsubstituted adamantyl, or substituted or unsubstituted carbazolyl (wherein the substituent is at least one member selected from the group consisting of methyl, t-butyl, t-amyl, and adamantyl (optionally substituted by methyl)), further preferably hydrogen, t-butyl, diphenylamino, or carbazolyl, particularly preferably hydrogen or t-butyl.

In one embodiment, at least one of R^{b1} to R^{b4} is preferably substituted or unsubstituted aryl, substituted or unsubstituted heteroaryl, substituted or unsubstituted diarylamino, substituted or unsubstituted arylheteroarylamino, substituted or unsubstituted alkyl, substituted or unsubstituted cycloalkyl, or substituted or unsubstituted carbazolyl (wherein the substituent is at least one member selected from the group consisting of alkyl, cycloalkyl, and alkyl-substituted or unsubstituted cycloalkyl), more preferably substituted or unsubstituted phenyl, substituted or unsubstituted diphenylamino, substituted or unsubstituted phenylnaphthylamino, substituted or unsubstituted phenylbiphenylamino, substituted or unsubstituted phenyldibenzofuranylamino, substituted or unsubstituted biphenyldibenzofuranylamino, substituted or unsubstituted naphthyldibenzofuranylamino, methyl, t-butyl, t-amyl, substituted or unsubstituted adamantyl, or substituted or unsubstituted carbazolyl (wherein the substituent is at least one member selected from the group consisting of methyl, t-butyl, t-amyl, and adamantyl (optionally substituted by methyl)), further preferably t-butyl, diphenylamino, or carbazolyl, particularly preferably t-butyl.

In one embodiment, at least one of R^{b1} to R^{b4} is preferably substituted or unsubstituted diarylamino or unsubstituted alkyl (wherein the substituent is alkyl), more preferably t-butyl, substituted or unsubstituted diphenylamino, substituted or unsubstituted phenylnaphthylamino, or substituted or unsubstituted phenylbiphenylamino (wherein the substituent is t-butyl).

The ring b is optionally condensed with at least one cycloalkane, at least one hydrogen atom in the cycloalkane is optionally replaced, and at least one -CH₂-moiety in the cycloalkane is optionally substituted by -O-. Specifically, two adjacent groups of R^{b1} to R^{b4} are optionally bonded to each other to form a cycloalkane-condensed structure, at least one hydrogen atom in the cycloalkane is optionally replaced, and at least one -CH₂- moiety in the cycloalkane is optionally substituted by -O-.

In one embodiment, R^{b1} and R^{b2}, R^{b2} and R^{b3}, or R^{b3} and R^{b4} are preferably bonded to each other to form a cycloalkane-condensed structure. R^{b2} and R^{b3} are more preferably bonded to each other to form a cycloalkane-condensed structure. R^{b2} and R^{b3} are further preferably bonded to each other to form a cyclopentane-condensed structure or a cyclohexane-condensed structure.

The ring b, when condensed with cycloalkane, is preferably represented by any of the following formulas:

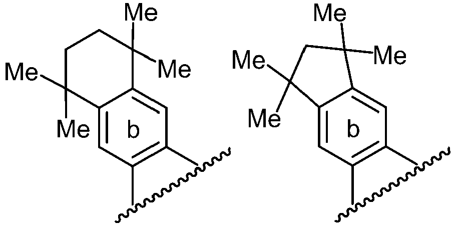

### <Description of R^{c1} to R^{c4} in compound>

R^{c1} to R^{c4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl. In this respect, two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group.

Among them, each of R^{c1} to R^{c4} is preferably hydrogen or substituted or unsubstituted aryl (wherein the substituent is alkyl), more preferably hydrogen or substituted or unsubstituted phenyl (wherein the substituent is at least one member selected from the group consisting of methyl, t-butyl, t-amyl, and adamantyl (optionally substituted by methyl)), further preferably hydrogen or phenyl.

In one embodiment, at least one of R^{c1} to R^{c4} is preferably substituted or unsubstituted aryl (wherein the substituent is alkyl), more preferably substituted or unsubstituted phenyl (wherein the substituent is at least one member selected from the group consisting of methyl, t-butyl, t-amyl, and adamantyl (optionally substituted by methyl)), further preferably phenyl.

The ring c² is optionally condensed with at least one cycloalkane, at least one hydrogen atom in the cycloalkane is optionally replaced, and at least one -CH₂-moiety in the cycloalkane is optionally substituted by -O-. Specifically, two adjacent groups of R^{c1} to R^{c4} are optionally bonded to each other to form a cycloalkane-condensed structure, at least one hydrogen atom in the cycloalkane is optionally replaced, and at least one -CH₂- moiety in the cycloalkane is optionally substituted by -O-.

In one embodiment, R^{c1} and R^{c2}, R^{c2} and R^{c3}, or R^{c3} and R^{c4} are preferably bonded to each other to form a cycloalkane-condensed structure. R^{c2} and R^{c3} are more preferably bonded to each other to form a cycloalkane-condensed structure. R^{c2} and R^{c3} are further preferably bonded to each other to form a cyclopentane-condensed structure or a cyclohexane-condensed structure.

The ring c, when condensed with cycloalkane, is preferably represented by any of the following formulas:

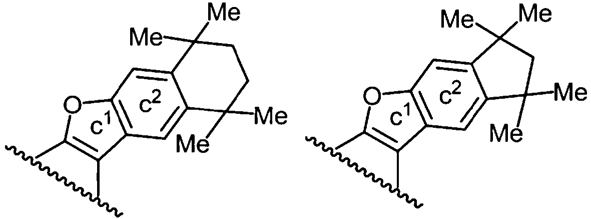

### <Description of change in ring structure by bond between substituents>

In the general formula (A-1), two adjacent groups of R^{a1} to R^{a3}, R^{b1} to R^{b4} and R^{c1} to R^{c4} are optionally bonded to each other to form an aryl ring or a heteroaryl ring. At least one hydrogen atom of the formed aryl ring or heteroaryl ring is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl.

In this respect, two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group, though these moieties are not bonded via a linking group in a preferred mode.

In the general formula (A-1), examples of the structure where an aryl ring or a heteroaryl ring is formed together with the ring b and/or the ring c² include the formula (A-1-1) to the formula (A-1-4):

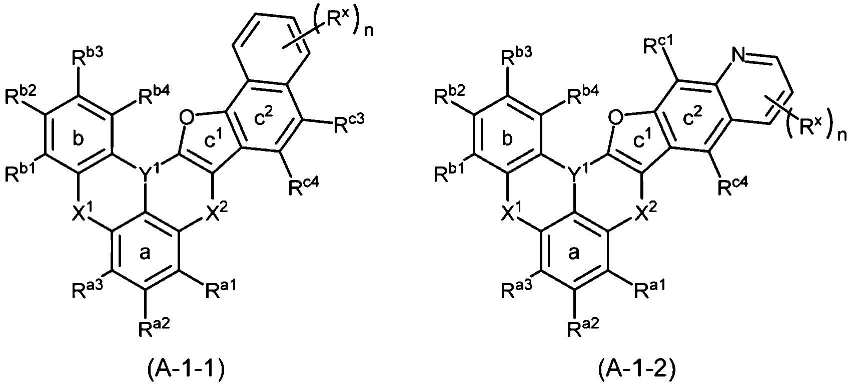

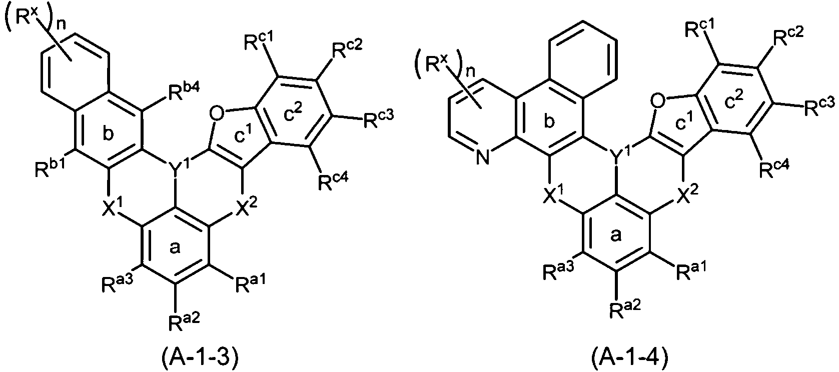

For example, in the formula (A-1-1), adjacent R^{c1} and R^{c2} form a phenyl ring together with the ring c². In the formula (A-1-2), adjacent R^{c2} and R^{c3} form a pyridyl ring together with the ring c². In the formula (A-1-3), adjacent R^{b2} and R^{b3} form a phenyl ring together with the ring b. In the formula (A-1-4), adjacent R^{b1} and R^{b2} form a pyridyl ring together with the ring b, and adjacent R^{b3} and R^{b4} form a phenyl ring together with the ring b.

As mentioned above, two adjacent groups of R^{a1} to R^{a3}, R^{b1} to R^{b4}, and R^{c1} to R^{c4} are optionally bonded to each other to form one aryl ring or heteroaryl ring together with the ring a, the ring b, or the ring c² and thereby form a bicyclic condensed ring. Alternatively, as in the formula (A-1-4), two adjacent groups of R^{a1} to R^{a3}, R^{b1} to R^{b4}, and R^{c1} to R^{c4} are optionally bonded to each other to form two aryl rings or heteroaryl rings together with the ring a, the ring b, or the ring c² and thereby form a tricyclic condensed ring.

An arbitrary substituent on the formed aryl ring or heteroaryl ring is represented by n R^{x} in addition to R^{a1} to R^{a3}, R^{b1} to R^{b4}, and R^{c1} to R^{c4}, and the upper limit of n is the maximum number of substitutable groups. In this respect, each R^{x} is independently substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl.

In this respect, two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group, though these moieties are not bonded via a linking group in a preferred mode.

### <Description of central element Y¹ in compound>

In the formula (A-1), Y¹ is B, P, P=O, P=S, Al, Ga, As, Si-R, or Ge-R. R of the "Si-R" and R of the "Ge-R" are each independently substituted or unsubstituted aryl, substituted or unsubstituted heteroaryl, substituted or unsubstituted alkyl, or substituted or unsubstituted cycloalkyl, and the substituent is preferably alkyl or cycloalkyl. In P=O, P=S, Si-R, or Ge-R, the atoms to be bonded to the ring a, the ring b, and the ring c¹ are P, C, Si, or Ge. Y¹ is preferably B, P, P=O, P=S, or Si-R, more preferably B, P, P=O, or P=S, particularly preferably B. Details of the substituents listed here will be collectively mentioned later.

### <Description of X¹ and X² in compound>

In the formula (A-1), X¹ and X² are each independently O, N-R, C(-R)₂, Si(-R)₂, S, or Se.

R of the "N-R" is hydrogen, aryl substituted by alkyl, substituted or unsubstituted heteroaryl, substituted or unsubstituted alkyl, substituted or unsubstituted cycloalkyl, or a group represented by the formula (G-1). In this respect, at least one of the aryl substituted by alkyl and the substituted or unsubstituted heteroaryl constituting the R moiety of the N-R is optionally condensed with at least one cycloalkane, at least one hydrogen atom in the cycloalkane is optionally replaced, and at least one -CH₂- moiety in the cycloalkane is optionally substituted by -O-.

R of the "N-R" is preferably substituted or unsubstituted aryl or substituted or unsubstituted heteroaryl.

The aryl of the substituted or unsubstituted aryl is more preferably phenyl, substituted or unsubstituted biphenyl, substituted or unsubstituted terphenyl, substituted or unsubstituted naphthyl, substituted or unsubstituted phenanthryl, or substituted or unsubstituted triphenyl, further preferably phenyl, biphenyl, or terphenyl, particularly preferably phenyl or biphenyl, most preferably phenyl.

The heteroaryl of the substituted or unsubstituted heteroaryl is preferably dibenzofuranyl, dibenzothiophenyl, or carbazolyl, more preferably dibenzofuranyl.

A form in which the aryl substituted by alkyl, the substituted or unsubstituted heteroaryl, or the group represented by the formula (G-1), represented by R in the "N-R" is condensed with cycloalkane is represented by any of the following structures:

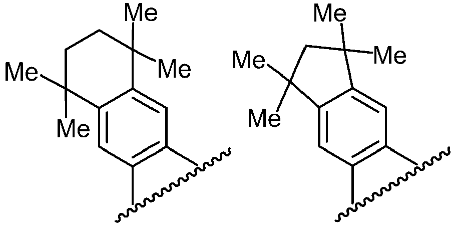

In one embodiment, at least one R moiety of the "N-R" is preferably aryl condensed with cycloalkane, more preferably 1,2,3,4-tetrahydro-1,1,4,4-tetramethylnaphthalen-6-yl or 1,1,3,3-tetramethyl-2,3-dihydro-1H-inden-5-yl.

The R moieties of the "C(-R)₂" and the R moieties of the "Si(-R)₂" are each independently hydrogen, substituted or unsubstituted aryl, substituted or unsubstituted heteroaryl, substituted or unsubstituted alkyl, or substituted or unsubstituted cycloalkyl, and two R moieties of the C(-R)₂ and the Si(-R)₂ are optionally bonded to each other to form a ring. In this respect, at least one of the substituted or unsubstituted aryl and the substituted or unsubstituted heteroaryl constituting the R moieties of the "C(-R)₂" and the R moieties of the "Si(-R)₂" is optionally condensed with at least one cycloalkane, at least one hydrogen atom in the cycloalkane is optionally replaced, and at least one -CH₂- moiety in the cycloalkane is optionally substituted by -O-.

The R moiety of the N-R and/or the R moiety of the C(-R)₂ is optionally bonded to the ring a and/or the ring b or to the ring a and/or the ring c² through a linking group.

However, at least one of X¹ and X² is N-R, wherein the R moiety of the N-R is a group represented by the formula (G-1). Preferably, one of X¹ and X² is N-R (wherein the R is a group represented by the formula (G-1)), and the other moiety is N-R (wherein R of the N-R is aryl substituted by alkyl, substituted or unsubstituted heteroaryl, aryl condensed with cycloalkane, heteroaryl condensed with cycloalkane, or a group represented by the formula (G-1)). More preferably, one of X¹ and X² is N-R (wherein the R is a group represented by the formula (G-1)), and the other moiety is N-R (wherein R of the N-R is aryl substituted by alkyl, aryl condensed with cycloalkane, or a group represented by the formula (G-1)). Further preferably, one of X¹ and X² is N-R (wherein the R is a group represented by the formula (G-1)), and the other moiety is N-R (wherein R of the N-R is aryl substituted by alkyl or aryl condensed with cycloalkane).

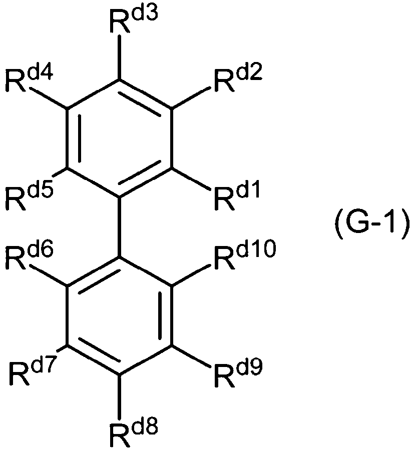

In the formula (G-1), R^{d1} to R^{d10} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl.

Two adjacent groups of R^{d1} to R^{d10} are optionally bonded to each other to form a cycloalkane-condensed structure, and at least one hydrogen atom in the cycloalkane is optionally replaced.

In one embodiment, R^{d1} to R^{d10} are each independently preferably hydrogen, alkyl, or substituted or unsubstituted aryl, more preferably substituted or unsubstituted phenyl or alkyl, further preferably alkyl, particularly preferably methyl, t-butyl, or t-amyl, most preferably t-butyl.

Two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group.

However, at least one of R^{d6} to R^{d10} is alkyl, or two adjacent groups of R^{d6} to R^{d10} are bonded to each other to form a cycloalkane-condensed structure. Preferably, at least one of R^{d7} to R^{d9} is alkyl, or two adjacent groups of R^{d7} to R^{d9} are bonded to each other to form a cycloalkane-condensed structure. More preferably, at least one of R^{d7} to R^{d9} is methyl, ethyl, propyl, isopropyl, butyl, i-butyl, s-butyl, t-amyl, or t-butyl, or two adjacent groups of R^{d7} to R^{d9} form a cyclopentane-condensed structure or a cyclohexane-condensed structure. Further preferably, at least one of R^{d7} to R^{d9} is methyl or t-butyl, or two adjacent groups of R^{d7} to R^{d9} form a cyclohexane-condensed structure.

When two adjacent groups of R^{d7} to R^{d9} form a cyclopentane-condensed structure or a cyclohexane-condensed structure, the formula G-1 is represented by any of the following formulas:

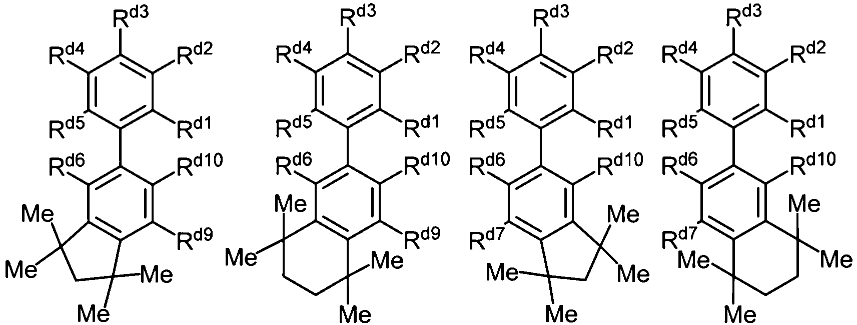

Any one of R^{d1} to R^{d5} is a bond to a nitrogen atom. Preferably, R^{d2} or R^{d3} is a bond to a nitrogen atom. More preferably, R^{d2} is a bond to a nitrogen atom.

In one embodiment, the formula (G-1) preferably represents a group represented by any of the formula (G-2) to the formula (G-21):

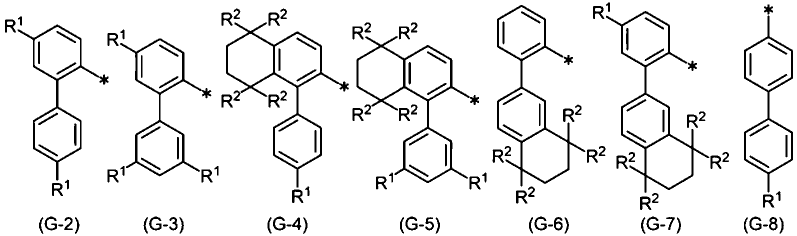

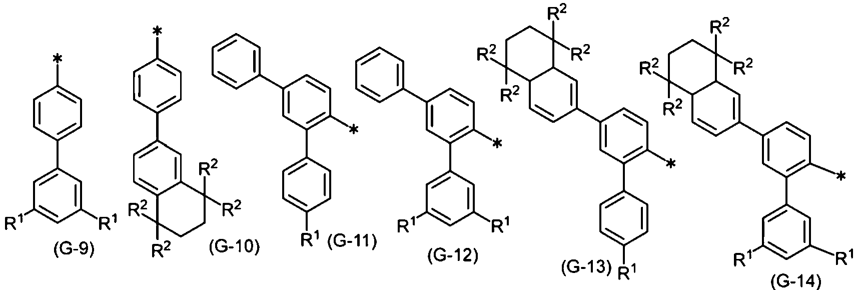

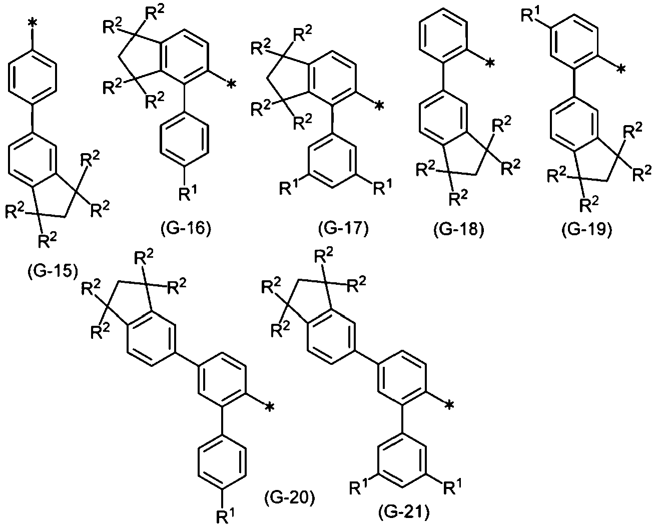

In the formulas (G-2) to (G-21), each R¹ is independently alkyl.

The alkyl is preferably alkyl having 1 to 24 carbon atoms. The "alkyl having 1 to 24 carbon atoms" may be linear or branched. Examples thereof include linear alkyl having 1 to 24 carbon atoms and branched alkyl having 3 to 24 carbon atoms, alkyl having 1 to 18 carbon atoms (branched alkyl having 3 to 18 carbon atoms), alkyl having 1 to 12 carbon atoms (branched alkyl having 3 to 12 carbon atoms), alkyl having 1 to 6 carbon atoms (branched alkyl having 3 to 6 carbon atoms), and alkyl having 1 to 4 carbon atoms (branched alkyl having 3 or 4 carbon atoms). Specific examples of the alkyl include methyl, ethyl, n-propyl, isopropyl, n-butyl, isobutyl, s-butyl, t-butyl, t-amyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl.

R¹ is preferably methyl, ethyl, propyl, isopropyl, butyl, i-butyl, s-butyl, t-butyl, or t-amyl, more preferably methyl, isopropyl, t-butyl, or t-amyl, further preferably methyl or t-butyl, particularly preferably t-butyl.

Each R² is independently hydrogen or alkyl.

Examples of the alkyl include the same as those for R¹.

R² is preferably hydrogen, methyl, ethyl, propyl, or isopropyl, more preferably hydrogen, methyl, or ethyl, further preferably hydrogen or methyl, particularly preferably methyl.

The formula (G-1) is preferably any of the formulas (G-2) to (G-7), the formulas (G-9) to (G-14), and the formulas (G-15) to (G-21), more preferably any of the formulas (G-4) to (G-7), the formula (G-10), the formula (G-13), and the formulas (G-15) to (G-19), further preferably any of the formulas (G-4) to (G-7) and the formulas (G-15) to (G-19). In this respect, R¹ and R² are as mentioned above. R¹ is preferably methyl, ethyl, propyl, isopropyl, butyl, i-butyl, s-butyl, t-butyl, methylphenyl, dimethylphenyl, trimethylphenyl, t-butylphenyl, di-t-butylphenyl, or tri-t-butylphenyl, more preferably methyl, isopropyl, t-butyl, t-amyl, or phenyl, further preferably methyl or t-butyl, particularly preferably t-butyl. R² is preferably hydrogen, methyl, ethyl, propyl, or isopropyl, more preferably hydrogen, methyl, or ethyl, further preferably hydrogen or methyl, particularly preferably methyl.

### <Specific description of ring and substituent>

Next, details of the rings and substituents (including a first substituent as well as a second substituent by which the first substituent is further substituted) listed in the above description will be collectively described.

The "aryl ring" is, for example, an aryl ring having 6 to 30 carbon atoms, preferably an aryl ring having 6 to 20 carbon atoms, an aryl ring having 6 to 16 carbon atoms, an aryl ring having 6 to 12 carbon atoms, or an aryl ring having 6 to 10 carbon atoms.

Specifically, the "aryl ring" is, for example, a monocyclic benzene ring, a condensed bicyclic naphthalene ring or indene ring, a condensed tricyclic acenaphthylene ring, fluorene ring, phenalene ring, phenanthrene ring, anthracene ring, or 9,10-dihydroanthracene ring, a condensed tetracyclic triphenylene ring, pyrene ring, or naphthacene ring, or a condensed pentacyclic perylene ring or pentacene ring.

At least one hydrogen atom of the "aryl ring" is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl mentioned later.

Examples of the aryl ring with at least one hydrogen atom replaced include: a dimethylfluorene ring, a dimethylbenzofluorene ring, and a dimethylindene ring in which two hydrogen atoms of a methylene group in a fluorene ring, a benzofluorene ring, and an indene ring are replaced with methyl; and a 9,9,10,10-tetramethyl-9,10-dihydroanthracene ring in which four hydrogen atoms of two methylene groups in a 9,10-dihydroanthracene ring are replaced with methyl.

The "heteroaryl ring" is, for example, a heteroaryl ring having 2 to 30 carbon atoms, preferably a heteroaryl ring having 2 to 25 carbon atoms, a heteroaryl ring having 2 to 20 carbon atoms, a heteroaryl ring having 2 to 15 carbon atoms, or a heteroaryl ring having 2 to 10 carbon atoms. The "heteroaryl ring" is, for example, a heterocyclic ring containing 1 to 5 hetero atoms selected from oxygen, sulfur, and nitrogen in addition to carbon as ring constituent atoms.

Specifically, the "heteroaryl ring" is, for example, a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phenanthroline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, a phenazasiline ring, an indolizine ring, a furan ring, a benzofuran ring, an isobenzofuran ring, a dibenzofuran ring, a naphthobenzofuran ring, a xanthene ring, a thiophene ring, a benzothiophene ring, an isobenzothiophene ring, a dibenzothiophene ring, a naphthobenzothiophene ring, a thioxanthene ring, a benzophosphole ring, a dibenzophosphole ring, a benzophosphole oxide ring, a dibenzophosphole oxide ring, a furazan ring, a thianthrene ring, an indolocarbazole ring, a benzindolocarbazole ring, a benzobenzindolocarbazole ring, an imidazoline ring, or an oxazoline ring.

At least one hydrogen atom of the "heteroaryl ring" is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl mentioned later.

Examples of the heteroaryl ring with at least one hydrogen atom replaced include: a 9-(phenyl, methyl, cyclohexyl, adamantyl, or 3,5-dimethyl-1-adamantyl)carbazole ring in which a hydrogen atom at position 9 of a carbazole ring is replaced with phenyl, methyl, cyclohexyl, adamantyl, or 3,5-dimethyl-1-adamantyl; and a dimethyldihydroacridine ring, a dimethylxanthene ring, and a dimethylthioxanthene ring in which two hydrogen atoms of a methylene group in an acridine ring, a xanthene ring, or a thioxanthene ring are replaced with methyl.

The "aryl" is, for example, aryl having 6 to 30 carbon atoms, preferably aryl having 6 to 20 carbon atoms, aryl having 6 to 16 carbon atoms, aryl having 6 to 12 carbon atoms, or aryl having 6 to 10 carbon atoms.

Specifically, the "aryl" is, for example, monocyclic phenyl, bicyclic biphenylyl (2-biphenylyl, 3-biphenylyl, or 4-biphenylyl), condensed bicyclic naphthyl (1-naphthyl or 2-naphthyl) or indenyl (2-indenyl, 3-indenyl, 4-indenyl, 5-indenyl, 6-indenyl or 7-indenyl), tricyclic terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, or p-terphenyl-4-yl), condensed tricyclic acenaphthylen-(1-, 3-, 4-, or 5-)yl, fluoren-(1-, 2-, 3-, 4-, or 9-)yl, phenalen-(1- or 2-)yl, phenanthren-(1-, 2-, 3-, 4-, or 9-)yl, or 9,10-dihydroanthracen-(1-, 2-, 3-, 4-, 5-, 6-, 7- or 8-)yl, tetracyclic quaterphenylyl (5'-phenyl-m-terphenyl-2-yl, 5'-phenyl-m-terphenyl-3-yl, 5'-phenyl-m-terphenyl-4-yl, or m-quaterphenyl), condensed tetracyclic triphenylen-(1- or 2-)yl, pyren-(1-, 2-, or 4-)yl, or naphthacen-(1-, 2-, or 5-)yl, or condensed pentacyclic perylen-(1-, 2-, or 3-)yl or pentacen-(1-, 2-, 5-, or 6-)yl.

The "substituted aryl" is a structure where at least one hydrogen atom in the aryl is replaced with a substituent mentioned later. The "substituted aryl" includes, for example, a structure where the aryl is substituted by aryl (specific examples of which are the groups mentioned above) such as phenyl, alkyl (specific examples of which are groups mentioned later) such as methyl, or cycloalkyl (specific examples of which are groups mentioned later) such as cyclohexyl or adamantyl. The substituted aryl with alkyl as a substituent is also referred to as, particularly, "aryl substituted by alkyl".

Specific examples of the "substituted aryl" also include: dimethylfluorenyl, dimethylbenzofluorenyl, and dimethylindenyl in which two hydrogen atoms of a methylene group in fluorenyl, benzofluorenyl, and indenyl are replaced with methyl; and 9,9,10,10-tetramethyl-9,10-dihydroanthracenyl in which four hydrogen atoms of two methylene groups in 9,10-dihydroanthracenyl are replaced with methyl.

The "arylene (ring)" is, for example, arylene having 6 to 30 carbon atoms, preferably, arylene having 6 to 20 carbon atoms, arylene having 6 to 16 carbon atoms, arylene having 6 to 12 carbon atoms, or arylene having 6 to 10 carbon atoms.

Specific examples of the "arylene" include structures of divalent groups obtained by removing one hydrogen atom from the "aryl" (monovalent group) mentioned above.

The "heteroaryl" is, for example, heteroaryl having 2 to 30 carbon atoms, preferably, heteroaryl having 2 to 25 carbon atoms, heteroaryl having 2 to 20 carbon atoms, heteroaryl having 2 to 15 carbon atoms, or heteroaryl having 2 to 10 carbon atoms. The "heteroaryl" is, for example, a monovalent group such as a heterocyclic ring containing 1 to 5 hetero atoms selected from oxygen, sulfur, and nitrogen in addition to carbon as ring constituent atoms.

Specifically, the "heteroaryl" is, for example, pyrrolyl, oxazolyl, isoxazolyl, thiazolyl, isothiazolyl, imidazolyl, oxadiazolyl, thiadiazolyl, triazolyl, tetrazolyl, pyrazolyl, pyridinyl, pyrimidinyl, pyridazinyl, pyrazinyl, triazinyl, indolyl, isoindolyl, 1H-indazolyl, benzimidazolyl, benzoxazolyl, benzothiazolyl, 1H-benzotriazolyl, quinolinyl, isoquinolinyl, cinnolinyl, quinazolinyl, quinoxalinyl, phenanthrolinyl, phthalazinyl, naphthyridinyl, purinyl, pteridinyl, carbazolyl, acridinyl, phenoxathiinyl, phenoxazinyl, phenothiazinyl, phenazinyl, phenazasilinyl, indolizinyl, furanyl, benzofuranyl, isobenzofuranyl, dibenzofuranyl, naphthobenzofuranyl, xanthenyl, thienyl, benzothienyl, isobenzothienyl, dibenzothienyl, naphthobenzothienyl, thioxanthenyl, benzophospholyl, dibenzophospholyl, a monovalent group of a benzophosphole oxide ring, a monovalent group of a dibenzophosphole oxide ring, furazanyl, thianthrenyl, indolocarbazolyl, benzindolocarbazolyl, benzobenzindolocarbazolyl, imidazolinyl, oxazolinyl, or dibenzosilacyclopentadienyl.

The "substituted heteroaryl" is a structure where at least one hydrogen atom in the heteroaryl is replaced with a substituent mentioned later. The "substituted heteroaryl" includes, for example, a structure where the heteroaryl is substituted by aryl (specific examples of which are the groups mentioned above) such as phenyl, alkyl (specific examples of which are groups mentioned later) such as methyl, or cycloalkyl (specific examples of which are groups mentioned later) such as cyclohexyl or adamantyl.

Specific examples of the "substituted heteroaryl" also include: 9-(phenyl, methyl, cyclohexyl, or adamantyl)carbazolyl in which a hydrogen atom at position 9 of carbazolyl is replaced with phenyl, methyl, cyclohexyl, or adamantyl; and dimethyldihydroacridinyl, dimethylxanthenyl, and dimethylthioxanthenyl in which two hydrogen atoms of a methylene group in acridinyl, xanthenyl, or thioxanthenyl are replaced with methyl.

The "heteroarylene (ring)" is, for example, heteroarylene having 2 to 30 carbon atoms, preferably heteroarylene having 2 to 25 carbon atoms, heteroarylene having 2 to 20 carbon atoms, heteroarylene having 2 to 15 carbon atoms, or heteroarylene having 2 to 10 carbon atoms. The "heteroarylene" is, for example, a divalent group such as a heterocyclic ring containing 1 to 5 hetero atoms selected from oxygen, sulfur, and nitrogen in addition to carbon as ring constituent atoms.

Specific examples of the "heteroarylene" include structures of divalent groups obtained by removing one hydrogen atom from the "heteroaryl" (monovalent group) mentioned above.

Each of the "diarylamino" and the "substituted diarylamino" is an amino group substituted by two aryl groups, and the description of the "aryl" and the "substituted aryl" mentioned above can be cited about details of this aryl.

Each of the "diheteroarylamino" and the "substituted diheteroarylamino" is an amino group substituted by two heteroaryl groups, and the description of the "heteroaryl" and the "substituted heteroaryl" mentioned above can be cited about details of this heteroaryl.

Each of the "arylheteroarylamino" and the "substituted aryldiheteroarylamino" is an amino group substituted by aryl and heteroaryl, and the description of the "aryl", the "heteroaryl", the "substituted aryl", and the "substituted heteroaryl" mentioned above can be cited about details of this aryl and heteroaryl.

Two aryl moieties of the "diarylamino" are optionally bonded to each other via a linking group, two heteroaryl moieties of the "diheteroarylamino" are optionally bonded to each other via a linking group, and the aryl and heteroaryl moieties of the "arylheteroarylamino" are optionally bonded to each other via a linking group. Examples of this linking group include a single bond, alkylene, alkenylene, alkynylene, -N(-R)-, -O-, -S-, -Si(-R)₂-, and -Se-. In one embodiment, the linking group is preferably a single bond, -CH₂-CH₂-, -CHR-CHR-, -CR₂-CR₂-, - CH=CH-, -CR=CR-, -C≡C-, -N(-R)-, -O-, -S-, -C(-R)₂-, -Si(-R)₂-, or -Se-. R of the "-CHR-CHR-", R of the "-CR₂-CR₂-", R of the "-CR=CR-", R of the "-N(-R)-", R of the "-C(-R)₂-", and R of the "-Si(-R)₂-" are each independently hydrogen, aryl, heteroaryl, alkyl, alkenyl, alkynyl, or cycloalkyl, and at least one hydrogen atom in the R moiety is optionally replaced with alkyl or cycloalkyl. Two adjacent R moieties in the "-CHR-CHR-", the "-CR₂-CR₂-", the "-CR=CR-", the "-C(-R)₂-", and the "-Si(-R)₂-" are optionally bonded to each other to form a cycloalkylene ring, an arylene ring, and a heteroarylene ring. The description of the "aryl", the "substituted aryl", the "arylene", the "heteroaryl", the "substituted heteroaryl", and the "heteroarylene" mentioned above, and the description of the "alkyl", the "alkylene", the "alkenyl", the "alkenylene", the "alkynyl", the "alkynylene", the "cycloalkyl", and the "cycloalkylene" mentioned later can be cited about details of the substituents listed here.

Each of the "diarylboryl" and the "substituted diarylboryl" is a boryl group substituted by two aryl groups. The description of the "aryl" and the "substituted aryl" mentioned above can be cited about details of this aryl.

Two aryl moieties of the "diarylboryl" are optionally bonded to each other via a linking group. Examples of this linking group include a single bond, alkylene, alkenylene, alkynylene, -N(-R)-, -O-, -S-, -Si(-R)₂-, and -Se-. In one embodiment, the linking group is preferably a single bond, -CH₂-CH₂-, -CHR-CHR-, -CR₂-CR₂-, - CH=CH-, -CR=CR-, -C≡C-, -N(-R)-, -O-, -S-, -C(-R)₂-, -Si(-R)₂-, or -Se-. R of the "-CHR-CHR-", R of the "-CR₂-CR₂-", R of the "-CR=CR-", R of the "-N(-R)-", R of the "-C(-R)₂-", and R of the "-Si(-R)₂-" are each independently hydrogen, aryl, heteroaryl, alkyl, alkenyl, alkynyl, or cycloalkyl, and at least one hydrogen atom in the R moiety is optionally replaced with alkyl or cycloalkyl. Two adjacent R moieties in the "-CHR-CHR-", the "-CR₂-CR₂-", the "-CR=CR-", the "-C(-R)₂-", and the "-Si(-R)₂-" are optionally bonded to each other to form a cycloalkylene ring, an arylene ring, and a heteroarylene ring. The description of the "aryl", the "substituted aryl", the "arylene", the "heteroaryl", the "substituted heteroaryl", and the "heteroarylene" mentioned above, and the description of the "alkyl", the "alkylene", the "alkenyl", the "alkenylene", the "alkynyl", the "alkynylene", the "cycloalkyl", and the "cycloalkylene" mentioned later can be cited about details of the substituents listed here.

The "alkyl" may be linear or branched and is, for example, linear alkyl having 1 to 24 carbon atoms or branched alkyl having 3 to 24 carbon atoms, preferably alkyl having 1 to 18 carbon atoms (branched alkyl having 3 to 18 carbon atoms), alkyl having 1 to 12 carbon atoms (branched alkyl having 3 to 12 carbon atoms), alkyl having 1 to 6 carbon atoms (branched alkyl having 3 to 6 carbon atoms), alkyl having 1 to 5 carbon atoms (branched alkyl having 3 to 5 carbon atoms), or alkyl having 1 to 4 carbon atoms (branched alkyl having 3 or 4 carbon atoms).

Specifically, the "alkyl" is, for example, methyl, ethyl, n-propyl, isopropyl, 1-ethyl-1-methylpropyl, 1,1-diethylpropyl, 1,1,2-trimethylpropyl, 1,1,2,2-tetramethylpropyl, 1-ethyl-1,2,2-trimethylpropyl, n-butyl, isobutyl, s-butyl, t-butyl, 2-ethylbutyl, 1,1-dimethylbutyl, 3,3-dimethylbutyl, 1,1-diethylbutyl, 1-ethyl-1-methylbutyl, 1-propyl-1-methylbutyl, 1,1,3-trimethylbutyl, 1-ethyl-1,3-dimethylbutyl, n-pentyl, isopentyl, neopentyl, t-pentyl(t-amyl), 1-methylpentyl, 2-propylpentyl, 1,1-dimethylpentyl, 1-ethyl-1-methylpentyl, 1-propyl-1-methylpentyl, 1-butyl-1-methylpentyl, 1,1,4-trimethylpentyl, n-hexyl, 1-methylhexyl, 2-ethylhexyl, 1,1-dimethylhexyl, 1-ethyl-1-methylhexyl, 1,1,5-trimethylhexyl, 3,5,5-trimethylhexyl, n-heptyl, 1-methylheptyl, 1-hexylheptyl, 1,1-dimethylheptyl, 2,2-dimethylheptyl, 2,6-dimethyl-4-heptyl, n-octyl, t-octyl(1,1,3,3-tetramethylbutyl), 1,1-dimethyloctyl, n-nonyl, n-decyl, 1-methyldecyl, n-undecyl, n-dodecyl, n-tridecyl, n-tetradecyl, n-pentadecyl, n-hexadecyl, n-heptadecyl, n-octadecyl, or n-eicosyl.

The "substituted alkyl" is a structure where at least one hydrogen atom in the alkyl is replaced with a substituent mentioned later.

The "alkylene" may be linear or branched and is, for example, linear alkyl having 1 to 24 carbon atoms or branched alkyl having 3 to 24 carbon atoms, preferably alkyl having 1 to 18 carbon atoms (branched alkyl having 3 to 18 carbon atoms), alkyl having 1 to 12 carbon atoms (branched alkyl having 3 to 12 carbon atoms), alkyl having 1 to 6 carbon atoms (branched alkyl having 3 to 6 carbon atoms), alkyl having 1 to 5 carbon atoms (branched alkyl having 3 to 5 carbon atoms), or alkyl having 1 to 4 carbon atoms (branched alkyl having 3 or 4 carbon atoms).

Specific examples of the "alkylene" include structures of divalent groups obtained by removing one hydrogen atom from the "alkyl" (monovalent group) mentioned above.

For the "alkenyl" and the "substituted alkenyl", see the description of the "alkyl" and the "substituted alkyl" mentioned above. The "alkenyl" and the "substituted alkenyl" are groups in which a C-C single bond in the structures of the "alkyl" and the "substituted alkyl" is replaced with a C=C double bond, and also include groups in which not only one but two or more single bonds are replaced with double bonds (also called alkadien-yl and alkatrien-yl).

For the "alkenylene", see the description of the "alkylene" mentioned above. Examples thereof include structures of divalent groups obtained by removing one hydrogen atom from the "alkenyl" (monovalent group) mentioned above.

For the "alkynyl" and the "substituted alkynyl", see the description of the "alkyl" and the "substituted alkyl" mentioned above. The "alkenyl" and the "substituted alkenyl" are groups in which a C-C single bond in the structures of the "alkyl" and the "substituted alkyl" is replaced with a C≡C triple bond, and also include groups in which not only one but two or more single bonds are replaced with triple bonds (also called alkadiyn-yl and alkatriyn-yl).

For the "alkynylene", see the description of the "alkylene" mentioned above. Examples thereof include structures of divalent groups obtained by removing one hydrogen atom from the "alkynyl" (monovalent group) mentioned above.

The "cycloalkyl" is, for example, cycloalkyl having 3 to 24 carbon atoms, preferably cycloalkyl having 3 to 20 carbon atoms, cycloalkyl having 3 to 16 carbon atoms, cycloalkyl having 3 to 14 carbon atoms, cycloalkyl having 3 to 12 carbon atoms, cycloalkyl having 5 to 10 carbon atoms, cycloalkyl having 5 to 8 carbon atoms, cycloalkyl having 5 or 6 carbon atoms, or cycloalkyl having 5 carbon atoms.

Specifically, the "cycloalkyl" is, for example, cyclopropyl, cyclobutyl, cyclopentyl, cyclohexyl, cycloheptyl, cyclooctyl, cyclononyl, cyclodecylnorbomenyl, bicyclo[1.1.0]butyl, bicyclo[1.1.1]pentyl, bicyclo[2.1.0]pentyl, bicyclo[2.1.1]hexyl, bicyclo[3.1.0]hexyl, bicyclo[2.2.1]heptyl, bicyclo[2.2.2]octyl, adamantyl, diamantyl, decahydronaphthalenyl, or decahydroazulenyl, or a form thereof substituted by alkyl having 1 to 5 carbon atoms or having 1 to 4 carbon atoms (particularly, methyl).

The "substituted cycloalkyl" is a structure where at least one hydrogen atom in the cycloalkyl is replaced with a substituent mentioned later.

The "cycloalkylene (ring)" is, for example, cycloalkylene having 3 to 24 carbon atoms, preferably cycloalkylene having 3 to 20 carbon atoms, cycloalkylene having 3 to 16 carbon atoms, cycloalkylene having 3 to 14 carbon atoms, cycloalkylene having 3 to 12 carbon atoms, cycloalkylene having 5 to 10 carbon atoms, cycloalkylene having 5 to 8 carbon atoms, cycloalkylene having 5 or 6 carbon atoms, or cycloalkylene having 5 carbon atoms.

Specific examples of the "cycloalkylene" include structures of divalent groups obtained by removing one hydrogen atom from the "cycloalkyl" (monovalent group) mentioned above.

The "alkoxy" may be linear or branched and is, for example, linear alkoxy having 1 to 24 carbon atoms or branched alkoxy having 3 to 24 carbon atoms, preferably alkoxy having 1 to 18 carbon atoms (branched alkoxy having 3 to 18 carbon atoms), alkoxy having 1 to 12 carbon atoms (branched alkoxy having 3 to 12 carbon atoms), alkoxy having 1 to 6 carbon atoms (branched alkoxy having 3 to 6 carbon atoms), alkoxy having 1 to 5 carbon atoms (branched alkoxy having 3 to 5 carbon atoms), or alkoxy having 1 to 4 carbon atoms (branched alkoxy having 3 to 4 carbon atoms).

Specifically, the "alkoxy" is, for example, methoxy, ethoxy, n-propoxy, isopropoxy, 1-ethyl-1-methylpropoxy, 1,1-diethylpropoxy, 1,1,2-trimethylpropoxy, 1,1,2,2-tetramethylpropoxy, 1-ethyl-1,2,2-trimethylpropoxy, n-butoxy, isobutoxy, s-butoxy, t-butoxy, 2-ethylbutoxy, 1,1-dimethylbutoxy, 3,3-dimethylbutoxy, 1,1-diethylbutoxy, 1-ethyl-1-methylbutoxy, 1-propyl-1-methylbutoxy, 1,1,3-trimethylbutoxy, 1-ethyl-1,3-dimethylbutoxy, n-pentyloxy, isopentyloxy, neopentyloxy, t-pentyloxy(t-amyloxy), 1-methylpentyloxy, 2-propylpentyloxy, 1,1-dimethylpentyloxy, 1-ethyl-1-methylpentyloxy, 1-propyl-1-methylpentyloxy, 1-butyl-1-methylpentyloxy, 1,1,4-trimethylpentyloxy, n-hexyloxy, 1-methylhexyloxy, 2-ethylhexyloxy, 1,1-dimethylhexyloxy, 1-ethyl-1-methylhexyloxy, 1,1,5-trimethylhexyloxy, 3,5,5-trimethylhexyloxy, n-heptyloxy, 1-methylheptyloxy, 1-hexylheptyloxy, 1,1-dimethylheptyloxy, 2,2-dimethylheptyloxy, 2,6-dimethyl-4-heptyloxy, n-octyloxy, t-octyloxy(1,1,3,3-tetramethylbutyloxy), 1,1-dimethyloctyloxy, n-nonyloxy, n-decyloxy, 1-methyldecyloxy, n-undecyloxy, n-dodecyloxy, n-tridecyloxy, n-tetradecyloxy, n-pentadecyloxy, n-hexadecyloxy, n-heptadecyloxy, n-octadecyloxy, or n-eicosyloxy.

The "substituted alkoxy" is a structure where at least one hydrogen atom in the alkoxy is replaced with a substituent mentioned later.

Each of the "aryloxy" and the "substituted aryloxy" is a group represented by "Ar-O- (wherein Ar is an aryl group)", and the description of the "aryl" and the "substituted aryl" mentioned above can be cited about details of this aryl.

Each of the "arylthio" and the "substituted arylthio" is a group represented by "Ar-S- (wherein Ar is an aryl group)", and the description of the "aryl" and the "substituted aryl" mentioned above can be cited about details of this aryl.

The "substituted silyl" is, for example, silyl substituted by at least one of aryl, alkyl, and cycloalkyl, preferably triarylsilyl, trialkylsilyl, tricycloalkylsilyl, dialkylcycloalkylsilyl, or alkyldicycloalkylsilyl.

The "triarylsilyl" is a silyl group substituted by three aryl groups, and the description of the "aryl" and the "substituted aryl" mentioned above can be cited about details of this aryl.

Specifically, the "triarylsilyl" is, for example, triphenylsilyl, diphenylmononaphthylsilyl, monophenyldinaphthylsilyl, or trinaphthylsilyl.

The "trialkylsilyl" is a silyl group substituted by three alkyl groups, and the description of the "alkyl" and the "substituted alkyl" mentioned above can be cited about details of this alkyl.

Specifically, the "trialkylsilyl" is, for example, trimethylsilyl, triethylsilyl, tri-n-propylsilyl, triisopropylsilyl, tri-n-butylsilyl, triisobutylsilyl, tri-s-butylsilyl, tri-t-butylsilyl, ethyldimethylsilyl, n-propyldimethylsilyl, isopropyldimethylsilyl, n-butyldimethylsilyl, isobutyldimethylsilyl, s-butyldimethylsilyl, t-butyldimethylsilyl, methyldiethylsilyl, n-propyldiethylsilyl, isopropyldiethylsilyl, n-butyldiethylsilyl, s-butyldiethylsilyl, t-butyldiethylsilyl, methyldi-n-propylsilyl, ethyldi-n-propylsilyl, n-butyldi-n-propylsilyl, s-butyldi-n-propylsilyl, t-butyldi-n-propylsilyl, methyldiisopropylsilyl, ethyldiisopropylsilyl, n-butyldiisopropylsilyl, s-butyldiisopropylsilyl, or t-butyldiisopropylsilyl.

The "tricycloalkylsilyl" is a silyl group substituted by three cycloalkyl groups, and the description of the "cycloalkyl" and the "substituted cycloalkyl" mentioned above can be cited about details of this cycloalkyl.

Specifically, the "tricycloalkylsilyl" is, for example, tricyclopentylsilyl or tricyclohexylsilyl.

The "dialkylcycloalkylsilyl" is a silyl group substituted by two alkyl groups and one cycloalkyl group, and the description of the "alkyl", the "substituted alkyl", the "cycloalkyl", and the "substituted cycloalkyl" mentioned above can be cited about details of this alkyl and cycloalkyl.

The "alkyldicycloalkylsilyl" is a silyl group substituted by one alkyl group and two cycloalkyl groups, and the description of the "alkyl", the "substituted alkyl", the "cycloalkyl", and the "substituted cycloalkyl" mentioned above can be cited about details of this alkyl and cycloalkyl.

The substituent (including the first substituent and the second substituent) influences the luminescence wavelength of the polycyclic aromatic compound through the steric hindrance, electron-donating properties, and electron-withdrawing properties of its structure. Therefore, the luminescence wavelength can be adjusted by the selection of the substituent. The substituent is preferably a group represented by any of structural formulas given below, more preferably methyl, t-butyl, bicyclooctyl, cyclohexyl, adamantyl, dimethyladamantyl, phenyl, o-tolyl, p-tolyl, 2,4-xylyl, 2,5-xylyl, 2,6-xylyl, 2,4,6-mesityl, diphenylamino, di-p-tolylamino, bis(p-(t-butyl)phenyl)amino, diphenylboryl, dimesitylboryl, dibenzooxaborininyl, phenyldibenzodiborininyl, carbazolyl, 3,6-dimethylcarbazolyl, 3,6-di-t-butylcarbazolyl, and phenoxy, further preferably, methyl, t-butyl, phenyl, o-tolyl, 2,6-xylyl, 2,4,6-mesityl, diphenylamino, di-p-tolylamino, bis(p-(t-butyl)phenyl)amino, carbazolyl, 3,6-dimethylcarbazolyl, 3,6-di-t-butylcarbazolyl, and tribenzazapinyl. A substituent having larger steric hindrance is preferred for selective synthesis from the viewpoint of easy synthesis. Specifically, t-butyl, o-tolyl, p-tolyl, 2,4-xylyl, 2,5-xylyl, 2,6-xylyl, 2,4,6-mesityl, di-p-tolylamino, bis(p-(t-butyl)phenyl)amino, 3,6-dimethylcarbazolyl, and 3,6-di-t-butylcarbazolyl are preferred.

In the following structural formulas, "Me" represents methyl, "tBu" represents t-butyl, "tAm" represents t-amyl, "tOct" represents t-octyl, and * represents a connecting position.

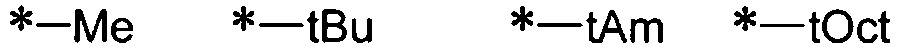

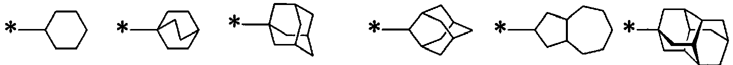

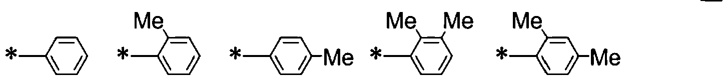

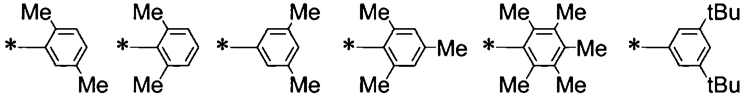

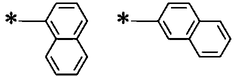

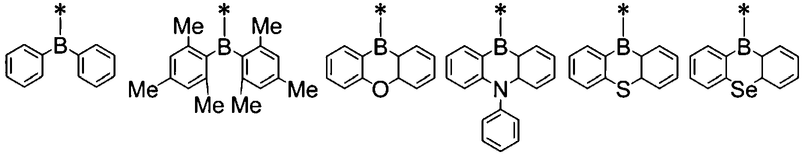

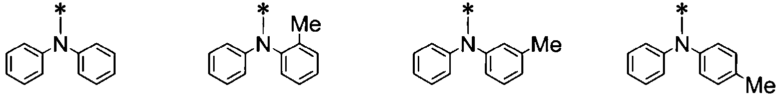

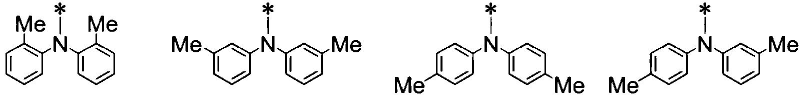

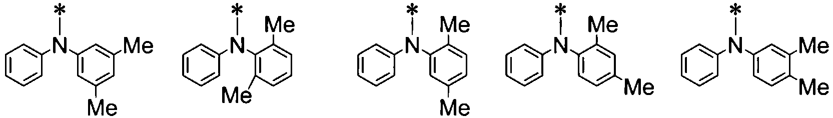

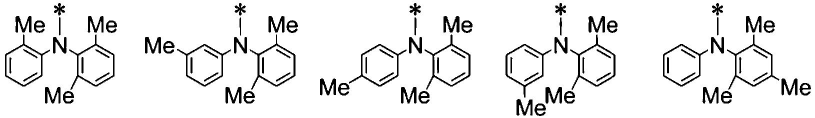

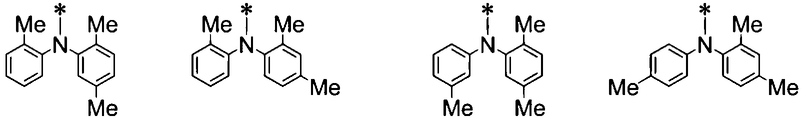

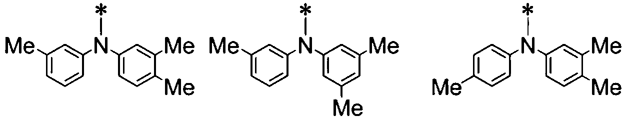

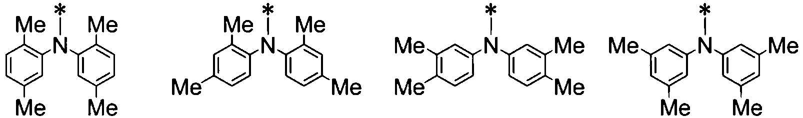

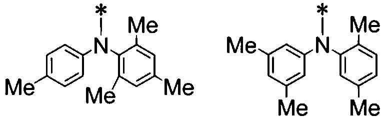

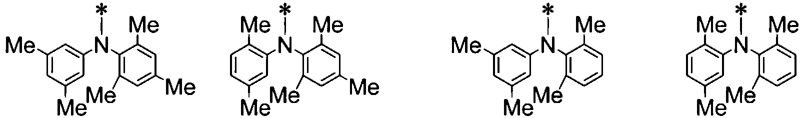

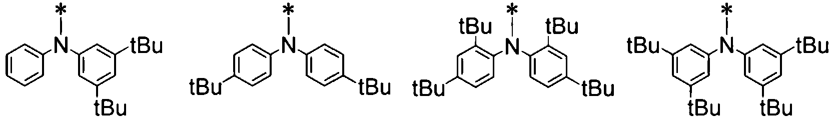

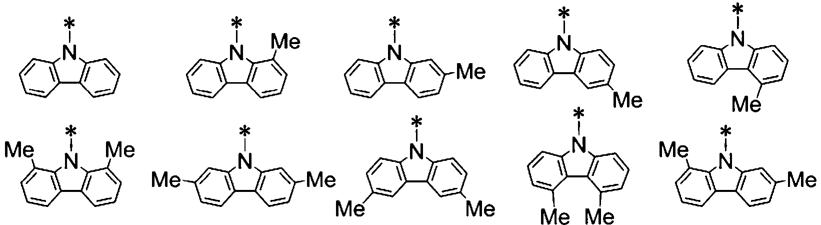

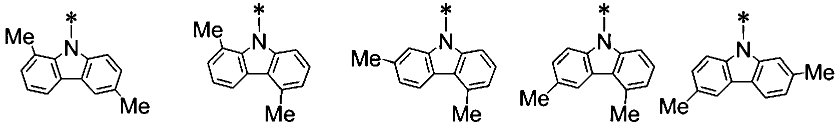

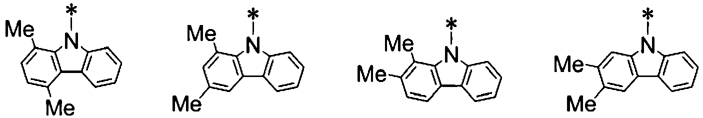

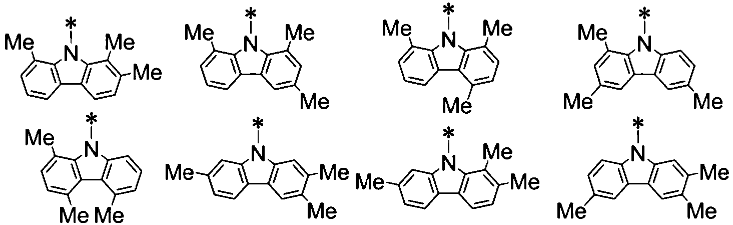

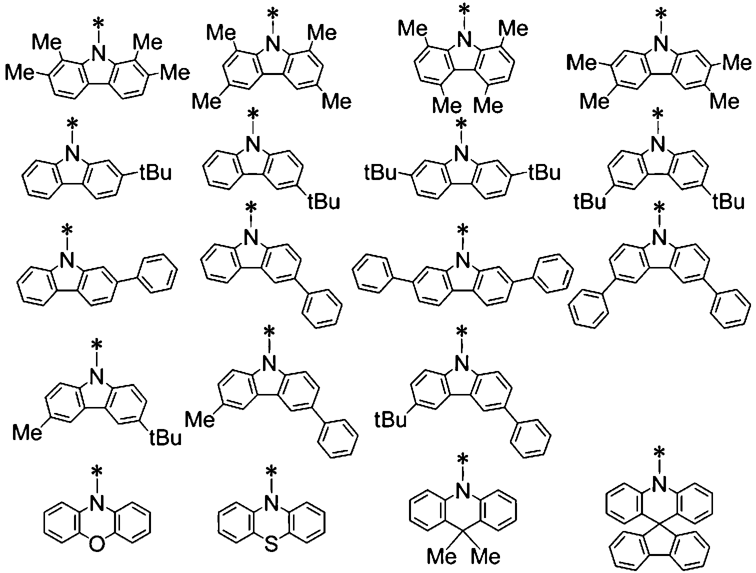

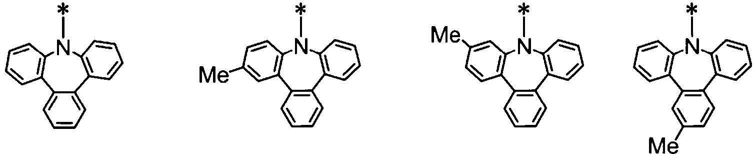

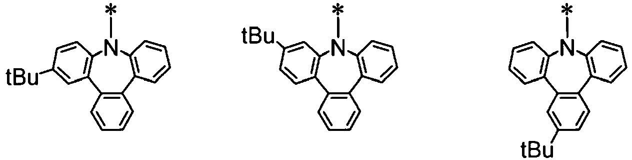

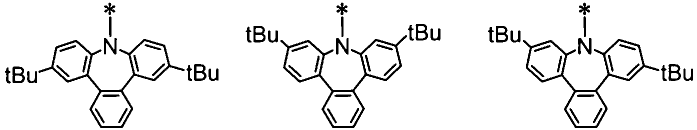

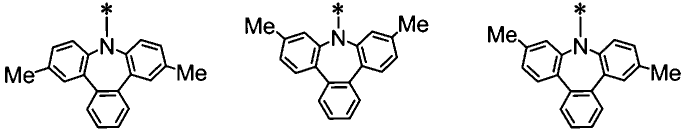

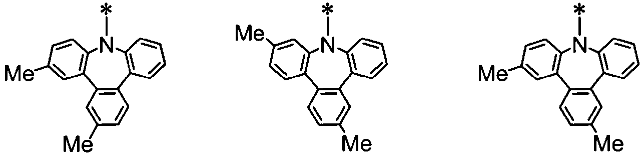

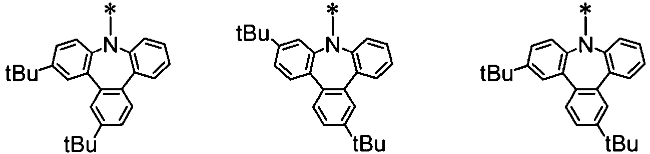

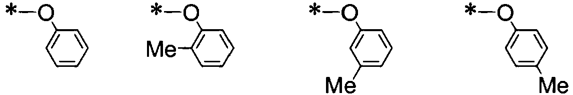

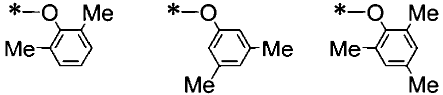

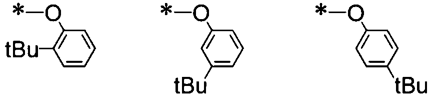

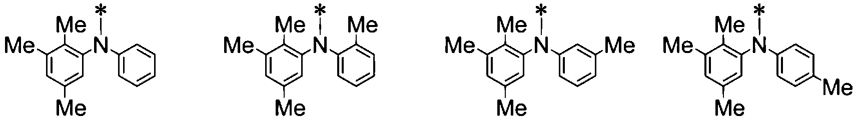

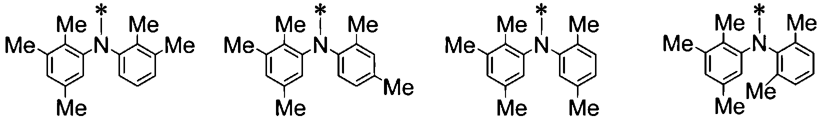

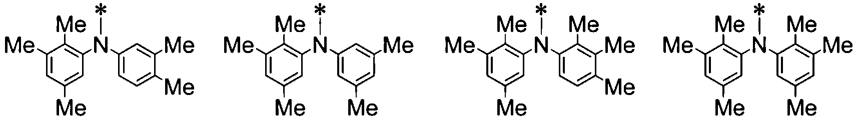

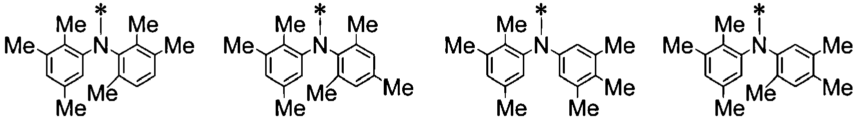

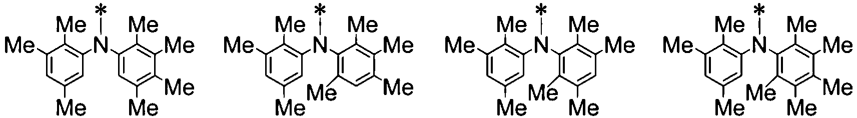

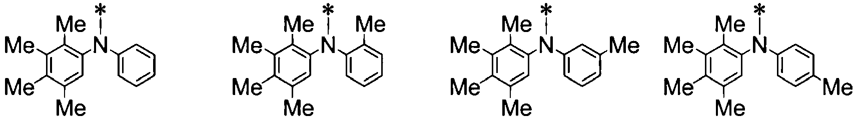

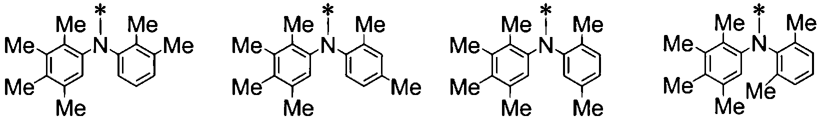

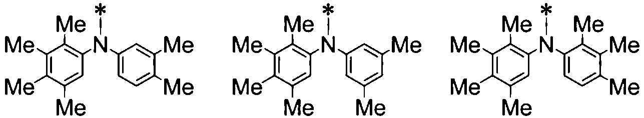

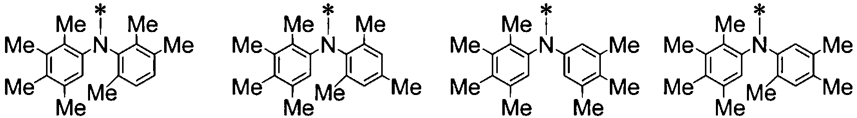

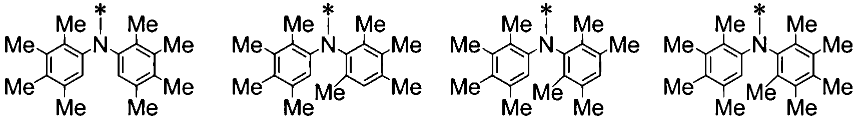

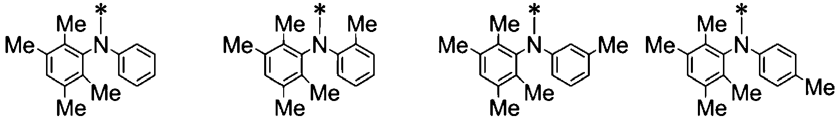

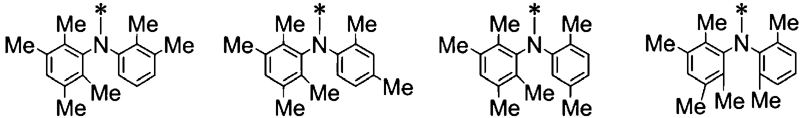

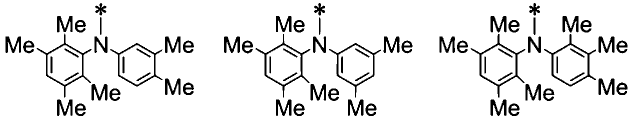

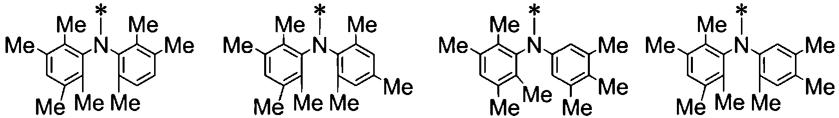

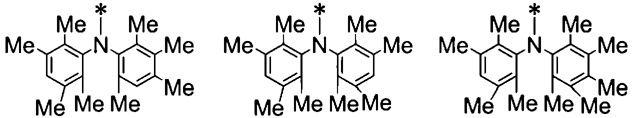

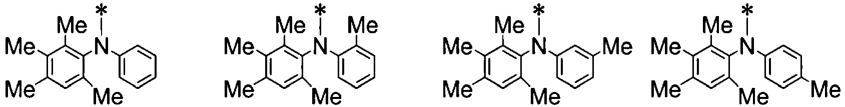

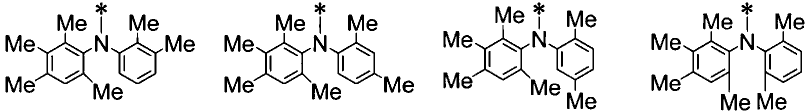

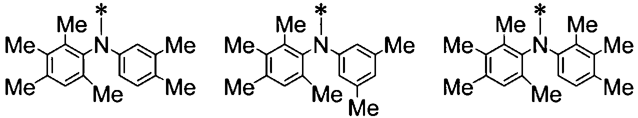

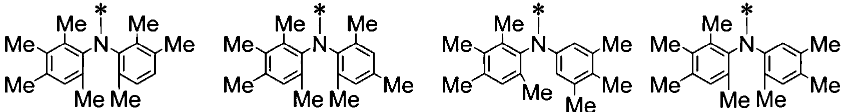

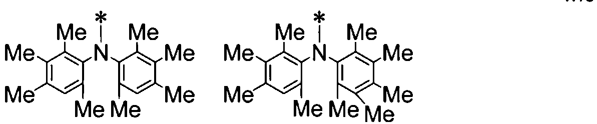

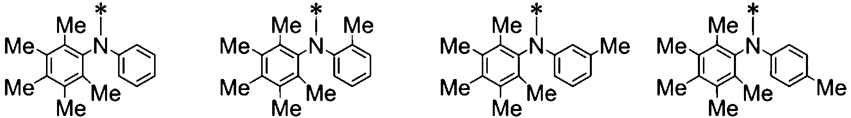

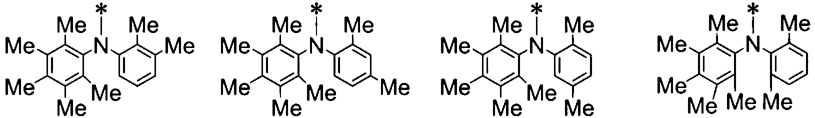

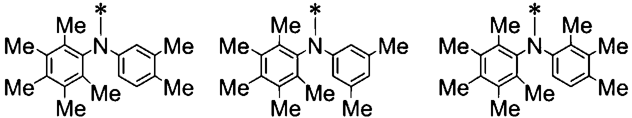

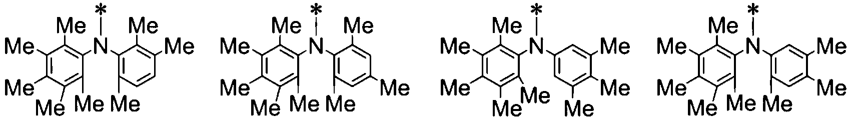

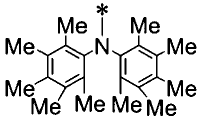

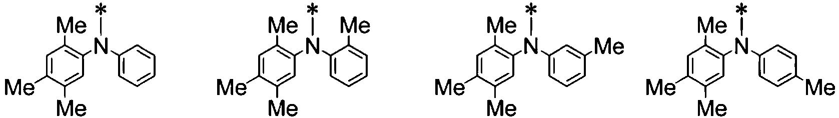

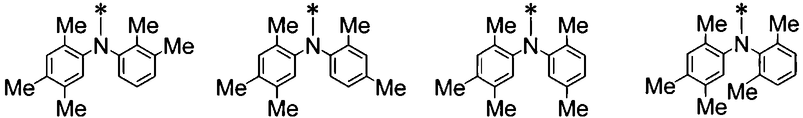

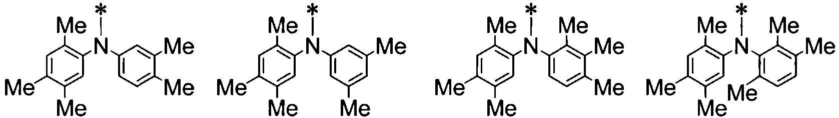

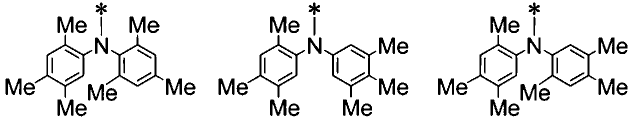

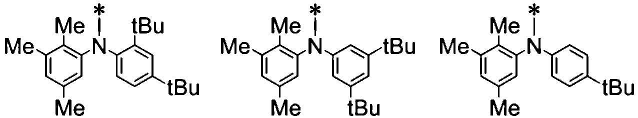

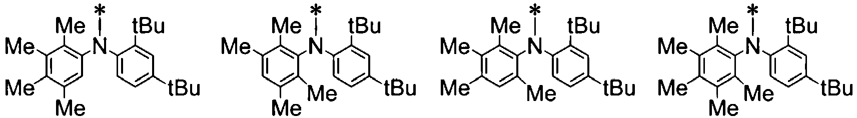

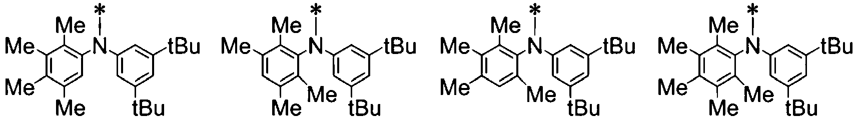

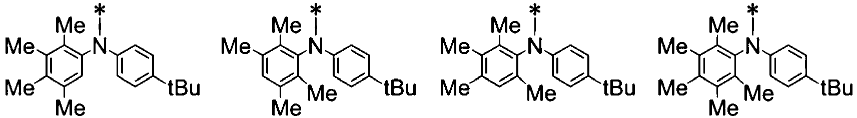

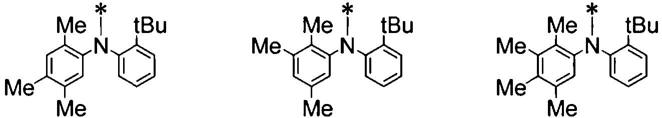

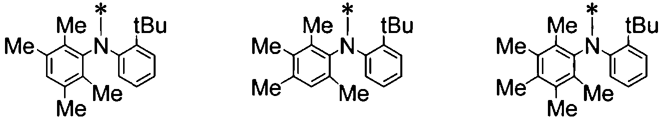

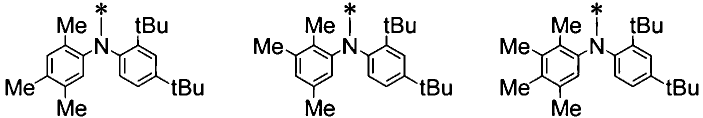

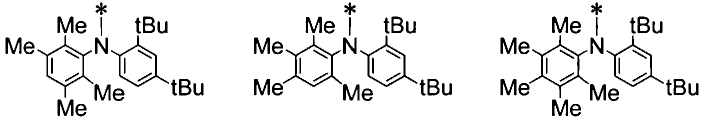

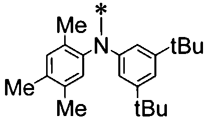

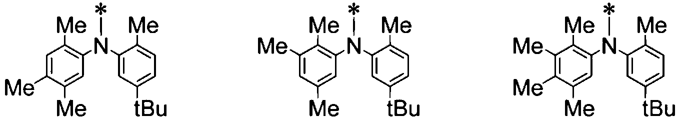

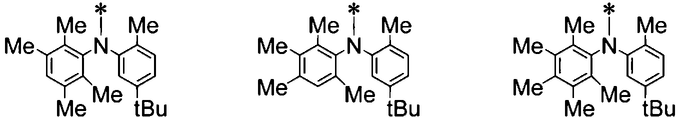

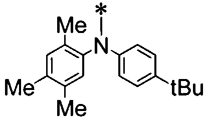

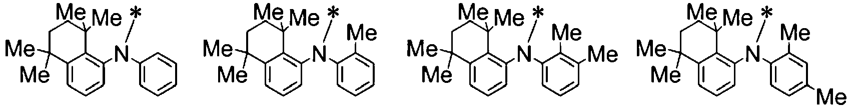

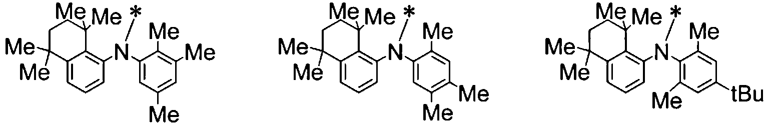

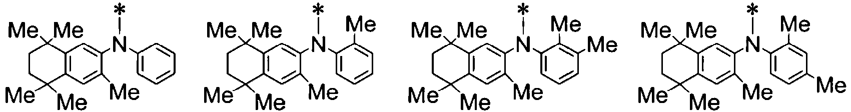

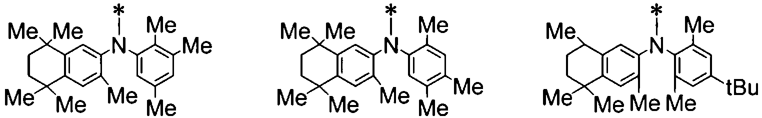

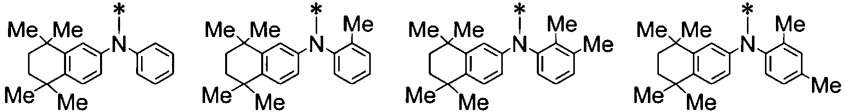

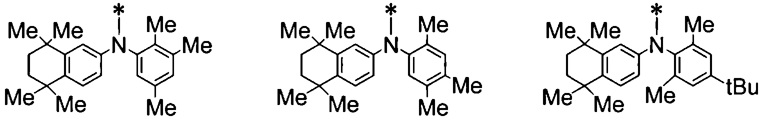

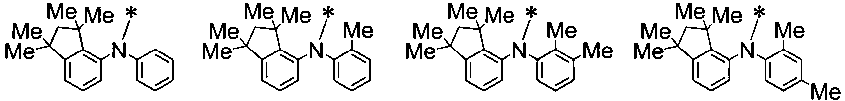

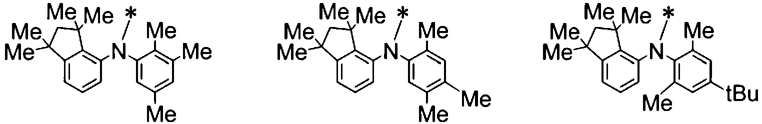

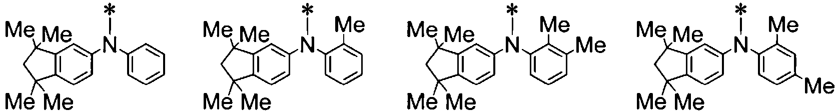

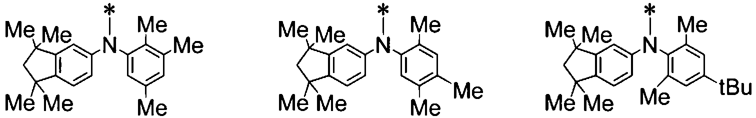

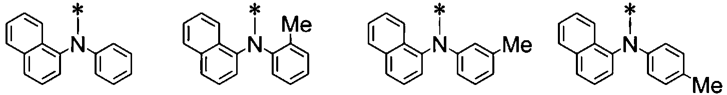

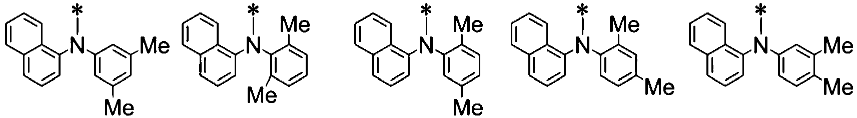

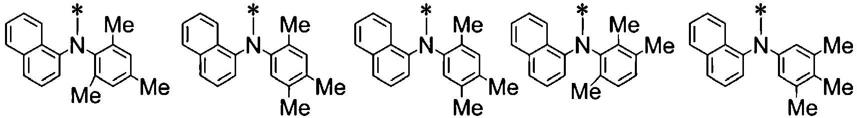

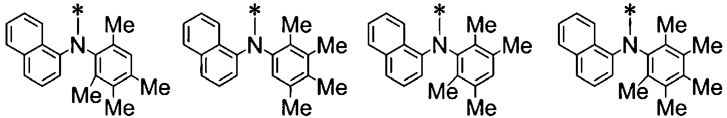

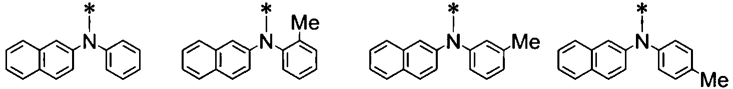

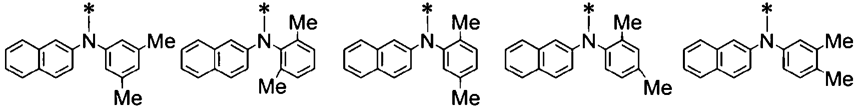

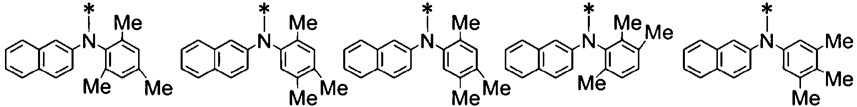

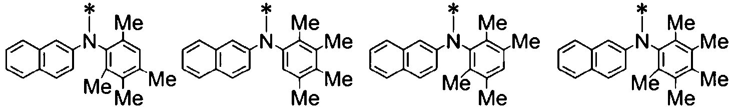

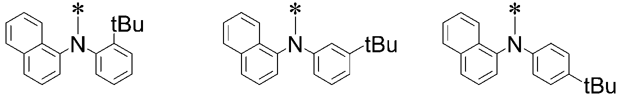

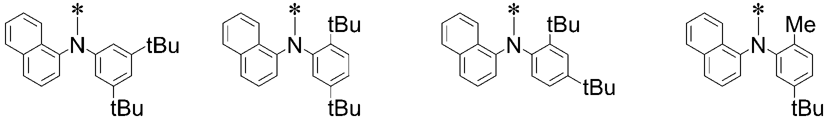

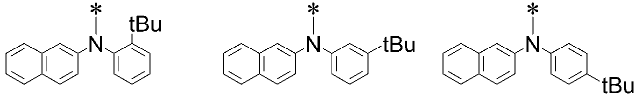

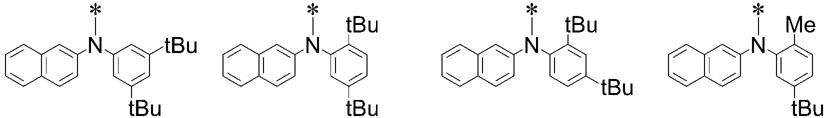

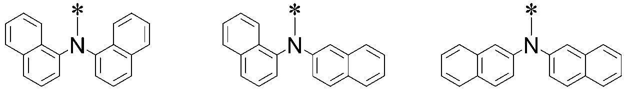

### <Description of multimer of polycyclic aromatic compound>

The present invention also provides a multimer of the polycyclic aromatic compound having a plurality of unit structures represented by the formula (A-1). The multimer is preferably a dimer to a hexamer, more preferably a dimer or a trimer, particularly preferably a dimer. The multimer can be in a form having a plurality of the unit structures in one compound and may be, for example, in a form in which a plurality of the unit structures are connected through a linking group such as a single bond, an alkylene group having 1 to 3 carbon atoms, a phenylene group, or a naphthylene group (linked type multimer) as well as a form in which a plurality of the unit structures share an arbitrary ring (ring a, ring b, ring c¹, or ring c²) contained in the unit structures (ring-sharing type multimer) or may be in a form in which arbitrary rings (ring a, ring b, ring c¹, or ring c²) contained in the unit structures are bonded so as to be condensed with each other (ring-condensed type multimer). A ring-sharing type multimer and a ring-condensed type multimer are preferred, and a ring-sharing type multimer is more preferred.

Examples of such a multimer include multimer compounds represented by the formulas (M2-A-1-b1) to (M2-A-1-b3) or the formula (M3-A-1-b1) given below. The multimer compound represented by any of the following formulas (M2-A-1-b1) to (M2-A-1-b3) is a multimer compound having two unit structures represented by the formula (A-1) so as to share a benzene ring as the ring b in one compound structure of the formula (A-1) (ring-sharing type multimer). The multimer compound represented by the following formula (M3-A-1-b1) is a multimer compound having three unit structures represented by the formula (A-1) so as to share a benzene ring as the ring b in one compound structure of the formula (A-1) (ring-sharing type multimer).

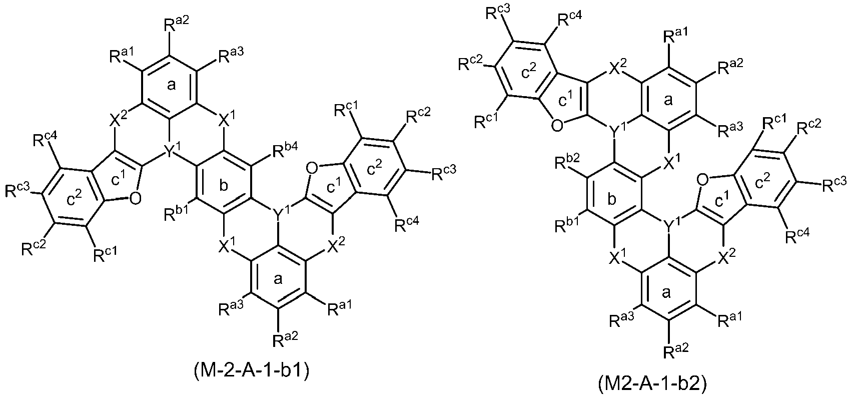

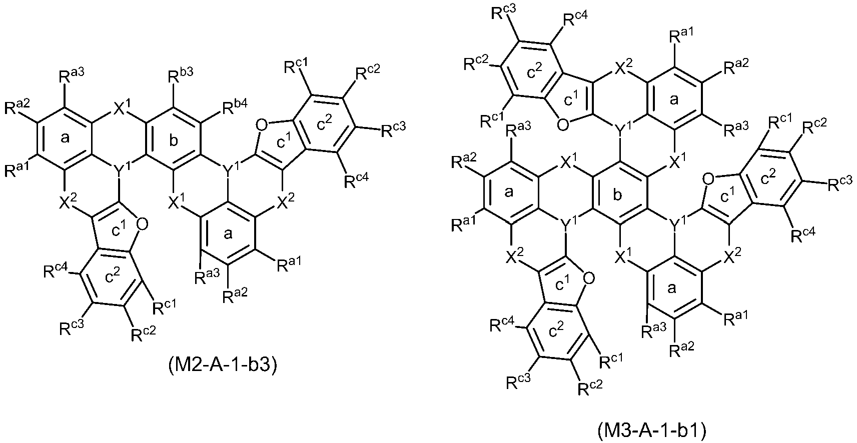

The multimer compound may be a multimer having a multimeric form represented by any of the formulas (M2-A-1-b1) to (M2-A-1-b3) or the formula (M3-A-1-b1) and an additional multimeric form in combination, may be a multimer having a multimeric form represented by any of the formulas (M2-A-1-b1) to (M2-A-1-b3) and a multimeric form represented by the formula (M3-A-1-b1) in combination, or may be a multimer having a multimeric form represented by any of the formulas (M2-A-1-b1) to (M2-A-1-b3), a multimeric form represented by the formula (M3-A-1-b1), and an additional multimeric form in combination.

### <Description of cycloalkane condensation>

At least one aromatic ring or heteroaromatic ring in the chemical structure of the polycyclic aromatic compound of the present invention is optionally condensed with at least one cycloalkane.

For example, at least one of the ring a, the ring b, the ring c², an aryl group (aryl group moiety in substituted or unsubstituted aryl, substituted or unsubstituted diarylamino, substituted or unsubstituted arylheteroarylamino, substituted or unsubstituted diarylboryl, substituted or unsubstituted aryloxy, substituted or unsubstituted arylthio, or substituted or unsubstituted triarylsilyl) and a heteroaryl group (heteroaryl moiety in substituted or unsubstituted heteroaryl, substituted or unsubstituted diheteroarylamino, or substituted or unsubstituted arylheteroarylamino) as the first substituent and the second substituent on these rings, a substituted or unsubstituted aryl group or a substituted or unsubstituted heteroaryl group as R of "Si-R" and R of "Ge-R" represented by Y¹, and aryl substituted by alkyl, substituted or unsubstituted aryl group, or substituted or unsubstituted heteroaryl group as R (including the formula (G-1)) of "N-R", R of "Si-R", and R of "Ge-R" represented by X¹ or X² is optionally condensed with at least one cycloalkane.

Preferably, at least one of the ring b, the ring c², an aryl group (aryl group moiety in substituted or unsubstituted aryl, substituted or unsubstituted diarylamino, substituted or unsubstituted diarylboryl, substituted or unsubstituted aryloxy, or substituted or unsubstituted arylthio) and a heteroaryl group (heteroaryl moiety in substituted or unsubstituted heteroaryl or substituted or unsubstituted heteroarylamino) as the first substituent on these rings or on the ring a, the ring b, or the ring c², a substituted or unsubstituted aryl ring or a substituted or unsubstituted heteroaryl ring formed by adjacent substituents bonded to each other in the ring b and the ring c², and aryl substituted by alkyl, substituted or unsubstituted aryl group, or substituted or unsubstituted heteroaryl group as R (including the formula (G-1)) of "N-R" represented by X¹ or X² is optionally condensed with at least one cycloalkane. At least one of R^{a1} to R^{a3} in the formulas (A-1) to (A-36), the formulas (M2-A-1-b1) to (M2-A-1-b3), and the formula (M3-A-1-b1) is aryl substituted by substituted or unsubstituted diarylamino, substituted or unsubstituted carbazolyl, substituted or unsubstituted alkyl, or substituted or unsubstituted cycloalkyl, or is heteroaryl substituted by substituted or unsubstituted diarylamino, substituted or unsubstituted carbazolyl, substituted or unsubstituted alkyl, or substituted or unsubstituted cycloalkyl, and the aryl or the heteroaryl is also preferably condensed with at least one cycloalkane.

More preferably, at least one of the ring b, the ring c², an aryl group (aryl group moiety in substituted or unsubstituted aryl or substituted or unsubstituted diarylamino) and a heteroaryl group (heteroaryl moiety in substituted or unsubstituted heteroaryl) as the first substituent on these rings or on the ring a, the ring b, or the ring c², a substituted or unsubstituted aryl ring formed by adjacent substituents bonded to each other in the ring b and the ring c, and aryl substituted by alkyl or substituted or unsubstituted aryl group as R (including the formula (G-1)) of "N-R" represented by X¹ or X² is optionally condensed with at least one cycloalkane. At least one of R^{a1} to R^{a3} in the formulas (A-1) to (A-12), the formulas (M2-A-1-b1) to (M2-A-1-b3), the formula (M3-A-1-b1), the formulas (A-1-b1) to (A-1-b22) given below, and the formulas (A-1-cl) to (A-1-c9) given below is aryl substituted by substituted or unsubstituted diarylamino, substituted or unsubstituted carbazolyl, substituted or unsubstituted alkyl, or substituted or unsubstituted cycloalkyl, or is heteroaryl substituted by substituted or unsubstituted diarylamino, substituted or unsubstituted carbazolyl, substituted or unsubstituted alkyl, or substituted or unsubstituted cycloalkyl, and the aryl or the heteroaryl is also preferably condensed with at least one cycloalkane.

In one embodiment, preferably substituted aryl and substituted heteroaryl as R^{a1} to R^{a3}, more preferably substituted aryl and substituted heteroaryl as R^{a2}, further preferably substituted aryl as R^{a2}, is optionally condensed with at least one cycloalkane, and at least one hydrogen atom in the cycloalkane is optionally replaced.

In one embodiment, preferably aryl substituted by alkyl, substituted or unsubstituted heteroaryl as R of N-R, more preferably aryl substituted by alkyl as R of N-R, is optionally condensed with at least one cycloalkane, and at least one hydrogen atom in the cycloalkane is optionally replaced.

Examples of the "cycloalkane" include cycloalkane having 3 to 24 carbon atoms, cycloalkane having 3 to 20 carbon atoms, cycloalkane having 3 to 16 carbon atoms, cycloalkane having 3 to 14 carbon atoms, cycloalkane having 5 to 10 carbon atoms, cycloalkane having 5 to 8 carbon atoms, cycloalkane having 5 or 6 carbon atoms, and cycloalkane having 5 carbon atoms.

Specific examples of the cycloalkane include cyclopropane, cyclobutane, cyclopentane, cyclohexane, cycloheptane, cyclooctane, cyclononane, cyclodecane, norbornene, bicyclo[1.1.0]butane, bicyclo[1.1.1]pentane, bicyclo[2.1.0]pentane, bicyclo[2.1.1]hexane, bicyclo[3.1.0]hexane, bicyclo[2.2.1]heptane, bicyclo[2.2.2]octane, adamantane, diamantane, decahydronaphthalene, and decahydroazulene, and forms thereof substituted by alkyl having 1 to 5 carbon atoms (particularly, methyl), forms thereof substituted by halogen (particularly, fluorine), and forms thereof substituted by deuterium.

Among them, for example, as shown in the structural formula (Cy-A) to the formula (Cy-D) given below, a structure is preferred where at least one hydrogen atom on carbon (carbon at a position adjacent to carbon at a condensation site in cycloalkyl to be condensed with an aromatic ring or a heteroaromatic ring) at position α of cycloalkane is replaced. A structure is more preferred where two hydrogen atoms on carbon at position α are replaced. A structure is further preferred where a total of four hydrogen atoms on two carbon atoms at position α are replaced. Examples of this substituent include forms substituted by alkyl having 1 to 5 carbon atoms (particularly, methyl), forms substituted by halogen (particularly, fluorine), and forms substituted by deuterium.

The formula (Cy-A), the formula (Cy-B), the formula (Cy-C), and the formula (Cy-D) illustrate forms of a benzene ring condensed with cycloalkane. The same holds true for an aryl ring other than the benzene ring, or a heteroaryl ring.

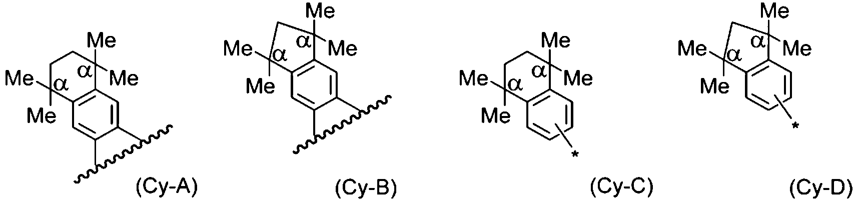

The number of cycloalkane moieties to be condensed with one aromatic ring or heteroaromatic ring is preferably 1 to 3, more preferably 1 or 2, further preferably 1. Examples of one or more cycloalkane moieties condensed with one benzene ring (phenyl group) will be given below. In each structural formula, * means, in the case of a benzene ring, that the benzene ring is contained in the skeletal structure of the compound, and means, in the case of a phenyl group, a bond by which the skeletal structure of the compound is substituted. As in the formula (Cy-1-4) and the formula (Cy-2-4), condensed cycloalkane rings may be condensed with each other. The same holds true for the cases where the ring (group) to be condensed is a different aromatic ring other than a benzene ring (phenyl group), or a heteroaromatic ring and the case where the cycloalkane to be condensed is different cycloalkane other than cyclopentane or cyclohexane.

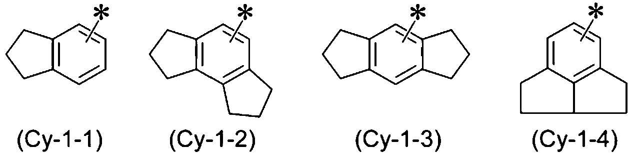

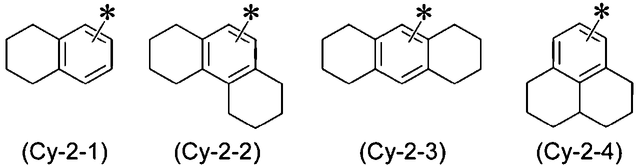

At least one -CH₂- moiety in the cycloalkane is optionally substituted by -O-. However, when a plurality of -CH₂- moieties are substituted by -O-, adjacent -CH₂-moieties are not substituted by -O-. Examples of one or more -CH₂- substituted by -O- in cycloalkane condensed with one benzene ring (phenyl group) will be given below. In each structural formula, * means, in the case of a benzene ring, that the benzene ring is contained in the skeletal structure of the compound, and means, in the case of a phenyl group, a bond by which the skeletal structure of the compound is substituted. The same holds true for the cases where the ring (group) to be condensed is a different aromatic ring other than a benzene ring (phenyl group), or a heteroaromatic ring and the case where the cycloalkane to be condensed is different cycloalkane other than cyclopentane or cyclohexane.

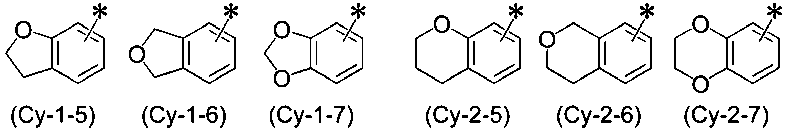

At least one hydrogen atom in the cycloalkane is optionally replaced. Examples of this substituent include substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, substituted silyl, cyano, and halogen. Two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group. The description of the first substituent mentioned above can be cited about details thereof. Among these substituents, alkyl (e.g., alkyl having 1 to 6 carbon atoms), cycloalkyl (e.g., cycloalkyl having 3 to 14 carbon atoms), halogen (e.g., fluorine), or the like is preferred.

In the case of being substituted by cycloalkyl, a substituted form constituting a spiro structure may be used. Examples of a spiro structure formed in cycloalkane condensed with one benzene ring (phenyl group) will be given below. In each structural formula, * means, in the case of a benzene ring, that the benzene ring is contained in the skeletal structure of the compound, and means, in the case of a phenyl group, a bond by which the skeletal structure of the compound is substituted.

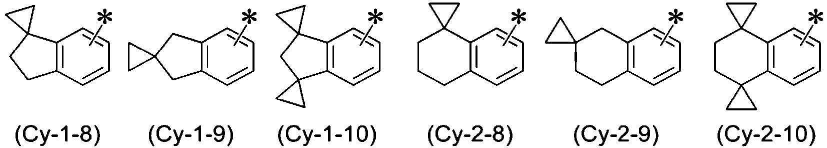

Other examples of the cycloalkane-condensed form include a polycyclic aromatic compound represented by the formula (A-1), the compound being substituted by a diarylamino group condensed with cycloalkane (condensed at its aryl group moiety therewith), a carbazolyl group condensed with cycloalkane (condensed at its benzene ring moiety), or a benzocarbazolyl group condensed with cycloalkane (condensed at its benzene ring moiety). Examples of the "diarylamino group" include the groups described as the "first substituent".

Further specific examples thereof include a polycyclic aromatic compound represented by the formula (A-1) wherein each of R^{b1} to R^{b3} and R^{c2} to R^{c3} (particularly, R^{b2} and R^{c2} at the para positions with respect to Y¹) is a diarylamino group condensed with cycloalkane (condensed at its aryl group moiety therewith) or a carbazolyl group condensed with cycloalkane (condensed at its benzene ring moiety).

### <Description of substitution by cyano or halogen>

At least one hydrogen atom in the polycyclic aromatic compound of the present invention is optionally replaced with cyano or halogen. The halogen is fluorine, chlorine, bromine, or iodine, preferably fluorine, chlorine, or bromine, more preferably fluorine or chlorine, most preferably fluorine.

### <Description of replacement with isotope>

Each element in the polycyclic aromatic compound represented by the formula (A-1) and the unit structure of the multimer thereof comprises a plurality of naturally occurring isotopes at natural abundance ratios, unless otherwise specified. However, at least one atom of an element in each structural formula may comprise a heavy stable isotope beyond the natural abundance ratio (e.g., 90 atom% or more). In the present specification, this is simply referred to as "replacement" with a "heavy stable isotope". More specifically, at least one hydrogen atom can be replaced with deuterium, at least one nitrogen atom can be replaced with nitrogen-15 (¹⁵N)*,* at least one sulfur atom can be replaced with sulfur-33 (³³S), sulfur-34 (³⁴S), or sulfur-36 (³⁶S), at least one oxygen atom can be replaced with oxygen-17 (¹⁷O) or oxygen-18 (¹⁸O), at least one carbon atom can be replaced with carbon-13 (¹³C), and at least one boron atom can be replaced with boron-11 (¹¹B). The same holds true for structures represented by the formulas (A-1-a1) to (A-1-al3), the formulas (A-1-b1) to (A-1-b22), the formulas (A-1-c1) to (A-1-c9), the formulas (A-1-d1) to (A-1-d2), the formula (A-2) to the formula (A-70), and the like. Subsequent description also applies to the polycyclic aromatic compound represented by the formula and the unit structure of the multimer thereof. At least some elements are replaced with their heavy stable isotopes, particularly, at least one boron atom is replaced with boron-11 (¹¹B), whereby high performance can be attained for an organic electroluminescent device using, as a dopant, a polycyclic aromatic compound having a structure composed of one or two or more structural units represented by the formula (A-1).

In one embodiment, in the compound or the unit structure represented by the formula (A-1), at least one hydrogen atom is optionally replaced with deuterium, at least one nitrogen atom is optionally replaced with nitrogen-15 (¹⁵N), at least one sulfur atom is optionally replaced with sulfur-33 (³³S), sulfur-34 (³⁴S), or sulfur-36 (³⁶S), at least one oxygen atom is optionally replaced with oxygen-17 (¹⁷O) or oxygen-18 (¹⁸O), at least one carbon atom is optionally replaced with carbon-13 (¹³C), and at least one boron atom is optionally replaced with boron-11 (¹¹B).

The polycyclic aromatic compound represented by the formula (A-1) or the unit structure of the multimer thereof preferably has replacement with at least one member selected from the group consisting of deuterium, nitrogen-15 (¹⁵N), sulfur-33 (³³S), sulfur-34 (³⁴S), sulfur-36 (³⁶S), oxygen-17 (¹⁷O), oxygen-18 (¹⁸O), carbon-13 (¹³C), and boron-11 (¹¹B), more preferably replacement with at least one member selected from the group consisting of deuterium, nitrogen-15 (¹⁵N), and boron-11 (¹¹B), further preferably replacement with deuterium. In the present specification, replacing hydrogen with deuterium is also referred to as, for example, "replacement of hydrogen with deuterium" or "deuteration". Specifically, in one embodiment, at least one hydrogen atom in the polycyclic aromatic compound represented by the formula (A-1) or the unit structure of the multimer thereof is optionally replaced with deuterium.

In the description of the polycyclic aromatic compound represented by the formula (A-1) or the unit structure of the multimer thereof, boron indicated by mere "B" or "boron" means that the compound is synthesized using a starting material having a natural abundance ratio as the isotope ratio of the element, unless otherwise specified.

By contrast, an element specified by a mass number, such as "¹¹B", means that the compound is synthesized using a starting material having an artificially elevated abundance ratio of the intended element as a starting material related to the element, or the synthesized compound is subjected to replacement with a heavy stable isotope using a starting material having an artificially elevated abundance ratio of the intended element. The same holds true for other elements, for example, hydrogen, nitrogen, sulfur, oxygen, or carbon.

In the case of an element specified by no specific mass number, the polycyclic aromatic compound of the present invention or the unit structure of the multimer thereof is encompassed by the present invention even if the isotope ratio of at least one atom in a polycyclic aromatic compound molecule is an arbitrary ratio different from the natural ratio.

In one embodiment, in the case of being replaced with a heavy stable isotope, a high isotope ratio is preferred. For example, in the case of replaced with boron-11 (¹¹B), the isotope ratio of ¹¹B is preferably 90 atom% or more. In the case of replaced with deuterium (D), the isotope ratio of D is preferably 40 atom% or more, more preferably 60 atom% or more, further preferably 80 atom% or more, most preferably 90 atom% or more. In the polycyclic aromatic compound of the present invention substituted by a plurality of deuterium (D) atoms, the individual deuterium atoms may differ in deuteration rate depending on a starting material or a reaction process. In this case, the isotope ratio of at least one (preferably two, more preferably three, further preferably four, particularly preferably five or more, most preferably all) D atom is preferably 40 atom% or more, more preferably 60 atom% or more, further preferably 80 atom% or more, most preferably 90 atom% or more. In the present specification, the isotope ratio can be measured by NMR.

### <Description of preferred polycyclic aromatic compound of present invention>

In a preferred embodiment, the formula (A-1) is preferably represented by any of the following formulas (A-1-a1) to (A-1-a13), formulas (A-1-b1) to (A-1-b22), formulas (A-1-c1) to (A-1-c9), and formulas (A-1-d1) to (A-1-d2):

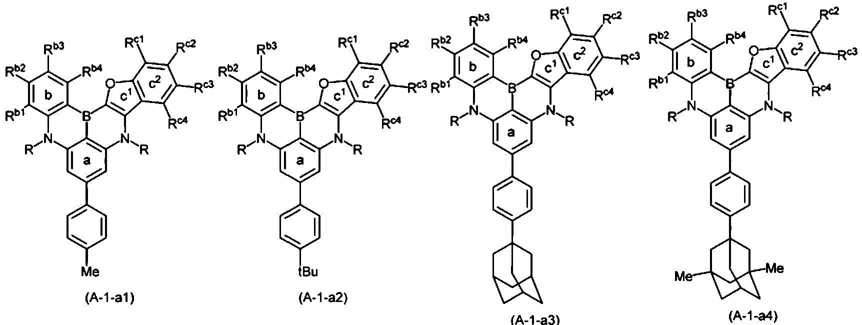

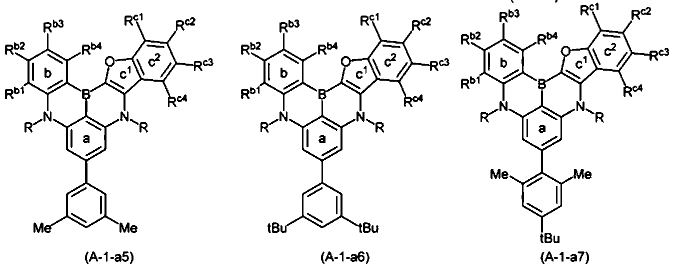

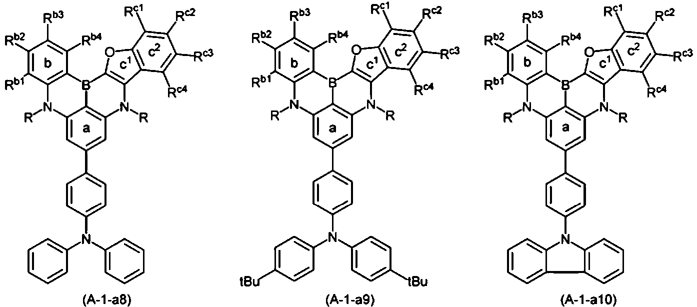

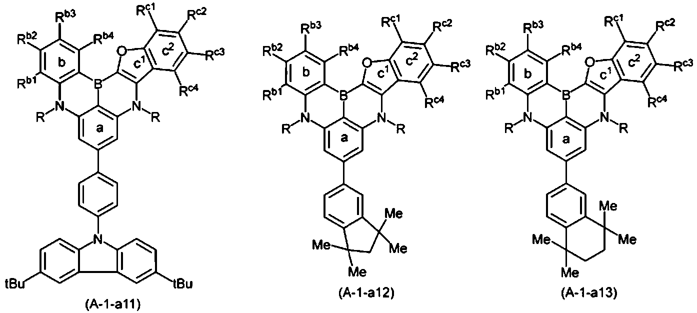

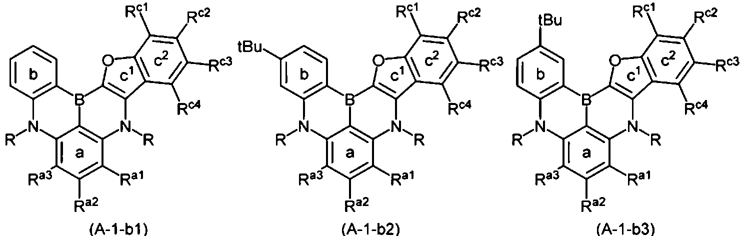

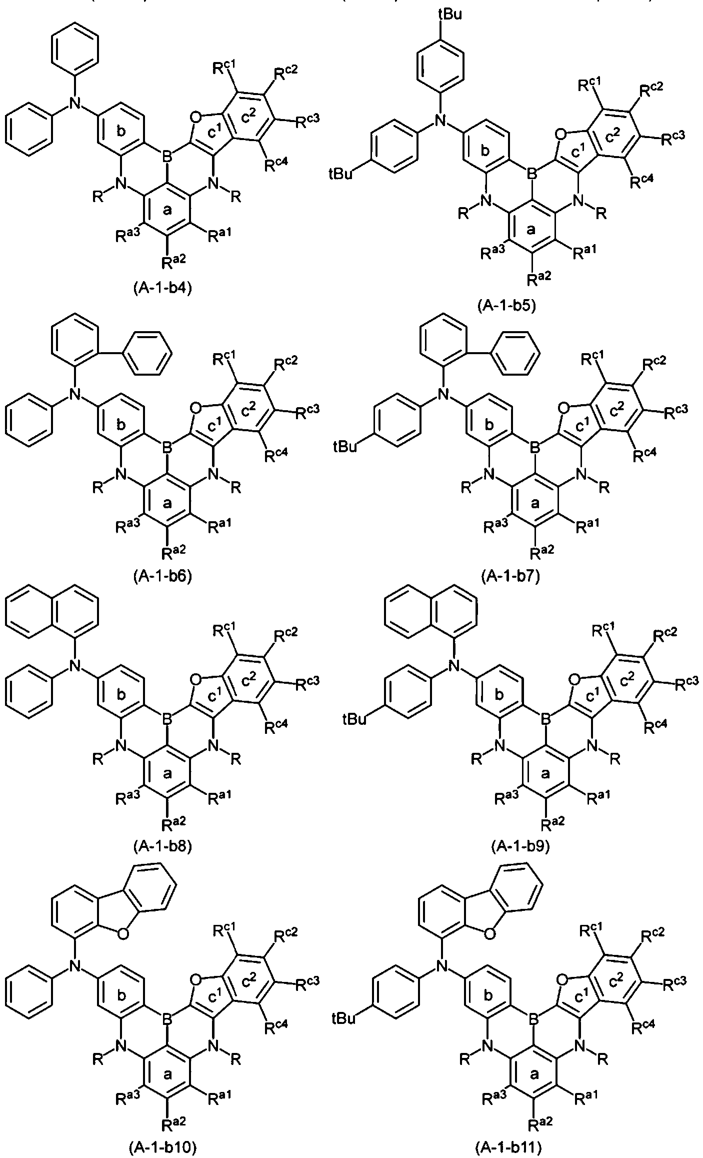

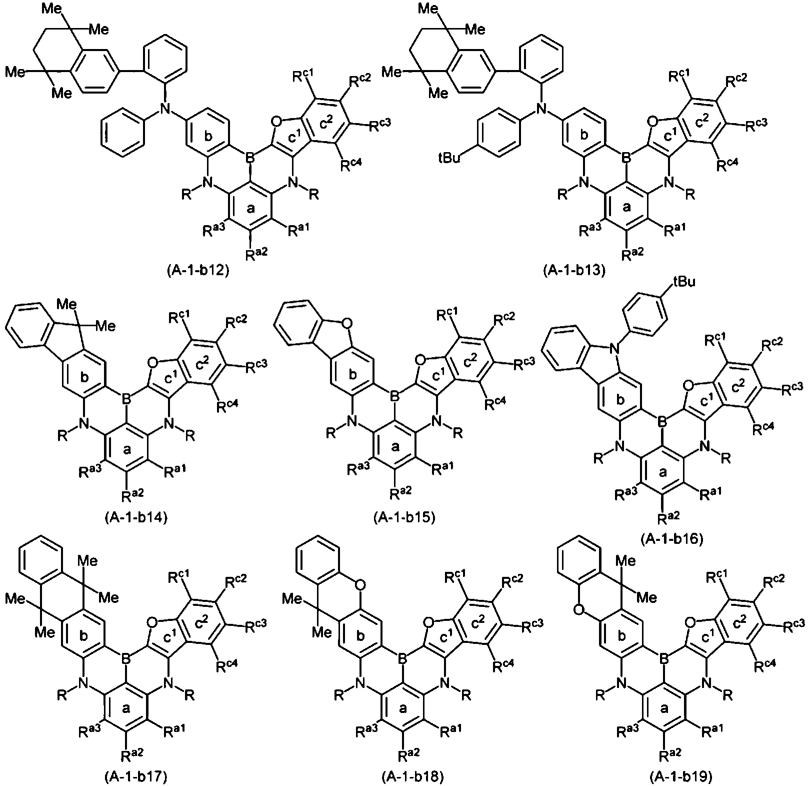

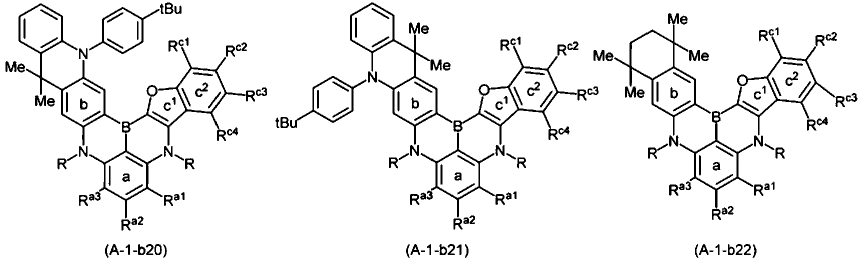

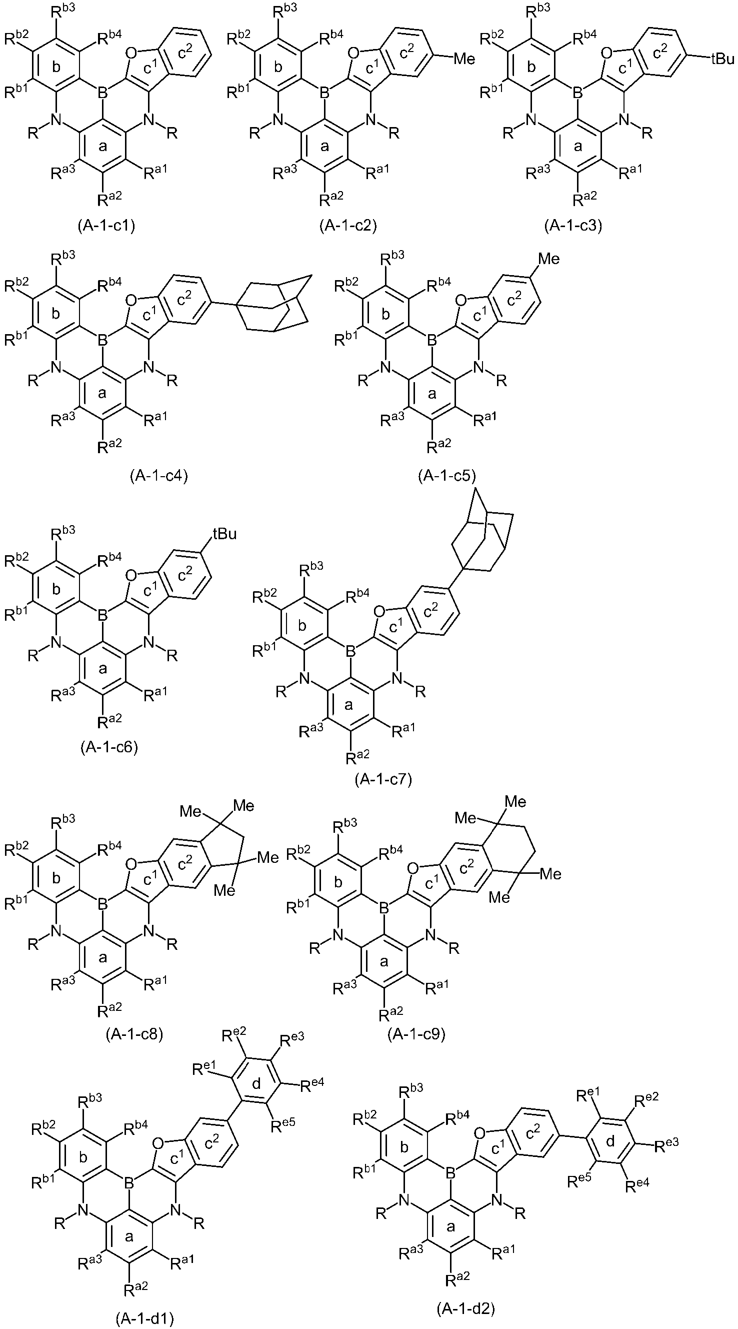

In the formulas (A-1-a1) to (A-1-a13), the formulas (A-1-b1) to (A-1-b22), the formulas (A-1-c1) to (A-1-c9), and the formula (A-1-d1) to the formula (A-1-d2),
R^{a1} to R^{a3}, R^{b1} to R^{b4} , R^{c1} to R^{c4} , and R^{e1} to R^{e5} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group, and
two adjacent groups of R^{a1} to R^{a3}, R^{b1} to R^{b4}, R^{c1} to R^{c4}, and R^{e1} to R^{e5} are optionally bonded to each other to form an aryl ring or a heteroaryl ring, and at least one hydrogen atom of the formed aryl ring and heteroaryl ring is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
on the proviso that at least one of R^{a1} to R^{a3} is substituted aryl with substituted or unsubstituted arylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent; and
R is hydrogen, aryl substituted by alkyl, substituted or unsubstituted heteroaryl, substituted or unsubstituted alkyl, substituted or unsubstituted cycloalkyl, or a group represented by the formula (G-1), wherein the R moiety of the N-R is optionally bonded to the ring a and/or the ring b or to the ring a and/or the ring c² through a linking group,
on the proviso that at least one R is a group represented by the formula (G-1):

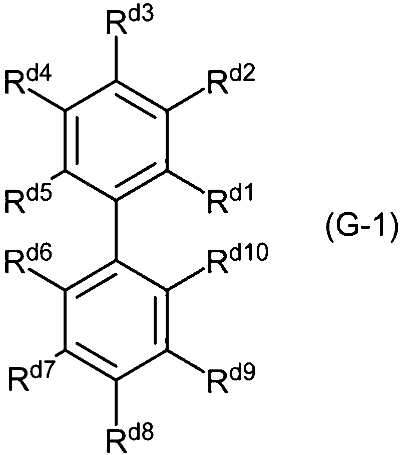

In the formula (G-1),
R^{d1} to R^{d10} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
two adjacent groups of R^{d1} to R^{d10} are optionally bonded to each other to form a cycloalkane-condensed structure,
on the proviso that at least one of R^{d6} to R^{d10} is alkyl, or two adjacent groups of Rd⁶ to Rd¹⁰ are bonded to each other to form a cycloalkane-condensed structure, and
any one of R^{d1} to R^{d5} is a bond to a nitrogen atom.

In the formulas (A-1-a1) to (A-1-a13), the formulas (A-1-b1) to (A-1-b22), the formulas (A-1-c1) to (A-1-c9), and the formula (A-1-d1) to the formula (A-1-d2), at least one of the ring a, the ring b, the ring c², the aryl ring, and the heteroaryl ring is optionally condensed with at least one cycloalkane, at least one hydrogen atom in the cycloalkane is optionally replaced, at least one -CH₂- moiety in the cycloalkane is optionally substituted by -O-, and at least one hydrogen atom is optionally replaced with cyano or halogen.

In a more preferred embodiment, the formula (A-1) is preferably represented by any of the following formulas (A-2) to (A-36) and more preferably represented by any of the following formulas (A-2) to (A-12):

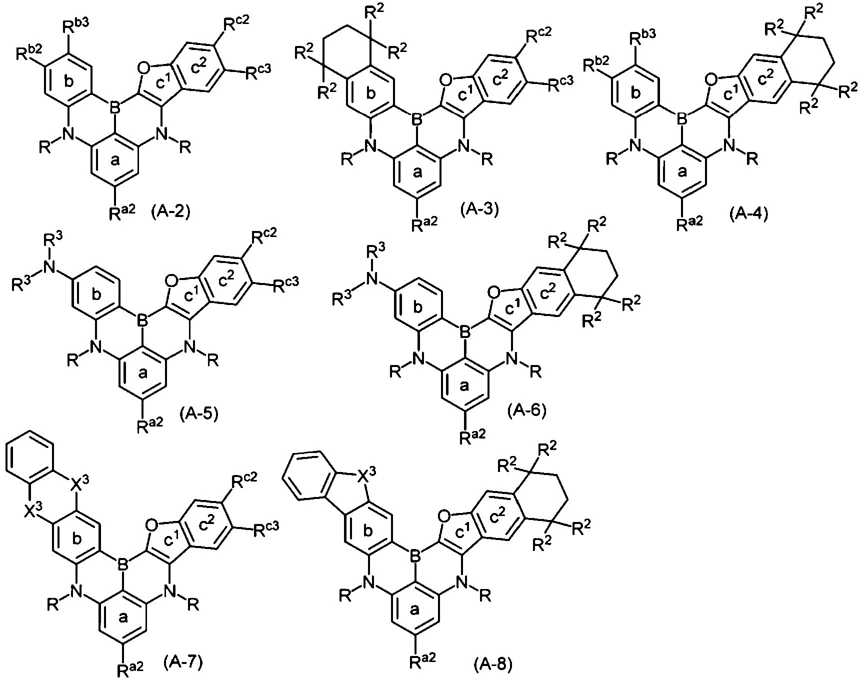

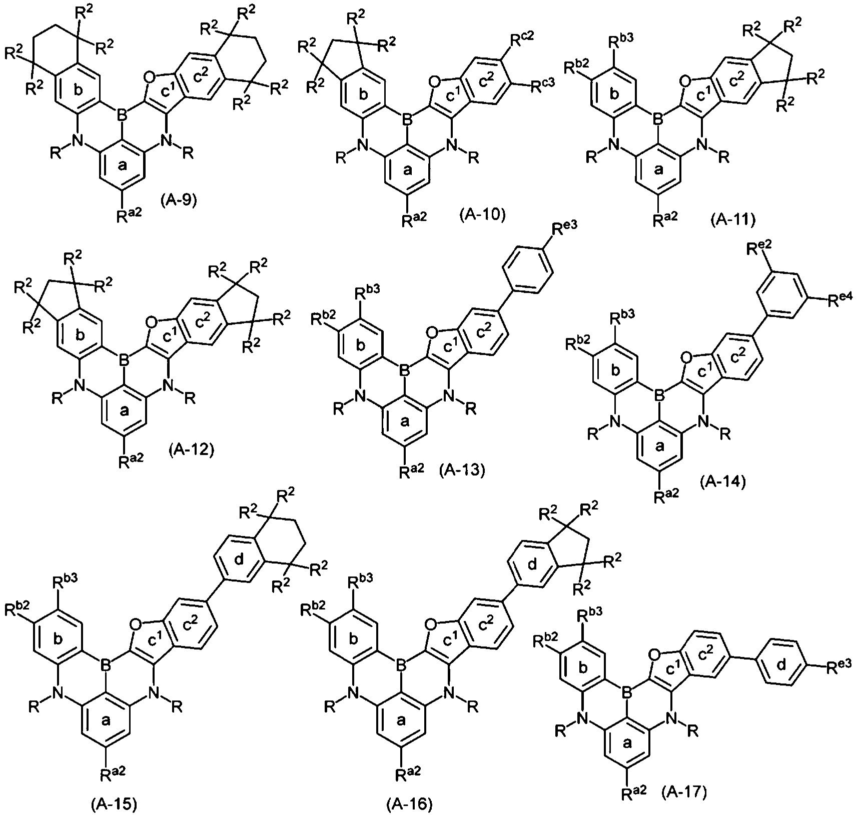

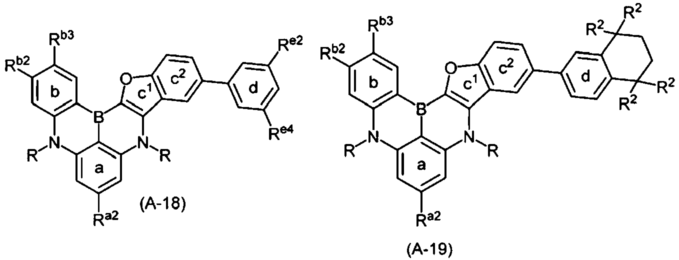

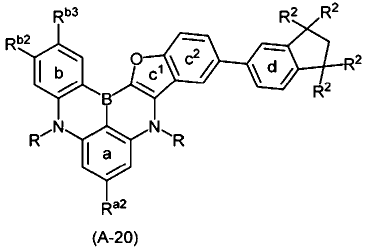

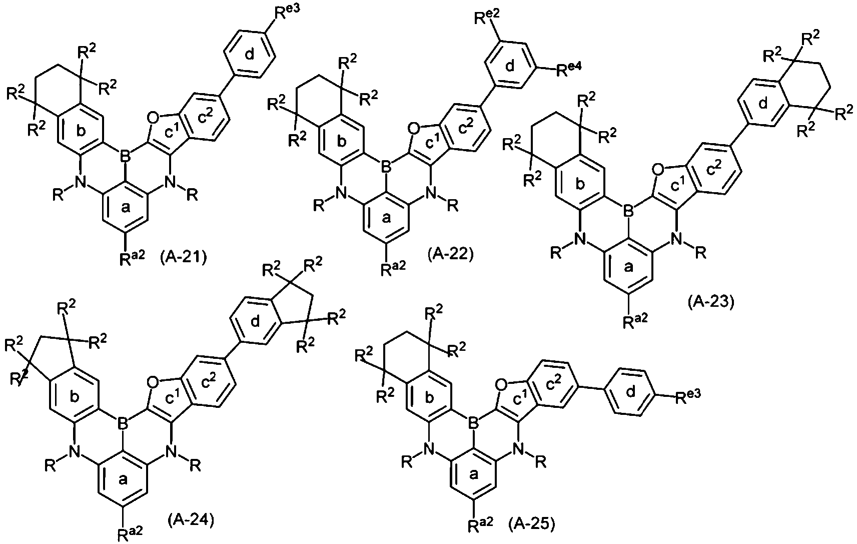

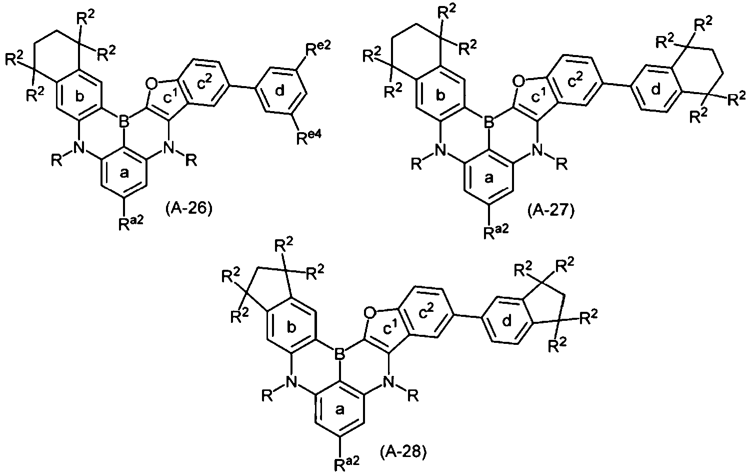

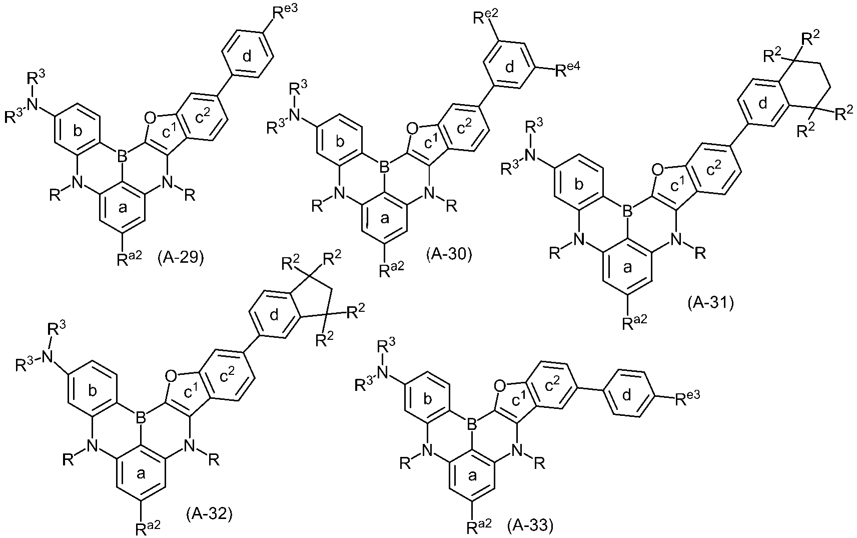

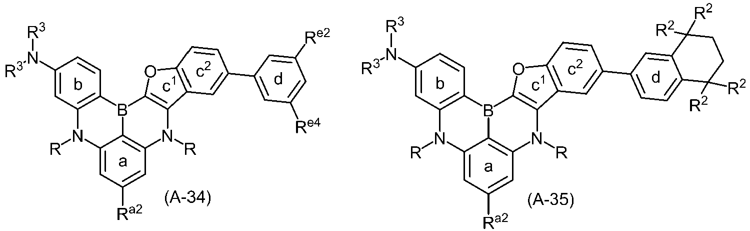

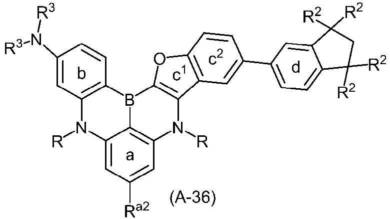

In the formulas (A-2) to (A-36), R^{a2} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent, wherein the aryl ring of the substituted aryl or the heteroaryl ring of the substituted heteroaryl is optionally condensed with at least one cycloalkane, and at least one hydrogen atom in the cycloalkane is optionally replaced. R^{a2} is preferably diarylamino optionally substituted by methyl, t-amyl, or t-butyl, or substituted aryl with alkyl as a substituent, more preferably methyl or t-butyldiarylamino, or substituted phenyl with alkyl as a substituent, further preferably a group represented by any of the following formulas (a1) to (a14) (wherein * represents a bond to the ring a), particularly preferably the following formula (a1), formula (a2), formula (a4), formula (a6), formula (a7), formula (a8), formula (a13), and formula (a14), most preferably the following formula (a2), formula (a6), formula (a13), and formula (a14):

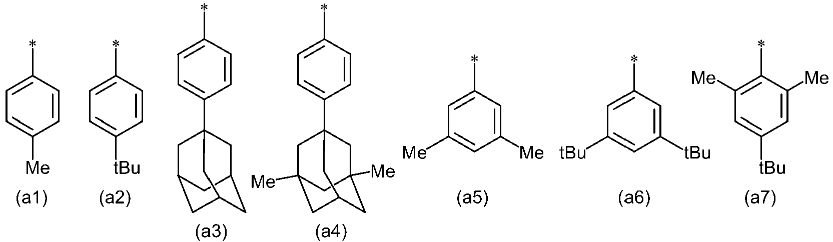

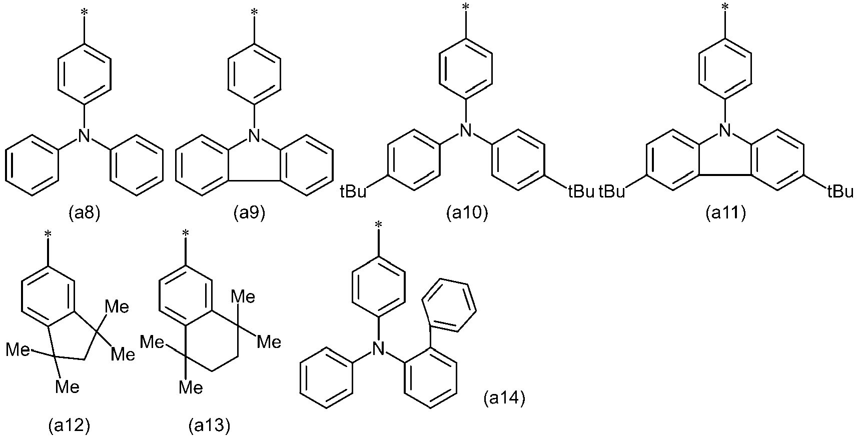

R^{b2} and R^{b3} are each independently hydrogen, substituted or unsubstituted alkyl, or substituted or unsubstituted cycloalkyl, preferably hydrogen or substituted or unsubstituted alkyl, more preferably one of the moieties is hydrogen, and the other moiety is substituted or unsubstituted alkyl, further preferably one of the moieties is hydrogen, and the other moiety is methyl, ethyl, propyl, isopropyl, butyl, i-butyl, s-butyl, t-butyl, t-amyl, adamantyl, or 3,5-dimethyl-1-adamantyl, particularly preferably one of the moieties is hydrogen, and the other moiety is methyl, t-butyl, or t-amyl. In one embodiment, R^{b2} is hydrogen, and R^{b3} is methyl or t-butyl. In an alternative embodiment, R^{b2} is methyl or t-butyl, and R^{b3} is hydrogen. In an alternative embodiment, R^{b2} is substituted or unsubstituted diarylamino, substituted or unsubstituted diheteroarylamino, or substituted or unsubstituted carbazolyl, and R^{b3} is hydrogen. Preferably, R^{b2} is substituted or unsubstituted diarylamino, and R^{b3} is hydrogen.

R^{c2} and R^{c3} are each independently alkyl, substituted or unsubstituted cycloalkyl, preferably one of the moieties is hydrogen, and the other moiety is substituted or unsubstituted alkyl or substituted or unsubstituted cycloalkyl, more preferably one of the moieties is hydrogen, and the other moiety is methyl, ethyl, propyl, isopropyl, butyl, i-butyl, s-butyl, t-butyl, t-amyl, adamantyl, or 3,5-dimethyl-1-adamantyl, further preferably one of the moieties is hydrogen, and the other moiety is methyl, t-butyl, adamantyl, or 3,5-dimethyl-1-adamantyl. In one embodiment, R^{b2} is hydrogen, and R^{b3} is methyl, t-butyl, adamantyl, or 3,5-dimethyl-1-adamantyl, preferably methyl or t-butyl. In an alternative embodiment, R^{b2} is methyl, t-butyl, adamantyl, or 3,5-dimethyl-1-adamantyl, preferably methyl or t-butyl, and R^{b3} is hydrogen.

R^{e2} to R^{e4} are each independently alkyl or substituted or unsubstituted cycloalkyl, preferably alkyl, more preferably methyl, ethyl, propyl, isopropyl, butyl, i-butyl, s-butyl, t-butyl, or t-amyl, further preferably t-butyl or t-amyl. In one embodiment, R^{e2} is preferably hydrogen. R^{e3} is preferably methyl, t-butyl, adamantyl, or 3,5-dimethyl-1-adamantyl, more preferably methyl or t-butyl.

One of two R moieties is a group represented by the formula (G-1), and the other moiety is aryl substituted by alkyl, substituted or unsubstituted heteroaryl, aryl condensed with cycloalkane, heteroaryl condensed with cycloalkane, or a group represented by the formula (G-1).

In this respect, one R moiety is preferably a group represented by any of the formulas (G-2) to (G-7), the formulas (G-11) to (G-14), and the formulas (G-16) to (G-19) mentioned above, more preferably a group represented by any of the formulas (G-2) to (G-7), further preferably a group represented by any of the formulas (G-4) to (G-7). In this respect, R¹ and R² are as mentioned above. R¹ is preferably methyl, ethyl, propyl, isopropyl, butyl, i-butyl, s-butyl, t-butyl, t-amyl, methylphenyl, dimethylphenyl, trimethylphenyl, t-butylphenyl, di-t-butylphenyl, or tri-t-butylphenyl, more preferably methyl, isopropyl, t-butyl, t-amyl, or phenyl, further preferably methyl, t-amyl, or t-butyl, particularly preferably t-butyl. R² is preferably hydrogen, methyl, ethyl, propyl, or isopropyl, more preferably hydrogen, methyl, or ethyl, further preferably hydrogen or methyl, particularly preferably methyl.

The other R moiety is preferably aryl substituted by alkyl, aryl condensed with cycloalkane, or a group represented by the formula (G-1), more preferably phenyl substituted by alkyl, phenyl condensed with cycloalkane, or a group represented by the formula (G-1), more preferably a group represented by any of the following formulas (r1) to (r8), the formulas (G-2) to (G-7), the formulas (G-11) to (G-14), and the formulas (G-16) to (G-19) (wherein * represents a bond to a nitrogen atom), further preferably the formula (r3), the formula (r4), the formula (r5), the formula (r6), the formulas (G-2) to (G-7), particularly preferably the formula (r3), the formula (r4), the formula (r6), the formula (G-5), the formula (G-6), or the formula (G-7).

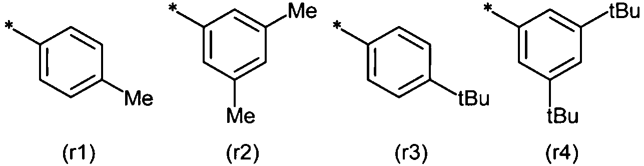

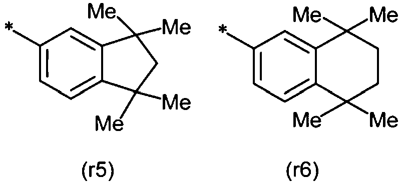

Each R² is independently hydrogen or alkyl, preferably alkyl, more preferably alkyl having 1 to 10 carbon atoms, further preferably methyl, ethyl, propyl, or butyl, particularly preferably methyl.

Each R³ is independently substituted or unsubstituted aryl or substituted or unsubstituted heteroaryl, preferably a group represented by any of the following formulas (R³-1) to (R³-11) (wherein * represents a bond to a nitrogen atom).

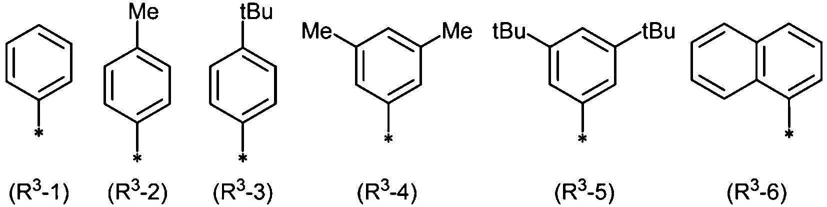

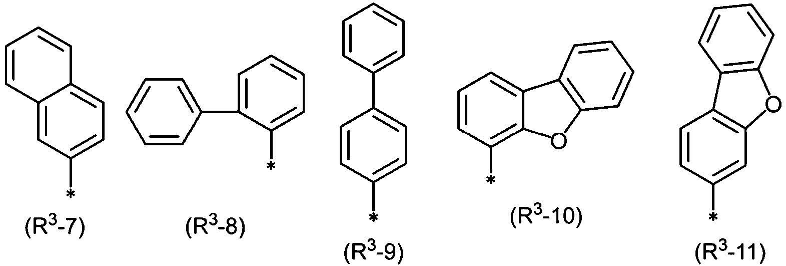

Two R³ moieties may be the same or different and are preferably the same.

In one embodiment, R³ is more preferably represented by the formula (R³-1), the formula (R³-3), the formula (R³-8), or the formula (R³-10), further preferably the formula (R³-1) or the formula (R³-3). In an alternative embodiment, one of the R³ moieties is a group represented by the formula (R³-3), and the other R³ moiety is preferably represented by the formula (R³-1), the formula (R³-3), the formula (R³-5), the formula (R³-6), or the formula (R³-10).

In one embodiment, N(R³)₂ in the formula (A-5), the formula (A-6), and the formula (A-29) to the formula (A-36) is preferably diphenylamino, bis(4-t-butylphenyl)amino, phenyl(4-t-butylphenyl)amino, (biphenyl-2-yl)phenylamino, (biphenyl-2-yl)(4-t-butylphenyl)amino, (4-dibenzofuranyl)phenylamino, or (4-dibenzofuranyl)(4-t-butylphenyl)amino, more preferably diphenylamino or bis(4-t-butylphenyl)amino.

Each X³ is independently O, N-R⁴, or C(-R⁴)₂. In this respect, each R⁴ is independently alkyl or substituted or unsubstituted aryl, preferably alkyl or substituted or unsubstituted phenyl, more preferably methyl, ethyl, propyl, isopropyl, butyl, i-butyl, s-butyl, t-butyl, phenyl, or 4-t-butylphenyl, further preferably methyl, t-butyl, or 4-t-butylphenyl.

In one embodiment, each X³ is independently O, N-bis(4-t-butylphenyl), or C(Me)₂.

In one embodiment, the formulas (A-7) and (A-8) are preferably the formulas (A-7-1) to (A-8-3), preferably the formulas (A-7-1) and (A-8-2).

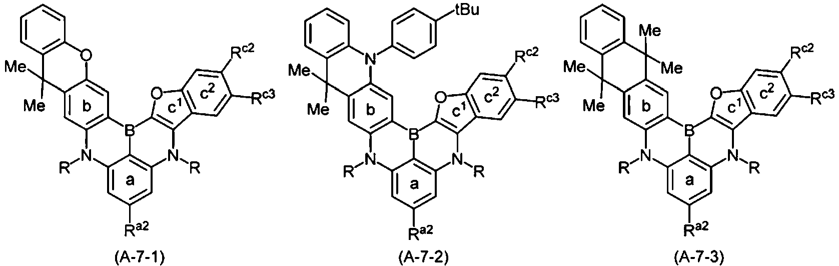

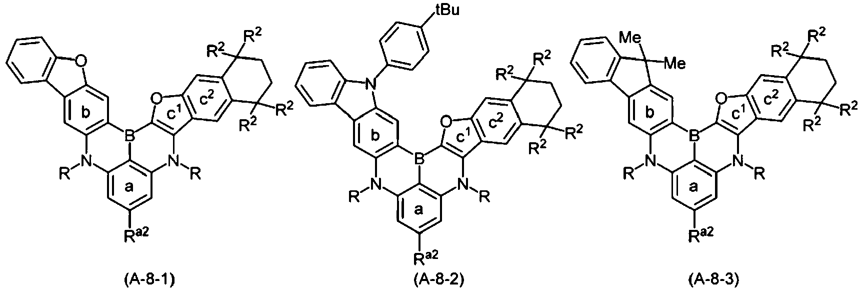

In a further preferred embodiment, the formula (A-1) is preferably represented by any of the following formulas (A-41) to (A-70):

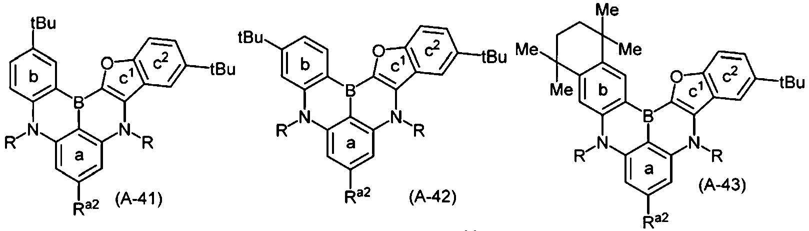

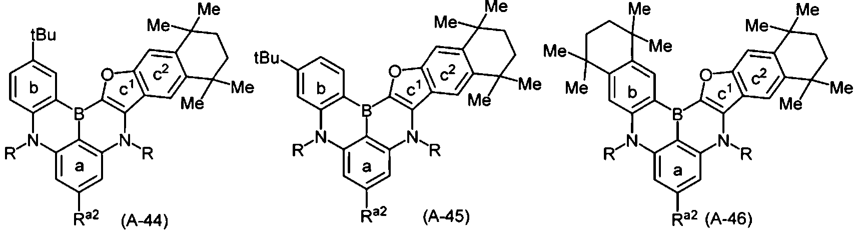

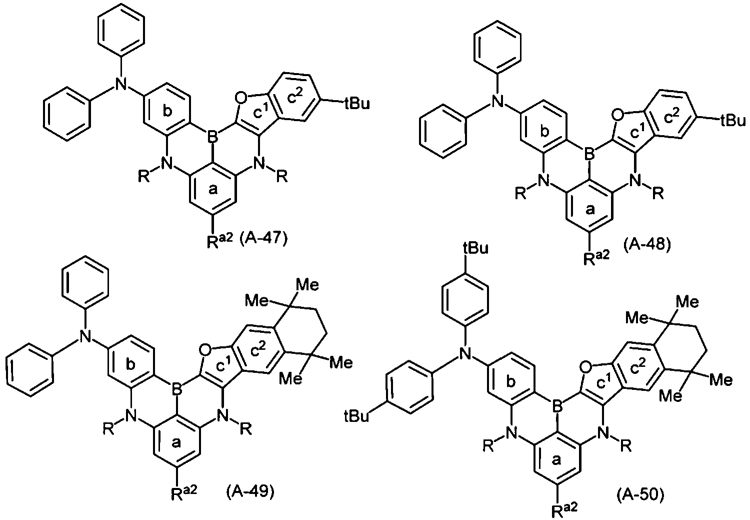

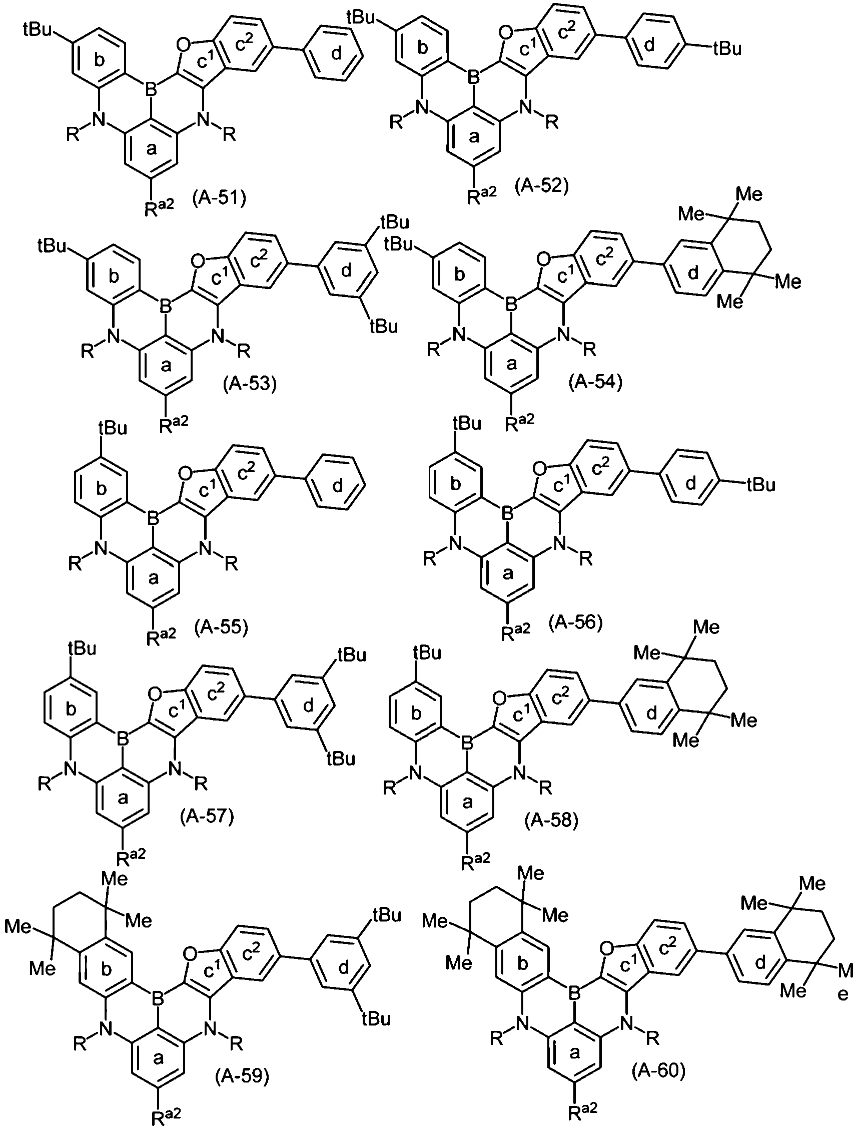

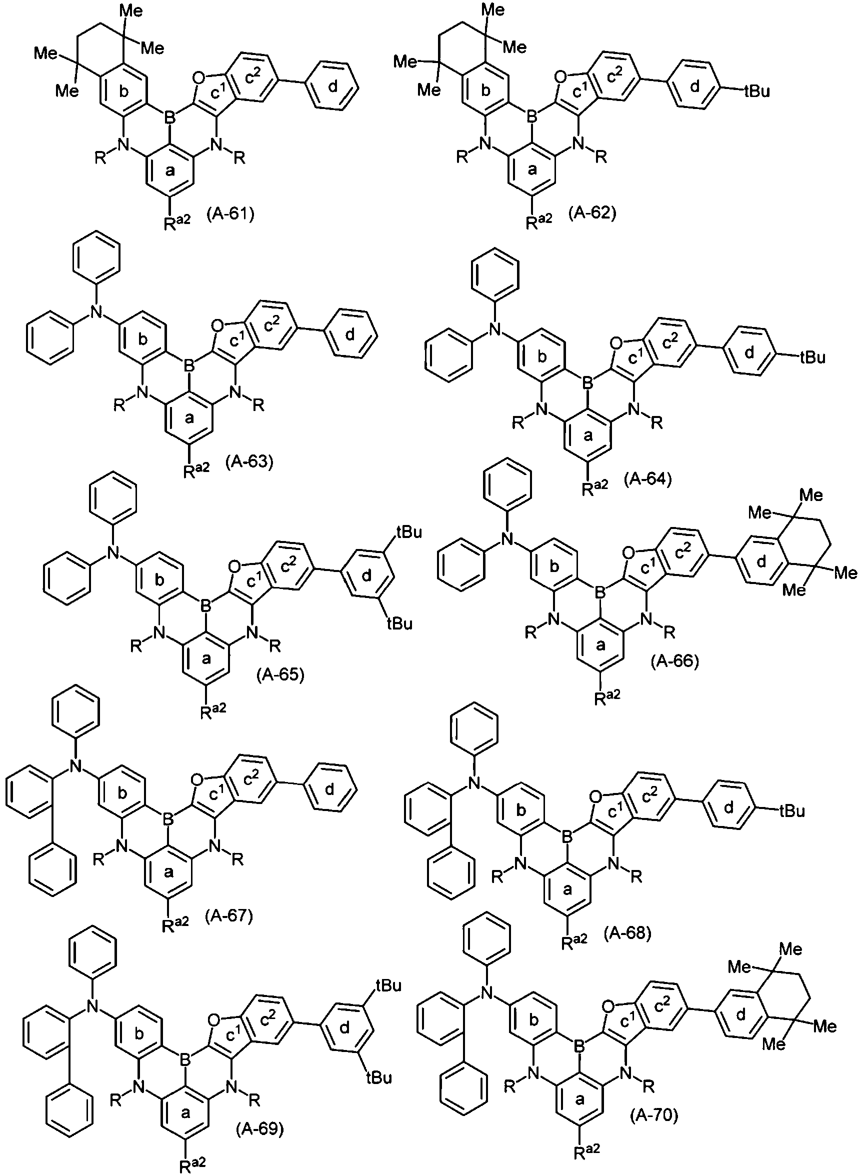

In the formulas (A-41) to (A-70), R^{a2} and R are the same as those of the formulas (A-2) to (A-8).

### <Description of specific example of polycyclic aromatic compound of present invention>

Specific examples of the polycyclic aromatic compound include compounds represented by structural formulas given below. In the following structural formulas, "Me" represents a methyl group, "tBu" represents a t-butyl group, "tAm" represents a t-amyl group, and "D" represents deuterium.

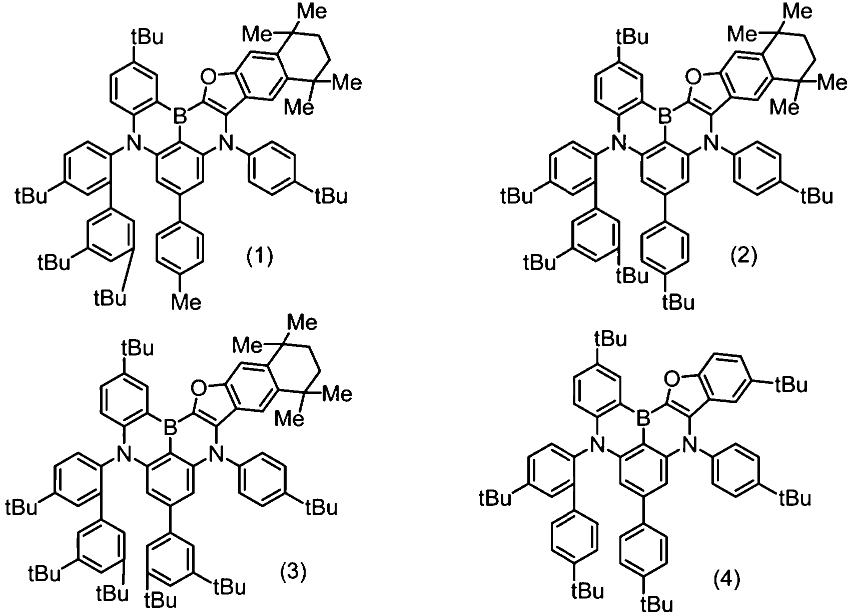

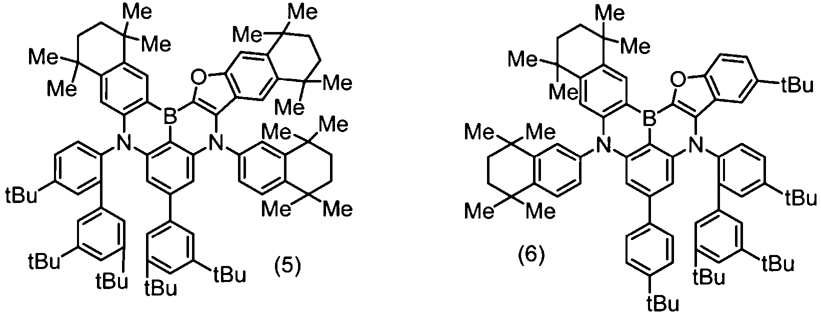

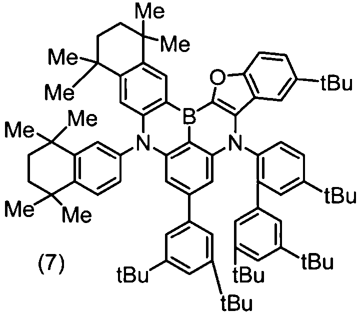

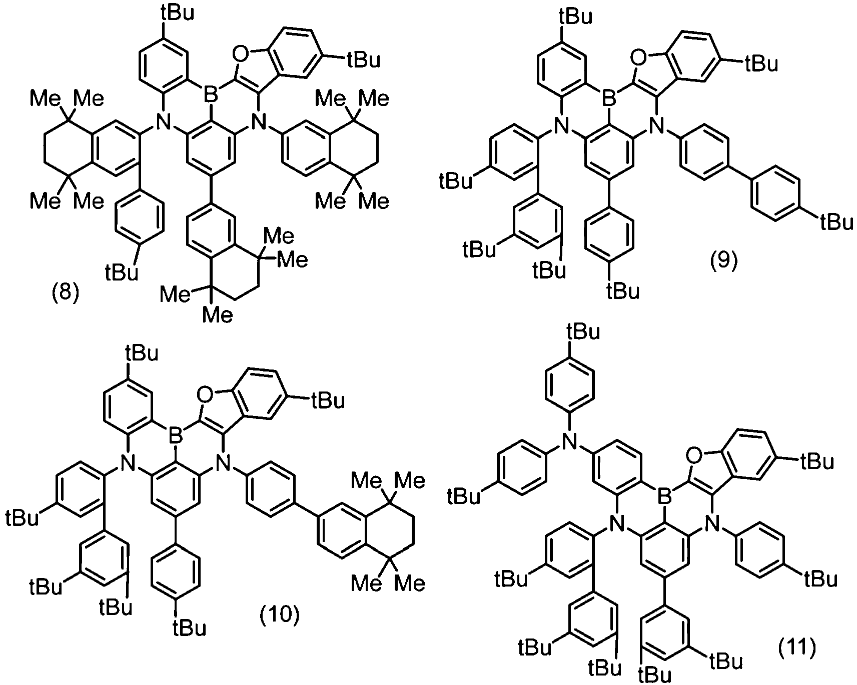

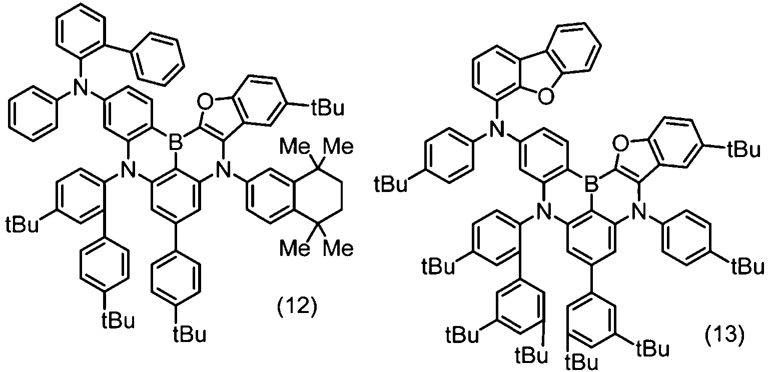

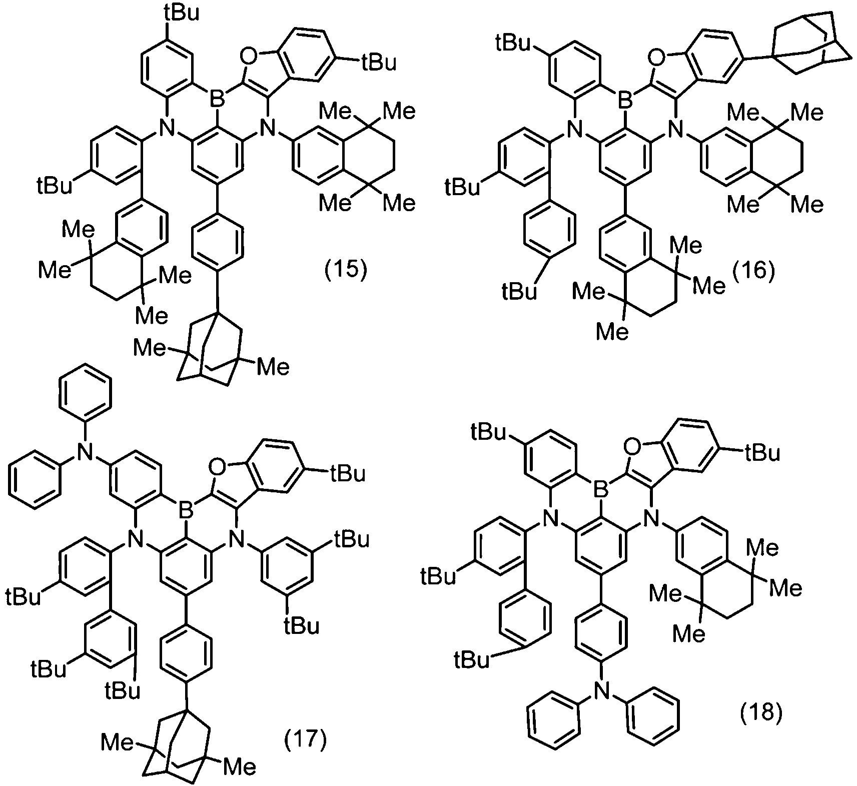

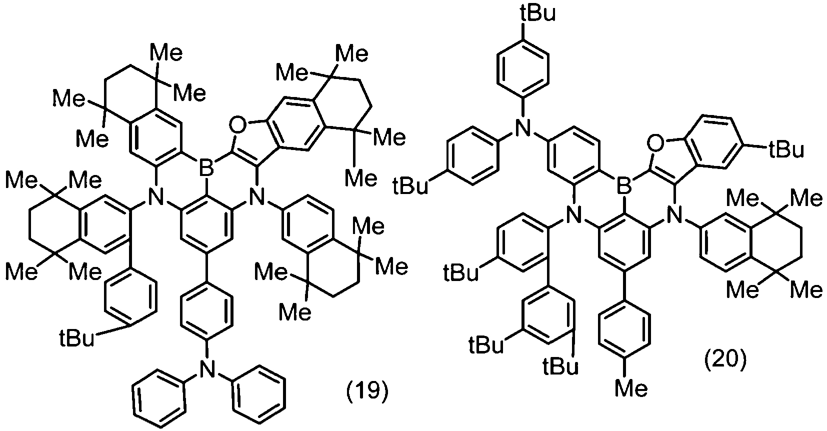

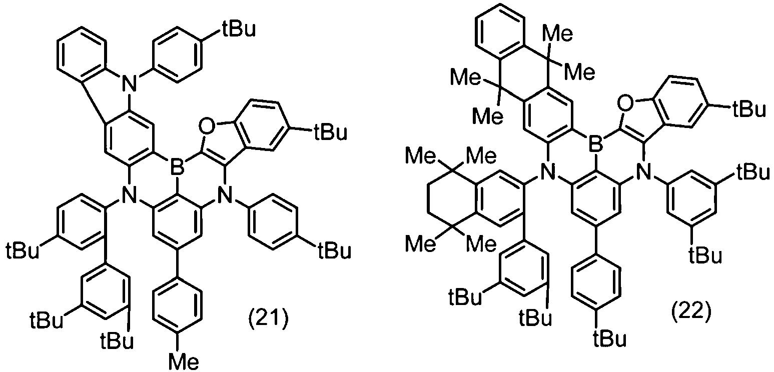

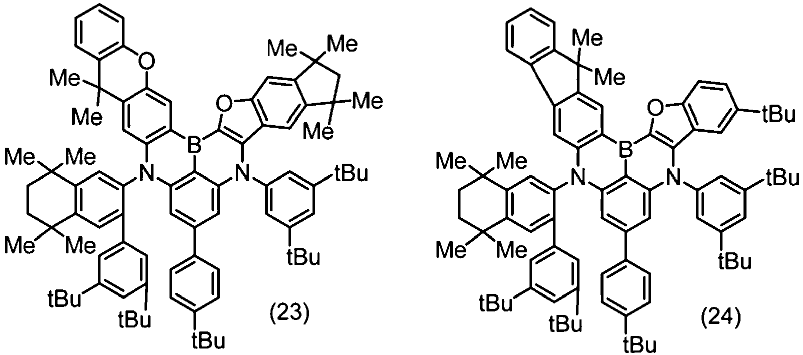

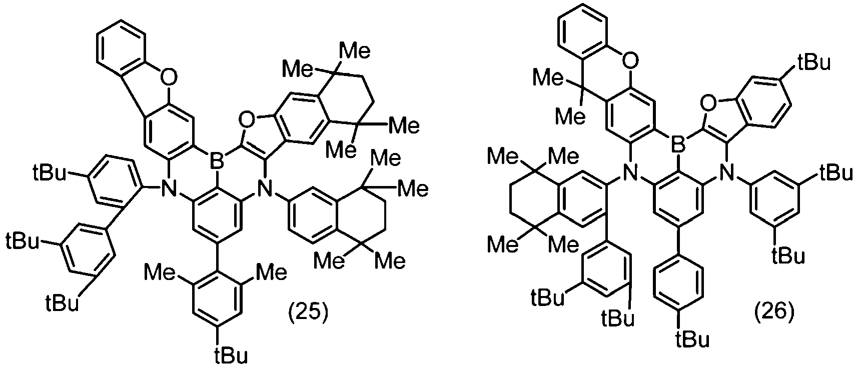

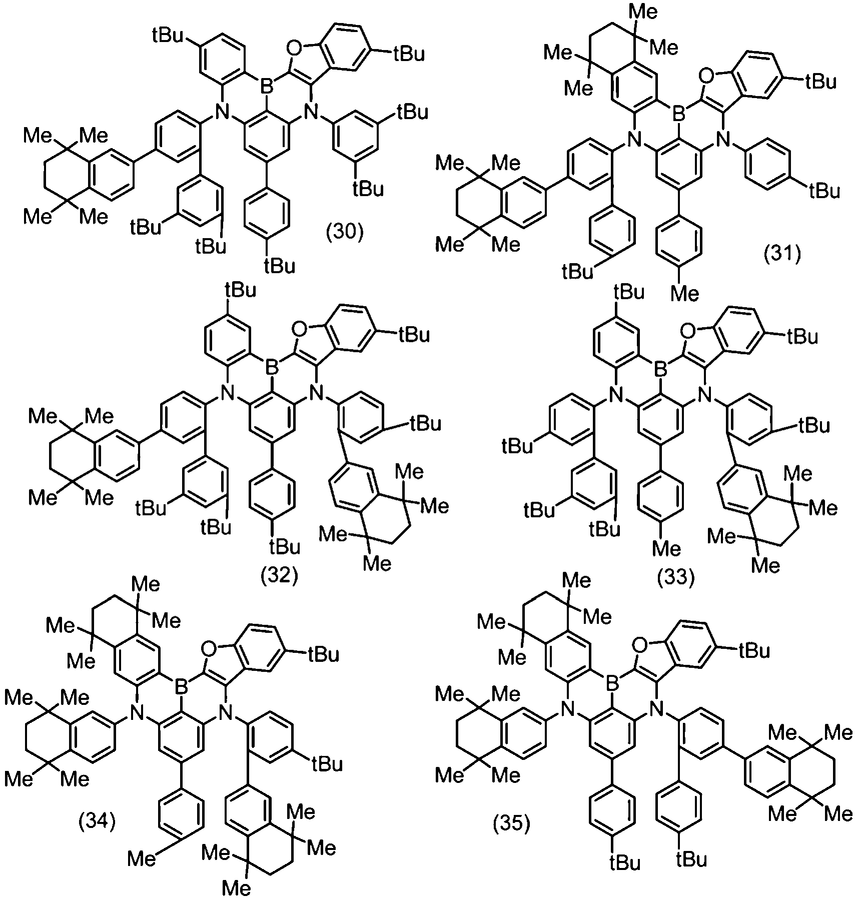

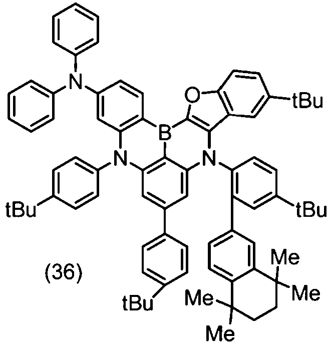

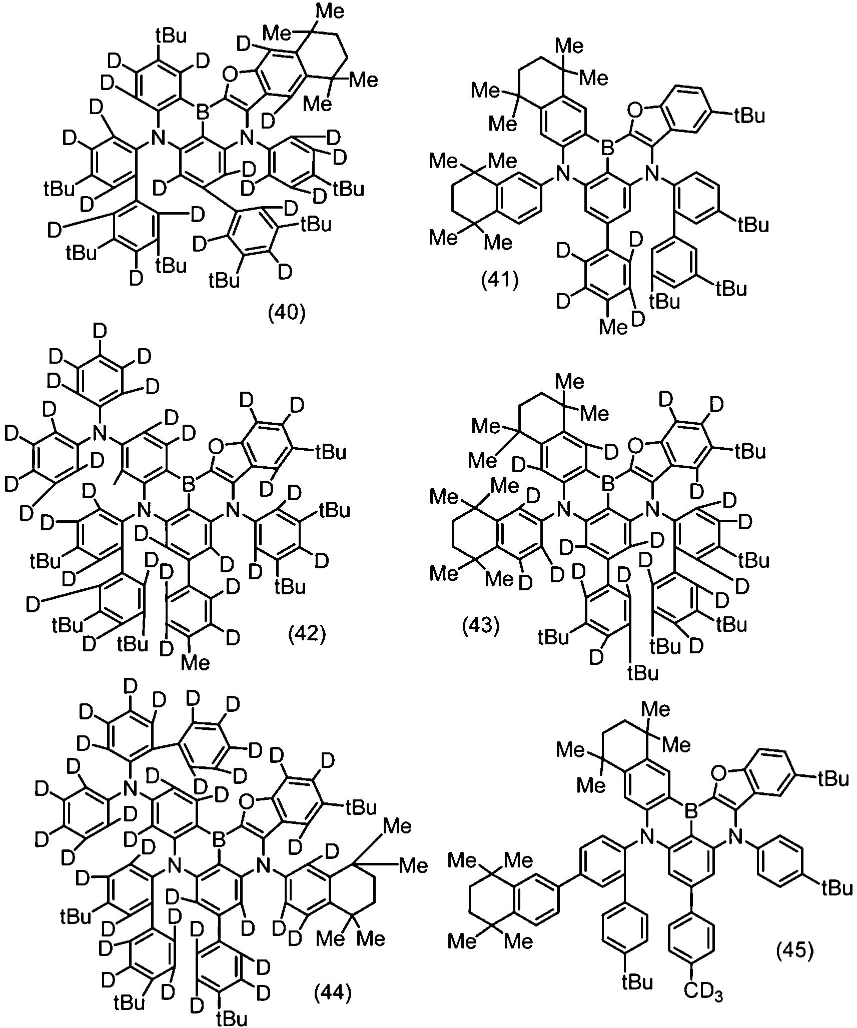

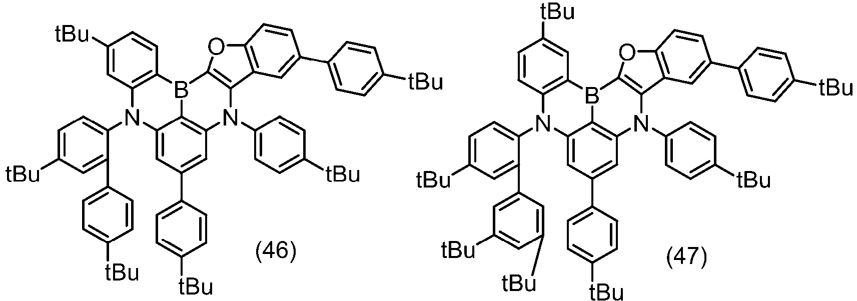

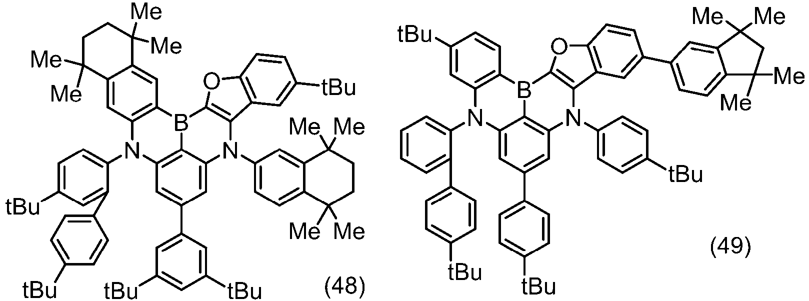

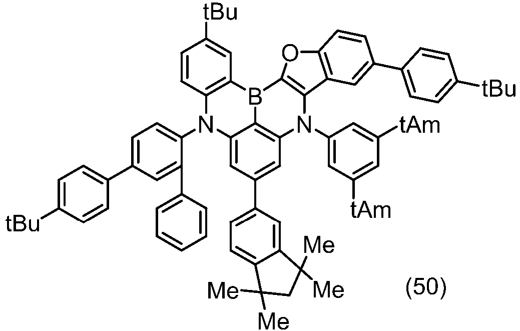

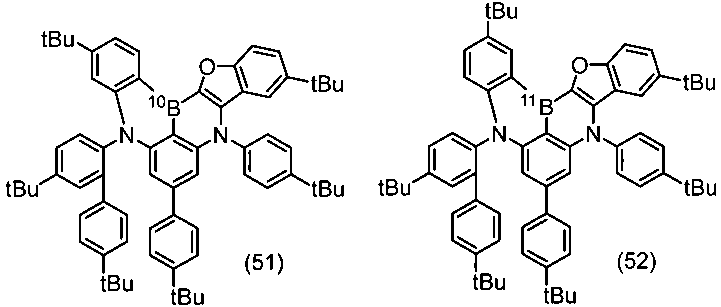

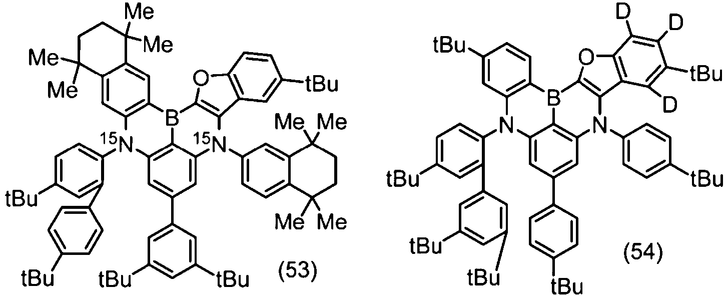

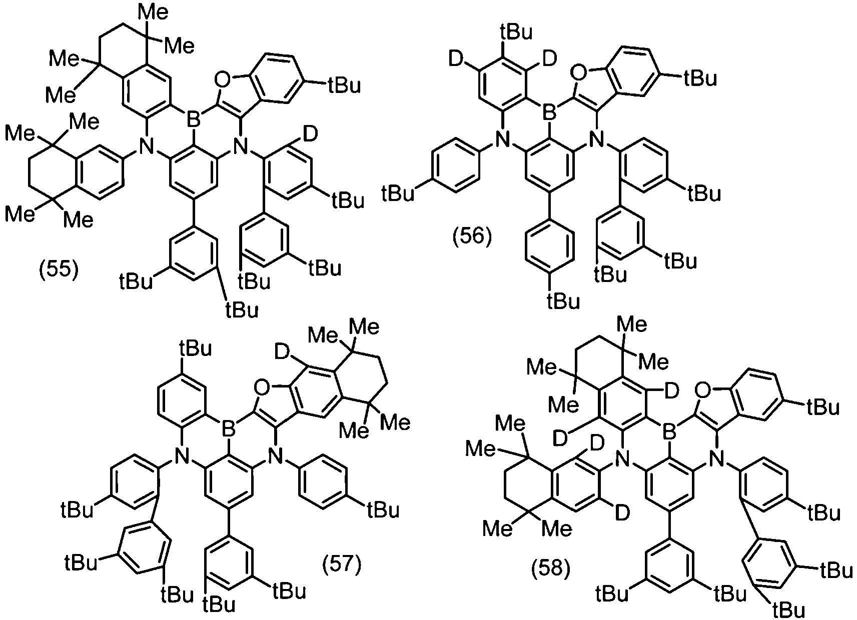

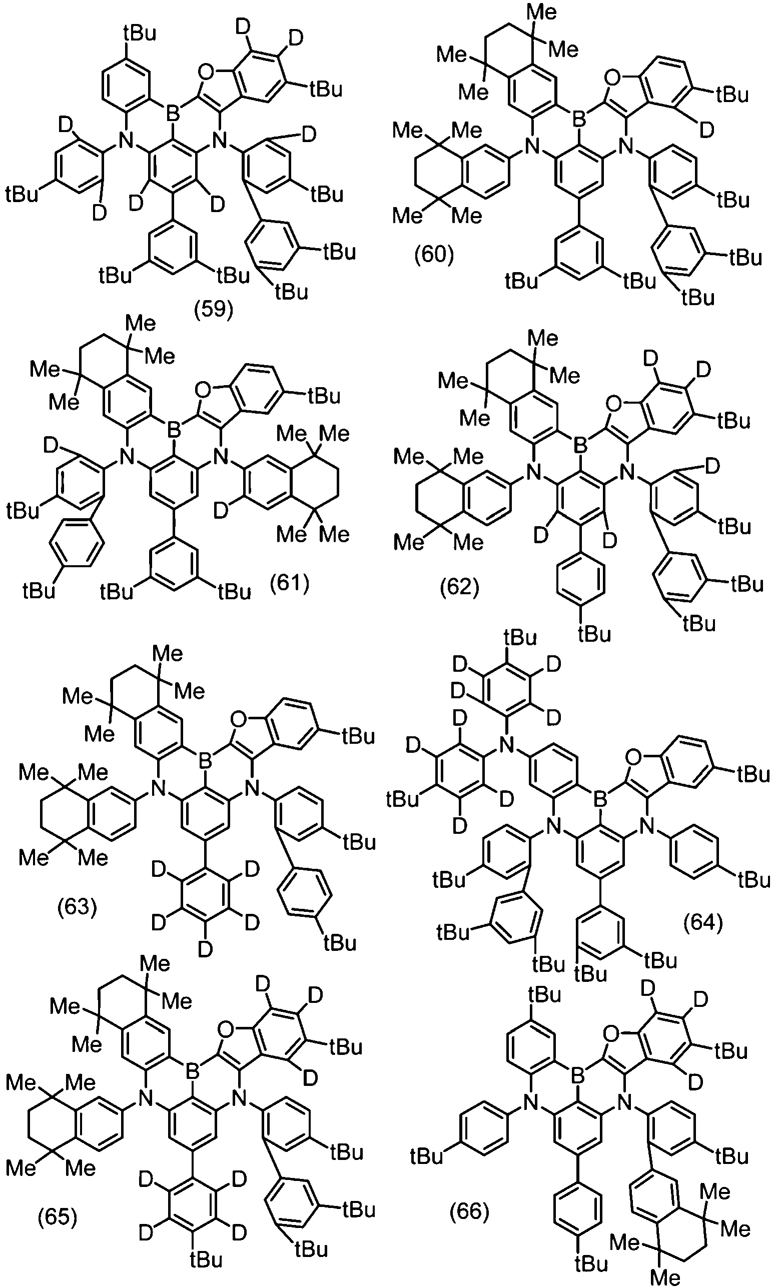

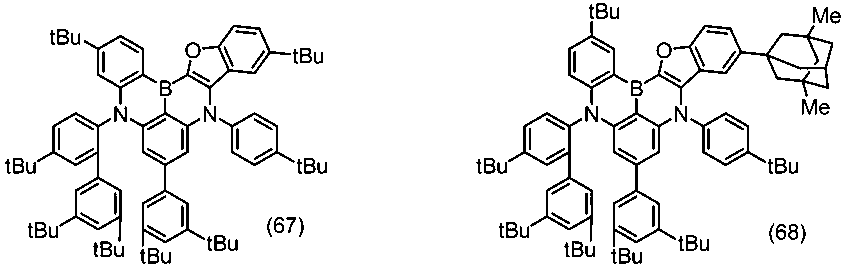

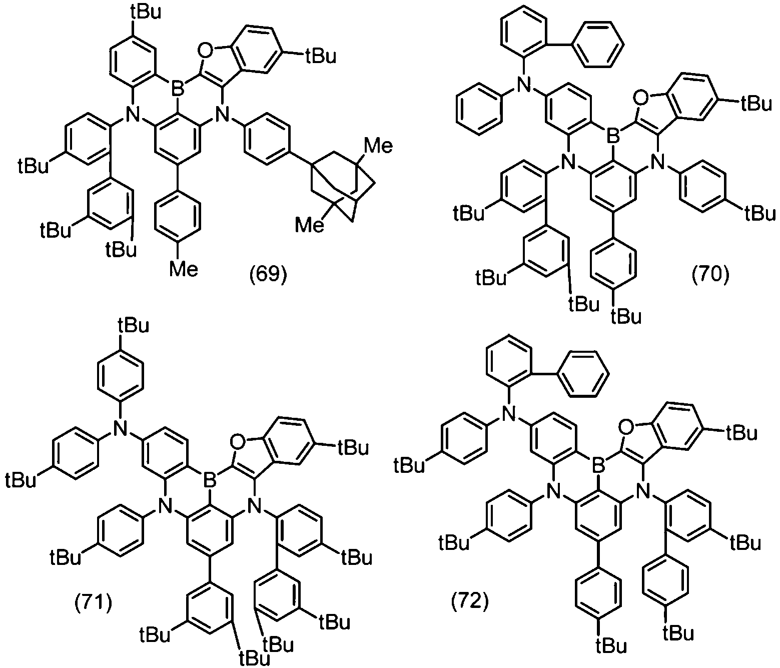

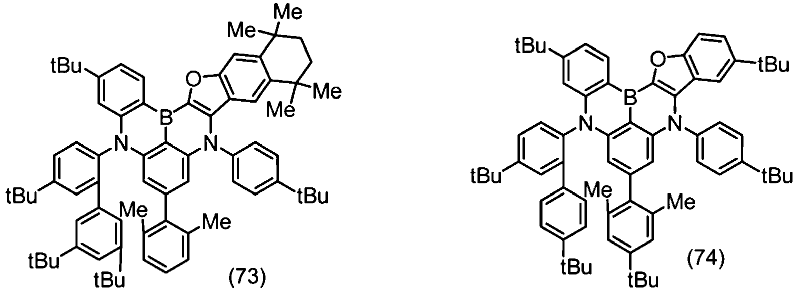

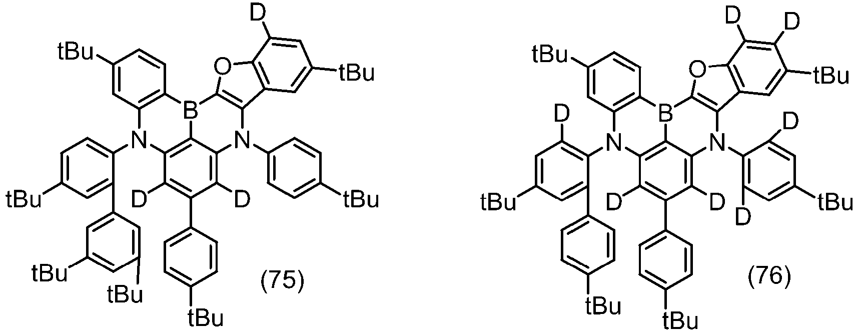

Among those mentioned above, the polycyclic aromatic compound is preferably a compound represented by any one of the formulas (1) to (13), the formula (15), the formula (16), the formula (18), the formulas (21) to (26), the formulas (31) to (35), the formula (40), the formula (41), the formula (45), the formula (52), the formula (55), the formula (57), the formula (59), the formula (60), the formula (64), and the formula (67) to the formula (76).

In one embodiment, the polycyclic aromatic compound is preferably a compound represented by any one of the formula (1) to the formula (4), the formula (6) to the formula (12), the formula (15), the formula (16), the formula (18), the formula (21) to the formula (23), the formula (25), the formula (26), the formula (31) to the formula (34), the formula (40), the formula (41), the formula (46) to the formula (47), the formula (51), the formula (52), the formula (55), the formula (59), the formula (60), and the formula (67) to the formula (76), more preferably a compound represented by any one of the formula (4), the formula (8), the formula (18), the formula (21), the formula (26), the formula (31), the formula (34), the formula (46), the formula (60), and the formula (67) to the formula (76), from the viewpoint of high quantum efficiency.

In one embodiment, the polycyclic aromatic compound is preferably a compound represented by any one of the formula (4) to the formula (12), the formula (16), the formula (18), the formula (22) to the formula (25), the formula (31) to the formula (35), the formula (40), the formula (41), the formula (47), the formula (51), the formula (52), the formula (55), the formula (57), the formula (59), the formula (60), the formula (67), the formula (68), the formula (70), and the formula (72) to the formula (76), more preferably a compound represented by any one of the formula (5), the formula (8), the formula (10) to the formula (12), the formula (18), the formula (23), the formula (32), the formula (34), the formula (35), the formula (40), the formula (41), the formula (51), the formula (52), the formula (55), the formula (57), the formula (59), the formula (60), the formula (75), and the formula (76), from the viewpoint of high device lifetime.

### <Application of polycyclic aromatic compound to polymer>

The polycyclic aromatic compound according to the present invention may be used as a polymer compound obtained by polymerizing a reactive compound thereof substituted by a reactive substituent as a monomer (the monomer for obtaining this polymer compound has a polymerizable substituent), or a cross-linked polymer obtained by further cross-linking the polymer compound (the polymer compound for obtaining this cross-linked polymer has a cross-linkable substituent), or as a pendant type polymer compound obtained by reacting a backbone type polymer with the reactive compound (the reactive compound for obtaining this pendant type polymer compound has a reactive substituent), or a pendant type cross-linked polymer obtained by further cross-linking the pendant type polymer compound (the pendant type polymer compound for obtaining this pendant type cross-linked polymer has a cross-linkable substituent), in a material for an organic device, for example, a material for an organic electroluminescent device, a material for an organic field-effect transistor, a material for an organic photovoltaic, or a wavelength conversion filter.

The reactive substituent mentioned above (including the polymerizable substituent, the cross-linkable substituent, and the reactive substituent for obtaining the pendant type polymer; hereinafter, also simply referred to as a "reactive substituent") is not particularly limited as long as the reactive substituent is a substituent that enables the polycyclic aromatic compound to be polymerized, a substituent that enables the thus-obtained polymer compound to be further cross-linked, or a substituent capable of pendant-reacting with a backbone type polymer. A substituent having any of structures given below is preferred. In each structural formula, * represents a connecting position.

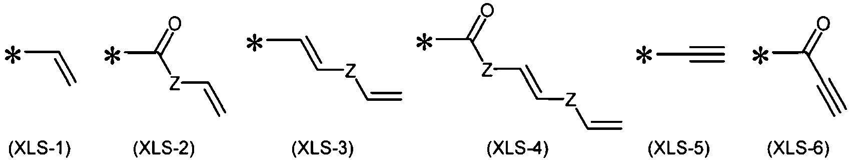

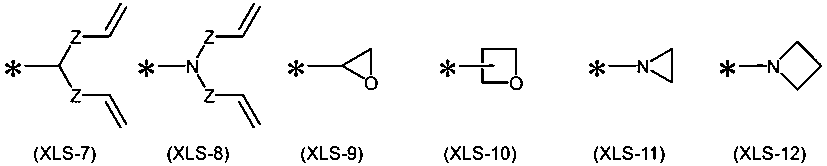

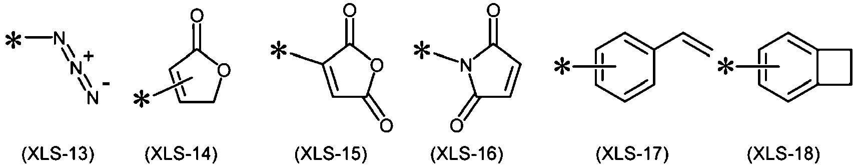

Each Z is independently a single bond, -O-, -S-, >C=O, -O-C(=O)-, alkylene having 1 to 12 carbon atoms, oxyalkylene having 1 to 12 carbon atoms, or polyoxyalkylene having 1 to 12 carbon atoms. Among the substituents, a group represented by the formula (XLS-1), the formula (XLS-2), the formula (XLS-3), the formula (XLS-9), the formula (XLS-10), or the formula (XLS-17) is preferred, and a group represented by the formula (XLS-1), the formula (XLS-3), or the formula (XLS-17) is more preferred.

Such a polymer compound, a cross-linked polymer, a pendant type polymer compound, and a pendant type cross-linked polymer may comprise, as repeat units, at least one compound selected from the group consisting of substituted or unsubstituted triarylamine, substituted or unsubstituted fluorene, substituted or unsubstituted anthracene, substituted or unsubstituted tetracene, substituted or unsubstituted triazine, substituted or unsubstituted carbazole, substituted or unsubstituted tetraphenylsilane, substituted or unsubstituted spirofluorene, substituted or unsubstituted triphenylphosphine, substituted or unsubstituted dibenzothiophene, and substituted or unsubstituted dibenzofuran, in addition to repeat units of the polycyclic aromatic compound according to the present invention.

Examples of the substituent in these repeat units include substituted or unsubstituted aryl, substituted or unsubstituted heteroaryl, substituted or unsubstituted diarylamino (wherein two aryl moieties are optionally bonded to each other via a linking group), substituted or unsubstituted diheteroarylamino (wherein two heteroaryl moieties are optionally bonded to each other via a linking group), substituted or unsubstituted arylheteroarylamino (wherein the aryl and heteroaryl moieties are optionally bonded to each other via a linking group), substituted or unsubstituted diarylboryl (wherein two aryl moieties are optionally bonded to each other via a linking group), substituted or unsubstituted alkyl, substituted or unsubstituted cycloalkyl, substituted or unsubstituted alkoxy, substituted or unsubstituted aryloxy, and substituted silyl (e.g., triarylsilyl, trialkylsilyl, tricycloalkylsilyl, dialkylcycloalkylsilyl, and alkyldicycloalkylsilyl). The description about the polycyclic aromatic compound according to the present invention mentioned above can be cited about details of "aryl" of triarylamine or these substituents.

### 2. Method for producing polycyclic aromatic compound represented by general formula (A-1)

The polycyclic aromatic compound represented by the general formula (A-1) can be produced in accordance with methods described in many known literatures including International Publication No. WO 2015/102118.

Basically, the polycyclic aromatic compound can be produced by first bonding the ring a to the ring b and to the ring c¹ and the ring c² through X¹ and X² to form an intermediate (first reaction) and then bonding the ring a, the ring b, and the ring c¹ and the ring c² through a group containing a central element Y¹ to produce a final product (second reaction). The first reaction can employ general amination reaction such as Buchwald-Hartwig reaction, or general etherification reaction such as nucleophilic substitution reaction or Ullmann reaction. The second reaction can employ tandem hetero Friedel-Crafts reaction (continuous aromatic electrophilic substitution reaction; the same holds true for the description below).

At any stage in such a reaction process, a deuterated, cyanated, or halogenated starting material can be used, or a deuteration, cyanation, or halogenation step can be added, to produce a compound deuterated, cyanated, or halogenated at a desired position.

The second reaction is, as shown in the scheme given below, reaction of introducing a central element Y¹ that connects the ring a, the ring b, and the ring c¹ and the ring c². First, a hydrogen atom between X¹ and X² shown in the structure of the intermediate is subjected to directed ortho metalation with, for example, n-butyllithium, sec-butyllithium, or t-butyllithium. Subsequently, boron trichloride, boron tribromide, or the like is added thereto for lithium-boron transmetalation. Then, a Bronsted base such as N,N-diisopropylethylamine can be added thereto so that tandem bora Friedel-Crafts reaction occurs to obtain a target product. In the second reaction, a Lewis acid such as aluminum trichloride may be added in order to accelerate the reaction.

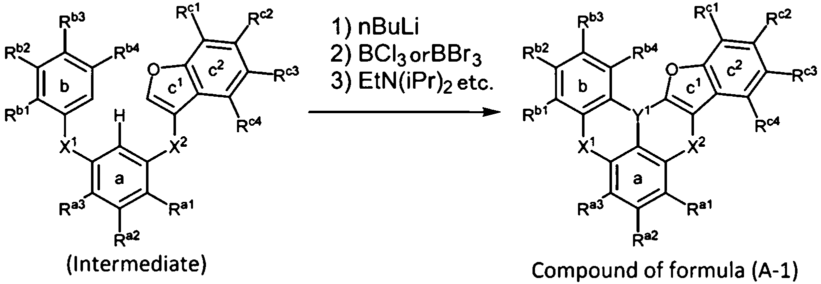

The multimer of such a compound can be produced using a plurality of intermediates having the ring a, the ring b, and the ring c¹ and the ring c². In this case, the amount of a reagent such as butyllithium used can be doubled or tripled to obtain a target product.

Specific examples of the solvent for use in the reaction described above include t-butylbenzene and xylene.

Examples of the directed ortho metalation reagent include alkyllithium such as methyllithium, n-butyllithium, sec-butyllithium, and t-butyllithium, and organic alkali compounds such as lithium diisopropylamide, lithium tetramethylpiperidide, lithium hexamethyldisilazide, and potassium hexamethyldisilazide.

Examples of the metal-Y¹ transmetalation reagent include halide of Y¹ such as trifluoride of Y¹, trichloride of Y¹, tribromide of Y¹, and triiodide of Y¹, aminated halide of Y¹ such as CIPN(NEt₂)₂, alkoxide of Y¹, and aryloxide of Y¹.

Examples of the Bronsted base include N,N-diisopropylethylamine, triethylamine, 2,2,6,6-tetramethylpiperidine, 1,2,2,6,6-pentamethylpiperidine, N,N-dimethylaniline, N,N-dimethyltoluidine, 2,6-lutidine, sodium tetraphenylborate, potassium tetraphenylborate, triphenylborane, tetraphenylsilane, Ar₄BNa, Ar₄BK, Ar₃B, and Ar₄Si (wherein Ar is aryl such as phenyl).

Examples of the Lewis acid include AlCl₃, AlBr₃, AlF₃, BF₃·OEt₂, BCl₃, BBr₃, BI₃, GaCl₃, GaBr₃, InCl₃, InBr₃, In(OTf)₃, SnCl₄, SnBr₄, AgOTf, ScCl₃, Sc(OTf)₃, ZnCl₂, ZnBr₂, Zn(OTf)₂, MgCl₂, MgBr₂, Mg(OTf)₂, LiOTf, NaOTf, KOTf, Me₃SiOTf, Cu(OTf)₂, CuCl₂, YCl₃, Y(OTf)₃, TiCl₄, TiBr₄, ZrCl₄, ZrBr₄, FeCl₃, FeBr₃, CoCl₃, and CoBr₃.

In the scheme, a Bronsted base or a Lewis acid may be used in order to accelerate tandem hetero Friedel-Crafts reaction. However, in the case of using halide of Y¹ such as trifluoride of Y¹, trichloride of Y¹, tribromide of Y¹, or triiodide of Y¹, an acid such as hydrogen fluoride, hydrogen chloride, hydrogen bromide, or hydrogen iodide is generated as aromatic electrophilic substitution reaction progresses. Therefore, a Bronsted base that scavenges the acid is effectively used. On the other hand, in the case of using aminated halide of Y¹ or alkoxide of Y¹, amine or an alcohol is generated as aromatic electrophilic substitution reaction progresses. Therefore, in many cases, it is not necessary to use the Bronsted base. Since the ability to eliminate an amino group or an alkoxy group is low, a Lewis acid is effectively used for promoting the elimination.

### 3. Organic device

In chemical structural formulas listed in this and subsequent paragraphs, "Me" represents a methyl group, and "tBu" represents a t-butyl group.

The polycyclic aromatic compound according to the present invention can be used as a material for an organic device. Examples of the organic device include organic electroluminescent devices, organic field-effect transistors, organic photovoltaics, and wavelength conversion filters.

### 3-1. Organic electroluminescent device

The polycyclic aromatic compound according to the present invention can be used as, for example, a material for an organic electroluminescent device. Hereinafter, the organic EL device according to the present embodiment will be described in detail with reference to the drawing. Fig. 1 is a schematic cross-sectional view showing the organic EL device according to the present embodiment.

### <Structure of organic electroluminescent device>

An organic EL device 100 shown in Fig. 1 has a substrate 101, a positive electrode 102 disposed on the substrate 101, a hole injection layer 103 disposed on the positive electrode 102, a hole transport layer 104 disposed on the hole injection layer 103, a luminescent layer 105 disposed on the hole transport layer 104, an electron transport layer 106 disposed on the luminescent layer 105, an electron injection layer 107 disposed on the electron transport layer 106, and a negative electrode 108 disposed on the electron injection layer 107.

The organic EL device 100 may be configured to have a substrate 101, a negative electrode 108 disposed on the substrate 101, an electron injection layer 107 disposed on the negative electrode 108, an electron transport layer 106 disposed on the electron injection layer 107, a luminescent layer 105 disposed on the electron transport layer 106, a hole transport layer 104 disposed on the luminescent layer 105, a hole injection layer 103 disposed on the hole transport layer 104, and a positive electrode 102 disposed on the hole injection layer 103 by reversing the order of preparation.

Not all the layers described above are essential. The organic EL device may be configured to have a minimum constituent unit composed of the positive electrode 102, the luminescent layer 105, and the negative electrode 108, and the hole injection layer 103, the hole transport layer 104, the electron transport layer 106, and the electron injection layer 107 are optionally established layers. Each of the layers described above may consist of a single layer or may consist of multiple layers.

The form of the layers constituting the organic EL device may be the configuration mode "substrate/positive electrode/hole injection layer/hole transport layer/luminescent layer/electron transport layer/electron injection layer/negative electrode" mentioned above as well as a configuration mode "substrate/positive electrode/hole transport layer/luminescent layer/electron transport layer/electron injection layer/negative electrode", "substrate/positive electrode/hole injection layer/luminescent layer/electron transport layer/electron injection layer/negative electrode", "substrate/positive electrode/hole injection layer/hole transport layer/luminescent layer/electron injection layer/negative electrode", "substrate/positive electrode/hole injection layer/hole transport layer/luminescent layer/electron transport layer/negative electrode", "substrate/positive electrode/luminescent layer/electron transport layer/electron injection layer/negative electrode", "substrate/positive electrode/hole transport layer/luminescent layer/electron injection layer/negative electrode", "substrate/positive electrode/hole transport layer/luminescent layer/electron transport layer/negative electrode", "substrate/positive electrode/hole injection layer/luminescent layer/electron injection layer/negative electrode", "substrate/positive electrode/hole injection layer/luminescent layer/electron transport layer/negative electrode", "substrate/positive electrode/luminescent layer/electron transport layer/negative electrode", or "substrate/positive electrode/luminescent layer/electron injection layer/negative electrode".

### <Substrate in organic electroluminescent device>

The substrate 101 is a support of the organic EL device 100, and quartz, glass, a metal, a plastic, or the like is usually used. The substrate 101 is formed into a plate, a film, or a sheet depending on a purpose. For example, a glass plate, a metal plate, metal foil, a plastic film, or a plastic sheet is used. Among them, a glass plate or a transparent plate made of a synthetic resin such as polyester, polymethacrylate, polycarbonate, or polysulfone is preferred. Soda lime glass, alkali-free glass, or the like is used as a glass substrate, and its thickness can also be a thickness sufficient for maintaining mechanical strength and can therefore be 0.2 mm or larger. The upper limit value of the thickness is, for example, 2 mm or smaller, preferably 1 mm or smaller. Alkali-free glass is more preferred because a material of the glass allows a smaller amount of ions to be eluted from the glass. Soda lime glass having a barrier coat of SiO₂ or the like is also commercially available and can therefore be used. The substrate 101 may be provided with a gas barrier membrane such as a dense silicon oxide membrane at least on one side in order to enhance gas barrier properties. Particularly, in the case of using a low-gas barrier plate, film, or sheet made of a synthetic resin as the substrate 101, it is preferred to establish a gas barrier membrane.

### <Positive electrode in organic electroluminescent device>

The positive electrode 102 plays a role in injecting holes to the luminescent layer 105. When at least one of the hole injection layer 103 and the hole transport layer 104 is disposed between the positive electrode 102 and the luminescent layer 105, the positive electrode injects holes to the luminescent layer 105 via such a layer.

Examples of the material that forms the positive electrode 102 include inorganic compounds and organic compounds. Examples of the inorganic compound include metals (aluminum, gold, silver, nickel, palladium, chromium, etc.), metal oxides (indium oxide, tin oxide, indium-tin oxide (ITO), indium-zinc oxide (IZO), etc.), metal halides (copper iodide, etc.), copper sulfide, carbon black, ITO glass, and NESA glass. Examples of the organic compound include polythiophene such as poly(3-methylthiophene), and conductive polymers such as polypyrrole and polyaniline. In addition, the material can be appropriately selected, for use, from among substances for use as positive electrodes for organic EL devices.

The resistance of a transparent electrode is not limited as long as current sufficient for the luminescence of the luminescent device can be supplied. Low resistance is desirable from the viewpoint of the power consumption of the luminescent device. For example, an ITO substrate of 300 Ω/sq or less functions as a device electrode. For example, a low resistant product of 100 to 5 Ω/sq, preferably 50 to 5 Ω/sq, is particularly desirably used because a substrate on the order of 10 Ω/sq can be supplied at present. The thickness of ITO can be arbitrarily selected depending on a resistance value and is often used at 50 to 300 nm.

### <Hole injection layer and hole transport layer in organic electroluminescent device>

The hole injection layer 103 plays a role in efficiently injecting holes transferred from the positive electrode 102 into the luminescent layer 105 or into the hole transport layer 104. The hole transport layer 104 plays a role in efficiently transporting holes injected from the positive electrode 102 or holes injected from the positive electrode 102 via the hole injection layer 103 to the luminescent layer 105. Each of the hole injection layer 103 and the hole transport layer 104 is formed by laminating and mixing one or two or more hole injection or transport materials or from a mixture of a hole injection or transport material and a polymer binder. Alternatively, the layer may be formed by adding an inorganic salt such as iron(III) chloride to a hole injection or transport material.

A hole-injecting or -transporting substance is required to efficiently inject or transport holes from the positive electrode between the electrodes given an electric field. High hole injection efficiency and efficient transport of injected holes are desirable. For this purpose, the substance preferably has a small ionization potential and a large hole mobility, is excellent in stability, and is unlikely to generate trapping impurities during production and during use.

The material that forms the hole injection layer 103 and the hole transport layer 104 (hole transport material) can be used by selecting an arbitrary compound from among conventional compounds commonly used as charge transport materials of holes in photoconductive materials, and known compounds for use in hole injection layers and hole transport layers in p type semiconductors and organic EL devices. In the present invention, the polycyclic aromatic compound represented by the formula (A-1) can be used as this hole transport material.

Specific examples thereof include heterocyclic compounds such as, carbazole derivatives (N-phenylcarbazole, polyvinylcarbazole, etc.), biscarbazole derivatives such as bis(N-arylcarbazole) and bis(N-alkylcarbazole), triarylamine derivatives (polymers having aromatic tertiary amino in the backbone or a side chain, 1,1-bis(4-di-p-tolylaminophenyl)cyclohexane, N,N'-diphenyl-N,N'-di(3-methylphenyl)-4,4'-diaminobiphenyl, N,N'-diphenyl-N,N'-dinaphthyl-4,4'-diaminobiphenyl, N,N'-diphenyl-N,N'-di(3-methylphenyl)-4,4'-diphenyl-1,1'-diamine, N,N'-dinaphthyl-N,N'-diphenyl-4,4'-diphenyl-1,1'-diamine, N⁴,N^{4'}-diphenyl- N⁴,N^{4'}-bis(9-phenyl-9H-carbazole-3-yl)-[1,1'-biphenyl]-4,4'-diamine, N⁴,N⁴,N^{4'},N^{4'}-tetra([1,1'-biphenyl]-4-yl)-[1,1'-biphenyl]-4,4'-diamine, triphenylamine derivatives such as 4,4',4"-tris(3-methylphenyl(phenyl)amino)triphenylamine, starburst amine derivatives, etc.), stilbene derivatives, phthalocyanine derivatives (metal-free or copper phthalocyanine, etc.), pyrazoline derivatives, hydrazone compounds, benzofuran derivatives, thiophene derivatives, oxadiazole derivatives, quinoxaline derivatives (e.g., 1,4,5,8,9,12-hexaazatriphenylene-2,3,6,7,10,11-hexacarbonitrile, etc.), porphyrin derivatives, and polysilane. For example, polycarbonate, styrene derivatives, polyvinylcarbazole, and polysilane having the monomer in a side chain are preferred for a polymer system. Any compound can be used without particular limitations as long as the compound forms a thin film necessary for the preparation of the luminescent device, can inject holes from the positive electrode, and can further transport the holes.

The conductivity of an organic semiconductor is known to be strongly influenced by the doping thereof. Such an organic semiconductor matrix substance is constituted by a favorably electron-donating compound or a favorably electron-accepting compound. A strong electron acceptor such as tetracyanoquinonedimethane (TCNQ) or 2,3,5,6-tetrafluorotetracyano-1,4-benzoquinonedimethane (F4TCNQ) is known for the doping of an electron-donating substance (see, for example, the literature "M. Pfeiffer, A. Beyer, T. Fritz, K. Leo, Appl. Phys. Lett., 73 (22), 3202-3204 (1998)" and the literature "J. Blochwitz, M. Pheiffer, T. Fritz, K. Leo, Appl. Phys. Lett., 73 (6), 729-731 (1998)"). Such a substance generates so-called holes by an electron transfer process for electron-donating base substances (hole transport substances). The conductivity of the base substance largely varies depending on the number and mobility of holes. For example, a benzidine derivative (TPD, etc.), a starburst amine derivative (TDATA, etc.), or specific metal phthalocyanine (particularly, zinc phthalocyanine (ZnPc), etc.) is known as a matrix substance having hole transport characteristics (Japanese Patent Laid-Open No. 2005-167175).

The material for the hole injection layer and the material for the hole transport layer mentioned above can also be used in the forms of a polymer compound obtained by polymerizing a reactive compound thereof substituted by a reactive substituent as a monomer, or its cross-linked polymer, or a pendant type polymer compound obtained by reacting a backbone type polymer with the reactive compound, or its pendant type cross-linked polymer, as materials for the hole layers. In this case, the description about the polycyclic aromatic compound represented by the formula (A-1) mentioned above can be cited about the reactive substituent.

### <Luminescent layer in organic electroluminescent device>

The luminescent layer 105 is a layer that emits light by recombining holes injected from the positive electrode 102 and electrons injected from the negative electrode 108 between the electrodes given an electric field. The material that forms the luminescent layer 105 can be a compound that emits light when excited by the recombination of holes and electrons (luminescent compound). The compound can preferably form a stable thin film shape and exhibits strong luminescence (fluorescence) efficiency in a solid state. In the present invention, the polycyclic aromatic compound represented by the formula (A-1) can be used as this material for the luminescent layer.

The luminescent layer may consist of a single layer or multiple layers, and each layer is formed from the material for the luminescent layer (host material and dopant material). One type each of host material and dopant material may be used, or a plurality of host materials or dopant materials may be combined. The host material may be mixed with a material for the hole transport layer or a material for the electron transport layer or a combination thereof. The dopant material may be contained in the whole or a portion of the host material. As for a doping method, the dopant material can be formed by a co-evaporation method with the host material. The dopant material may be mixed in advance with the host material and deposited at the same time, or may be mixed in advance with the host material, together with an organic solvent, followed by film formation by a wet film formation method. In the case of combining a plurality of dopants, specific examples of a dopant to be combined with the compound of the present invention will be shown below.

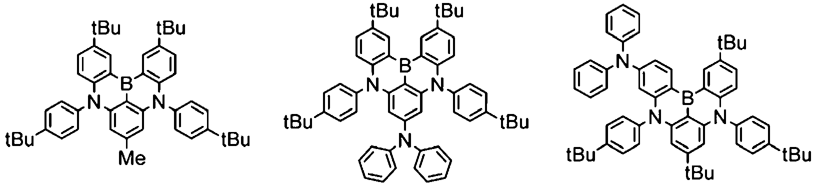

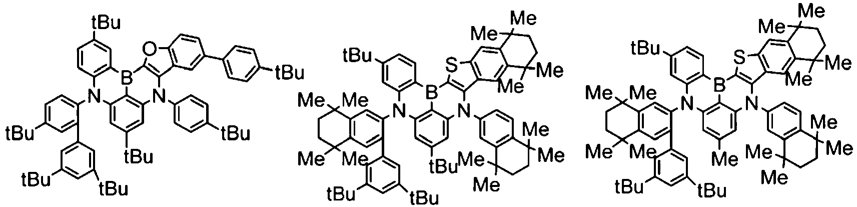

The amount of the host material used differs depending on the type of the host material and can be determined according to the characteristics of the host material. The amount of the host material used, as a guideline, is preferably 50 to 99.999% by weight, more preferably 80 to 99.95% by weight, further preferably 90 to 99.9% by weight, of the whole material for the luminescent layer.

The amount of the dopant material used differs depending on the type of the dopant material and can be determined according to the characteristics of the dopant material. The amount of the dopant used, as a guideline, is preferably 0.001 to 50% by weight, more preferably 0.05 to 20% by weight, further preferably 0.1 to 10% by weight, of the whole material for the luminescent layer. The amount that falls within the above range is preferred, for example, because a concentration quenching phenomenon can be prevented. A portion or the whole of hydrogen atoms in the dopant material is also preferably deuterated from the viewpoint of durability.

On the other hand, in an organic EL device using a thermally activated delayed fluorescence dopant material, the amount of the dopant material used is preferably a lower concentration because a concentration quenching phenomenon can be prevented, and is preferably a higher concentration in view of the efficiency of a thermally activated delayed fluorescence mechanism. In an organic EL device using a thermally activated delayed fluorescence assistant dopant material, the amount of the dopant material used is preferably a lower concentration than that of the amount of the assistant dopant material used in view of the efficiency of the thermally activated delayed fluorescence mechanism of the assistant dopant material. The polycyclic aromatic compound of the present invention can be used as a dopant (emitting dopant) in an organic EL device using a thermally activated delayed fluorescence assistant dopant material.

In the case of using an assistant dopant material, the amounts of the host material, the assistant dopant material, and the dopant material used, as a guideline, are 40 to 99.999% by weight, 59 to 1% by weight, and 20 to 0.001% by weight, preferably 60 to 99.99% by weight, 39 to 5% by weight, and 10 to 0.01% by weight, more preferably 70 to 99.95% by weight, 29 to 10% by weight, and 5 to 0.05% by weight, respectively, of the whole material for the luminescent layer.

Examples of the host material include condensed ring derivatives such as anthracene, pyrene, dibenzochrysene, and fluorene, bisstyryl derivatives such as bisstyrylanthracene derivatives and distyrylbenzene derivatives, tetraphenylbutadiene derivatives, and cyclopentadiene derivatives, which have heretofore been known as luminescent materials. Particularly, an anthracene compound, a fluorene compound, or a dibenzochrysene compound is preferred. A portion or the whole of hydrogen atoms in the host material is also preferably deuterated from the viewpoint of durability. The luminescent layer is also preferably constituted by a host compound with a portion or the whole of hydrogen atoms deuterated and a dopant compound with a portion or the whole of hydrogen atoms deuterated in combination.

The triplet energy of the host material is preferably higher than that of a dopant or an assistant dopant having the highest triplet energy in the luminescent layer from the viewpoint of promoting the occurrence of TADF in the luminescent layer without inhibition. Specifically, the triplet energy of the host material is preferably 0.01 eV or more, more preferably 0.03 eV or more, further preferably 0.1 eV or more. A TADF-active compound may be used as the host material.

Examples of the host material include a compound represented by the general formula (H1) given below, a compound represented by the general formula (H2) given below, a compound represented by the general formula (H3) given below, a compound comprising a structure represented by the general formula (H4) given below, a compound represented by the general formula (H5) given below, a compound represented by the general formula (H6) given below, TADF materials (e.g., a compound of the general formula (H7) mentioned later), a compound represented by the general formula (H8) given below, fluorene compounds, and dibenzochrysene compounds. A compound represented by the general formula (H1) is preferred.

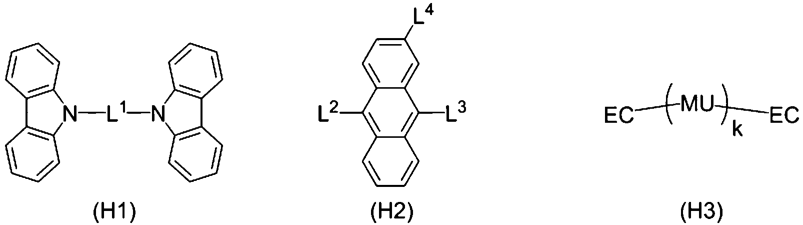

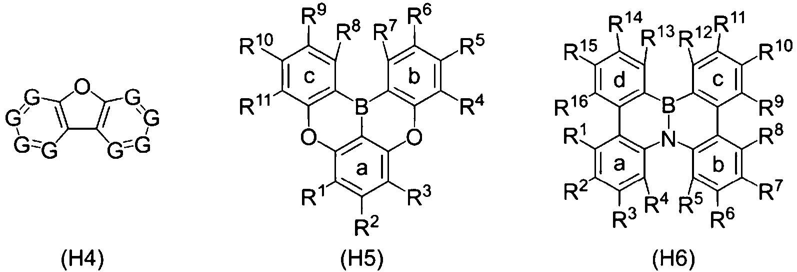

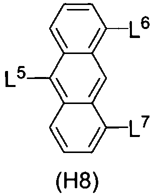

### <Compound represented by general formula (H1)>

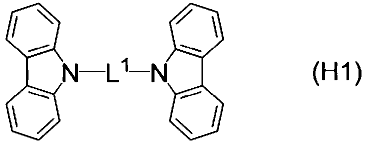

In the formula (H1), L¹ is arylene having 6 to 30 carbon atoms or heteroarylene having 2 to 30 carbon atoms, preferably arylene having 6 to 24 carbon atoms, more preferably arylene having 6 to 16 carbon atoms, further preferably arylene having 6 to 12 carbon atoms, particularly preferably arylene having 6 to 10 carbon atoms, and preferably heteroarylene having 2 to 25 carbon atoms, more preferably heteroarylene having 2 to 20 carbon atoms, further preferably heteroarylene having 2 to 15 carbon atoms, particularly preferably heteroarylene having 2 to 10 carbon atoms. Specific examples of the arylene include divalent groups such as a benzene ring, a biphenyl ring, a naphthalene ring, a terphenyl ring, an acenaphthylene ring, a fluorene ring, a phenalene ring, a phenanthrene ring, a triphenylene ring, a pyrene ring, a naphthacene ring, a perylene ring, and a pentacene ring. Specific examples of the heteroarylene include divalent groups such as a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, a phenazasiline ring, an indolizine ring, a furan ring, a benzofuran ring, an isobenzofuran ring, a dibenzofuran ring, a thiophene ring, a benzothiophene ring, a dibenzothiophene ring, a furazan ring, a thianthrene ring, an indolocarbazole ring, a benzindolocarbazole ring, a benzobenzindolocarbazole ring, and a naphthobenzofuran ring.

At least one hydrogen atom in the compound represented by the formula (H1) is optionally replaced with alkyl having 1 to 6 carbon atoms, cycloalkyl having 3 to 14 carbon atoms, cyano, halogen, or deuterium.

### <Compound represented by general formula (H2)>

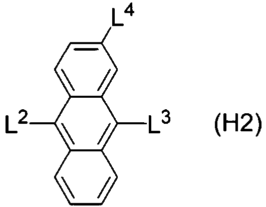

In the formula (H2), L² and L³ are each independently aryl having 6 to 30 carbon atoms or heteroaryl having 2 to 30 carbon atoms, and L⁴ is hydrogen, aryl having 6 to 30 carbon atoms, or heteroaryl having 2 to 30 carbon atoms. The aryl is preferably aryl having 6 to 24 carbon atoms, more preferably aryl having 6 to 16 carbon atoms, further preferably aryl having 6 to 12 carbon atoms, particularly preferably aryl having 6 to 10 carbon atoms. Specific examples thereof include monovalent groups such as a benzene ring, a biphenyl ring, a naphthalene ring, a terphenyl ring, an acenaphthylene ring, a fluorene ring, a phenalene ring, a phenanthrene ring, a triphenylene ring, a pyrene ring, a naphthacene ring, a perylene ring, and a pentacene ring. The heteroaryl is preferably heteroaryl having 2 to 25 carbon atoms, more preferably heteroaryl having 2 to 20 carbon atoms, further preferably heteroaryl having 2 to 15 carbon atoms, particularly preferably heteroaryl having 2 to 10 carbon atoms. Specific examples thereof include monovalent groups such as a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, a phenazasiline ring, an indolizine ring, a furan ring, a benzofuran ring, an isobenzofuran ring, a dibenzofuran ring, a thiophene ring, a benzothiophene ring, a dibenzothiophene ring, a furazan ring, a thianthrene ring, an indolocarbazole ring, a benzindolocarbazole ring, a benzobenzindolocarbazole ring, and a naphthobenzofuran ring.

At least one hydrogen atom in the compound represented by the formula (H2) is optionally replaced with alkyl having 1 to 6 carbon atoms, cycloalkyl having 3 to 14 carbon atoms, cyano, halogen, or deuterium.

Specific examples of the anthracene compound represented by the general formula (H2) include compounds represented by the formula (3-131-Y) to the formula (3-182-Y), and compounds represented by the formula (3-183-N), the formula (3-184-Y) to the formula (3-284-Y), and the formula (3-500) to the formula (3-557). Hydrogen atoms in these formulas may be partially or wholly replaced with deuterium. Particularly preferred modes of replacement with deuterium are individually listed. Y in the formulas may be -O-, -S-, >N-R^{X1} (wherein R^{X1} is aryl optionally substituted by alkyl, or alkyl), or >C(R^{X2})₂ (wherein R^{X2} is optionally linked aryl, or alkyl). As for a formula number, the formula (3-131-Y) is defined as the formula (3-131-O) when Y is, for example, O, and as the formula (3-131-S) and the formula (3-131-N) when Y is -S- and >N-R²⁹, respectively.

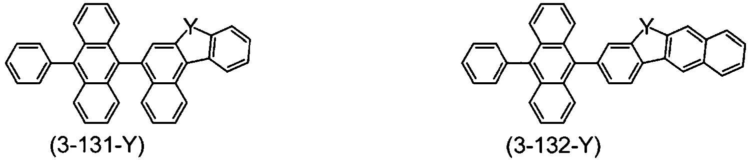

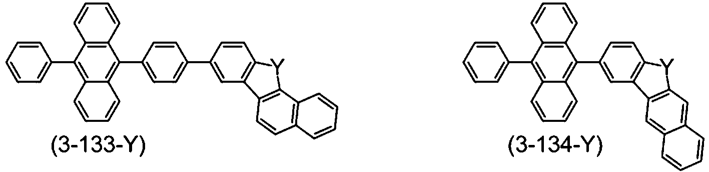

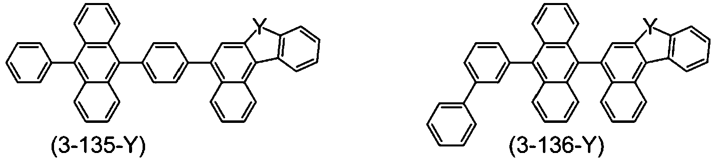

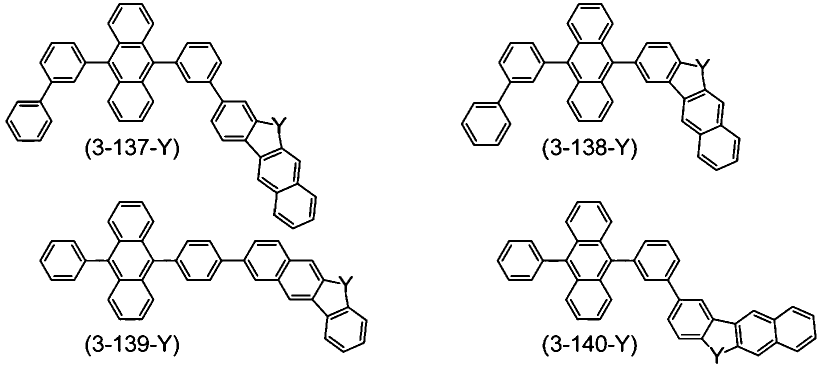

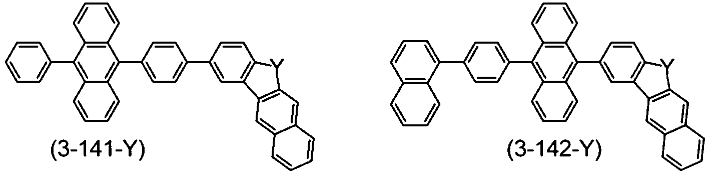

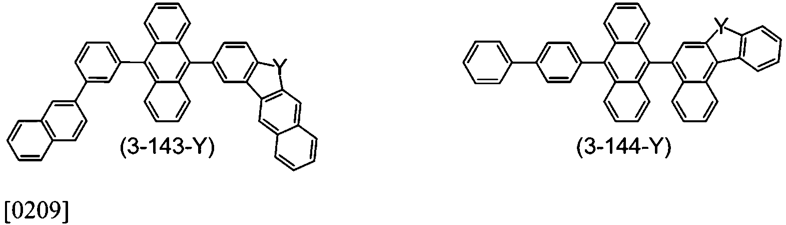

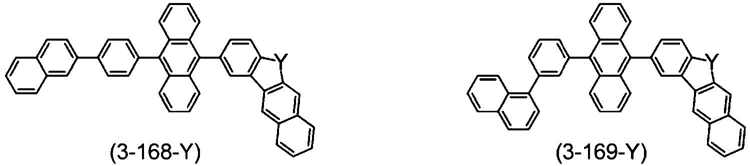

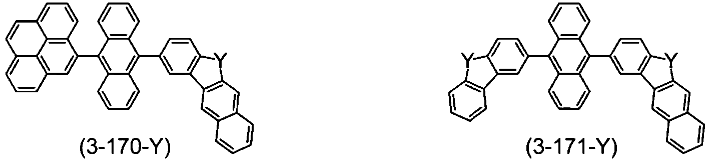

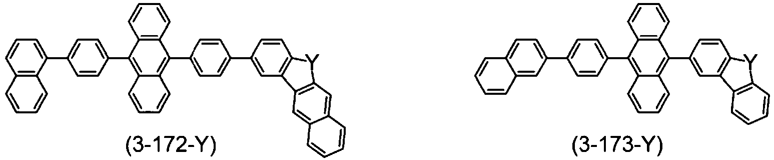

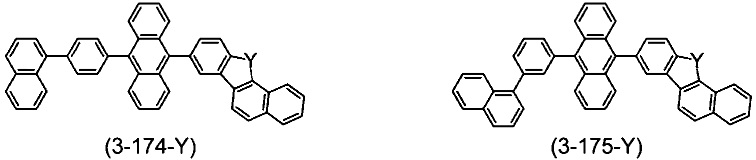

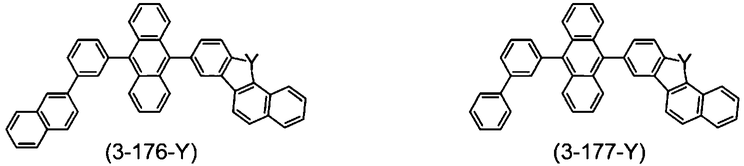

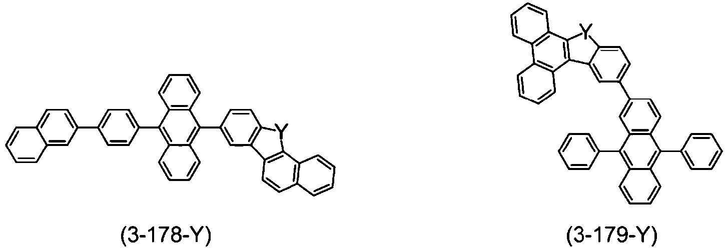

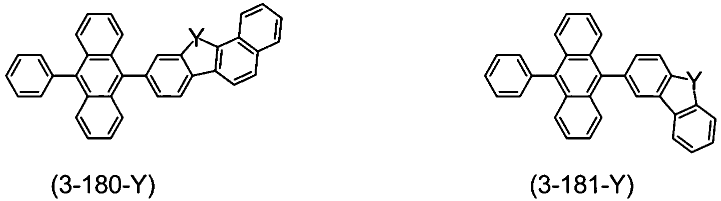

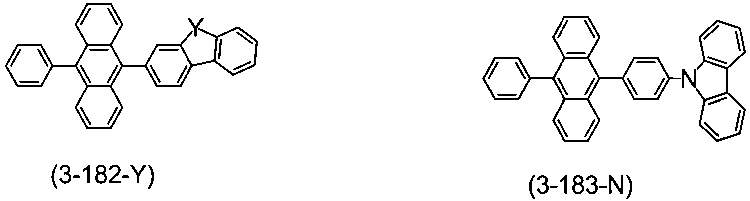

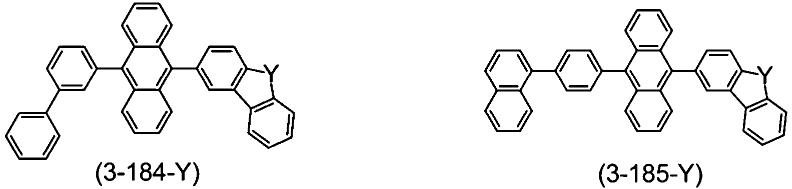

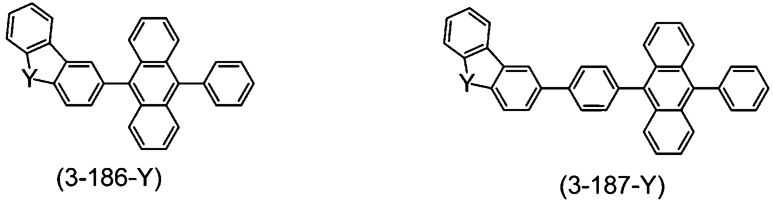

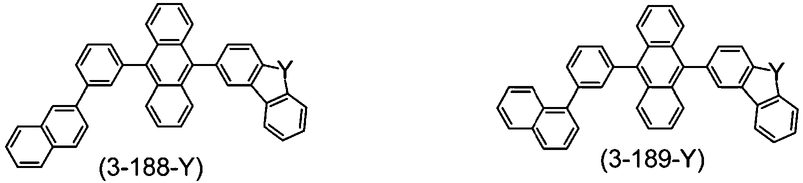

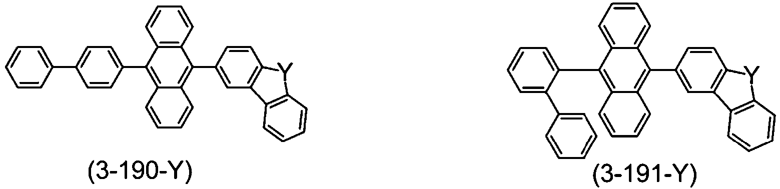

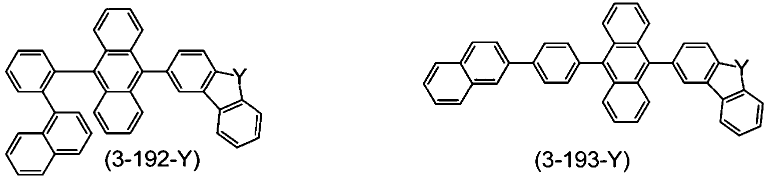

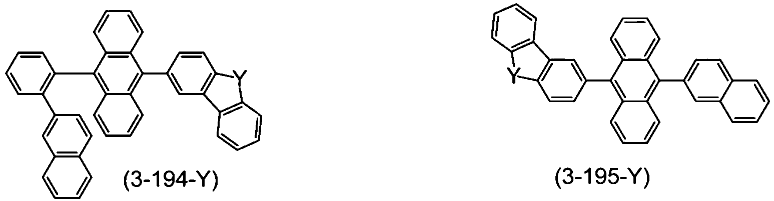

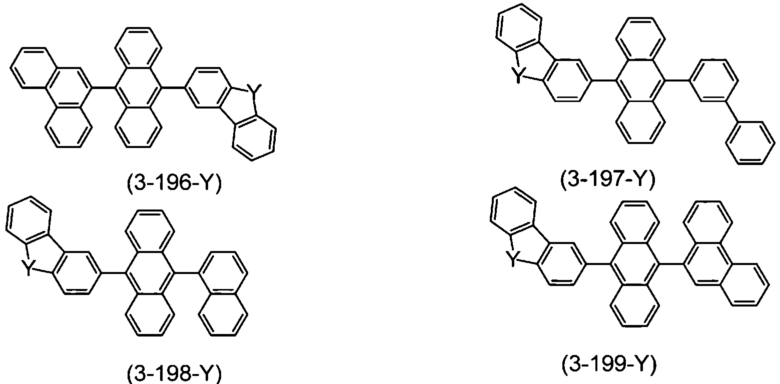

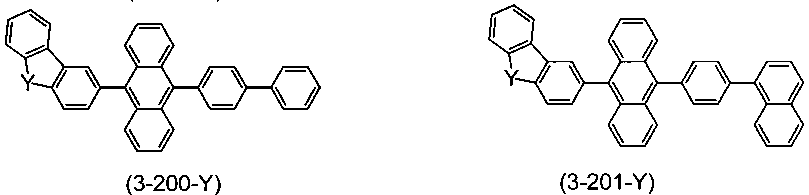

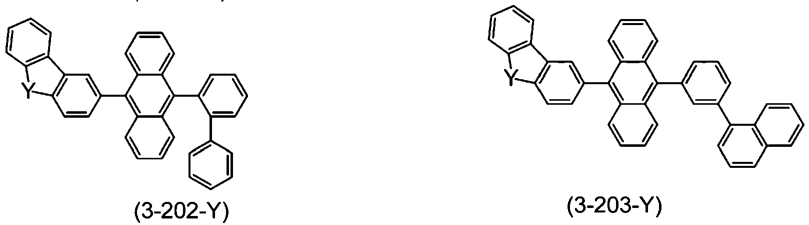

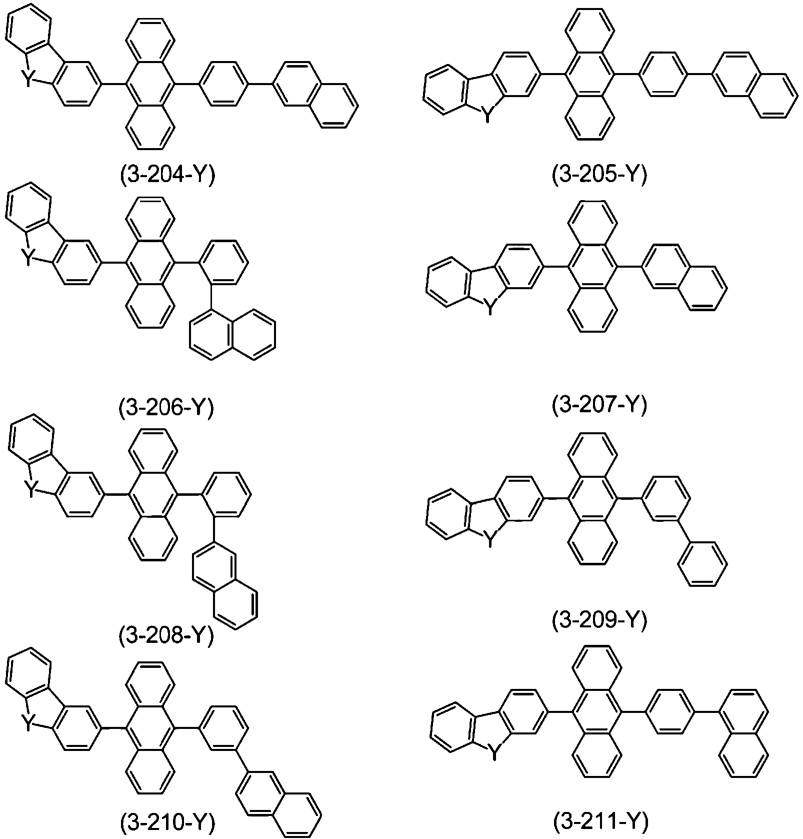

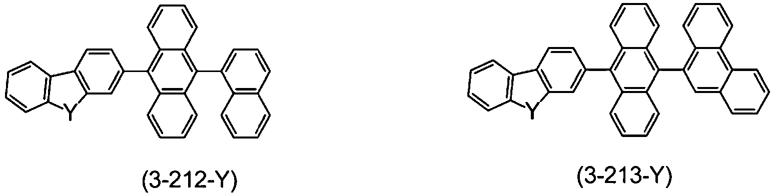

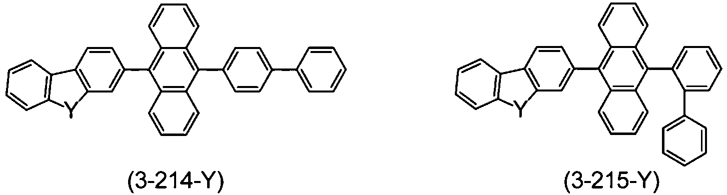

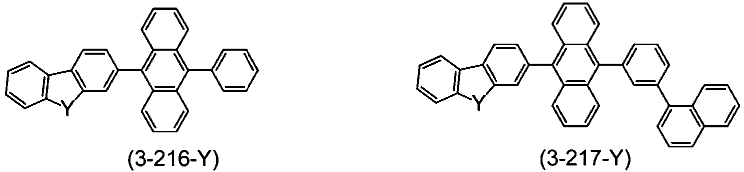

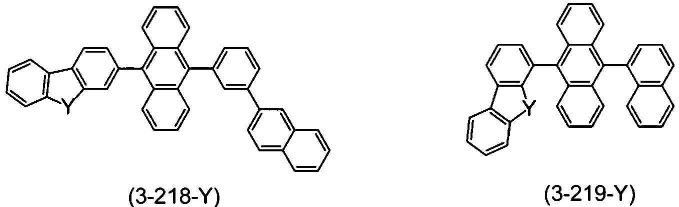

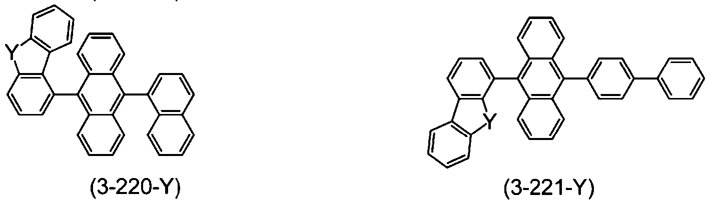

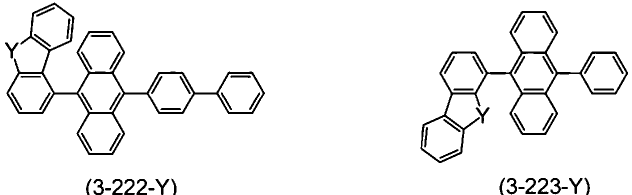

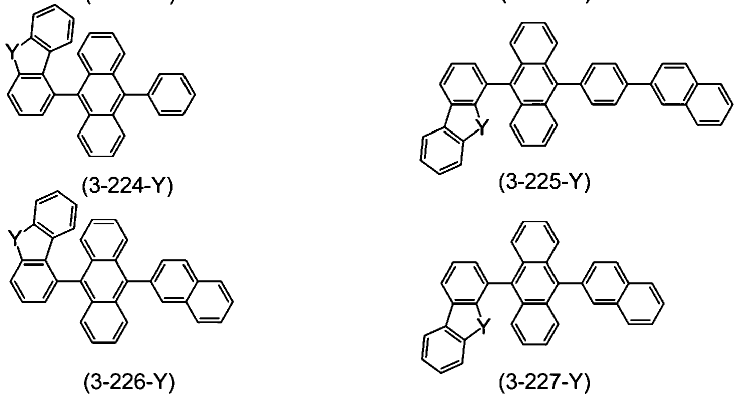

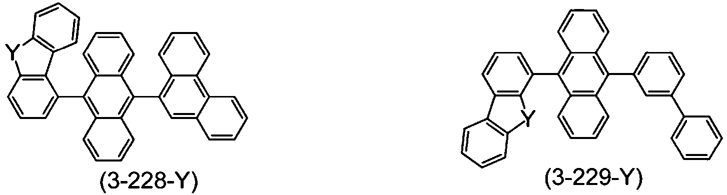

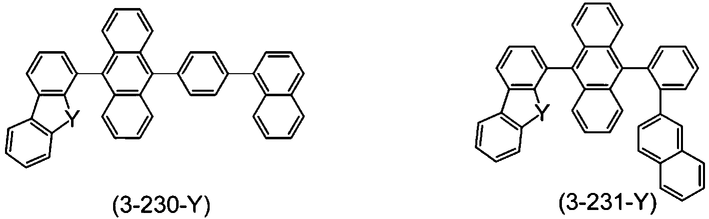

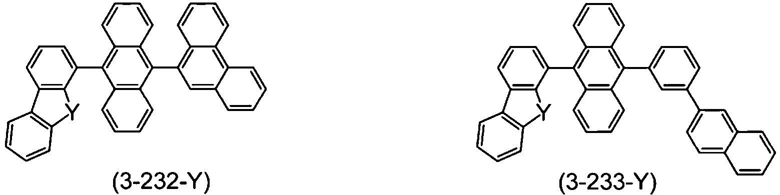

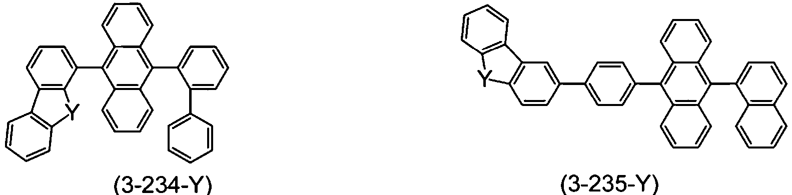

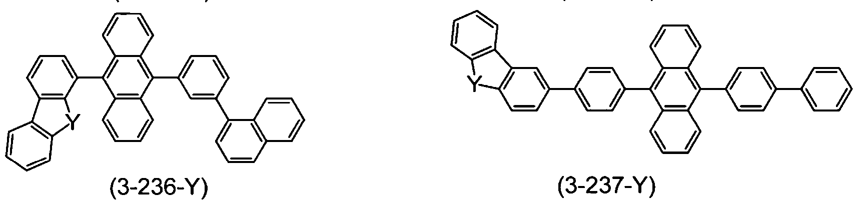

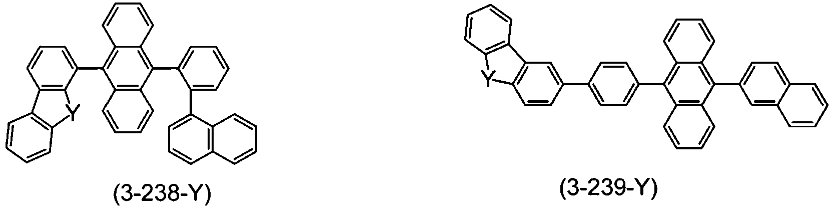

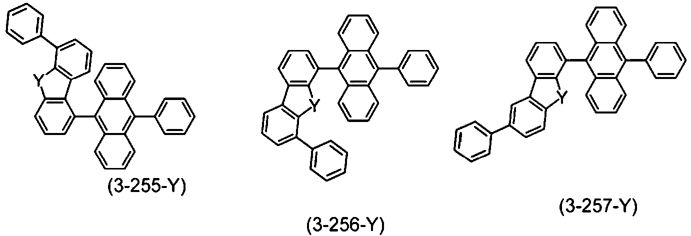

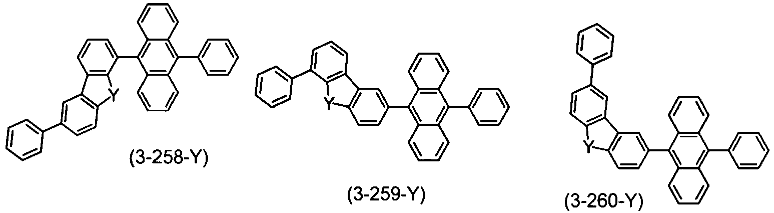

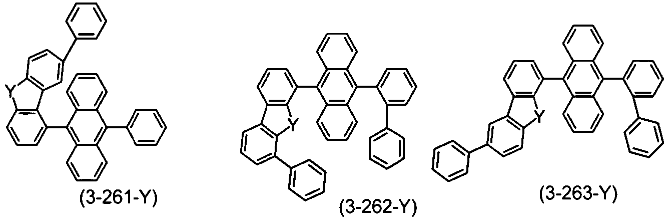

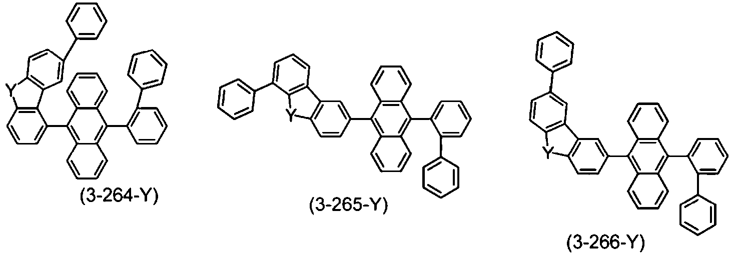

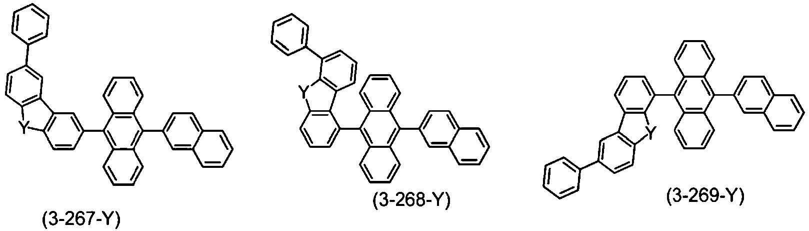

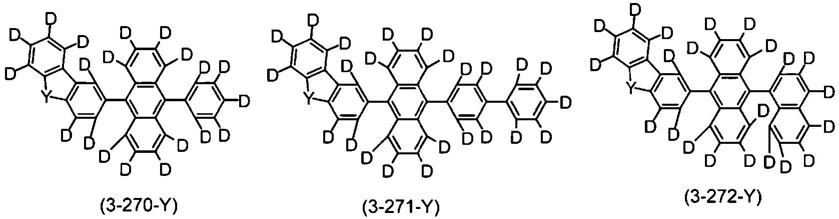

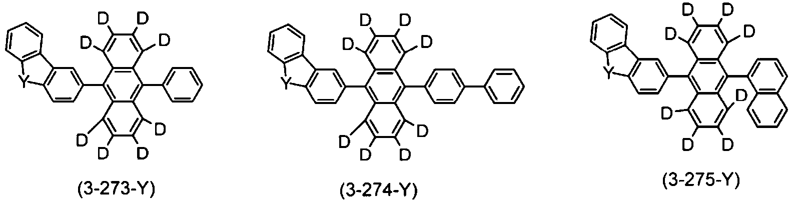

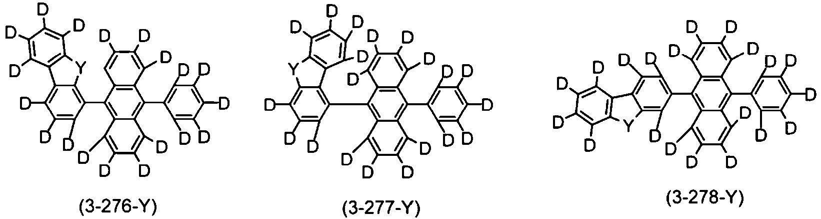

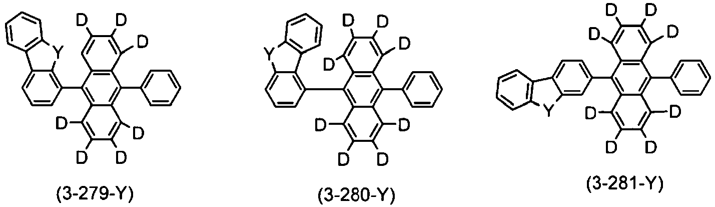

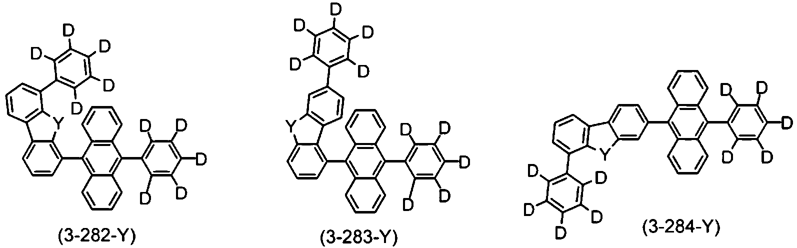

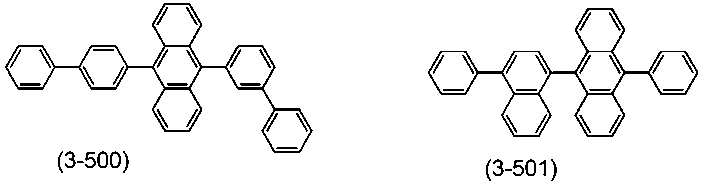

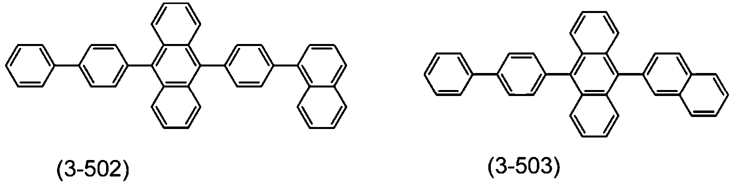

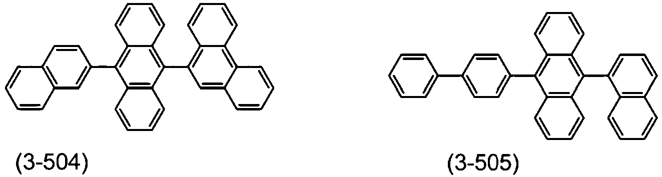

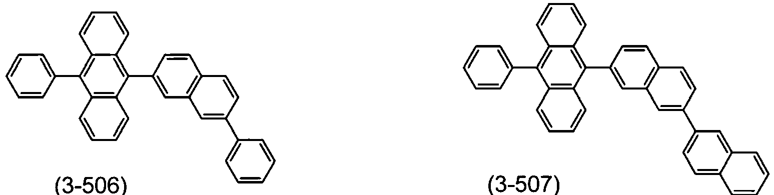

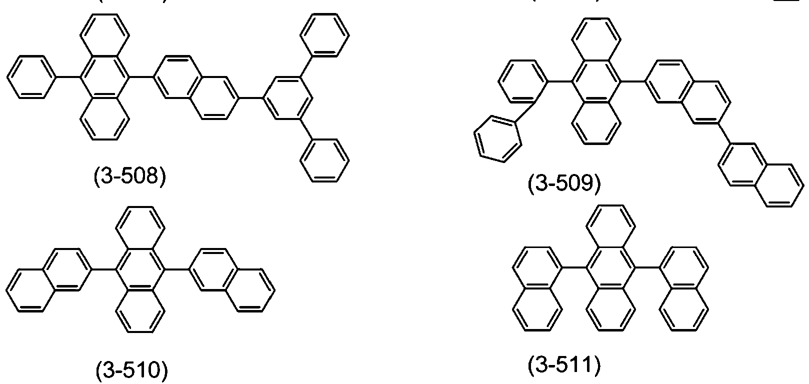

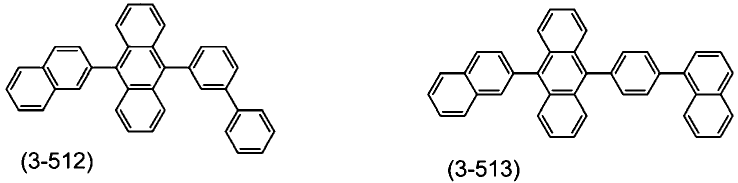

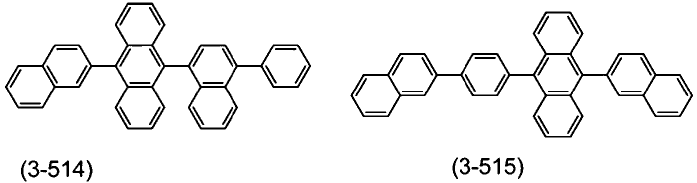

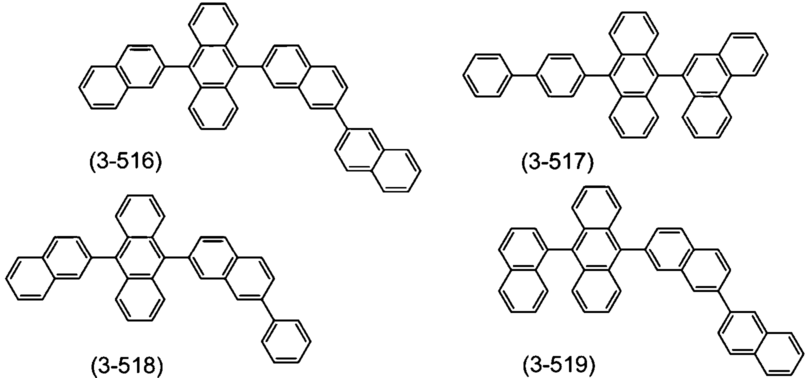

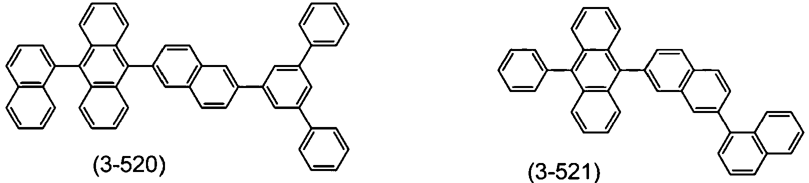

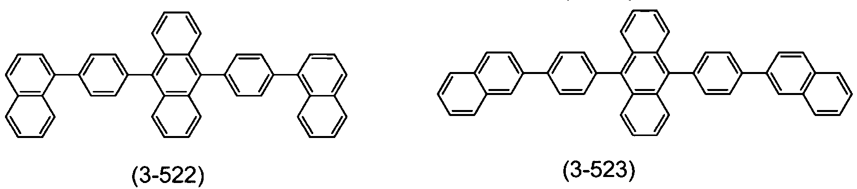

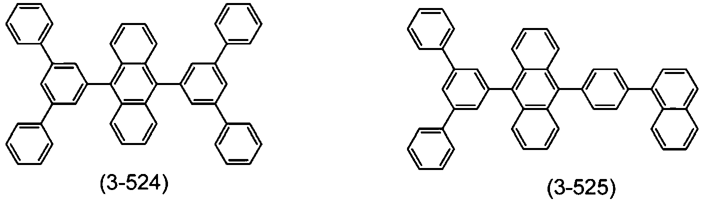

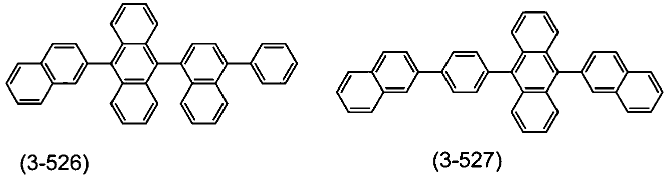

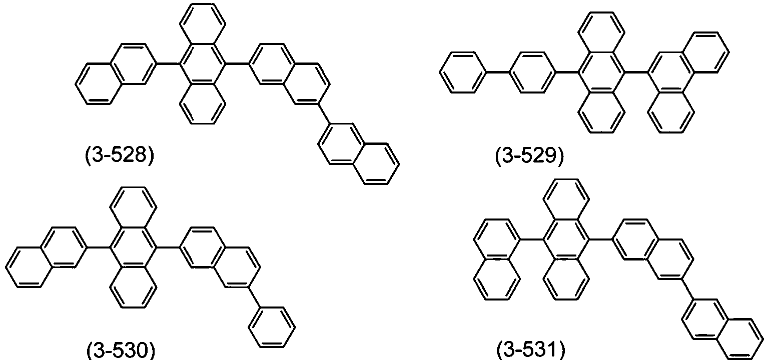

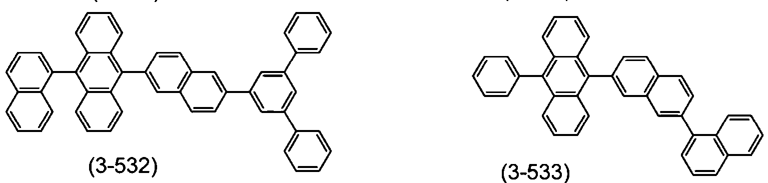

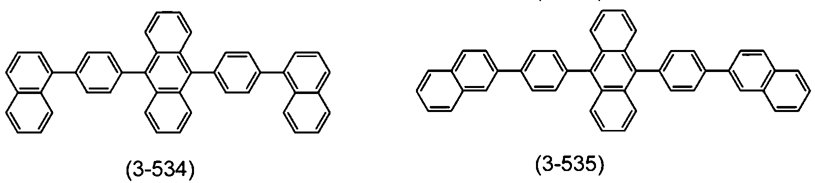

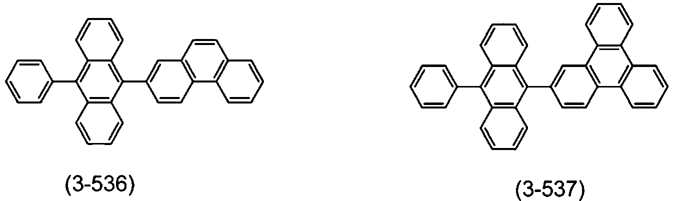

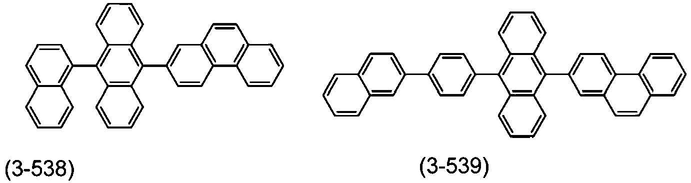

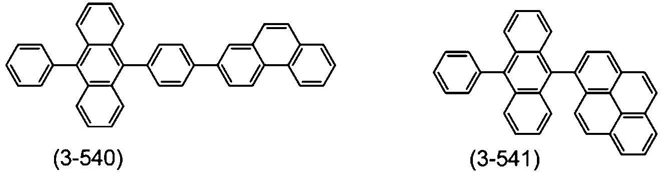

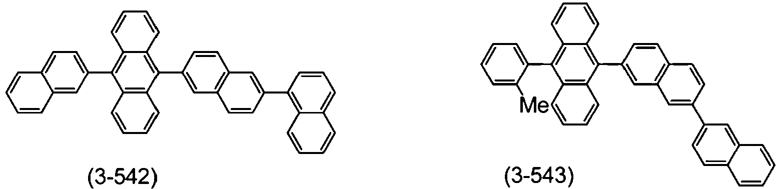

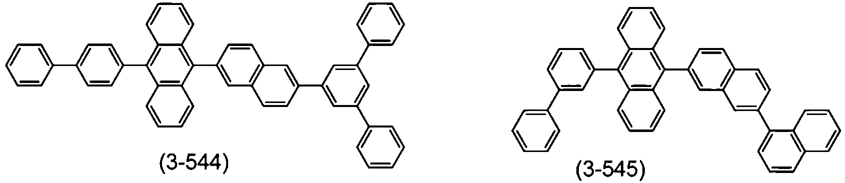

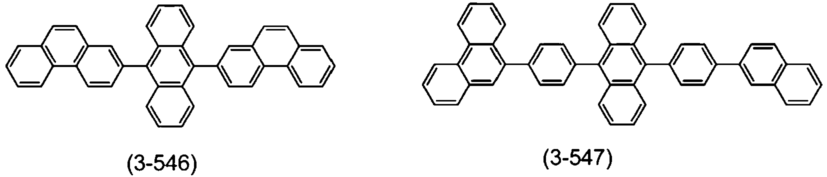

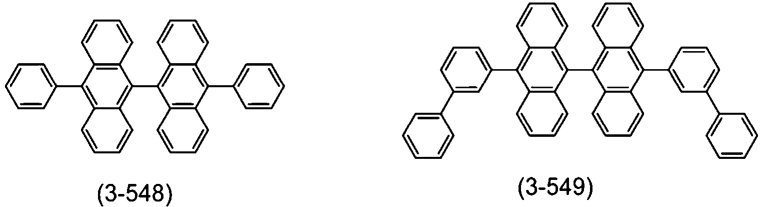

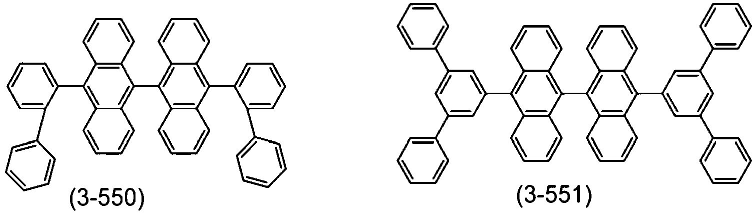

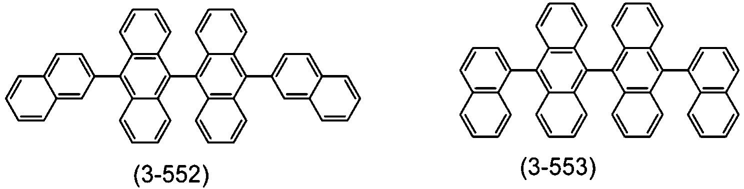

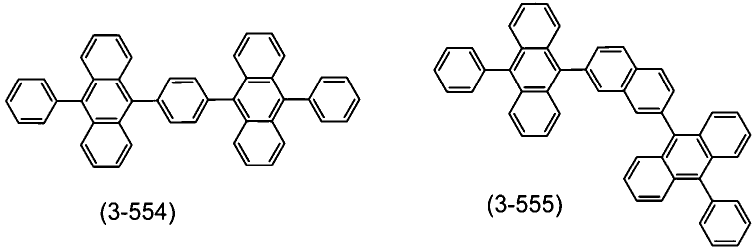

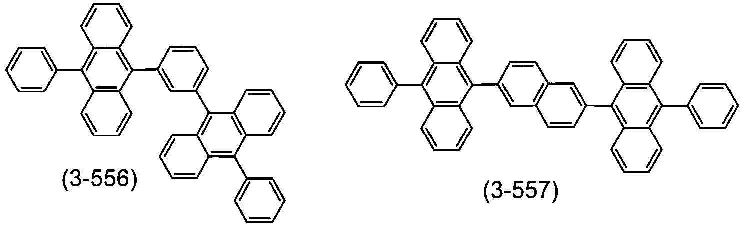

### <One example of compound represented by general formula (H3) (polymer host material)>

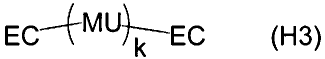

In the formula (H3),
each MU is independently a divalent group represented by removing two arbitrary hydrogen atoms from an aromatic compound, each EC is independently a monovalent group represented by removing one arbitrary hydrogen atom from an aromatic compound, two hydrogen atoms in MU are replaced with EC or MU, and k is an integer of 2 to 50000.

More specifically,
each MU is independently arylene, heteroarylene, diarylenearylamino, diarylenearylboryl, oxaborine-diyl, or azaborine-diyl,
each EC is independently hydrogen, aryl, heteroaryl, diarylamino, diheteroarylamino, arylheteroarylamino, or aryloxy,
at least one hydrogen atom in MU and EC is optionally further replaced with aryl, heteroaryl, diarylamino, alkyl, or cycloalkyl, and
k is an integer of 2 to 50000.
k is preferably an integer of 20 to 50000, more preferably an integer of 100 to 50000.

In the formula (H3), at least one hydrogen atom in MU and EC is optionally replaced with alkyl having 1 to 24 carbon atoms, cycloalkyl having 3 to 24 carbon atoms, halogen, or deuterium. Further, arbitrary -CH₂- in the alkyl is optionally substituted by -O- or -Si(CH₃)₂-, arbitrary -CH₂- except for -CH₂- directly bonded to EC in the formula (H3) in the alkyl is optionally substituted by arylene having 6 to 24 carbon atoms, and arbitrary hydrogen in the alkyl is optionally replaced with fluorine.

Examples of MU include divalent groups represented by removing two arbitrary hydrogen atoms from any of the following compounds:

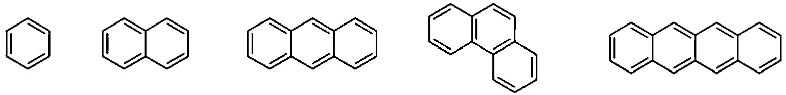

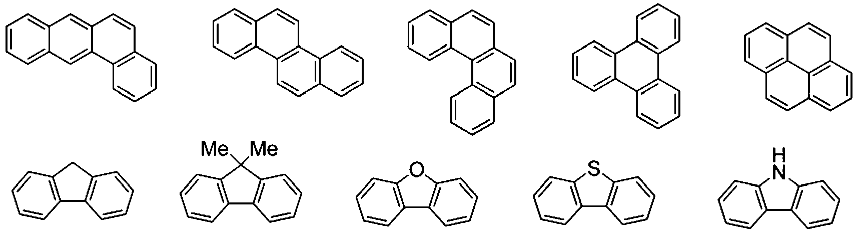

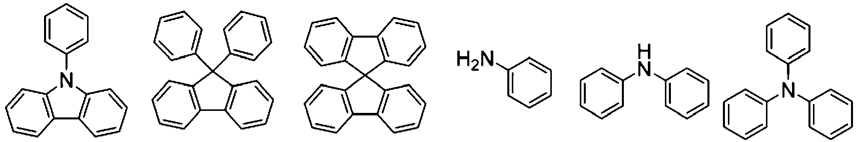

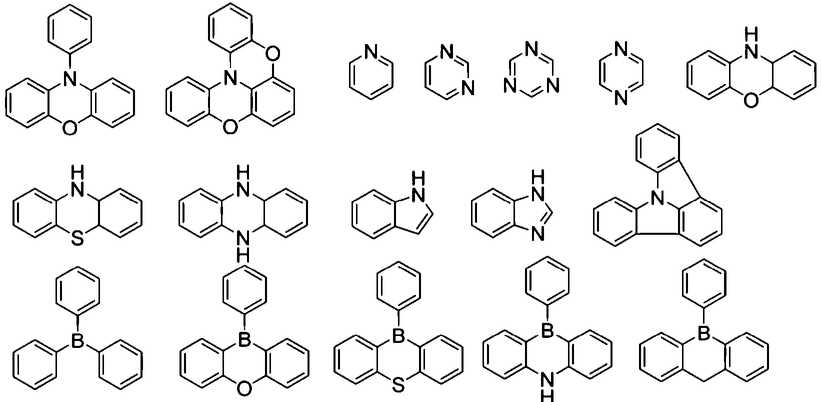

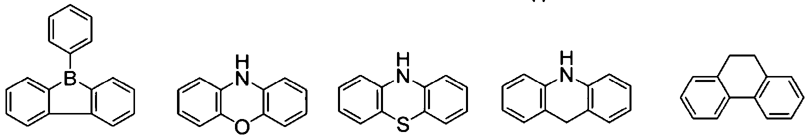

More specific examples thereof include divalent groups represented by any of structures given below. In these structures, MU is bonded at * to another MU or EC.

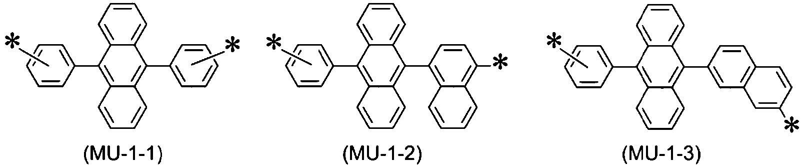

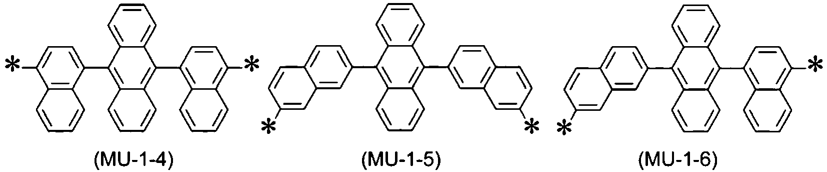

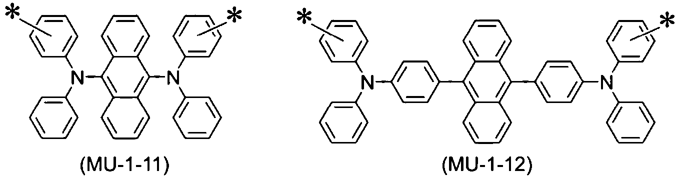

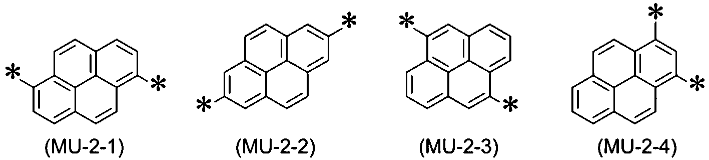

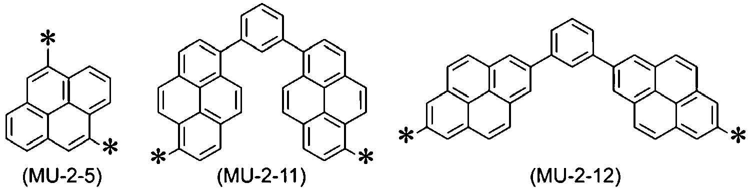

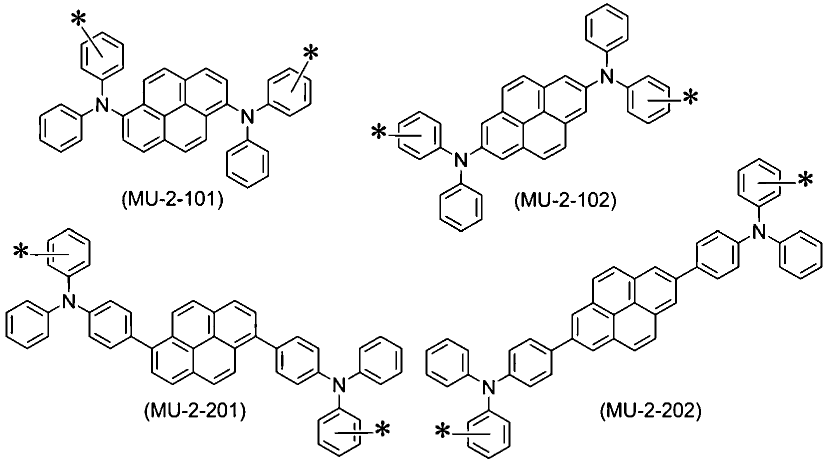

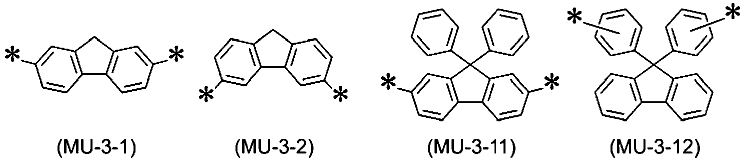

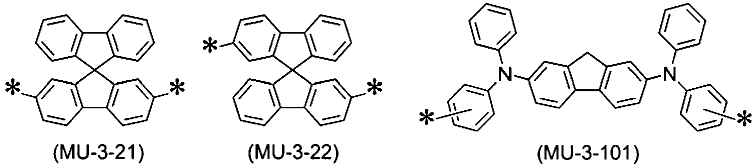

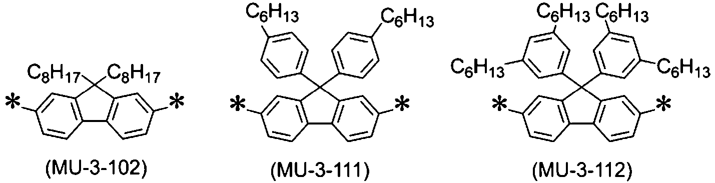

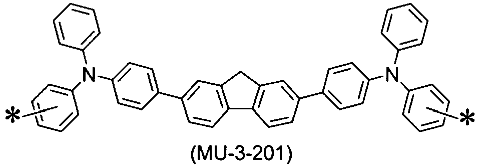

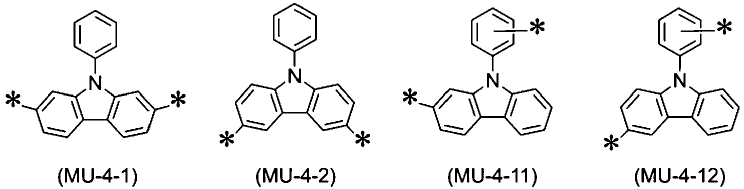

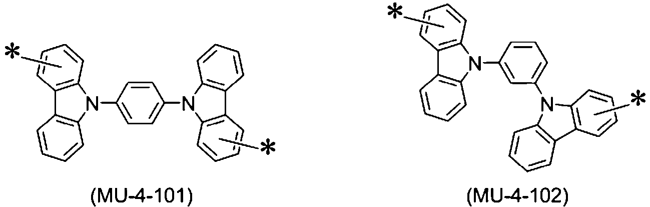

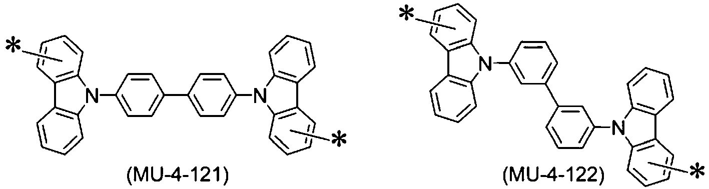

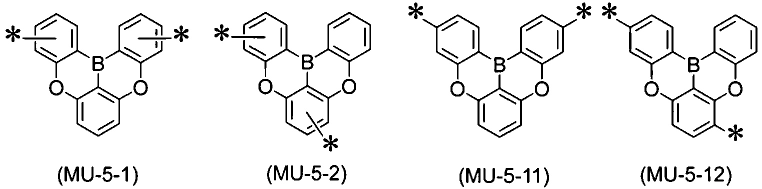

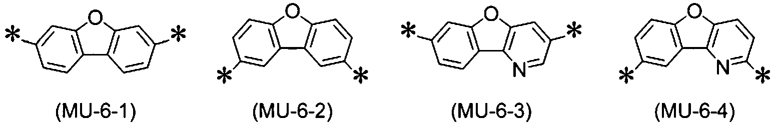

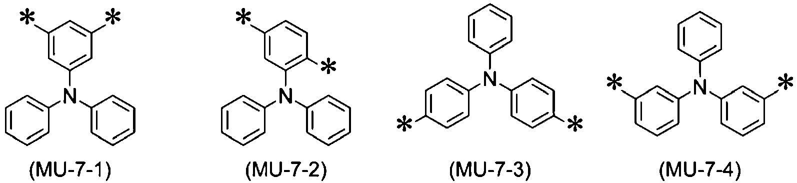

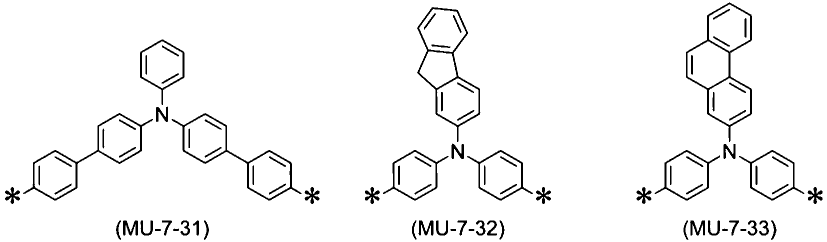

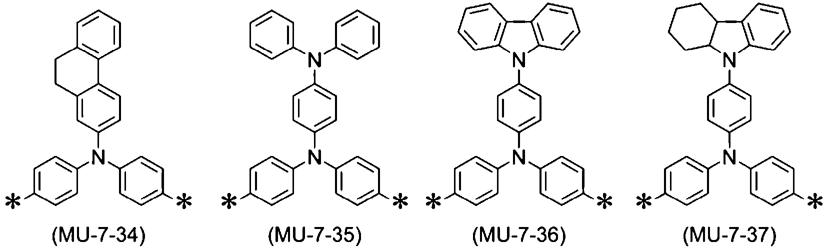

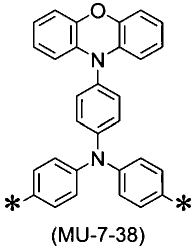

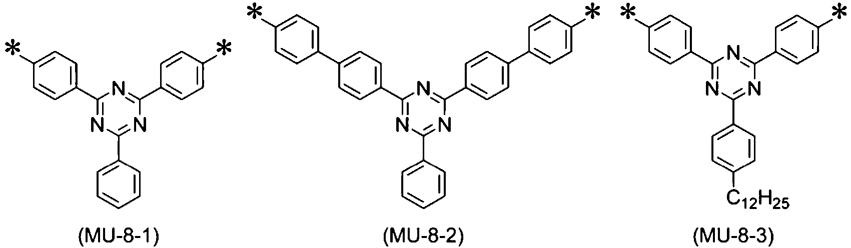

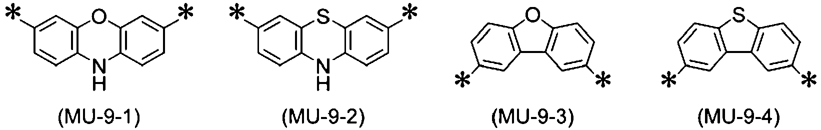

Examples of EC include monovalent groups represented by any of structures given below. In these structures, EC is bonded at * to MU.

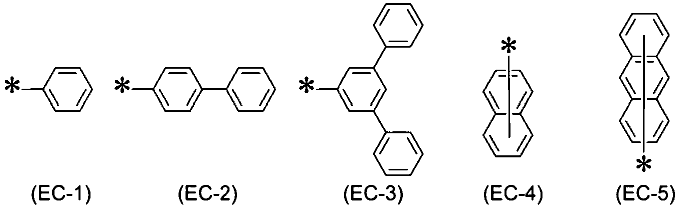

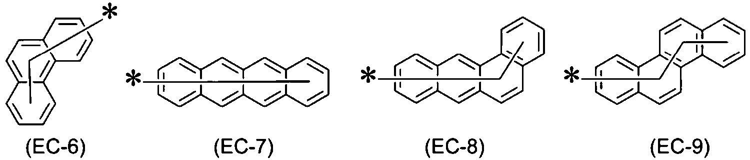

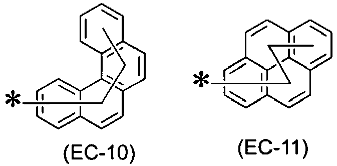

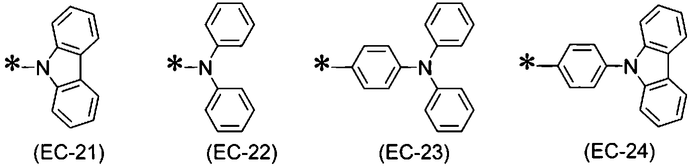

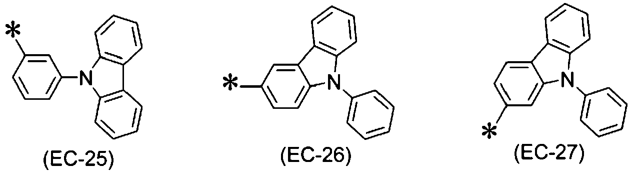

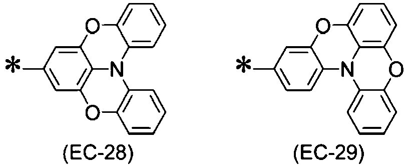

In the compound represented by the formula (H3), preferably 10 to 100% MU based on the total number of MU moieties (k) in a molecule has alkyl having 1 to 24 carbon atoms, more preferably 30 to 100% MU based on the total number of MU moieties (k) in a molecule has alkyl having 1 to 18 carbon atoms (branched alkyl having 3 to 18 carbon atoms), and further preferably 50 to 100% MU based on the total number of MU moieties (k) in a molecule has alkyl having 1 to 12 carbon atoms (branched alkyl having 3 to 12 carbon atoms), from the viewpoint of solubility and film formability by application. On the other hand, preferably 10 to 100% MU based on the total number of MU moieties (k) in a molecule has alkyl having 7 to 24 carbon atoms, more preferably 30 to 100% MU based on the total number of MU moieties (k) in a molecule has alkyl having 7 to 24 carbon atoms (branched alkyl having 7 to 24 carbon atoms), from the viewpoint of in-plane orientation and charge transport.

### <Compound comprising structure represented by general formula (H4)>

The compound is a compound comprising a structure represented by the following formula (H4) and comprises a plurality of, preferably 1 to 5, more preferably 1 to 3, further preferably 1 or 2, most preferably 1 structure(s) of the formula (H4), and a plurality of structures of the formula (H4) contained therein are bonded to each other directly through a single bond or bonded to each other through a specific linking group.

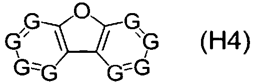

In the general formula (H4), each G is independently "=C(-H)-" or "=N-", and H in the "=C(-H)-" is optionally replaced with a substituent or another structure represented by the formula (H4).

For example, compounds described in International Publication Nos. WO 2012/153780 and WO 2013/038650 can be used as the compound comprising a structure represented by the general formula (H4), and the compound can be produced in accordance with methods described in the literatures.

Examples of the substituent in the case of replacing H in the "=C(-H)-" represented by G are, but are not limited thereto, as mentioned below.

Specific examples of the substituent "aryl group" include phenyl, tolyl, xylyl, naphthyl, phenanthryl, pyrenyl, chrysenyl, benzo[c]phenanthryl, benzo[g]chrysenyl, benzanthryl, triphenylenyl, fluorenyl, 9,9-dimethylfluorenyl, benzofluorenyl, dibenzofluorenyl, biphenylyl, terphenylyl, quaterphenylyl, and fluoranthenyl and can preferably include phenyl, biphenylyl, terphenylyl, quaterphenylyl, naphthyl, triphenylenyl, and fluorenyl. Examples of the aryl group having a substituent can include tolyl, xylyl and 9,9-dimethylfluorenyl. As shown in the specific examples, the aryl group includes both of a condensed aryl group and a non-condensed aryl group.

Specific examples of the substituent "heteroaryl group" include pyrrolyl, pyrazolyl, pyrazinyl, pyrimidinyl, pyridazinyl, pyridyl, triazinyl, indolyl, isoindolyl, imidazolyl, benzimidazolyl, indazolyl, imidazo[1,2-a]pyridinyl, furyl, benzofuranyl, isobenzofuranyl, dibenzofuranyl, azadibenzofuranyl, thienyl, benzothienyl, dibenzothienyl, azadibenzothienyl, quinolyl, isoquinolyl, quinoxalinyl, quinazolinyl, naphthyridinyl, carbazolyl, azacarbazolyl, phenanthridinyl, acridinyl, phenanthrolinyl, phenazinyl, phenothiazinyl, phenoxazinyl, oxazolyl, oxadiazolyl, furazanyl, benzoxazolyl, thienyl, thiazolyl, thiadiazolyl, benzothiazolyl, triazolyl, and tetrazolyl and can preferably include dibenzofuranyl, dibenzothienyl, carbazolyl, pyridyl, pyrimidinyl, triazinyl, azadibenzofuranyl, and azadibenzothienyl. Dibenzofuranyl, dibenzothienyl, azadibenzofuranyl, or azadibenzothienyl is further preferred.

The substituent "substituted silyl group" is also preferably a group selected from the group consisting of a substituted or unsubstituted trialkylsilyl group, a substituted or unsubstituted arylalkylsilyl group, and a substituted or unsubstituted triarylsilyl group.

Specific examples of the substituted or unsubstituted trialkylsilyl group can include trimethylsilyl and triethylsilyl. Specific examples of the substituted or unsubstituted arylalkylsilyl group can include diphenylmethylsilyl, ditolylmethylsilyl, and phenyldimethylsilyl. Specific examples of the substituted or unsubstituted triarylsilyl group can include triphenylsilyl and tritolylsilyl.

The substituent "substituted phosphine oxide group" is also preferably a substituted or unsubstituted diarylphosphine oxide group. Specific examples of the substituted or unsubstituted diarylphosphine oxide group can include diphenylphosphine oxide and ditolylphosphine oxide.

Examples of the substituent "substituted carboxy group" include benzoyloxy.

Examples of the linking group that connects a plurality of structures represented by the formula (H4) include divalent to tetravalent, divalent or trivalent, or divalent derivatives of the aryl and the heteroaryl mentioned above.

Specific examples of the compound comprising a structure represented by the general formula (H4) will be shown below.

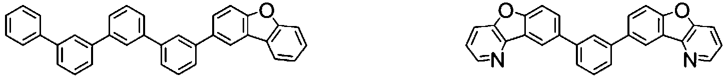

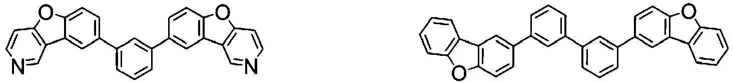

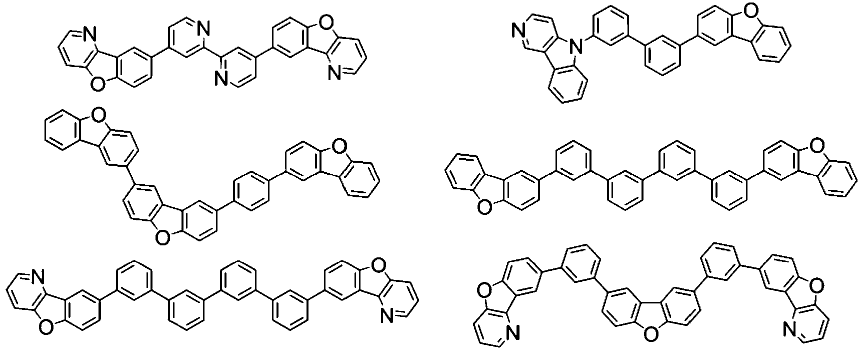

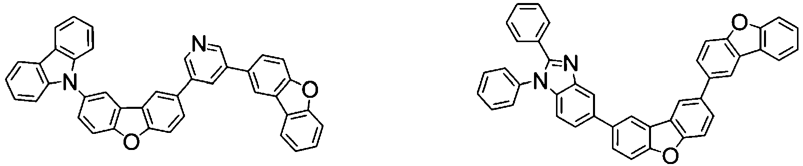

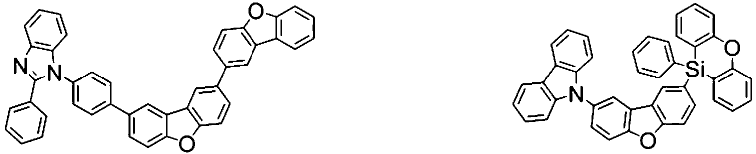

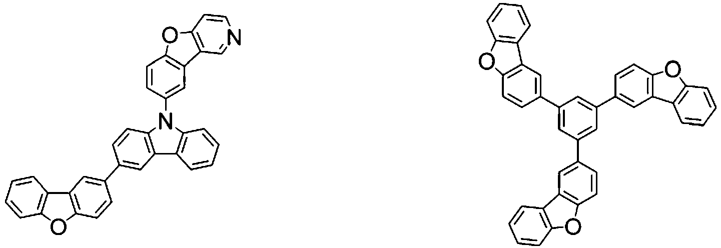

### <Compound represented by general formula (H5)>

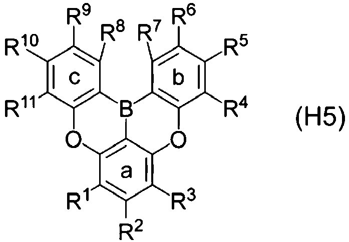

In the formula (H5),
R¹ to R¹¹ are each independently hydrogen, aryl, heteroaryl, diarylamino, diheteroarylamino, arylheteroarylamino, alkyl, or cycloalkyl (all of which are the first substituents), and at least one hydrogen atom in the R¹ to the R¹¹ is optionally further replaced with aryl, heteroaryl, diarylamino, alkyl, or cycloalkyl (all of which are the second substituents),
adjacent groups of R¹ to R¹¹ are optionally bonded to each other to form an aryl ring or a heteroaryl ring together with the ring a, the ring b, or the ring c, at least one hydrogen atom in the formed ring is optionally replaced with aryl, heteroaryl, diarylamino, diheteroarylamino, arylheteroarylamino, alkyl, or cycloalkyl (all of which are the first substituents), and at least one hydrogen atom in these substituents is optionally further replaced with aryl, heteroaryl, diarylamino, alkyl, or cycloalkyl (all of which are the second substituents),
arbitrary "-C(-R)=" (wherein R is any of R¹ to R¹¹) in the ring a, the ring b, and the ring c is optionally replaced with "-N=", and
at least one hydrogen atom in the compound represented by the formula (H5) is each independently optionally replaced with halogen or deuterium.

Arbitrary "-C(-R)=" (wherein R is any of R¹ to R¹¹) in the ring a, the ring b, and the ring c in the formula (H5) is optionally replaced with "-N=" so that the ring is changed to a pyridine ring, a pyrimidine ring, a pyridazine ring, a pyrazine ring, or any of other nitrogen-containing heteroaryl rings.

Preferably, in the formula (H5),
R¹ to R¹¹ are each independently hydrogen, aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and at least one hydrogen atom in the R¹ to the R¹¹ is optionally further replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and
adjacent groups of R¹ to R¹¹ are optionally bonded to each other to form an aryl ring having 9 to 16 carbon atoms or a heteroaryl ring having 6 to 15 carbon atoms together with the ring a, the ring b, or the ring c, at least one hydrogen atom in the formed ring is optionally replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and at least one hydrogen atom in these substituents is optionally further replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms.

Further preferably, in the formula (H5),
R¹ to R¹¹ are each independently hydrogen, aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and at least one hydrogen atom in the R¹ to the R¹¹ is optionally further replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and
adjacent groups of R¹ to R¹¹ are optionally bonded to each other to form an aryl ring having 9 to 12 carbon atoms or a heteroaryl ring having 6 to 12 carbon atoms together with the ring a, the ring b, or the ring c, at least one hydrogen atom in the formed ring is optionally replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and at least one hydrogen atom in these substituents is optionally further replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms.

Examples of the "aryl" or the "heteroaryl" in the aryl, the heteroaryl, the diarylamino, the diheteroarylamino, and the arylheteroarylamino in the first substituents and the second substituents include the following.

Specific examples of the "aryl" include aryl having 6 to 30 carbon atoms. The aryl is preferably aryl having 6 to 24 carbon atoms, more preferably aryl having 6 to 20 carbon atoms, further preferably aryl having 6 to 16 carbon atoms, particularly preferably aryl having 6 to 12 carbon atoms, most preferably aryl having 6 to 10 carbon atoms. Examples thereof include monocyclic aryl including phenyl, bicyclic aryl including (2-,3-,4-)biphenylyl, condensed bicyclic aryl including (1- or 2-)naphthyl, tricyclic aryl including terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, and p-terphenyl-4-yl), condensed tricyclic aryl including acenaphthylen-(1-, 3-, 4-, or 5-)yl, fluoren-(1-, 2-, 3-, 4-, or 9-)yl, phenalen-(1- or 2-)yl, (1-, 2-, 3-, 4-, or 9-)phenanthryl, tetracyclic aryl including quaterphenylyl (5'-phenyl-m-terphenyl-2-yl, 5'-phenyl-m-terphenyl-3-yl, 5'-phenyl-m-terphenyl-4-yl, and m-quaterphenylyl), condensed tetracyclic aryl including triphenylen-(1- or 2-)yl, pyren-(1-, 2-, or 4-)yl, naphthacen-(1-, 2-, or 5-)yl, and condensed pentacyclic aryl including perylen-(1-, 2-, or 3-)yl and pentacen-(1-, 2-, 5-, or 6-)yl.

Specific examples of the "heteroaryl" include heteroaryl having 2 to 30 carbon atoms. The heteroaryl is preferably heteroaryl having 2 to 25 carbon atoms, more preferably heteroaryl having 2 to 20 carbon atoms, further preferably heteroaryl having 2 to 15 carbon atoms, particularly preferably heteroaryl having 2 to 10 carbon atoms. Examples thereof include pyrrolyl, oxazolyl, isoxazolyl, thiazolyl, isothiazolyl, imidazolyl, oxadiazolyl, thiadiazolyl, triazolyl, tetrazolyl, pyrazolyl, pyridinyl, pyrimidinyl, pyridazinyl, pyrazinyl, triazinyl, indolyl, isoindolyl, 1H-indazolyl, benzimidazolyl, benzoxazolyl, benzothiazolyl, 1H-benzotriazolyl, quinolinyl, isoquinolinyl, cinnolinyl, quinazolinyl, quinoxalinyl, phthalazinyl, naphthyridinyl, purinyl, pteridinyl, carbazolyl, acridinyl, phenoxathiinyl, phenoxazinyl, phenothiazinyl, phenazinyl, phenazasilinyl, indolizinyl, furanyl, benzofuranyl, isobenzofuranyl, dibenzofuranyl, naphthobenzofuranyl, thienyl, benzothienyl, isobenzothienyl, dibenzothienyl, naphthobenzothienyl, benzophospholyl, dibenzophospholyl, monovalent groups of a benzophosphole oxide ring, monovalent groups of a dibenzophosphole oxide ring, furazanyl, thianthrenyl, indolocarbazolyl, benzindolocarbazolyl, and benzobenzindolocarbazolyl.

In the first substituents and the second substituents, the "alkyl" may be linear or branched. Examples thereof include linear alkyl having 1 to 24 carbon atoms and branched alkyl having 3 to 24 carbon atoms. The alkyl is preferably alkyl having 1 to 18 carbon atoms (branched alkyl having 3 to 18 carbon atoms), more preferably alkyl having 1 to 12 carbon atoms (branched alkyl having 3 to 12 carbon atoms), further preferably alkyl having 1 to 6 carbon atoms (branched alkyl having 3 to 6 carbon atoms), particularly preferably alkyl having 1 to 5 carbon atoms (branched alkyl having 3 to 5 carbon atoms) or alkyl having 1 to 4 carbon atoms (branched alkyl having 3 or 4 carbon atoms), most preferably methyl. Examples thereof include methyl, ethyl, n-propyl, isopropyl, n-butyl, isobutyl, s-butyl, t-butyl, n-pentyl, isopentyl, neopentyl, t-pentyl(t-amyl), n-hexyl, 1-methylpentyl, 3,3-dimethylbutyl, 2-ethylbutyl, n-heptyl, 1-methylhexyl, n-octyl, t-octyl(1,1,3,3-tetramethylbutyl), 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl. Examples thereof also include 1-ethyl-1-methylpropyl, 1,1-diethylpropyl, 1,1-dimethylbutyl, 1-ethyl-1-methylbutyl, 1,1,4-trimethylpentyl, 1,1,2-trimethylpropyl, 1,1-dimethyloctyl, 1,1-dimethylpentyl, 1,1-dimethylheptyl, 1,1,5-trimethylhexyl, 1-ethyl-1-methylhexyl, 1-ethyl-1,3-dimethylbutyl, 1,1,2,2-tetramethylpropyl, 1-butyl-1-methylpentyl, 1,1-diethylbutyl, 1-ethyl-1-methylpentyl, 1,1,3-trimethylbutyl, 1-propyl-1-methylpentyl, 1,1,2-trimethylpropyl, 1-ethyl-1,2,2-trimethylpropyl, 1-propyl-1-methylbutyl, and 1,1-dimethylhexyl.

In the first substituents and the second substituents, examples of the "cycloalkyl" include cycloalkyl having 3 to 24 carbon atoms, cycloalkyl having 3 to 20 carbon atoms, cycloalkyl having 3 to 16 carbon atoms, cycloalkyl having 3 to 14 carbon atoms, cycloalkyl having 5 to 10 carbon atoms, cycloalkyl having 5 to 8 carbon atoms, cycloalkyl having 5 or 6 carbon atoms, and cycloalkyl having 5 carbon atoms. Examples thereof include cyclopropyl, cyclobutyl, cyclopentyl, cyclohexyl, cycloheptyl, cyclooctyl, cyclononyl, cyclodecyl, and forms thereof substituted by alkyl having 1 to 4 carbon atoms (particularly, methyl), bicyclo[1.1.0]butyl, bicyclo[1.1.1]pentyl, bicyclo[2.1.0]pentyl, bicyclo[2.1.1]hexyl, bicyclo[3.1.0]hexyl, bicyclo[2.2.1]heptyl, bicyclo[2.2.2]octyl, adamantyl, diamantyl, decahydronaphthalenyl, and decahydroazulenyl.

When the first substituents are aryl, the substitution positions are preferably R¹, R³, R⁴, R⁵, R¹⁰, and R¹¹. For example, the substitution of R¹ and R³, the substitution of R⁵ and R¹⁰, or the substitution of R⁴ and R¹¹ is more preferred. The aryl is preferably a phenyl group.

When the first substituents are heteroaryl, the substitution positions are preferably R¹, R², R³, R⁴, R⁵, R⁶, R⁹, R¹⁰, and R¹¹. For example, the substitution of R¹, the substitution of R², the substitution of R³, the substitution of R¹ and R³, the substitution of R⁴ and R¹¹, the substitution of R⁵ and R¹⁰, or the substitution of R⁶ and R⁹ is more preferred. The heteroaryl is preferably a carbazolyl group. These positions may be substituted by the heteroaryl (e.g., carbazolyl) via a phenylene group.

Specific examples of the compound represented by the formula (H5) include compounds represented by structural formulas given below. In the formulas, "Me" represents a methyl group.

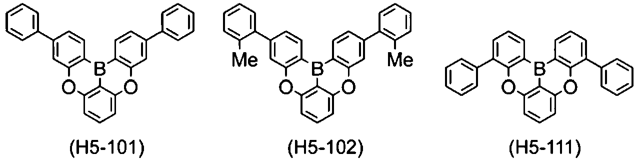

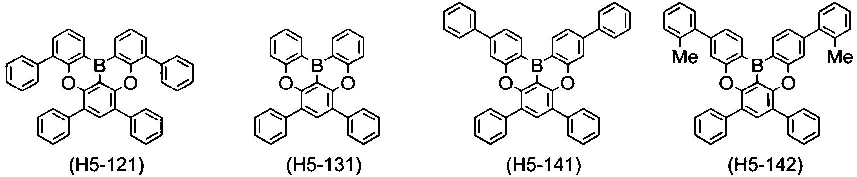

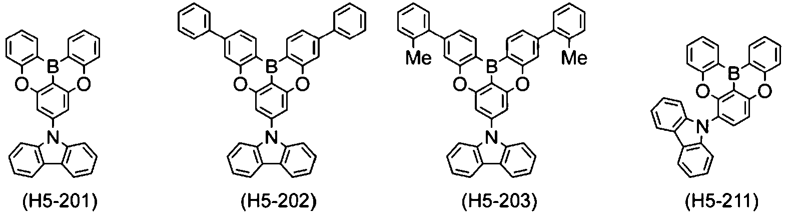

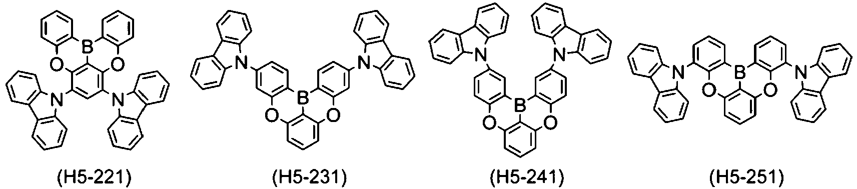

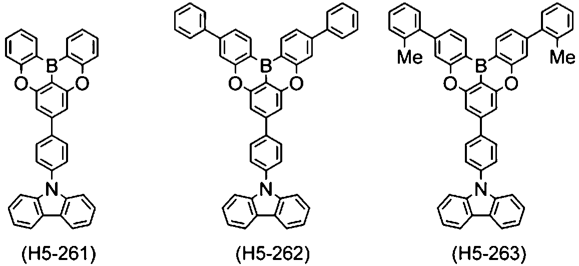

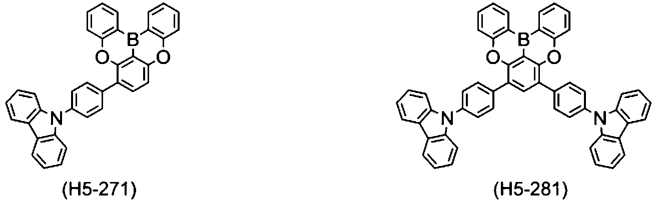

The compound represented by the formula (H5) can be produced by first bonding the rings a to c through a connecting group (-O-) to form an intermediate (first reaction) and then bonding the rings a to c through B (boron) to produce a final product (second reaction). The first reaction can employ, for example, general etherification reaction such as nucleophilic substitution reaction or Ullmann reaction. The second reaction can employ tandem hetero Friedel-Crafts reaction (continuous aromatic electrophilic substitution reaction). For details of the first and second reactions, see the description International Publication No. WO 2015/102118.

### <Compound represented by general formula (H6)>

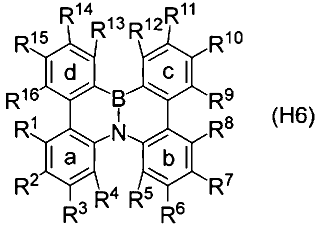

In the formula (H6),
R¹ to R¹⁶ are each independently hydrogen, aryl, heteroaryl, diarylamino, diheteroarylamino, arylheteroarylamino, alkyl, or cycloalkyl (all of which are the first substituents), and at least one hydrogen atom in the R¹ to the R¹⁶ is optionally further replaced with aryl, heteroaryl, diarylamino, alkyl, or cycloalkyl (all of which are the second substituents),
adjacent groups of R¹ to R¹⁶ are optionally bonded to each other to form an aryl ring or a heteroaryl ring together with the ring a, the ring b, the ring c, or the ring d, at least one hydrogen atom in the formed ring is optionally replaced with aryl, heteroaryl, diarylamino, diheteroarylamino, arylheteroarylamino, alkyl, or cycloalkyl (all of which are the first substituents), and at least one hydrogen atom in these substituents is optionally further replaced with aryl, heteroaryl, diarylamino, alkyl, or cycloalkyl (all of which are the second substituents), and
at least one hydrogen atom in the compound represented by the formula (H6) is each independently optionally replaced with halogen or deuterium.

Preferably, in the formula (H6),
R¹ to R¹⁶ are each independently hydrogen, aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and at least one hydrogen atom in the R¹ to the R¹⁶ is optionally further replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and
adjacent groups of R¹ to R¹⁶ are optionally bonded to each other to form an aryl ring having 9 to 16 carbon atoms or a heteroaryl ring having 6 to 15 carbon atoms together with the ring a, the ring b, the ring c, or the ring d, at least one hydrogen atom in the formed ring is optionally replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms, and at least one hydrogen atom in these substituents is optionally further replaced with aryl having 6 to 30 carbon atoms, heteroaryl having 2 to 30 carbon atoms, diarylamino (on the proviso that the aryl is aryl having 6 to 12 carbon atoms), alkyl having 1 to 12 carbon atoms, or cycloalkyl having 3 to 16 carbon atoms.

Further preferably, in the formula (H6),
R¹ to R¹⁶ are each independently hydrogen, aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and at least one hydrogen atom in the R¹ to the R¹⁶ is optionally further replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and
adjacent groups of R¹ to R¹⁶ are optionally bonded to each other to form an aryl ring having 9 to 12 carbon atoms or a heteroaryl ring having 6 to 12 carbon atoms together with the ring a, the ring b, the ring c, or the ring d, at least one hydrogen atom in the formed ring is optionally replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms, and at least one hydrogen atom in these substituents is optionally further replaced with aryl having 6 to 16 carbon atoms, heteroaryl having 2 to 15 carbon atoms, diarylamino (on the proviso that the aryl is aryl having 6 to 10 carbon atoms), alkyl having 1 to 6 carbon atoms, or cycloalkyl having 3 to 14 carbon atoms.

Examples of the "aryl" or the "heteroaryl" in the aryl, the heteroaryl, the diarylamino, the diheteroarylamino, and the arylheteroarylamino in the first substituents and the second substituents include the following.

Specific examples of the "aryl" include aryl having 6 to 30 carbon atoms. The aryl is preferably aryl having 6 to 24 carbon atoms, more preferably aryl having 6 to 20 carbon atoms, further preferably aryl having 6 to 16 carbon atoms, particularly preferably aryl having 6 to 12 carbon atoms, most preferably aryl having 6 to 10 carbon atoms. Examples thereof include monocyclic aryl including phenyl, bicyclic aryl including (2-,3-,4-)biphenylyl, condensed bicyclic aryl including (1- or 2-)naphthyl, tricyclic aryl including terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, and p-terphenyl-4-yl), condensed tricyclic aryl including acenaphthylen-(1-, 3-, 4-, or 5-)yl, fluoren-(1-, 2-, 3-, 4-, or 9-)yl, phenalen-(1- or 2-)yl, (1-, 2-, 3-, 4-, or 9-)phenanthryl, tetracyclic aryl including quaterphenylyl (5'-phenyl-m-terphenyl-2-yl, 5'-phenyl-m-terphenyl-3-yl, 5'-phenyl-m-terphenyl-4-yl, and m-quaterphenylyl), condensed tetracyclic aryl including triphenylen-(1- or 2-)yl, pyren-(1-, 2-, or 4-)yl, naphthacen-(1-, 2-, or 5-)yl, and condensed pentacyclic aryl including perylen-(1-, 2-, or 3-)yl and pentacen-(1-, 2-, 5-, or 6-)yl.

Specific examples of the "heteroaryl" include heteroaryl having 2 to 30 carbon atoms. The heteroaryl is preferably heteroaryl having 2 to 25 carbon atoms, more preferably heteroaryl having 2 to 20 carbon atoms, further preferably heteroaryl having 2 to 15 carbon atoms, particularly preferably heteroaryl having 2 to 10 carbon atoms. Examples thereof include pyrrolyl, oxazolyl, isoxazolyl, thiazolyl, isothiazolyl, imidazolyl, oxadiazolyl, thiadiazolyl, triazolyl, tetrazolyl, pyrazolyl, pyridinyl, pyrimidinyl, pyridazinyl, pyrazinyl, triazinyl, indolyl, isoindolyl, 1H-indazolyl, benzimidazolyl, benzoxazolyl, benzothiazolyl, 1H-benzotriazolyl, quinolinyl, isoquinolinyl, cinnolinyl, quinazolinyl, quinoxalinyl, phthalazinyl, naphthyridinyl, purinyl, pteridinyl, carbazolyl, acridinyl, phenoxathiinyl, phenoxazinyl, phenothiazinyl, phenazinyl, phenazasilinyl, indolizinyl, furanyl, benzofuranyl, isobenzofuranyl, dibenzofuranyl, naphthobenzofuranyl, thienyl, benzothienyl, isobenzothienyl, dibenzothienyl, naphthobenzothienyl, benzophospholyl, dibenzophospholyl, monovalent groups of a benzophosphole oxide ring, monovalent groups of a dibenzophosphole oxide ring, furazanyl, thianthrenyl, indolocarbazolyl, benzindolocarbazolyl, and benzobenzindolocarbazolyl.

In the first substituents and the second substituents, the "alkyl" may be linear or branched. Examples thereof include linear alkyl having 1 to 24 carbon atoms and branched alkyl having 3 to 24 carbon atoms. The alkyl is preferably alkyl having 1 to 18 carbon atoms (branched alkyl having 3 to 18 carbon atoms), more preferably alkyl having 1 to 12 carbon atoms (branched alkyl having 3 to 12 carbon atoms), further preferably alkyl having 1 to 6 carbon atoms (branched alkyl having 3 to 6 carbon atoms), particularly preferably alkyl having 1 to 5 carbon atoms (branched alkyl having 3 to 5 carbon atoms) or alkyl having 1 to 4 carbon atoms (branched alkyl having 3 or 4 carbon atoms), most preferably methyl. Examples thereof include methyl, ethyl, n-propyl, isopropyl, n-butyl, isobutyl, s-butyl, t-butyl, n-pentyl, isopentyl, neopentyl, t-pentyl(t-amyl), n-hexyl, 1-methylpentyl, 3,3-dimethylbutyl, 2-ethylbutyl, n-heptyl, 1-methylhexyl, n-octyl, t-octyl(1,1,3,3-tetramethylbutyl), 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl. Examples thereof also include 1-ethyl-1-methylpropyl, 1,1-diethylpropyl, 1,1-dimethylbutyl, 1-ethyl-1-methylbutyl, 1,1,4-trimethylpentyl, 1,1,2-trimethylpropyl, 1,1-dimethyloctyl, 1,1-dimethylpentyl, 1,1-dimethylheptyl, 1,1,5-trimethylhexyl, 1-ethyl-1-methylhexyl, 1-ethyl-1,3-dimethylbutyl, 1,1,2,2-tetramethylpropyl, 1-butyl-1-methylpentyl, 1,1-diethylbutyl, 1-ethyl-1-methylpentyl, 1,1,3-trimethylbutyl, 1-propyl-1-methylpentyl, 1,1,2-trimethylpropyl, 1-ethyl-1,2,2-trimethylpropyl, 1-propyl-1-methylbutyl, and 1,1-dimethylhexyl.

In the first substituents and the second substituents, examples of the "cycloalkyl" include cycloalkyl having 3 to 24 carbon atoms, cycloalkyl having 3 to 20 carbon atoms, cycloalkyl having 3 to 16 carbon atoms, cycloalkyl having 3 to 14 carbon atoms, cycloalkyl having 5 to 10 carbon atoms, cycloalkyl having 5 to 8 carbon atoms, cycloalkyl having 5 or 6 carbon atoms, and cycloalkyl having 5 carbon atoms. Examples thereof include cyclopropyl, cyclobutyl, cyclopentyl, cyclohexyl, cycloheptyl, cyclooctyl, cyclononyl, cyclodecyl, and forms thereof substituted by alkyl having 1 to 4 carbon atoms (particularly, methyl), bicyclo[1.1.0]butyl, bicyclo[1.1.1]pentyl, bicyclo[2.1.0]pentyl, bicyclo[2.1.1]hexyl, bicyclo[3.1.0]hexyl, bicyclo[2.2.1]heptyl, bicyclo[2.2.2]octyl, adamantyl, diamantyl, decahydronaphthalenyl, and decahydroazulenyl.

The compound represented by the formula (H6) can be produced with reference to the description of International Publication No. WO 2014/042197.

### <TADF material>

Back energy transfer from an excited triplet state to an excited singlet state, which usually has low transition probability, is efficiently caused by decrease in energy difference between the excited singlet state and the excited triplet state so that emission (thermally activated delayed fluorescence, TADF) from the singlet occurs. In usual fluorescence emission, 75% of triplet excitons caused by current excitation pass through a thermal deactivation pathway and therefore, cannot be isolated as fluorescence. On the other hand, in TADF, all the excitons can be exploited in fluorescence emission, and an efficient organic EL device can be achieved.

Examples of the TADF material that can be used for such purposes include a compound represented by the following general formula (H7), and a compound having the following general formula (H7) as a substructure.

ED-Ln-EA (H7)

In the formula (H7), ED is an electron-donating group, Ln is a connecting group, EA is an electron-accepting group, and an energy difference (ΔS¹T¹) between singlet energy (S¹) and triplet energy (T¹) of the compound represented by the formula (H7) is 0.2 eV or less (Hiroki Uoyama, Kenichi Goushi, Katsuyuki Shizu, Hiroko Nomura, Chihaya Adachi, Nature, 492, 234-238 (2012)). The energy difference (ΔS¹T¹) is preferably 0.15 eV or less, more preferably 0.10 eV or less, further preferably 0.08 eV or less.

The TADF material is preferably a donor-acceptor type TADF compound (D-A type TADF compound) designed such that efficient reverse intersystem crossing occurs by the intramolecular localization of HOMO and LUMO using an electron-donating substituent called donor and an electron-accepting substituent called acceptor.

In this context, the "electron-donating substituent" (donor) in the present specification means a substituent and a substructure in which the LUMO orbital is localized in a TADF compound molecule, and the "electron-accepting substituent" (acceptor) means a substituent and a substructure in which the HOMO orbital is localized in a TADF compound molecule.

In general, the TADF compound using the donor and the acceptor obtains a very fast reverse intersystem crossing rate because of large spin orbit coupling (SOC) attributed to the structure, small exchange interaction between HOMO and LUMO, and small ΔE(ST). On the other hand, the TADF compound using the donor and the acceptor might reduce color purity when used as a luminescent material, because of having large structural relaxation in an excited state (since the stable structure of a certain molecule varies between a ground state and an excited state, the conversion of the ground state to the excited state by external stimulation changes a subsequent structure to the stable structure in the excited state) to provide a wide range of emission spectra.

When the TADF material reduces color purity, a fluorescent compound can be added as an additional component to the luminescent layer or a layer adjacent to the luminescent layer. The TADF material works as an assisting dopant, and the additional component works as an emitting dopant. The additional component can be a compound whose absorption spectrum overlaps at least partially with the luminescence peak of the assisting dopant.

For example, structures described in Chemistry of Materials, 2017, 29, 1946-1963 can be used as donor and acceptor structures for use in the TADF material. Examples of ED include functional groups containing sp³ nitrogen and more specifically include groups derived from carbazole, dimethylcarbazole, di-t-butylcarbazole, dimethoxycarbazole, tetramethylcarbazole, benzofluorocarbazole, benzothienocarbazole, phenyldihydroindolocarbazole, phenylbicarbazole, bicarbazole, tercarbazole, diphenylcarbazolylamine, tetraphenylcarbazolyldiamine, phenoxazine, dihydrophenazine, phenothiazine, dimethyldihydroacridine, diphenylamine, bis(t-butylphenyl)amine, N¹-(4-(diphenylamino)phenyl)-N⁴,N⁴-diphenylbenzene-1,4-diamine, dimethyltetraphenyldihydroacridinediamine, tetramethyl-dihydro-indenoacridine, and diphenyl-dihydrodibenzazasiline. Examples of EA include sp² nitrogen-containing aromatic rings, CN-substituted aromatic ring, rings having ketone, and a cyano group and more specifically include groups derived from sulfonyldibenzene, benzophenone, phenylenebis(phenylmethanone), benzonitrile, isonicotinonitrile, phthalonitrile, isophthalonitrile, p-phthalonitrile, triazole, oxazole, thiadiazole, benzothiazole, benzobis(thiazole), benzoxazole, benzobis(oxazole), quinoline, benzimidazole, dibenzoquinoxaline, heptaazaphenalene, thioxanthone dioxide, dimethylanthracenone, anthracenedione, pyridine, 5H-cyclopenta[1,2-b:5,4-b']dipyridine, benzenetricarbonitrile, fluorenedicarbonitrile, pyrazinedicarbonitrile, pyridinedicarbonitrile, dibenzoquinoxalinedicarbonitrile, pyrimidine, phenylpyrimidine, methylpyrimidine, triazine, triphenyltriazine, bis(phenylsulfonyl)benzene, dimethylthioxanthene dioxide, thianthrene tetraoxide, and tris(dimethylphenyl)borane. Examples of Ln include a single bond and arylene and more specifically include phenylene, biphenylene, and naphthylene. In any of the structures, hydrogen is optionally replaced with alkyl, cycloalkyl, or aryl. Particularly, a compound having at least one substructure selected from carbazole, phenoxazine, acridine, triazine, pyrimidine, pyrazine, thioxanthene, benzonitrile, phthalonitrile, isophthalonitrile, diphenylsulfone, triazole, oxadiazole, thiadiazole, and benzophenone is preferred.

The compound represented by the general formula (H7) is more specifically a compound represented by any of the following general formula (H7-1), formula (H7-2), and formula (H7-3):

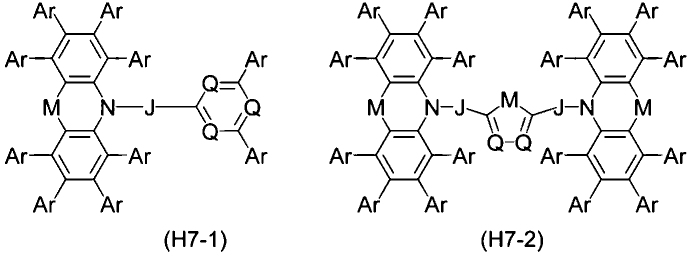

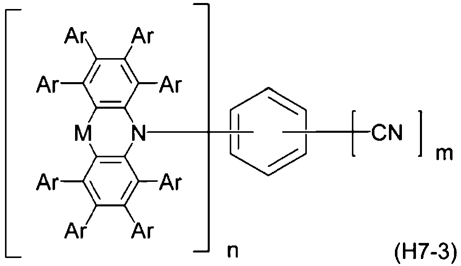

In the general formula (H7-1), the formula (H7-2), and the formula (H7-3),
each M is independently a single bond, -O-, >N-Ar, or >C(-Ar)₂, preferably a single bond, -O-, or >N-Ar from the viewpoint of deep HOMO in the substructure to be formed, and a high excited singlet energy level and excited triplet energy level,
J is a spacer structure that separates a donor substructure and an acceptor substructure, and each J is independently arylene having 6 to 18 carbon atoms, preferably arylene having 6 to 12 carbon atoms from the viewpoint of the amplitude of conjugation coming from the donor substructure and the acceptor substructure, more specific examples of which include phenylene, methylphenylene, and dimethylphenylene,
each Q is independently =C(-H)- or =N-, preferably =N- from the viewpoint of shallow LUMO in the substructure to be formed, and a high excited singlet energy level and excited triplet energy level,
each Ar is independently hydrogen, aryl having 6 to 24 carbon atoms, heteroaryl having 2 to 24 carbon atoms, alkyl having 1 to 12 carbon atoms, or cycloalkyl having 3 to 18 carbon atom, preferably hydrogen, aryl having 6 to 12 carbon atoms, heteroaryl having 2 to 14 carbon atoms, alkyl having 1 to 4 carbon atoms, or cycloalkyl having 6 to 10 carbon atoms, more preferably hydrogen, phenyl, tolyl, xylyl, mesityl, biphenyl, pyridyl, bipyridyl, triazinyl, carbazolyl, dimethylcarbazolyl, di-t-butylcarbazolyl, benzimidazole, or phenylbenzimidazole, further preferably hydrogen, phenyl, or carbazolyl, from the viewpoint of deep HOMO in the substructure to be formed, and a high excited singlet energy level and excited triplet energy level,
m is 1 or 2, and
n is an integer of 2 to (6 - m), preferably an integer of 4 to (6 - m) from the viewpoint of steric hindrance.

At least one hydrogen atom in the compound represented by each of the formulas is optionally replaced with halogen or deuterium.

Examples of the compound represented by the formula (H7) include compounds represented by structures given below. In the structural formulas, * represents a connecting position, "Me" represents a methyl group, and "tBu" represents a t-butyl group.

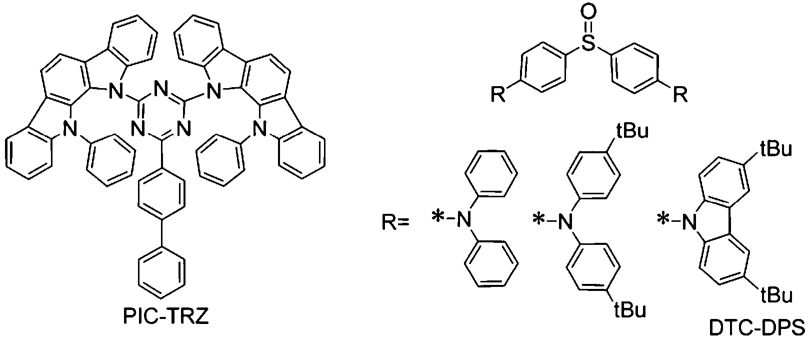

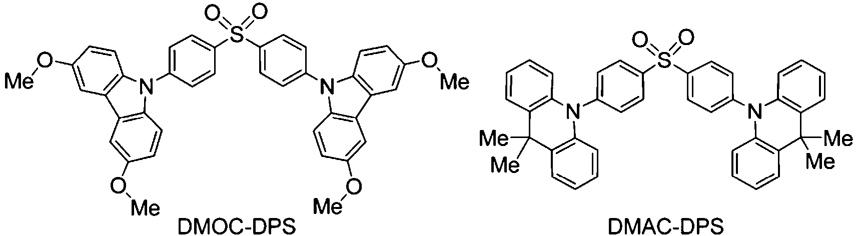

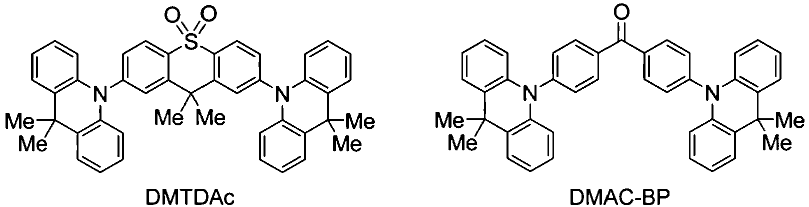

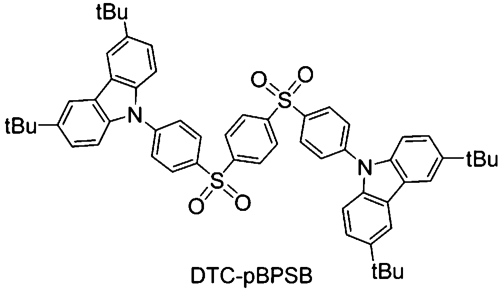

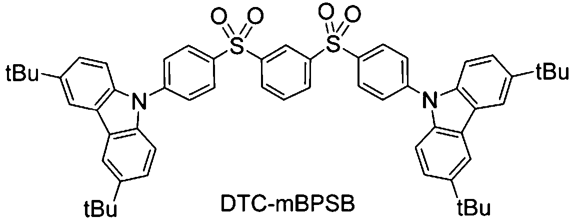

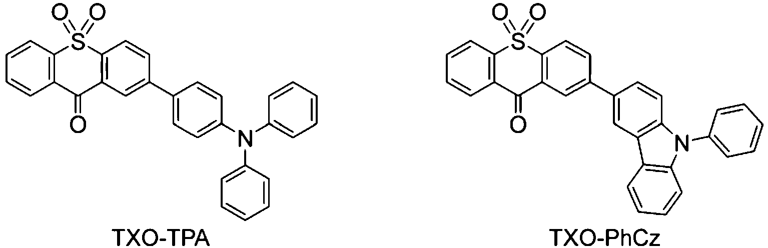

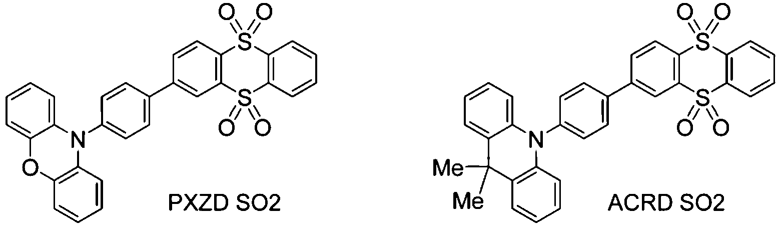

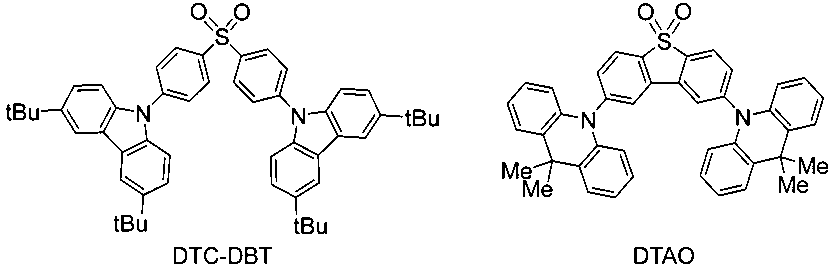

### <Compound represented by general formula (H8)>

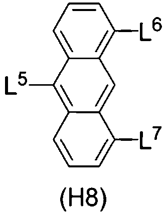

In the formula (H8), L⁵, L⁶, and L⁷ are each independently aryl having 6 to 30 carbon atoms or heteroaryl having 2 to 30 carbon atoms. The aryl is preferably aryl having 6 to 24 carbon atoms, more preferably aryl having 6 to 16 carbon atoms, further preferably aryl having 6 to 12 carbon atoms, particularly preferably aryl having 6 to 10 carbon atoms. Specific examples thereof include monovalent groups such as a benzene ring, a biphenyl ring, a naphthalene ring, a terphenyl ring, an acenaphthylene ring, a fluorene ring, a phenalene ring, a phenanthrene ring, a triphenylene ring, a pyrene ring, a naphthacene ring, a perylene ring, and a pentacene ring. The heteroaryl is preferably heteroaryl having 2 to 25 carbon atoms, more preferably heteroaryl having 2 to 20 carbon atoms, further preferably heteroaryl having 2 to 15 carbon atoms, particularly preferably heteroaryl having 2 to 10 carbon atoms. Specific examples thereof include monovalent groups such as a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, a phenazasiline ring, an indolizine ring, a furan ring, a benzofuran ring, an isobenzofuran ring, a dibenzofuran ring, a thiophene ring, a benzothiophene ring, a dibenzothiophene ring, a furazan ring, a thianthrene ring, an indolocarbazole ring, a benzindolocarbazole ring, a benzobenzindolocarbazole ring, and a naphthobenzofuran ring.

At least one hydrogen atom in the compound represented by the formula (H8) is optionally replaced with alkyl having 1 to 6 carbon atoms, cycloalkyl having 3 to 14 carbon atoms, cyano, halogen, or deuterium.

### <Fluorene compound>

The compound represented by the general formula (4) basically functions as a host.

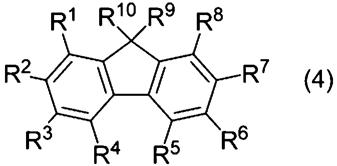

In the formula (4),
R¹ to R¹⁰ are each independently hydrogen, aryl, heteroaryl (wherein the heteroaryl is optionally bonded to a fluorene skeleton in the formula (4) via a linking group), diarylamino, diheteroarylamino, arylheteroarylamino, alkyl, cycloalkyl, alkenyl, alkoxy, or aryloxy, and at least one hydrogen atom in these substituents is optionally replaced with aryl, heteroaryl, alkyl, or cycloalkyl,
R¹ and R², R² and R³, R³ and R⁴, R⁵ and R⁶, R⁶ and R⁷, R⁷ and R⁸, or R⁹ and R¹⁰ are optionally bonded to each other to form a condensed ring or a spiro ring, at least one hydrogen atom in the formed ring is optionally replaced with aryl, heteroaryl (wherein the heteroaryl is optionally bonded to the formed ring via a linking group), diarylamino, diheteroarylamino, arylheteroarylamino, alkyl, cycloalkyl, alkenyl, alkoxy, or aryloxy, and at least one hydrogen atom in these substituents is optionally replaced with aryl, heteroaryl, alkyl, or cycloalkyl, and
at least one hydrogen atom in the compound represented by the formula (4) is optionally replaced with halogen, cyano, or deuterium.

The description of each group in the polycyclic aromatic compound of the formula (A-1) mentioned above can be cited about details of the group in the definition of the formula (4).

Examples of the alkenyl represented by R¹ to R¹⁰ include alkenyl having 2 to 30 carbon atoms. The alkenyl is preferably alkenyl having 2 to 20 carbon atoms, more preferably alkenyl having 2 to 10 carbon atoms, further preferably alkenyl having 2 to 6 carbon atoms, particularly preferably alkenyl having 2 to 4 carbon atoms. The alkenyl is preferably vinyl, 1-propenyl, 2-propenyl, 1-butenyl, 2-butenyl, 3-butenyl, 1-pentenyl, 2-pentenyl, 3-pentenyl, 4-pentenyl, 1-hexenyl, 2-hexenyl, 3-hexenyl, 4-hexenyl, or 5-hexenyl.

Specific examples of the heteroaryl also include monovalent groups represented by removing one arbitrary hydrogen atom from the compound of the following formula (4-Arl), formula (4-Ar2), formula (4-Ar3), formula (4-Ar4), or formula (4-Ar5):

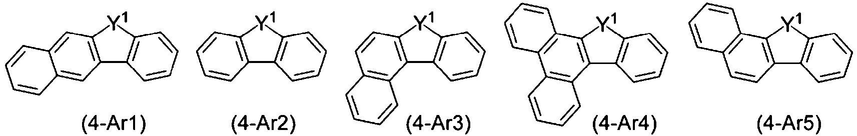

In the formula (4-Ar1) to the formula (4-Ar5), each Y' is independently O, S, or N-R, and R is phenyl, biphenylyl, naphthyl, anthracenyl, or hydrogen, and
at least one hydrogen atom in the structures of the formula (4-Arl) to the formula (4-Ar5) is optionally replaced with phenyl, biphenylyl, naphthyl, anthracenyl, phenanthrenyl, methyl, ethyl, propyl, or butyl.

The heteroaryl is optionally bonded to a fluorene skeleton in the formula (4) via a linking group. Specifically, the fluorene skeleton in the formula (4) and the heteroaryl may not only be directly bonded to each other but bonded to each other via a linking group. Examples of this linking group include phenylene, biphenylene, naphthylene, anthracenylene, methylene, ethylene, -OCH₂CH₂-, - CH₂CH₂O-, and -OCH₂CH₂O-.

In the formula (4), R¹ and R², R² and R³, R³ and R⁴, R⁵ and R⁶, R⁶ and R⁷, or R⁷ and R⁸ are optionally bonded to each other to form a condensed ring, and R⁹ and R¹⁰ are optionally bonded to each other to form a spiro ring. The condensed ring formed by R¹ to R⁸ is a ring condensed with a benzene ring in the formula (4) and is an aliphatic ring or an aromatic ring, preferably an aromatic ring. Examples of the structure including the benzene ring in the formula (4) include a naphthalene ring and a phenanthrene ring. The spiro ring formed by R⁹ and R¹⁰ is a ring spiro-bonded to a 5-membered ring in the formula (4) and is an aliphatic ring or an aromatic ring, preferably an aromatic ring. Examples thereof include a fluorene ring.

The compound represented by the general formula (4) is preferably a compound represented by any of the formula (4-1), the formula (4-2), and the formula (4-3) given below, which represent a compound with a condensed benzene ring formed by R¹ and R² bonded to each other in the general formula (4), a compound with a condensed benzene ring formed by R³ and R⁴ bonded to each other in the general formula (4), and a compound with none of R¹ to R⁸ bonded in the general formula (4), respectively.

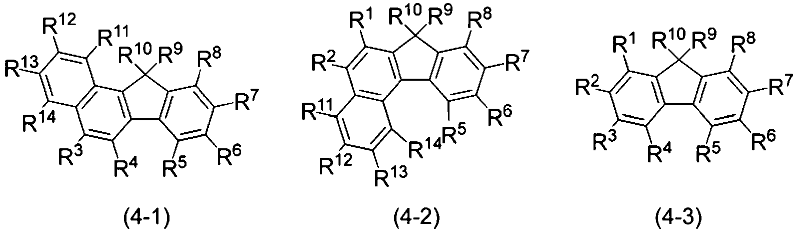

R¹ to R¹⁰ in the formula (4-1), the formula (4-2), and the formula (4-3) are as defined in the corresponding R¹ to R¹⁰ in the formula (4), and R¹¹ to R¹⁴ in the formula (4-1) and the formula (4-2) are also as defined in R¹ to R¹⁰ in the formula (4).

The compound represented by the general formula (4) is further preferably a compound represented by any of the formula (4-1A), the formula (4-2A), and the formula (4-3A) given below, which represent compounds with a spiro-fluorene ring formed by R⁹ and R¹⁰ bonded to each other in the formula (4-1), the formula (4-2), and the formula (4-3), respectively.

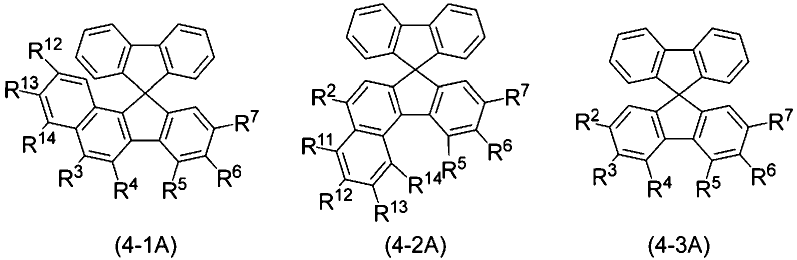

R² to R⁷ in the formula (4-1A), the formula (4-2A), and the formula (4-3A) are as defined in the corresponding R² to R⁷ in the formula (4-1), the formula (4-2), and the formula (4-3), and R¹¹ to R¹⁴ in the formula (4-1A) and the formula (4-2A) are also as defined in R¹¹ to R¹⁴ in the formula (4-1) and the formula (4-2).

The whole or a portion of hydrogen atoms in the compound represented by the formula (4) is optionally replaced with halogen, cyano, or deuterium.

Specific examples of the fluorene compound include compounds represented by any of the formula (4-4) to the formula (4-22) given below. In the following structural formulas, "Me" represents a methyl group.

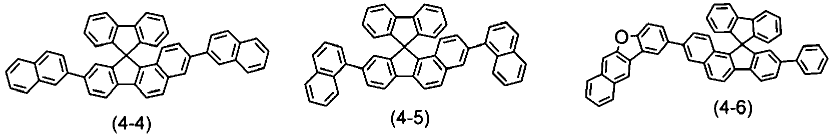

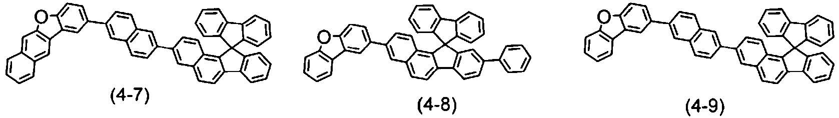

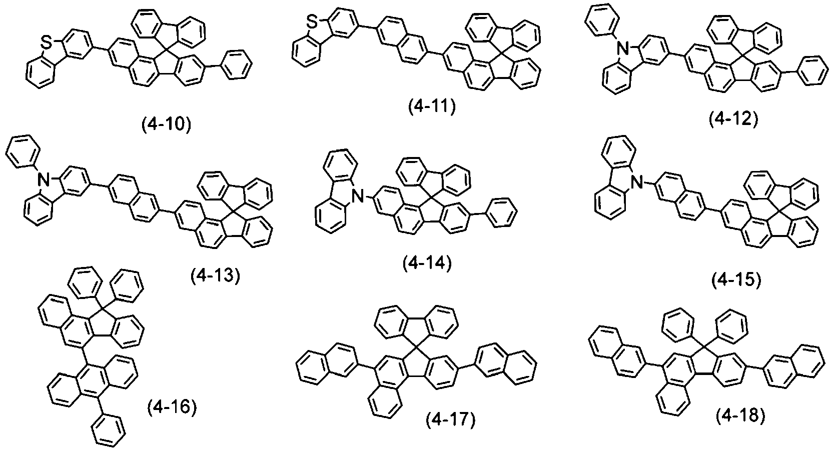

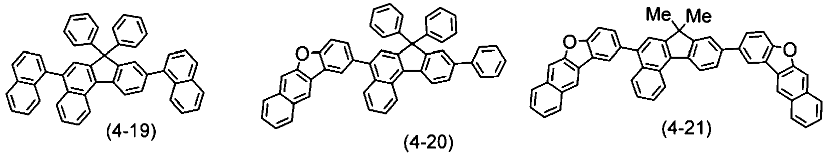

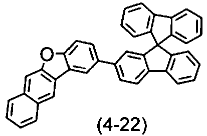

### <Dibenzochrysene compound>

The dibenzochrysene compound as a host is, for example, a compound represented by the following general formula (5):

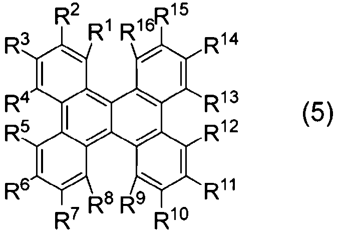

In the formula (5),
R¹ to R¹⁶ are each independently hydrogen, aryl, heteroaryl (wherein the heteroaryl is optionally bonded to a dibenzochrysene skeleton in the formula (5) via a linking group), diarylamino, diheteroarylamino, arylheteroarylamino, alkyl, cycloalkyl, alkenyl, alkoxy, or aryloxy, and at least one hydrogen atom in these substituents is optionally replaced with aryl, heteroaryl, alkyl, or cycloalkyl,
adjacent groups of R¹ to R¹⁶ are optionally bonded to each other to form a condensed ring, at least one hydrogen atom in the formed ring is optionally replaced with aryl, heteroaryl (wherein the heteroaryl is optionally bonded to the formed ring via a linking group), diarylamino, diheteroarylamino, arylheteroarylamino, alkyl, cycloalkyl, alkenyl, alkoxy, or aryloxy, and at least one hydrogen atom in these substituents is optionally replaced with aryl, heteroaryl, alkyl, or cycloalkyl, and
at least one hydrogen atom in the compound represented by the formula (5) is optionally replaced with halogen, cyano, or deuterium.

The description of each group in the polycyclic aromatic compound of the formula (A-1) mentioned above can be cited about details of the group in the definition of the formula (5).

Examples of the alkenyl in the definition of the formula (5) include alkenyl having 2 to 30 carbon atoms. The alkenyl is preferably alkenyl having 2 to 20 carbon atoms, more preferably alkenyl having 2 to 10 carbon atoms, further preferably alkenyl having 2 to 6 carbon atoms, particularly preferably alkenyl having 2 to 4 carbon atoms. The alkenyl is preferably vinyl, 1-propenyl, 2-propenyl, 1-butenyl, 2-butenyl, 3-butenyl, 1-pentenyl, 2-pentenyl, 3-pentenyl, 4-pentenyl, 1-hexenyl, 2-hexenyl, 3-hexenyl, 4-hexenyl, or 5-hexenyl.

Specific examples of the heteroaryl also include monovalent groups represented by removing one arbitrary hydrogen atom from the compound of the following formula (5-Arl), formula (5-Ar2), formula (5-Ar3), formula (5-Ar4), or formula (5-Ar5):

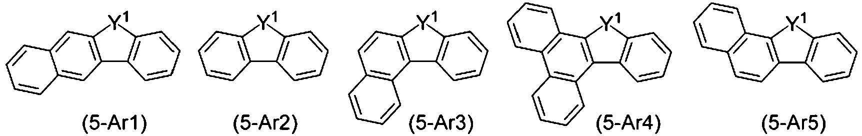

In the formula (5-Arl) to the formula (5-Ar5), each Y¹ is independently O, S, or N-R, and R is phenyl, biphenylyl, naphthyl, anthracenyl, or hydrogen, and
at least one hydrogen atom in the structures of the formula (5-Arl) to the formula (5-Ar5) is optionally replaced with phenyl, biphenylyl, naphthyl, anthracenyl, phenanthrenyl, methyl, ethyl, propyl, or butyl.

The heteroaryl is optionally bonded to a dibenzochrysene skeleton in the formula (5) via a linking group. Specifically, the dibenzochrysene skeleton in the formula (5) and the heteroaryl may not only be directly bonded to each other but bonded to each other via a linking group. Examples of this linking group include phenylene, biphenylene, naphthylene, anthracenylene, methylene, ethylene, - OCH₂CH₂-, -CH₂CH₂O-, and -OCH₂CH₂O-.

In the compound represented by the general formula (5), preferably, each of R¹, R⁴, R⁵, R⁸, R⁹, R¹², R¹³, and R¹⁶ is hydrogen. In this case, R², R³, R⁶, R⁷, R¹⁰, R¹¹, R¹⁴, and R¹⁵ in the formula (5) are each independently preferably hydrogen, phenyl, biphenylyl, naphthyl, anthracenyl, phenanthrenyl, a monovalent group having a structure of the formula (5-Arl), the formula (5-Ar2), the formula (5-Ar3), the formula (5-Ar4), or the formula (5-Ar5) (wherein the monovalent group having the structure is optionally bonded to a dibenzochrysene skeleton in the formula (5) via phenylene, biphenylene, naphthylene, anthracenylene, methylene, ethylene, - OCH₂CH₂-, -CH₂CH₂O-, or -OCH₂CH₂O-), methyl, ethyl, propyl, or butyl.

In the compound represented by the general formula (5), more preferably, each of R¹, R², R⁴, R⁵, R⁷, R⁸, R⁹, R¹⁰, R¹², R¹³, R¹⁵, and R¹⁶ is hydrogen. In this case, at least one (preferably one or two, more preferably one) of R³, R⁶, R¹¹, and R¹⁴ in the formula (5) is a monovalent group having a structure of the formula (5-Ar1), the formula (5-Ar2), the formula (5-Ar3), the formula (5-Ar4), or the formula (5-Ar5) via a single bond, phenylene, biphenylene, naphthylene, anthracenylene, methylene, ethylene, -OCH₂CH₂-, -CH₂CH₂O-, or -OCH₂CH₂O-, and
each moiety other than the at least one moiety (i.e., each moiety other than the position substituted by the monovalent group having the structure) is hydrogen, phenyl, biphenylyl, naphthyl, anthracenyl, methyl, ethyl, propyl, or butyl, and at least one hydrogen atom in these substituted is optionally replaced with phenyl, biphenylyl, naphthyl, anthracenyl, methyl, ethyl, propyl, or butyl.

In the case of selecting a monovalent group having a structure represented by any of the formula (5-Ar1) to the formula (5-Ar5) as R², R³, R⁶, R⁷, R¹⁰, R¹¹, R¹⁴, and R¹⁵ in the formula (5), at least one hydrogen atom in the structure is optionally bonded to any of R¹ to R¹⁶ in the formula (5) to form a single bond.

Specific examples of the dibenzochrysene compound include compounds represented by any of the formula (5-1) to the formula (5-39) given below. In the following structural formulas, "tBu" represents a t-butyl group.

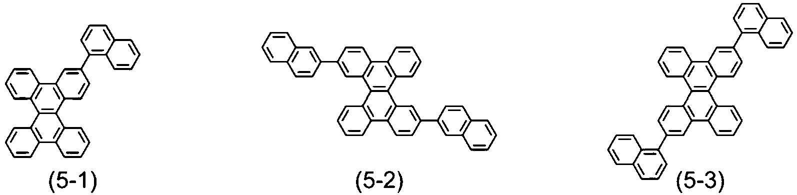

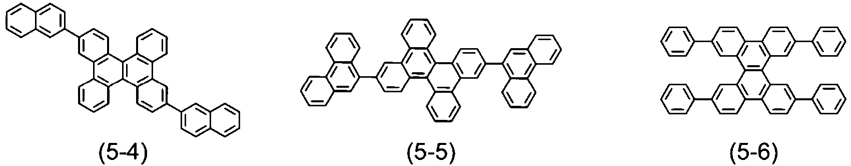

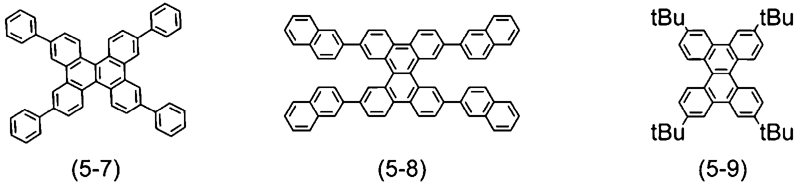

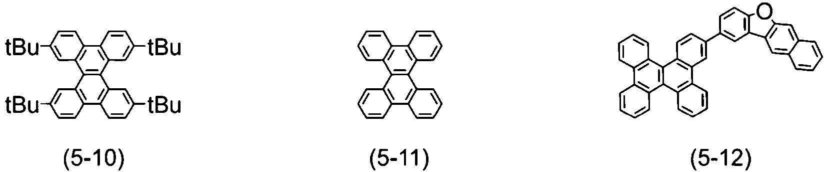

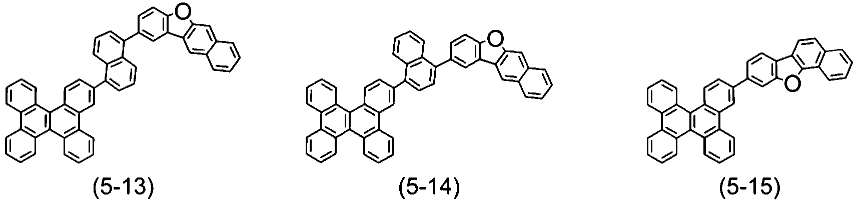

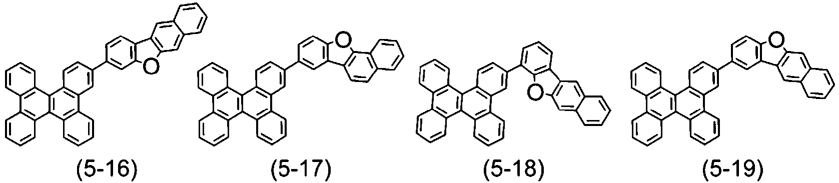

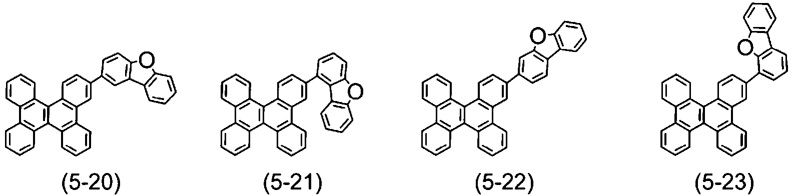

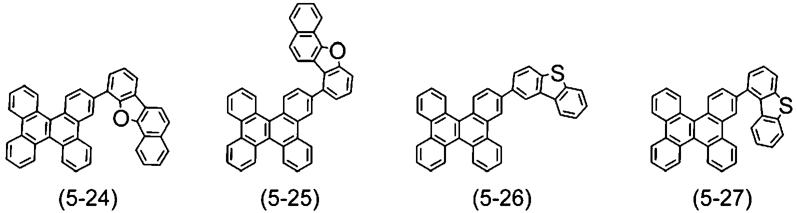

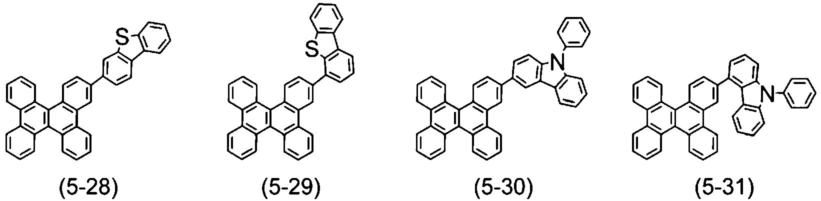

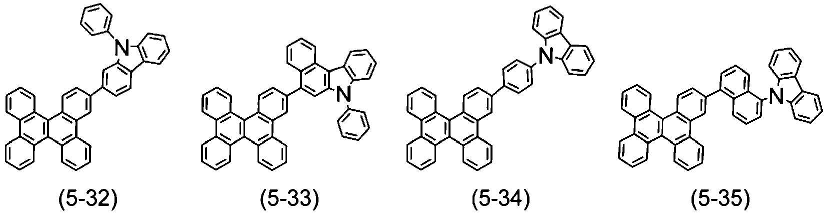

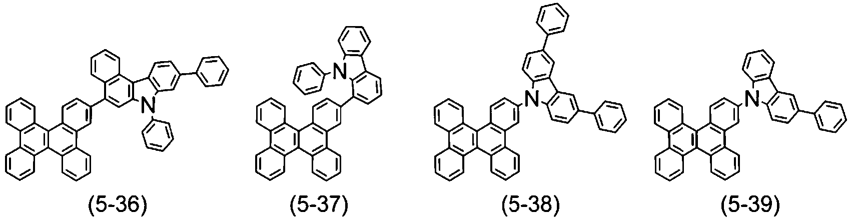

A known compound can be used as the dopant material, and the dopant material can be selected from among various materials depending on desired luminescence color. Specific examples thereof include condensed ring derivatives such as phenanthrene, anthracene, pyrene, tetracene, pentacene, perylene, naphthopyrene, dibenzopyrene, rubrene, and chrysene, benzoxazole derivatives, benzothiazole derivatives, benzimidazole derivatives, benzotriazole derivatives, oxazole derivatives, oxadiazole derivatives, thiazole derivatives, imidazole derivatives, thiadiazole derivatives, triazole derivatives, pyrazoline derivatives, stilbene derivatives, thiophene derivatives, tetraphenylbutadiene derivatives, cyclopentadiene derivatives, bisstyryl derivatives such as bisstyrylanthracene derivatives and distyrylbenzene derivatives (Japanese Patent Laid-Open No. 1-245087), bisstyrylarylene derivatives (Japanese Patent Laid-Open No. 2-247278), diazaindacene derivatives, furan derivatives, benzofuran derivatives, isobenzofuran derivatives such as phenylisobenzofuran, dimesitylisobenzofuran, di(2-methylphenyl)isobenzofuran, di(2-trifluoromethylphenyl)isobenzofuran, and phenylisobenzofuran, dibenzofuran derivatives, coumarin derivatives such as 7-dialkylaminocoumarin derivatives, 7-piperizinocoumarin derivatives, 7-hydroxycoumarin derivatives, 7-methoxycoumarin derivatives, 7-acetoxycoumarin derivatives, 3-benzothiazolylcoumarin derivatives, 3-benzimidazolylcoumarin derivatives, and 3-benzoxazolylcoumarin derivatives, dicyanomethylenepyran derivatives, dicyanomethylenethiopyran derivatives, polymethine derivatives, cyanine derivatives, oxobenzanthracene derivatives, xanthene derivatives, rhodamine derivatives, fluoresceine derivatives, pyrylium derivatives, carbostyril derivatives, acridine derivatives, oxazine derivatives, phenylene oxide derivatives, quinacridone derivatives, quinazoline derivatives, pyrrolopyridine derivatives, furopyridine derivatives, 1,2,5-thiadiazolopyrene derivatives, pyrromethene derivatives, perinone derivatives, pyrrolopyrrole derivatives, squarylium derivatives, violanthrone derivatives, phenazine derivatives, acridone derivatives, deazaflavin derivatives, fluorene derivatives, and benzofluorene derivatives.

The material for the luminescent layer (host material and dopant material) mentioned above can also be used in the forms of a polymer compound obtained by polymerizing a reactive compound thereof substituted by a reactive substituent as a monomer, or its cross-linked polymer, or a pendant type polymer compound obtained by reacting a backbone type polymer with the reactive compound, or its pendant type cross-linked polymer, as a material for the luminescent layer. In this case, the description about the polycyclic aromatic compound represented by the formula (A-1) mentioned above can be cited about the reactive substituent.

### <Electron injection layer and electron transport layer in organic electroluminescent device>

The electron injection layer 107 plays a role in efficiently injecting electrons transferred from the negative electrode 108 into the luminescent layer 105 or into the electron transport layer 106. The electron transport layer 106 plays a role in efficiently transporting electrons injected from the negative electrode 108 or electrons injected from the negative electrode 108 via the electron injection layer 107 to the luminescent layer 105. Each of the electron transport layer 106 and the electron injection layer 107 is formed by laminating and mixing one or two or more electron transport or injection materials or from a mixture of an electron transport or injection material and a polymer binder.

The electron injection or transport layer is a layer responsible for the injection of electrons from the negative electrode and further transport of the electrons. High electron injection efficiency and efficient transport of injected electrons are desirable. For this purpose, the substance preferably has large electron affinity and a large electron mobility, is excellent in stability, and is unlikely to generate trapping impurities during production and during use. However, in consideration of transport balance between holes and electrons, a substance that plays a main role in being able to efficiently block the flow of holes from the positive electrode to the negative electrode side without recombination has the same level of an effect of improving luminescence efficiency as that of a material having high electron-transporting ability, even if the substance has not so high electron-transporting ability. Thus, the electron injection or transport layer according to the present embodiment may also have the function of a layer that can efficiently block the transfer of holes.

The material that forms the electron transport layer 106 or the electron injection layer 107 (electron transport material) can be used by selecting an arbitrary compound from among conventional compounds commonly used as electron transfer compounds in photoconductive materials, and known compounds for use in electron injection layers and electron transport layers in organic EL devices. In the present invention, the polycyclic aromatic compound represented by the formula (A-1) can be used as this electron transport material.

The material for use in the electron transport layer or the electron injection layer preferably contains at least one member selected from among compounds of aromatic rings or heteroaromatic rings constituted by one or more atoms selected from among carbon, hydrogen, oxygen, sulfur, silicon, and phosphorus, pyrrole derivatives and their condensed ring derivatives, and metal complexes having electron-accepting nitrogen. Specific examples thereof include condensed ring type aromatic ring derivatives such as naphthalene and anthracene, styryl type aromatic ring derivatives typified by 4,4'-bis(diphenylethenyl)biphenyl, perinone derivatives, coumarin derivatives, naphthalimide derivatives, quinone derivatives such as anthraquinone and diphenoquinone, phosphorus oxide derivatives, carbazole derivatives, and indole derivatives. Examples of the metal complex having electron-accepting nitrogen include hydroxyazole complexes such as hydroxyphenyloxazole complexes, azomethine complexes, tropolone metal complexes, flavonol metal complexes, and benzoquinoline metal complexes. These materials may be used singly or may be used as a mixture with different materials.

Other specific examples of the electron transfer compound include pyridine derivatives, naphthalene derivatives, anthracene derivatives, phenanthroline derivatives, perinone derivatives, coumarin derivatives, naphthalimide derivatives, anthraquinone derivatives, diphenoquinone derivatives, diphenylquinone derivatives, perylene derivatives, oxadiazole derivatives (1,3-bis[(4-t-butylphenyl)1,3,4-oxadiazolyl]phenylene, etc.), thiophene derivatives, triazole derivatives (N-naphthyl-2,5-diphenyl-1,3,4-triazole, etc.), thiadiazole derivatives, metal complexes of oxine derivatives, quinolinol metal complexes, quinoxaline derivatives, polymers of quinoxaline derivatives, benzazole compounds, gallium complexes, pyrazole derivatives, perfluorinated phenylene derivatives, triazine derivatives, pyrazine derivatives, benzoquinoline derivatives (2,2'-bis(benzo[h]quinolin-2-yl)-9,9'-spirobifluorene, etc.), imidazopyridine derivatives, borane derivatives, benzimidazole derivatives (tris(N-phenylbenzimidazol-2-yl)benzene, etc.), benzoxazole derivatives, benzothiazole derivatives, quinoline derivatives, oligo pyridine derivatives such as terpyridine, bipyridine derivatives, terpyridine derivatives (1,3-bis(4'-(2,2':6'2"-terpyridinyl))benzene, etc.), naphthyridine derivatives (bis(1-naphthyl)-4-(1,8-naphthyridin-2-yl)phenylphosphine oxide, etc.), aldazine derivatives, carbazole derivatives, indole derivatives, phosphorus oxide derivatives, and bisstyryl derivatives.

A metal complex having electron-accepting nitrogen may be used. Examples thereof include quinolinol metal complexes, hydroxyazole complexes such as hydroxyphenyloxazole complexes, azomethine complexes, tropolone metal complexes, flavonol metal complexes, and benzoquinoline metal complexes.

The materials mentioned above may be used singly or may be used as a mixture with different materials.

Among the materials mentioned above, borane derivatives, pyridine derivatives, fluoranthene derivatives, BO derivatives, anthracene derivatives, benzofluorene derivatives, phosphine oxide derivatives, pyrimidine derivatives, carbazole derivatives, triazine derivatives, benzimidazole derivatives, phenanthroline derivatives, and quinolinol metal complexes described in Japanese Patent Laid-Open No. 2021-14446 are preferred.

The electron transport layer or the electron injection layer may further contain a substance that can reduce the material that forms the electron transport layer or the electron injection layer. Various substances can be used as this reducing substance as long as the substances have given reducing properties. For example, at least one member selected from the group consisting of an alkali metal, an alkaline earth metal, a rare earth metal, alkali metal oxide, alkali metal halide, alkaline earth metal oxide, alkaline earth metal halide, rare earth metal oxide, rare earth metal halide, an organic complex of an alkali metal, an organic complex of an alkaline earth metal, and an organic complex of a rare earth metal can be suitably used.

Preferred examples of the reducing substance include alkali metals such as Na (work function: 2.36 eV), K (work function: 2.28 eV), Rb (work function: 2.16 eV), and Cs (work function: 1.95 eV), and alkaline earth metals such as Ca (work function: 2.9 eV), Sr (work function: 2.0 to 2.5 eV), and Ba (work function: 2.52 eV). A substance having a work function of 2.9 eV or less is particularly preferred. Among them, the reducing substance is more preferably an alkali metal K, Rb, or Cs, further preferably Rb or Cs, most preferably Cs. Such an alkali metal has particularly high reducing ability and achieves improvement in luminescence brightness or long lifetime for the organic EL device by addition in a relatively small amount to the material that forms the electron transport layer or the electron injection layer. A combination of two or more of these alkali metals is also preferred as the reducing substance having a work function of 2.9 eV or less. Particularly, a combination including Cs, for example, a combination of Cs and Na, Cs and K, Cs and Rb, or Cs and Na and K, is preferred. The substance containing Cs can efficiently exert reducing ability and achieves improvement in luminescence brightness or long lifetime for the organic EL device by addition to the material that forms the electron transport layer or the electron injection layer.

The material for the electron injection layer and the material for the electron transport layer mentioned above can also be used in the forms of a polymer compound obtained by polymerizing a reactive compound thereof substituted by a reactive substituent as a monomer, or its cross-linked polymer, or a pendant type polymer compound obtained by reacting a backbone type polymer with the reactive compound, or its pendant type cross-linked polymer, as materials for the electron layers. In this case, the description about the polycyclic aromatic compound represented by the formula (A-1) mentioned above can be cited about the reactive substituent.

### <Negative electrode in organic electroluminescent device>

The negative electrode 108 plays a role in injecting electrons to the luminescent layer 105 via the electron injection layer 107 and the electron transport layer 106.

The material that forms the negative electrode 108 is not particularly limited as long as the substance can efficiently inject electrons to an organic layer. The same or similar material as the material that forms the positive electrode 102 can be used. Among them, the material is preferably, for example, a metal such as tin, indium, calcium, aluminum, silver, copper, nickel, chromium, gold, platinum, iron, zinc, lithium, sodium, potassium, cesium, or magnesium, or an alloy thereof (magnesium-silver alloy, magnesium-indium alloy, aluminum-lithium alloy such as lithium fluoride/aluminum, etc.). Lithium, sodium, potassium, cesium, calcium, or magnesium, or an alloy containing such a metal having a low work function is effective for enhancing electron injection efficiency and improving device characteristics. However, in general, these metals having a low work function are often unstable in atmosphere. For example, a method using a highly stable electrode by doping an organic layer with a trace amount of lithium, cesium, or magnesium is known in order to improve this point. Inorganic salts such as lithium fluoride, cesium fluoride, lithium oxide, and cesium oxide can also be used as other dopants, though the dopant is not limited thereto.

Preferred examples of electrode protection include lamination with metals such as platinum, gold, silver, copper, iron, tin, aluminum, and indium, or alloys of these metals, inorganic materials such as silica, titania, and silicon nitride, polyvinyl alcohols, vinyl chloride, or hydrocarbon polymer compounds. Methods for preparing these electrodes are not particularly limited and include, for example, resistive heating, electron beam deposition, sputtering, ion plating, and coating as long as conduction can be attained.

### <Binder that may be used in each layer>

The materials for use in the hole injection layer, the hole transport layer, the luminescent layer, the electron transport layer, and the electron injection layer mentioned above can form, alone, their respective layers and may be dispersed, for use, in a polymer binder such as polyvinyl chloride, polycarbonate, polystyrene, poly(N-vinylcarbazole), polymethyl methacrylate, polybutyl methacrylate, polyester, polysulfone, polyphenylene oxide, polybutadiene, a solvent-soluble resin including hydrocarbon resin, ketone resin, phenoxy resin, polyamide, ethylcellulose, vinyl acetate resin, ABS resin, and polyurethane resin, or a curable resin including phenol resin, xylene resin, petroleum resin, urea resin, melamine resin, unsaturated polyester resin, alkyd resin, epoxy resin, and silicone resin.

### <Method for preparing organic electroluminescent device>

Each layer constituting the organic EL device can be formed by preparing a material supposed to constitute each layer into a thin film by a method such as a deposition method, a resistivity heating deposition, electron beam deposition, sputtering, a molecular lamination method, a printing method, a spin coating method, a casting method, or a coating method. The film thickness of each layer thus formed is not particularly limited and can be appropriately set depending on the properties of the material. The film thickness is usually in the range of 2 nm to 5000 nm. The film thickness can usually be measured using a crystal oscillation type film thickness measurement apparatus or the like. In the case of preparing a thin film by use of a deposition method, the deposition conditions differ depending on the type of the material, an intended crystal structure and associated structure of the film, and the like. In general, the deposition conditions are appropriately set within the ranges of preferably a boat heating temperature of +50 to +400°C, a vacuum of 10⁻⁶ to 10⁻³ Pa, a deposition rate of 0.01 to 50 nm/sec, a substrate temperature of -150 to +300°C, and a film thickness of 2 nm to 5 µm.

In the case of applying direct-current voltage to the organic EL device thus obtained, the voltage can be applied with the positive electrode having + polarity and the negative electrode having - polarity. When voltage on the order of 2 to 40 V is applied, luminescence can be observed from a transparent or translucent electrode side (positive electrode or negative electrode, or both). This organic EL device also emits luminescence when pulse current or alternating current is applied thereto. The alternating current to be applied can have an arbitrary waveform.

Next, a method for preparing an organic EL device composed of positive electrode/hole injection layer/hole transport layer/luminescent layer made of a host material and a dopant material/electron transport layer/electron injection layer/negative electrode will be described as one example of the method for preparing the organic EL device.

### <Deposition method>

A thin film of a positive electrode material is formed on an appropriate substrate by a deposition method or the like to prepare a positive electrode. Then, thin films of a hole injection layer and a hole transport layer are formed on this positive electrode. A host material and a dopant material are co-evaporated thereonto to form a thin film serving as a luminescent layer. An electron transport layer and an electron injection layer are formed on this luminescent layer. A thin film made of a substance for a negative electrode is further formed thereon by a deposition method or the like to prepare a negative electrode. In this way, the organic EL device of interest can be obtained. In the preparation of the organic EL device mentioned above, the order of preparation may be reversed to prepare a negative electrode, an electron injection layer, an electron transport layer, a luminescent layer, a hole transport layer, a hole injection layer, and a positive electrode in this order.

### <Application example of organic electroluminescent device>

The present invention can also be applied to, for example, a display comprising the organic EL device or a lighting comprising the organic EL device.

The display or the lighting comprising the organic EL device can be produced by a known method of, for example, connecting the organic EL device according to the present embodiment to a known drive system, and can be driven by appropriately using a known driving method such as direct-current drive, pulse drive, or alternating-current drive.

Examples of the display include panel displays such as color flat panel displays, and flexible displays such as flexible color organic electroluminescent (EL) displays (see, for example, Japanese Patent Laid-Open Nos. 10-335066, 2003-321546, and 2004-281086). Examples of the display mode of the display include matrix and segment modes. The matrix display and the segment display may coexist in the same panel.

In the matrix, pixels for display are two-dimensionally arranged in a grid or mosaic pattern or the like, and the assembly of the pixels displays characters or images. The shape or size of the pixels is determined depending on a purpose. For example, square pixels of 300 µm or smaller per side are usually used in the image and character display of a personal computer, a monitor, or a television, and pixels of a mm order per side are used for a large display such as a display panel. Pixels of the same color can be arranged for monochrome display, whereas red, green, and blue pixels are arranged for color display. This case typically includes delta type and stripe type. A method for driving this matrix may be a line-sequential driving method or an active matrix. The line-sequential drive is advantageous in that the structure is simple. The active matrix may be superior in consideration of operating characteristics. Therefore, these approaches also need to be used differently depending on purposes.

In the segment mode (type), a pattern is formed so as to display predetermined information, and luminescence is caused in a determined region. Examples thereof include time or temperature display in digital clocks and thermometers, operating state display of audio equipment and electromagnetic cookers, and panel display of automobiles.

Examples of the lighting include lightings such as interior illuminations, and backlights of liquid crystal displays (see, for example, Japanese Patent Laid-Open Nos. 2003-257621, 2003-277741, and 2004-119211). The backlight is used mainly for the purpose of improving the visibility of a non-self-luminous display and used in liquid crystal displays, clocks, audio equipment, automobile panels, display panels, signs, and the like. Particularly, as for backlights for liquid crystal displays, particularly, backlights for personal computers, a challenge to which is thinning, a backlight using the luminescent device according to the present embodiment is characterized by being thin and having a light weight, in consideration of a conventional mode difficult to thin due to its constituent fluorescent light or light guide plate.

### 3-2. Other organic devices

The polycyclic aromatic compound according to the present invention can be used in the preparation of, for example, an organic field-effect transistor, an organic photovoltaic, or a wavelength conversion filter, in addition to the organic electroluminescent device mentioned above.

The organic field-effect transistor refers to a transistor that controls current by an electric field generated by voltage input, and is provided with a source electrode and a drain electrode as well as a gate electrode. When voltage is applied to the gate electrode, the transistor generates an electric field and can control current by arbitrarily stemming the flow of electrons (or holes) between the source electrode and the drain electrode. The field-effect transistor is easily downsized as compared with a mere transistor (bipolar transistor), and is frequently used as a device constituting an integrated circuit or the like.

The structure of the organic field-effect transistor can usually be provided with the source electrode and the drain electrode in contact with an organic semiconductor active layer formed using the polycyclic aromatic compound according to the present invention, and further provided with the gate electrode flanking an insulating layer (dielectric layer) in contact with the organic semiconductor active layer. Examples of the device structure include the following structures:
(1) substrate/gate electrode/insulator layer/source electrode and drain electrode/organic semiconductor active layer,
(2) substrate/gate electrode/insulator layer/organic semiconductor active layer/source electrode and drain electrode,
(3) substrate/organic semiconductor active layer/source electrode and drain electrode/insulator layer/gate electrode, and
(4) substrate/source electrode and drain electrode/organic semiconductor active layer/insulator layer/gate electrode.

The organic field-effect transistor thus configured can be applied to a liquid crystal display in an active matrix-driven mode, a pixel-driven switching device of an organic electroluminescent display, or the like.

The organic photovoltaic has a structure where a positive electrode such as ITO, a hole transport layer, a photoelectric conversion layer, an electron transport layer, and a negative electrode are laminated on a transparent substrate such as glass. The photoelectric conversion layer has a p type semiconductor layer on the positive electrode side and an n type semiconductor layer on the negative electrode side. The polycyclic aromatic compound according to the present invention may be used as a material for the hole transport layer, the p type semiconductor layer, the n type semiconductor layer, or the electron transport layer depending on its physical properties. The polycyclic aromatic compound according to the present invention is capable of functioning as a hole transport material or an electron transport material in the organic photovoltaic. The organic photovoltaic can appropriately has, in addition to the layers described above, a hole block layer, an electron block layer, an electron injection layer, a hole injection layer, a smoothing layer, or the like. In the organic photovoltaic, known materials for use in organic photovoltaics can be appropriately selected and used in combination.

Active studies are currently underway on the application of multicolor technology based on a color conversion scheme to liquid crystal displays, organic EL displays, illuminations, and the like. The color conversion is the wavelength conversion of luminescence from a luminescent material to light with a longer wavelength and refers to, for example, the conversion of ultraviolet light or blue light to green light or red luminescence. Three primary colors of blue, green, and red colors, i.e., white light, may be isolated from, for example, a blue light source, by preparing a wavelength conversion material having such a color conversion function into a film, and combining the film with the blue light source. A full-color display may be prepared by preparing a light source unit from such a blue light source and a white light source combined with the wavelength conversion filter having the color conversion function, and combining this unit with a liquid crystal-driven moiety and a color filter. In the absence of the liquid crystal-driven moiety, this display can be used directly as a white light source and can be applied to, for example, a white light source for LED illuminations. A full-color organic EL display may be prepared without the use of a metal mask, by using a blue organic EL device as a light source in combination with wavelength conversion filters that convert blue light to green light and red light. A full-color micro-LED display may be prepared at low cost by using blue micro-LED as a light source in combination with wavelength conversion filters that convert blue light to green light and red light.

The polycyclic aromatic compound of the present invention can be used as a material for use in this wavelength conversion filter. Use of the wavelength conversion filter comprising the polycyclic aromatic compound of the present invention can convert ultraviolet light or light from a light source or a luminescent device that generates blue color with a shorter wavelength to blue light or green light with high color purity suitable for use in displays (displays using the organic EL device, or liquid crystal displays). The color to be converted can be adjusted by appropriately selecting a substituent in the polycyclic aromatic compound of the present invention, a binder resin for use in a composition for wavelength conversion mentioned later, or thee like. The wavelength conversion material can be prepared as a composition for wavelength conversion comprising the polycyclic aromatic compound of the present invention. A wavelength conversion filter may be formed using this composition for wavelength conversion.

The composition for wavelength conversion may comprise a binder resin, other additives, and a solvent, in addition to the polycyclic aromatic compound of the present invention. For example, a binder resin described in the paragraphs 0173 to 0176 of International Publication No. WO 2016/190283 can be used. Compounds described in the paragraphs 0177 to 0181 of International Publication No. WO 2016/190283 can be used as other additives. For the solvent, see the description of the solvent contained in the composition for luminescent layer formation described above.

The wavelength conversion filter comprises a wavelength conversion layer formed by curing the composition for wavelength conversion. For a method for preparing the wavelength conversion layer from the composition for wavelength conversion, see a known film formation method. The wavelength conversion filter may consist of only the wavelength conversion layer formed from the composition comprising the polycyclic aromatic compound of the present invention or may comprise other wavelength conversion layers (e.g., a wavelength conversion layer that converts blue light to green light or red light and a wavelength conversion layer that converts blue light or green light to red light). The wavelength conversion filter may further comprise a base material layer, and a barrier layer for preventing the deterioration of the color conversion layer due to oxygen, moisture, or heat.

### Examples

Hereinafter, the present invention will be further specifically described with reference to Examples. However, the present invention is not limited by these examples. First, Synthesis Examples of polycyclic aromatic compounds will be described below.

### <Synthesis Example (1): Synthesis of compound (1)>

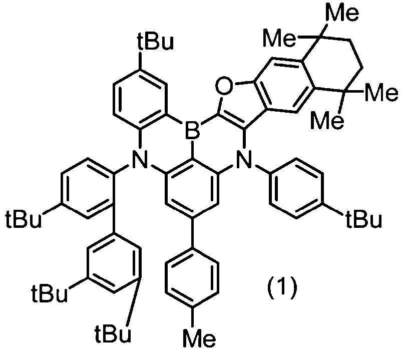

In a nitrogen atmosphere, 5-bromo-1,2,3-trichlorobenzene (26.0 g), 4-methylphenylboronic acid (13.6 g), tetrakis(triphenylphosphine)palladium(0) (3.5 g) as a palladium catalyst, potassium carbonate (20.7 g), toluene (100 ml), and water (10 mL) were placed in a flask and heated at a reflux temperature for 5 hours. After the completion of reaction, water and ethyl acetate were added to the reaction solution, and the mixture was stirred. Then, an organic layer was separated and washed with water. Then, the organic layer was concentrated, and the obtained crude product was purified with a silica gel short column (eluent: toluene/heptane = 1/4 (volume ratio)) to obtain an intermediate (Int-1-1) (24.2 g).

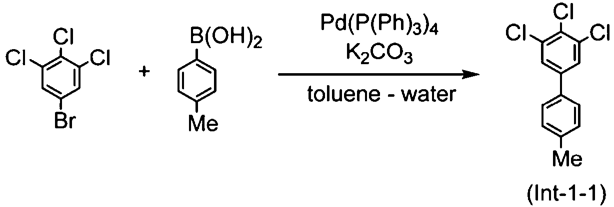

In a nitrogen atmosphere, the intermediate (Int-1-1) (19.0 g), the intermediate (Int-1-2) (32.9 g), dichlorobis[di-t-butyl(4-dimethylaminophenyl)phosphino]palladium(II) (Pd-132 (1.5 g) as a palladium catalyst, tBuONa (10.1 g), and toluene (100 ml) were placed in a flask and heated at a reflux temperature for 8 hours. After the completion of reaction, water and ethyl acetate were added to the reaction solution, and the mixture was stirred. Then, an organic layer was separated and washed with water. Then, the organic layer was concentrated, and the obtained crude product was purified with a silica gel short column (eluent: toluene/heptane = 1/4 (volume ratio)) to obtain an intermediate (Int-1-3) (36.9 g).

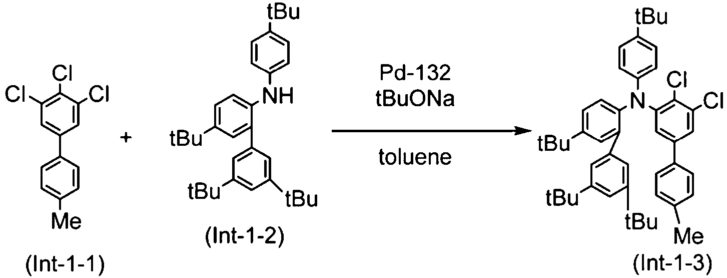

In a nitrogen atmosphere, the intermediate (Int-1-3) (35.2 g), the intermediate (Int-1-4) (18.8 g), Pd-132 (1.1 g) as a palladium catalyst, tBuONa (7.2 g), and toluene (300 ml) were placed in a flask and heated at a reflux temperature for 6 hours. After the completion of reaction, water and ethyl acetate were added to the reaction solution, and the mixture was stirred. Then, an organic layer was separated and washed with water. Then, the organic layer was concentrated, and the obtained crude product was purified with a silica gel short column (eluent: toluene/heptane = 1/5 (volume ratio)) to obtain an intermediate (Int-1) (32.2 g).

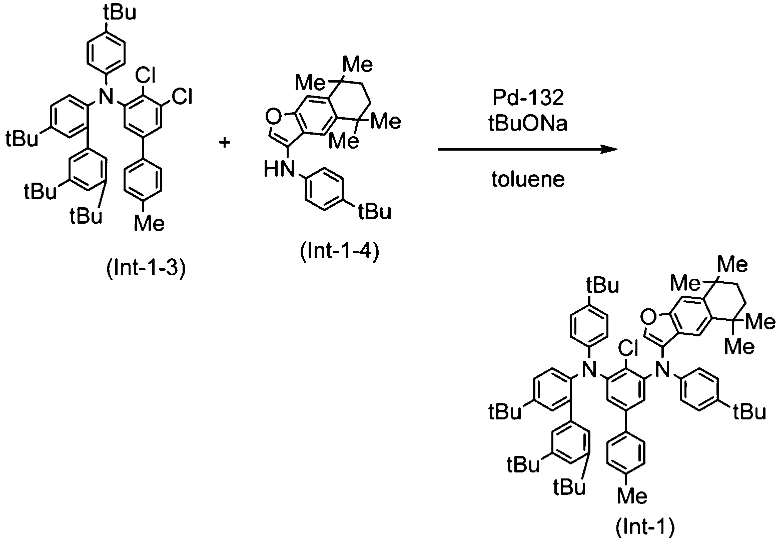

In a nitrogen atmosphere, a 1.60 M solution of t-butyllithium in pentane (12.5 ml) was added at 0°C to a flask containing the intermediate (Int-1) (10.4 g) and t-butylbenzene (100 ml). After the completion of dropwise addition, the mixture was warmed to 70°C and stirred for 0.5 hours. Then, components having a lower boiling point than that of t-butylbenzene were distilled off under reduced pressure. After cooling to -50°C, boron tribromide (3.8 g) was added to the residue, and the mixture was warmed to room temperature and stirred for 0.5 hours. Then, after cooling to 0°C again, N,N-diisopropylethylamine (3.9 g) was added to the reaction solution, and the mixture was stirred at room temperature until heat was no longer generated, then warmed to 100°C, and heated and stirred for 1 hour. The reaction solution was cooled to room temperature and separated into organic and aqueous layers by the addition of an aqueous sodium acetate solution cooled in an ice bath and subsequently ethyl acetate. The organic layer was concentrated and then purified with a silica gel short column (eluent: toluene/heptane = 1/5 (volume ratio)). The obtained crude product was recrystallized from toluene to obtain a compound (1) (1.0 g).

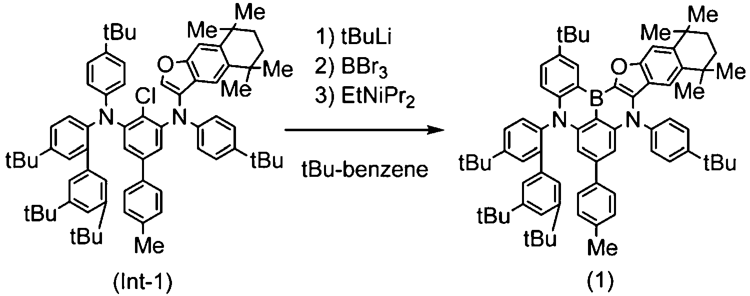

A target compound of m/z(M+H) = 1017.68 was confirmed by APCI-MS.

### Synthesis Example (2): Synthesis of compound (2)

A compound (2) was obtained from an intermediate (Int-2) in the same manner as in Synthesis Example (1).

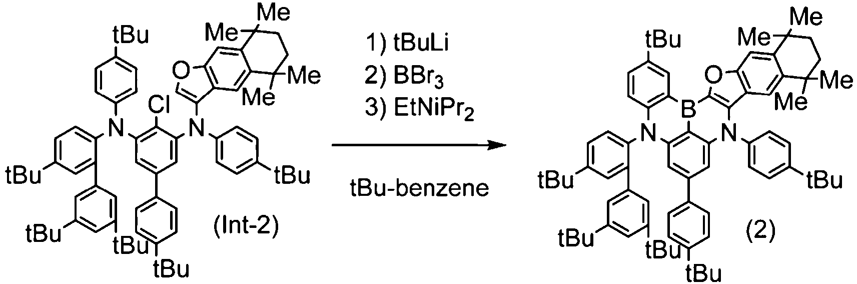

A target compound was confirmed by NMR measurement.
¹H-NMR (500 MHz, CDCl₃): δ = 8.75 (d, 1H), 7.76-7.70 (m, 2H), 7.68 (d, 1H), 7.63 (dd, 1H), 7.55 (s, 1H), 7.50 (dd, 1H), 7.43 (dd, 1H), 7.40-7.28 (m, 6H), 6.94 (t, 1H), 6.89 (d, 2H), 6.61-6.57 (m, 2H), 6.48 (s, 1H), 5.85 (s, 1H), 1.70-1.60 (m, 4H), 1.50 (s, 9H), 1.48 (s, 9H), 1.45 (s, 9H), 1.35 (s, 6H), 1.32 (s, 9H), 1.02-0.98 (m, 6H), 0.88 (s, 18H).

### Synthesis Example (3): Synthesis of compound (3)

A compound (3) was obtained from an intermediate (Int-3) in the same manner as in Synthesis Example (1).

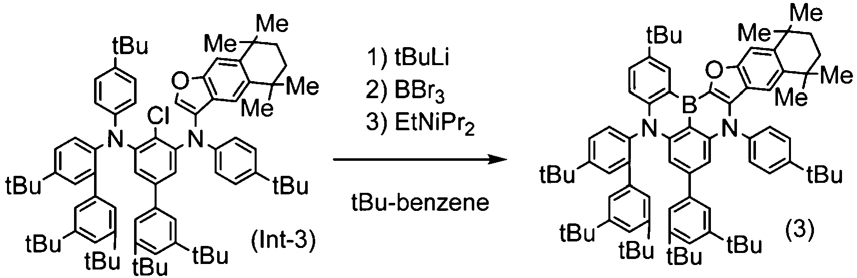

A target compound was confirmed by NMR measurement.
¹H-NMR (500 MHz, CDCl₃): δ = 8.74 (d, 1H), 7.76-7.67 (m, 3H), 7.63 (d, 1H), 7.56 (s, 1H), 7.53 (dd, 1H), 7.45 (dd, 1H), 7.41 (d, 1H), 7.34 (dd, 1H), 7.33 (t, 1H), 7.21 (d, 2H), 6.94 (t, 1H), 6.89 (d, 2H), 6.75 (d, 1H), 6.56 (s, 1H), 6.40 (s, 1H), 5.99 (s, 1H), 1.70-1.60 (m, 4H), 1.48-1.43 (m, 27H), 1.37-1.34 (m, 6H), 1.25 (s, 18H), 1.01-0.98 (m, 6H), 0.87 (s, 18H).

### Synthesis Example (4): Synthesis of compound (4)

A compound (4) was obtained from an intermediate (Int-4) in the same manner as in Synthesis Example (1).

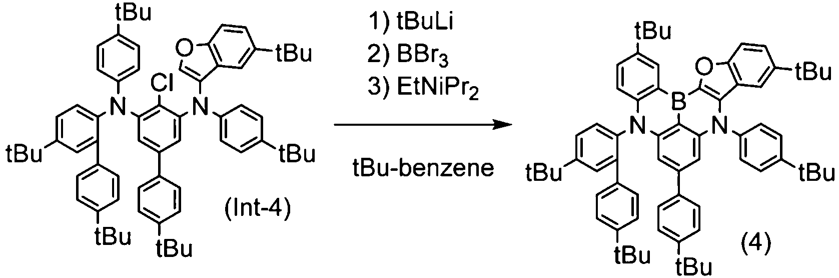

A target compound of m/z(M+H) = 949.62 was confirmed by APCI-MS.

### Synthesis Example (5): Synthesis of compound (5)

A compound (5) was obtained from an intermediate (Int-5) in the same manner as in Synthesis Example (1).

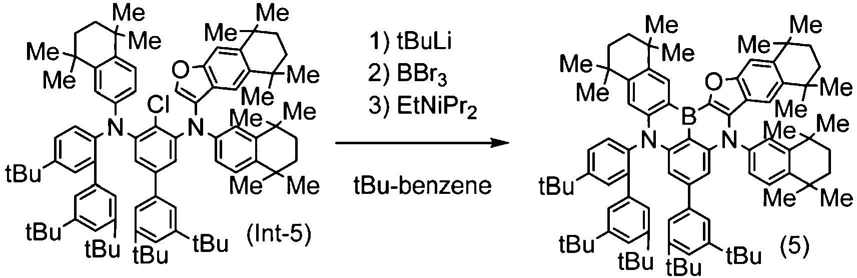

A target compound of m/z(M+H) = 1223.89 was confirmed by APCI-MS.

### Synthesis Example (6): Synthesis of compound (6)

A compound (6) was obtained from an intermediate (Int-6) in the same manner as in Synthesis Example (1).

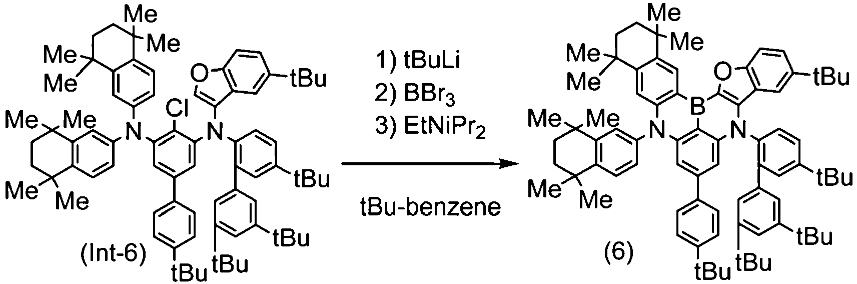

A target compound was confirmed by NMR measurement.
¹H-NMR (500 MHz, CDCl₃): δ = 8.70 (s, 1H), 7.72 (m, 2H), 7.58 (m, 2H), 7.48 (d, 1H), 7.36 (m, 6H), 7.14 (m, 1H), 6.96 (m, 2H), 6.88 (s, 2H), 6.76 (s, 1H), 6.37 (s, 1H), 6.14 (s, 1H), 1.82 (m, 4H), 1.70 (m, 4H), 1.53 (s, 9H), 1.47 (m, 6H), 1.40 (s, 6H), 1.34 (s, 12H), 1.27 (d, 3H), 1.22 (s, 9H), 1.07 (d, 6H), 0.81 (s, 9H), 0.79 (s, 9H).

### Synthesis Example (7): Synthesis of compound (7)

A compound (7) was obtained from an intermediate (Int-7) in the same manner as in Synthesis Example (1).

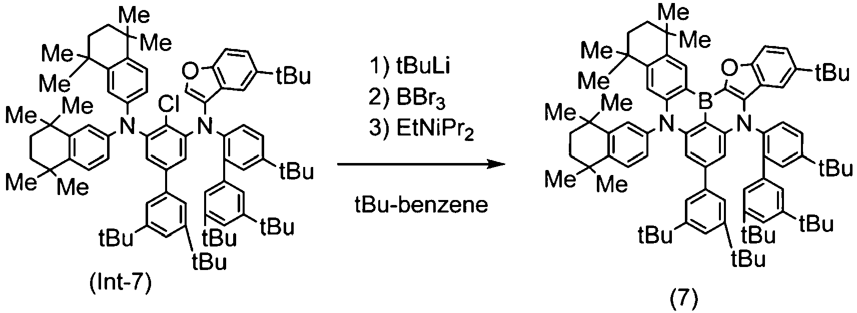

A target compound was confirmed by NMR measurement.
¹H-NMR (500 MHz, CDCl₃): δ = 8.68 (s, 1H), 7.70 (m, 2H), 7.55 (m, 2H), 7.48 (d, 1H), 7.38 (m, 2H), 7.30 (s, 1H), 7.24 (m, 2H), 7.04 (m, 1H), 6.91 (d, 1H), 6.87 (s, 1H), 6.80 (s, 1H), 6.74 (s, 1H), 6.45 (d, 1H), 6.32 (s, 1H), 6.28 (d, 1H), 1.78 (m, 4H), 1.70 (m, 4H), 1.54 (s, 3H), 1.47 (s, 15H), 1.41 (d, 3H), 1.36 (m, 6H), 1.27 (s, 9H), 1.25 (s, 9H), 1.21 (s, 9H), 1.07 (d, 6H), 0.81 (s, 9H), 0.79 (s, 9H).

### Synthesis Example (8): Synthesis of compound (8)

A compound (8) was obtained from an intermediate (Int-8) in the same manner as in Synthesis Example (1).

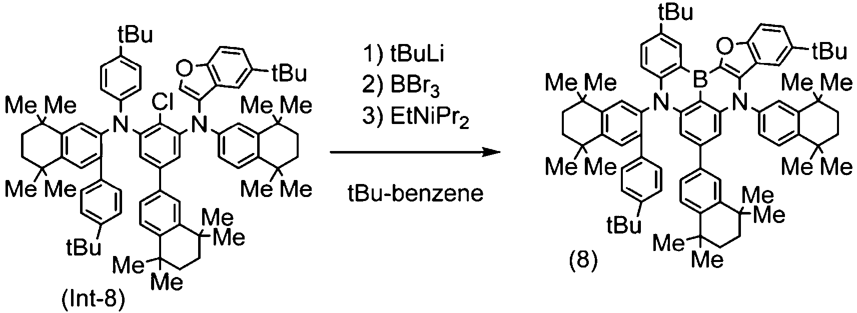

A target compound of m/z(M+H) = 1111.76 was confirmed by APCI-MS.

### Synthesis Example (9): Synthesis of compound (9)

A compound (9) was obtained from an intermediate (Int-9) in the same manner as in Synthesis Example (1).

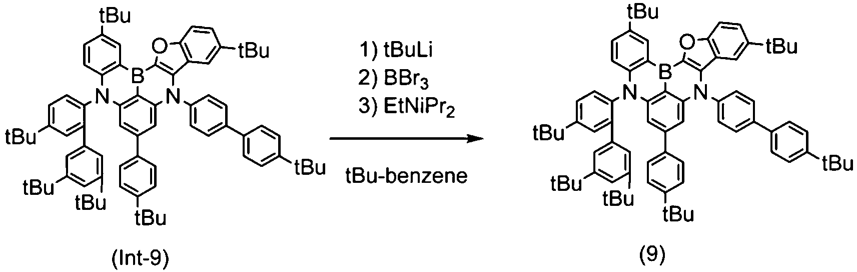

A target compound of m/z(M+H) = 1081.71 was confirmed by APCI-MS.

### Synthesis Example (10): Synthesis of compound (10)

A compound (10) was obtained from an intermediate (Int-10) in the same manner as in Synthesis Example (1).

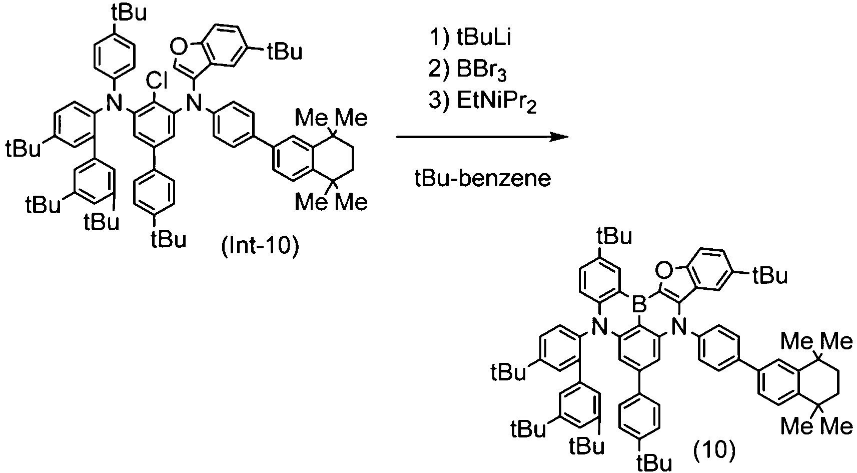

A target compound of m/z(M+H) = 1135.76 was confirmed by APCI-MS.

### Synthesis Example (11): Synthesis of compound (11)

A compound (11) was obtained from an intermediate (Int-11) in the same manner as in Synthesis Example (1).

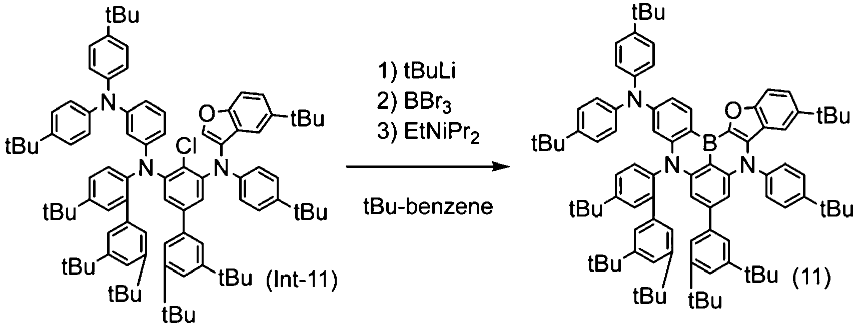

A target compound of m/z(M+H) = 1284.88 was confirmed by APCI-MS.

### Synthesis Example (12): Synthesis of compound (12)

A compound (12) was obtained from an intermediate (Int-12) in the same manner as in Synthesis Example (1).

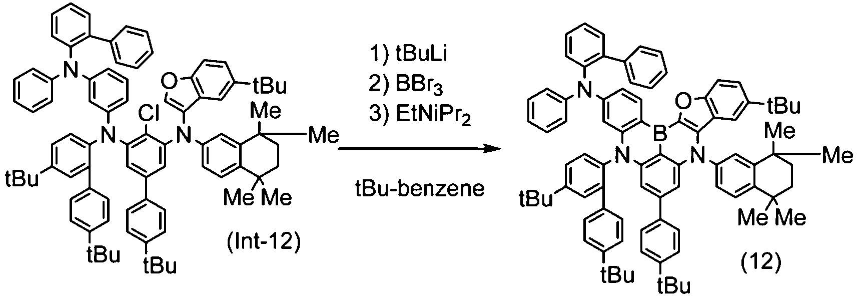

A target compound of m/z(M+H) = 1190.71 was confirmed by APCI-MS.

### Synthesis Example (13): Synthesis of compound (13)

A compound (13) was obtained from an intermediate (Int-13) in the same manner as in Synthesis Example (1).

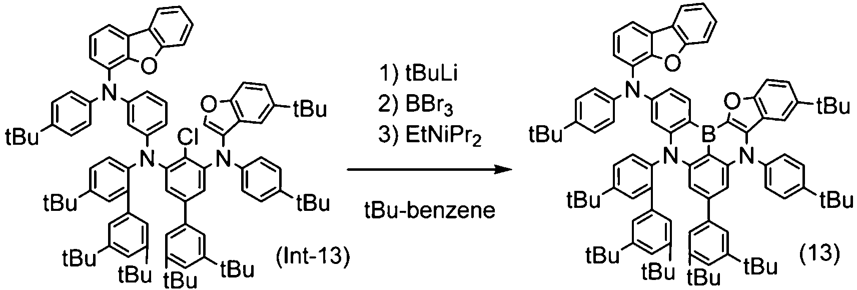

A target compound of m/z(M+H) = 1318.83 was confirmed by APCI-MS.

### Synthesis Example (14): Synthesis of compound (15)

A compound (15) was obtained from an intermediate (Int-15) in the same manner as in Synthesis Example (1).

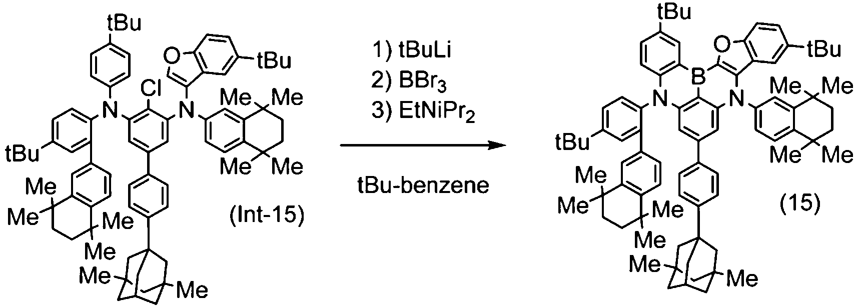

A target compound of m/z(M+H) = 1163.79 was confirmed by APCI-MS.

### Synthesis Example (15): Synthesis of compound (16)

A compound (16) was obtained from an intermediate (Int-16) in the same manner as in Synthesis Example (1).

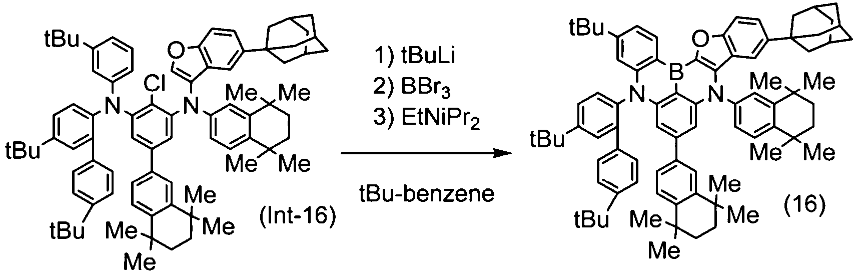

A target compound of m/z(M+H) = 1135.76 was confirmed by APCI-MS.

### Synthesis Example (16): Synthesis of compound (18)

A compound (18) was obtained from an intermediate (Int-18) in the same manner as in Synthesis Example (1).

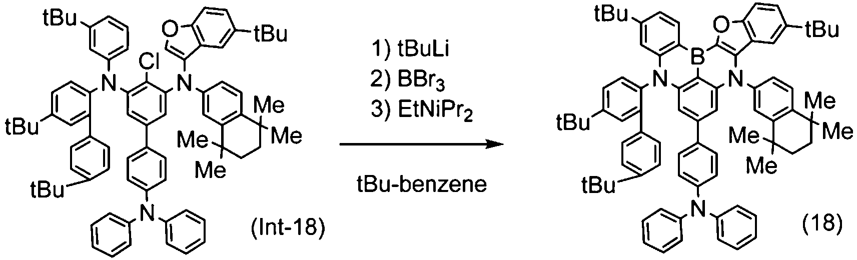

A target compound of m/z(M+H) = 1114.68 was confirmed by APCI-MS.

### Synthesis Example (17): Synthesis of compound (21)

A compound (21) was obtained from an intermediate (Int-21) in the same manner as in Synthesis Example (1).

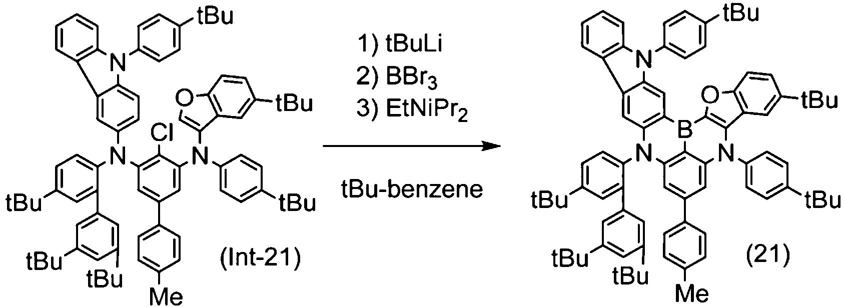

A target compound of m/z(M+H) = 1128.69 was confirmed by APCI-MS.

### Synthesis Example (18): Synthesis of compound (22)

A compound (22) was obtained from an intermediate (Int-22) in the same manner as in Synthesis Example (1).

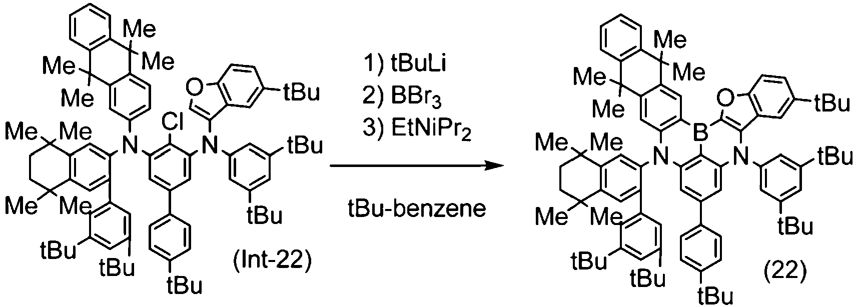

A target compound of m/z(M+H) = 1217.84 was confirmed by APCI-MS.

### Synthesis Example (19): Synthesis of compound (23)

A compound (23) was obtained from an intermediate (Int-23) in the same manner as in Synthesis Example (1).

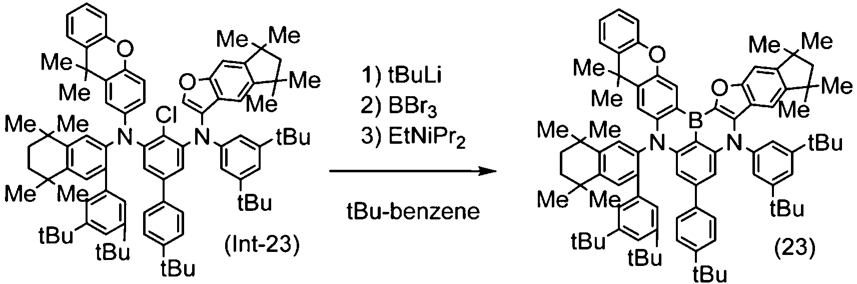

A target compound of m/z(M+H) = 1231.82 was confirmed by APCI-MS.

### Synthesis Example (20): Synthesis of compound (24)

A compound (24) was obtained from an intermediate (Int-24) in the same manner as in Synthesis Example (1).

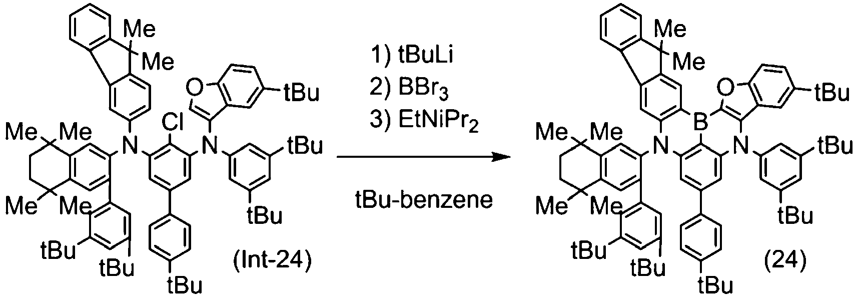

A target compound of m/z(M+H) = 1175.79 was confirmed by APCI-MS.

### Synthesis Example (21): Synthesis of compound (25)

A compound (25) was obtained from an intermediate (Int-25) in the same manner as in Synthesis Example (1).

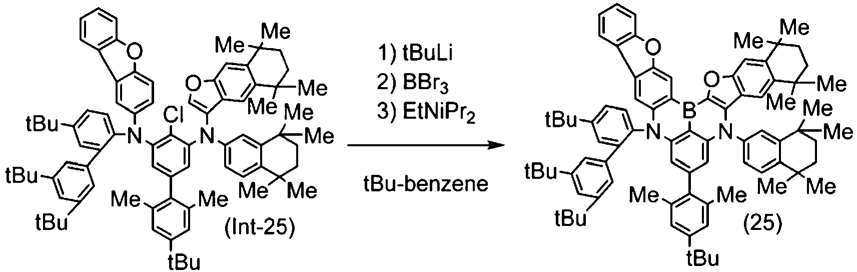

A target compound of m/z(M+H) = 1175.76 was confirmed by APCI-MS.

### Synthesis Example (22): Synthesis of compound (26)

A compound (26) was obtained from an intermediate (Int-26) in the same manner as in Synthesis Example (1).

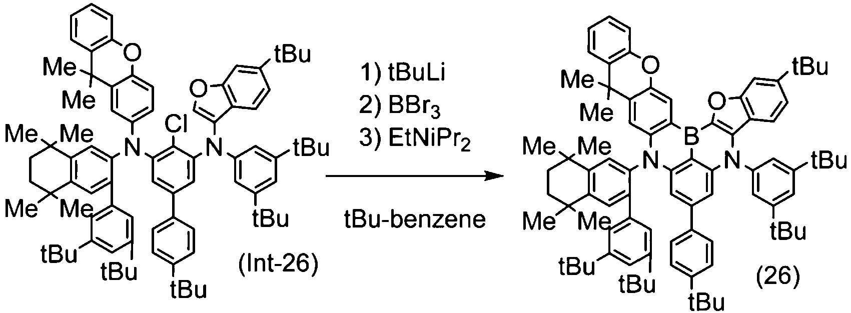

A target compound of m/z(M+H) = 1191.79 was confirmed by APCI-MS.

### Synthesis Example (23): Synthesis of compound (31)

A compound (31) was obtained from an intermediate (Int-31) in the same manner as in Synthesis Example (1).

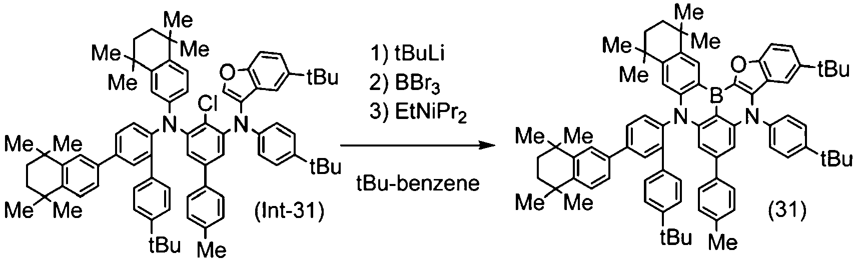

A target compound of m/z(M+H) = 1091.70 was confirmed by APCI-MS.

### Synthesis Example (24): Synthesis of compound (32)

A compound (32) was obtained from an intermediate (Int-32) in the same manner as in Synthesis Example (1).

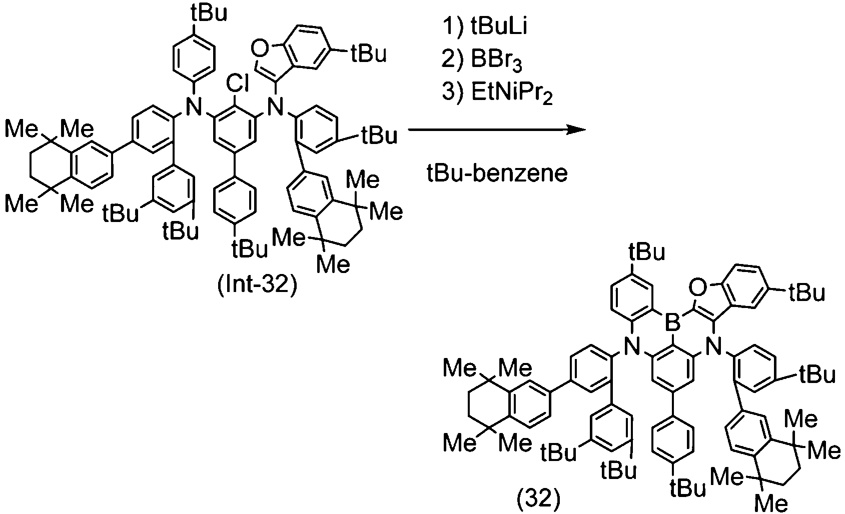

A target compound of m/z(M+H) = 1321.90 was confirmed by APCI-MS.

### Synthesis Example (25): Synthesis of compound (33)

A compound (33) was obtained from an intermediate (Int-33) in the same manner as in Synthesis Example (1).

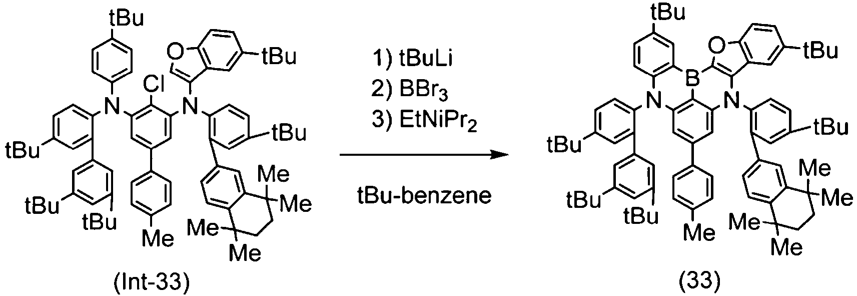

A target compound of m/z(M+H) = 1149.78 was confirmed by APCI-MS.

### Synthesis Example (26): Synthesis of compound (34)

A compound (34) was obtained from an intermediate (Int-34) in the same manner as in Synthesis Example (1).

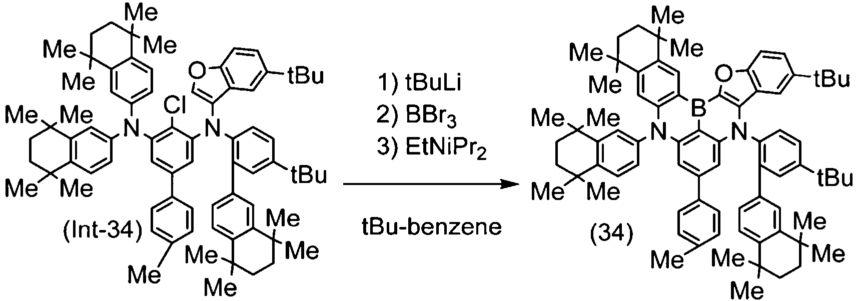

A target compound of m/z(M+H) = 1069.71 was confirmed by APCI-MS.

### Synthesis Example (27): Synthesis of compound (35)

A compound (35) was obtained from an intermediate (Int-35) in the same manner as in Synthesis Example (1).

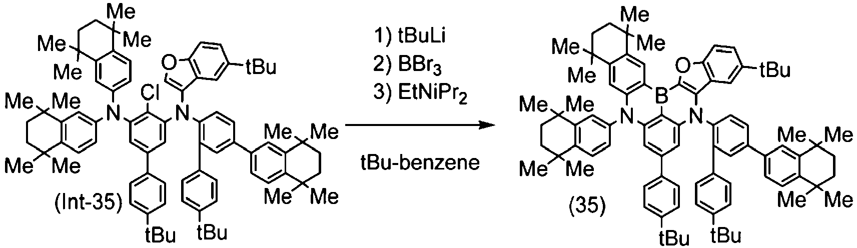

A target compound of m/z(M+H) = 1187.79 was confirmed by APCI-MS.

### Synthesis Example (28): Synthesis of compound (40)

A compound (40) was obtained from an intermediate (Int-40) in the same manner as in Synthesis Example (1).

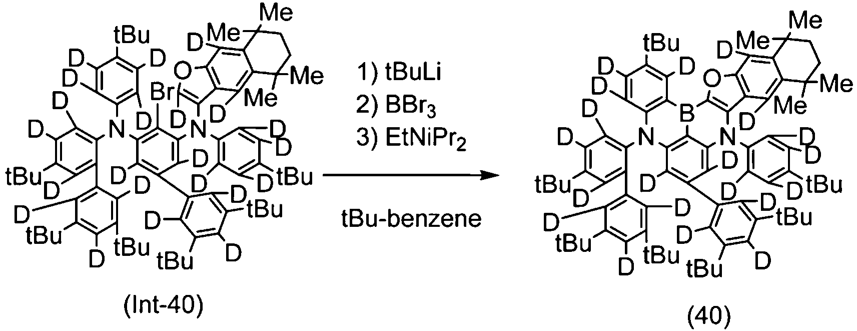

A target compound of m/z(M+H) = 1135.92 was confirmed by APCI-MS.

### Synthesis Example (29): Synthesis of compound (41)

A compound (41) was obtained from an intermediate (Int-41) in the same manner as in Synthesis Example (1).

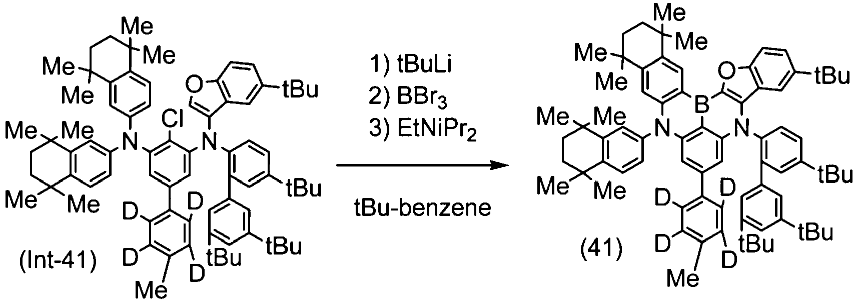

A target compound of m/z(M+H) = 1075.76 was confirmed by APCI-MS.

### Synthesis Example (30): Synthesis of compound (45)

A compound (45) was obtained from an intermediate (Int-45) in the same manner as in Synthesis Example (1).

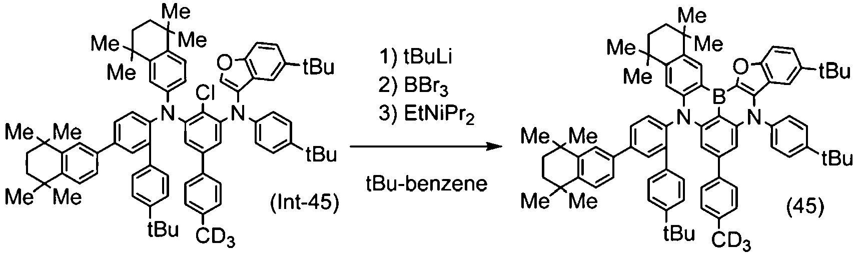

A target compound of m/z(M+H) = 1094.72 was confirmed by APCI-MS.

### Synthesis Example (31): Synthesis of compound (46)

A compound (46) was obtained from an intermediate (Int-46) in the same manner as in Synthesis Example (1).

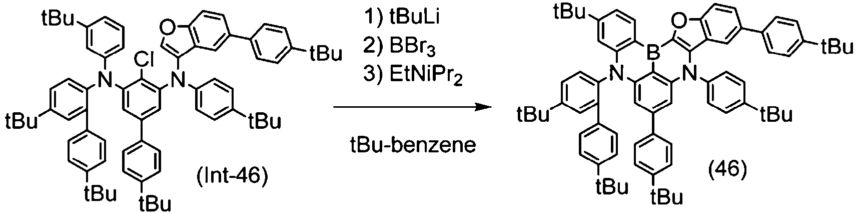

A target compound of m/z(M+H) = 1025.65 was confirmed by APCI-MS.

### Synthesis Example (32): Synthesis of compound (47)

A compound (47) was obtained from an intermediate (Int-47) in the same manner as in Synthesis Example (1).

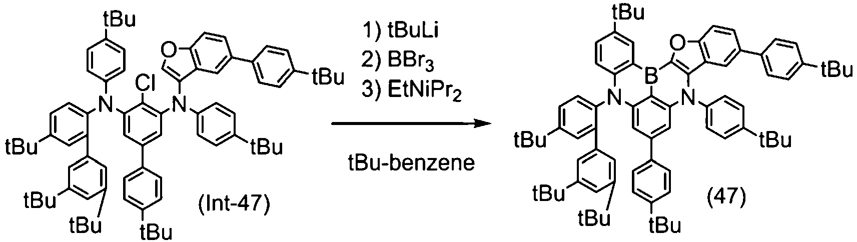

A target compound of m/z(M+H) = 1081.71 was confirmed by APCI-MS.

### Synthesis Example (33): Synthesis of compound (48)

A compound (48) was obtained from an intermediate (Int-48) in the same manner as in Synthesis Example (1).

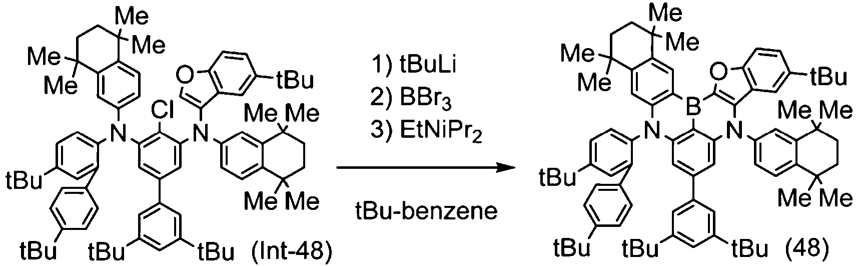

A target compound of m/z(M+H) = 1113.78 was confirmed by APCI-MS.

### Synthesis Example (34): Synthesis of compound (49)

A compound (49) was obtained from an intermediate (Int-49) in the same manner as in Synthesis Example (1).

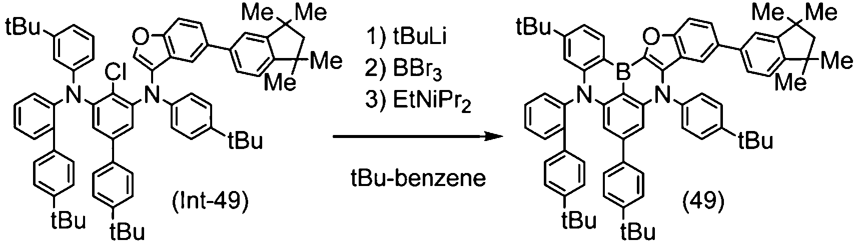

A target compound of m/z(M+H) = 1009.62 was confirmed by APCI-MS.

### Synthesis Example (35): Synthesis of compound (50)

A compound (50) was obtained from an intermediate (Int-50) in the same manner as in Synthesis Example (1).

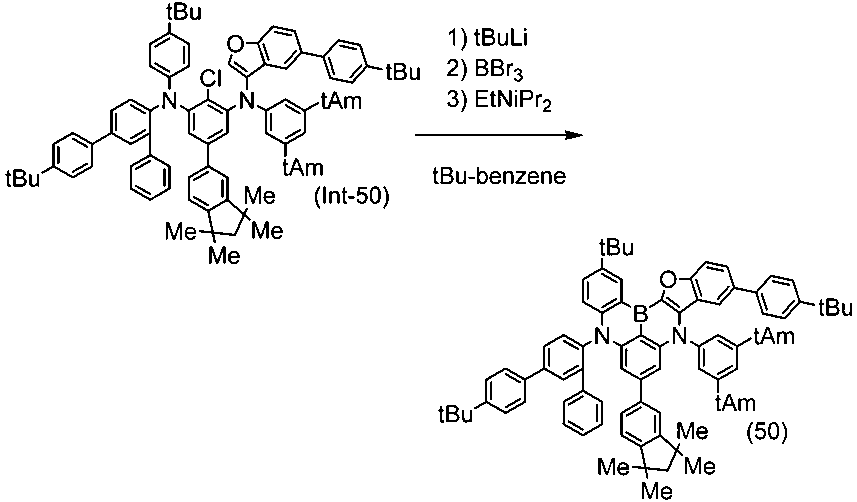

A target compound of m/z(M+H) = 1169.75 was confirmed by APCI-MS.

### Synthesis Example (36): Synthesis of compound (51)

A compound (51) was obtained from an intermediate (Int-51) in the same manner as in Synthesis Example (1) except that BBr₃ was changed to ¹⁰BBr₃.

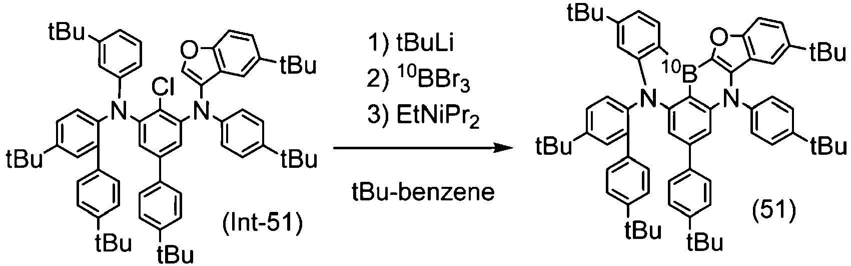

A target compound of m/z(M+H) = 948.62 was confirmed by APCI-MS.

### Synthesis Example (37): Synthesis of compound (52)

A compound (52) was obtained from an intermediate (Int-52) in the same manner as in Synthesis Example (1) except that BBr₃ was changed to ¹¹BBr₃.

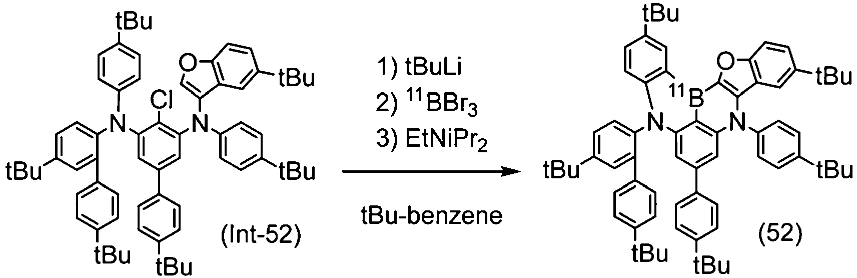

A target compound of m/z(M+H) = 949.62 was confirmed by APCI-MS.

### Synthesis Example (38): Synthesis of compound (55)

A compound (55) was obtained from an intermediate (Int-55) in the same manner as in Synthesis Example (1).

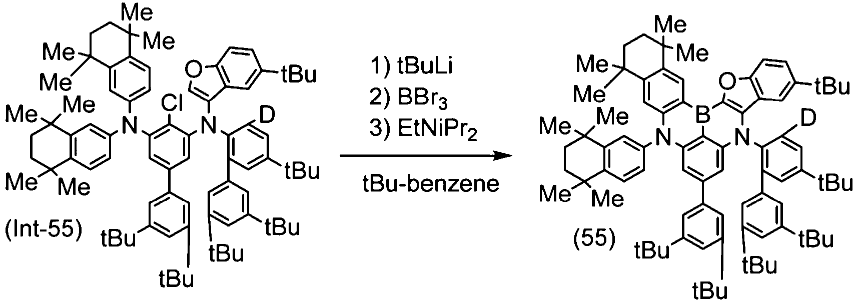

A target compound of m/z(M+H) = 1170.85 was confirmed by APCI-MS.

### Synthesis Example (39): Synthesis of compound (57)

A compound (57) was obtained from an intermediate (Int-57) in the same manner as in Synthesis Example (1).

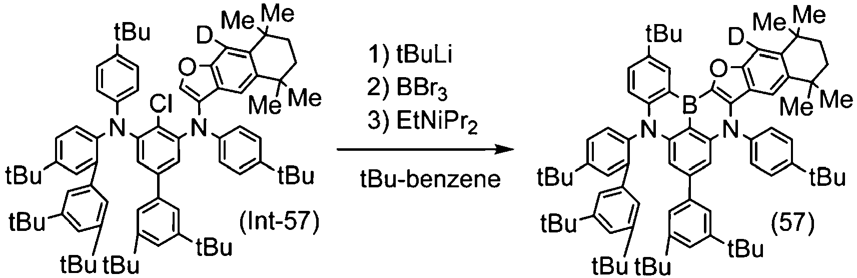

A target compound of m/z(M+H) = 1116.80 was confirmed by APCI-MS.

### Synthesis Example (40): Synthesis of compound (59)

A compound (59) was obtained from an intermediate (Int-59) in the same manner as in Synthesis Example (1).

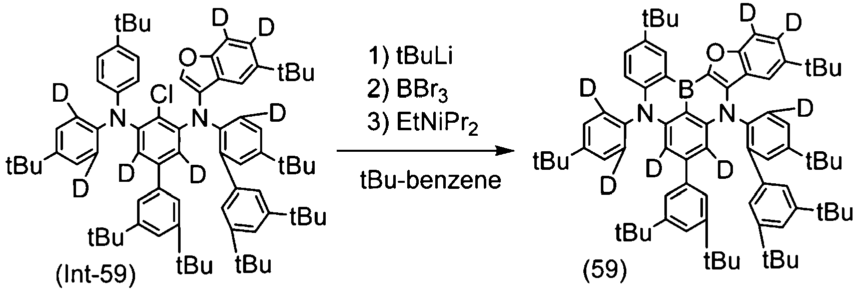

A target compound of m/z(M+H) = 1168.79 was confirmed by APCI-MS.

### Synthesis Example (41): Synthesis of compound (60)

A compound (60) was obtained from an intermediate (Int-60) in the same manner as in Synthesis Example (1).

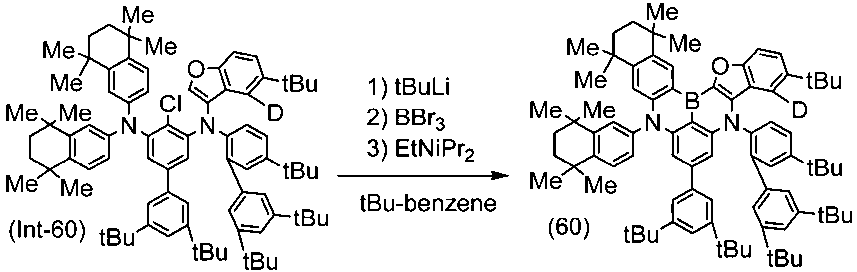

A target compound of m/z(M+H) = 1170.85 was confirmed by APCI-MS.

### Synthesis Example (42): Synthesis of compound (64)

A compound (64) was obtained from an intermediate (Int-64) in the same manner as in Synthesis Example (1).

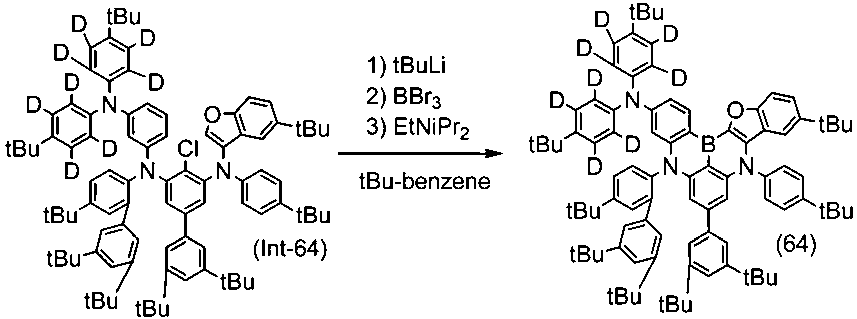

A target compound of m/z(M+H) = 1292.93 was confirmed by APCI-MS.

### Synthesis Example (43): Synthesis of compound (67)

A compound (67) was obtained from an intermediate (Int-67) in the same manner as in Synthesis Example (1).

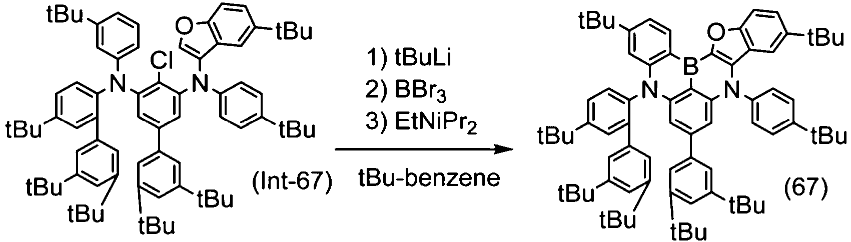

A target compound of m/z(M+H) = 1061.75 was confirmed by APCI-MS.

### Synthesis Example (44): Synthesis of compound (68)

A compound (68) was obtained from an intermediate (Int-68) in the same manner as in Synthesis Example (1).

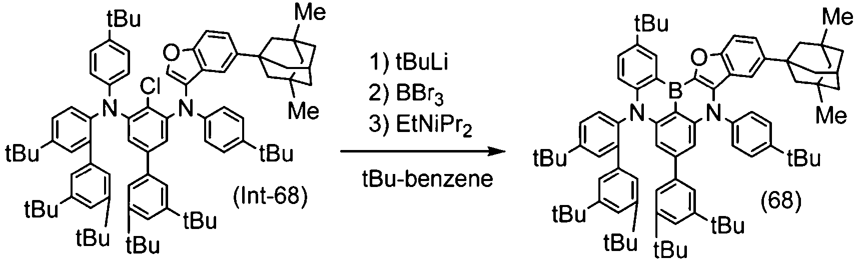

A target compound of m/z(M+H) = 1167.82 was confirmed by APCI-MS.

### Synthesis Example (45): Synthesis of compound (69)

A compound (69) was obtained from an intermediate (Int-69) in the same manner as in Synthesis Example (1).

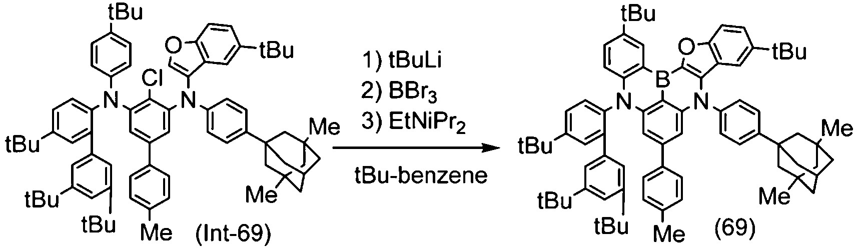

A target compound of m/z(M+H) = 1069.71 was confirmed by APCI-MS.

### Synthesis Example (46): Synthesis of compound (70)

A compound (70) was obtained from an intermediate (Int-70) in the same manner as in Synthesis Example (1).

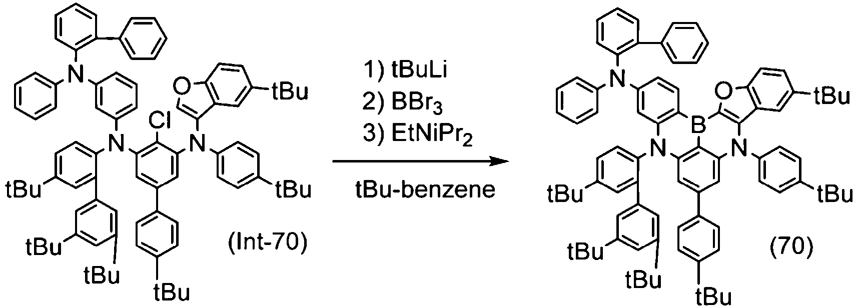

A target compound of m/z(M+H) = 1192.73 was confirmed by APCI-MS.

### Synthesis Example (47): Synthesis of compound (71)

A compound (71) was obtained from an intermediate (Int-71) in the same manner as in Synthesis Example (1).

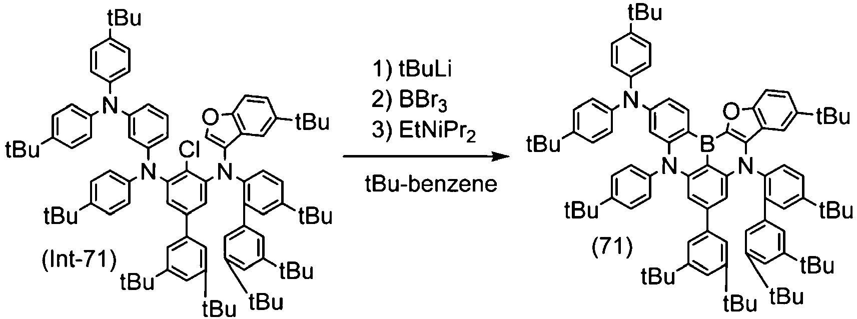

A target compound of m/z(M+H) = 1284.88 was confirmed by APCI-MS.

### Synthesis Example (48): Synthesis of compound (72)

A compound (72) was obtained from an intermediate (Int-72) in the same manner as in Synthesis Example (1).

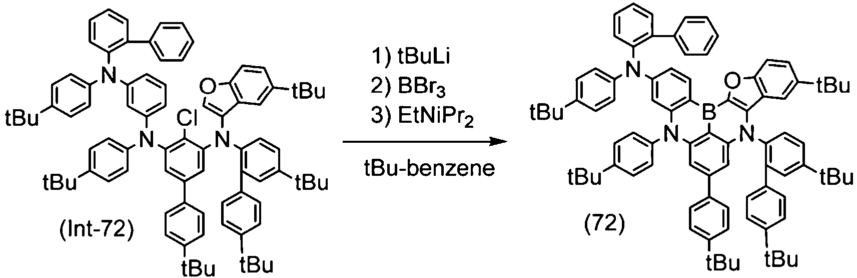

A target compound of m/z(M+H) = 1192.73 was confirmed by APCI-MS.

### Synthesis Example (49): Synthesis of compound (73)

A compound (73) was obtained from an intermediate (Int-73) in the same manner as in Synthesis Example (1).

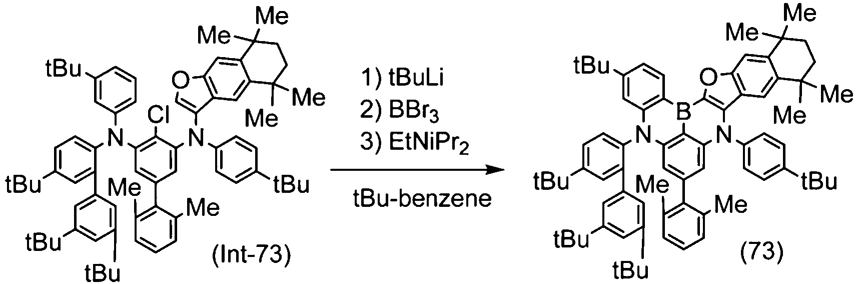

A target compound of m/z(M+H) = 1031.70 was confirmed by APCI-MS.

### Synthesis Example (50): Synthesis of compound (74)

A compound (74) was obtained from an intermediate (Int-74) in the same manner as in Synthesis Example (1).

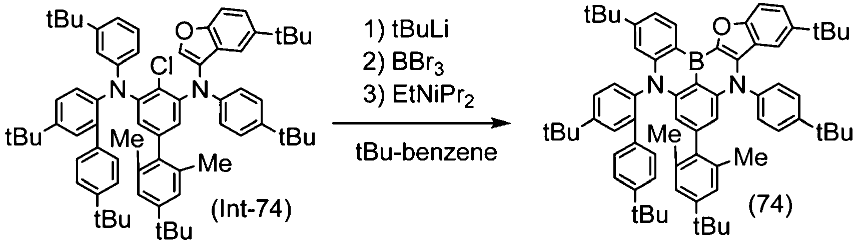

A target compound of m/z(M+H) = 997.65 was confirmed by APCI-MS.

### Synthesis Example (51): Synthesis of compound (75)

A compound (75) was obtained from an intermediate (Int-75) in the same manner as in Synthesis Example (1).

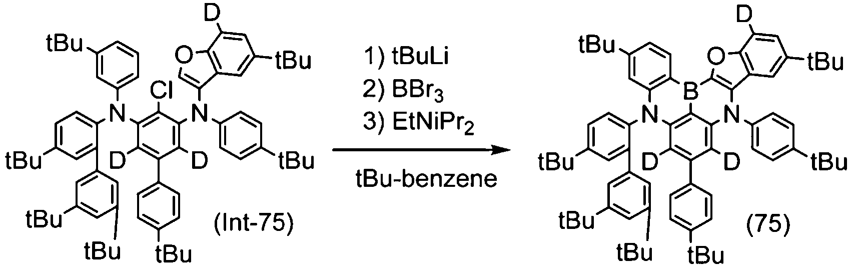

A target compound of m/z(M+H) = 1008.70 was confirmed by APCI-MS.

### Synthesis Example (52): Synthesis of compound (76)

A compound (76) was obtained from an intermediate (Int-76) in the same manner as in Synthesis Example (1).

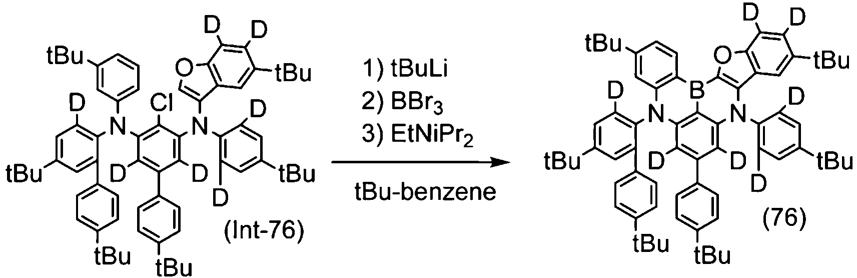

A target compound of m/z(M+H) = 956.66 was confirmed by APCI-MS.

### <Applicability to organic EL device>

The compound of the present invention is presumed to have an appropriate energy gap (Eg), high triplet excitation energy (E_{T}), and small ΔEST as features and can therefore be expected to be applied to, for example, a luminescent layer and a charge transport layer, particularly, to a luminescent layer.

### <B. Evaluation of deposition type organic EL device>

Next, the preparation and evaluation of an organic EL device using the polycyclic aromatic compound of the present invention will be described.

### <Configuration of organic EL device>

Tables B-1 to B-4 below show the material configuration of each layer in organic EL devices of Examples B1 to B52 and Comparative Examples B1 to B5.

**[Table B-1]**

| | Hole injection layer 1 40 nm | Hole injection layer 2 5 nm | Hole transport layer 1 45 nm | Hole transport layer 2 10 nm | Luminescent layer 25 nm | | Electron transport layer 1 5 nm | Electron transport layer 2 25 nm | Negative electrode 1 nm/ 100 nm |
|---|---|---|---|---|---|---|---|---|---|
| | | | | | Host | Dopant | | | |
| Example B1 | HI | HAT -CN | HT-1 | HT-2 | BH | Compound (1) | ET-1 | ET-2 +Liq | LiF/Al |
| Example B2 | HI | HAT -CN | HT-1 | HT-2 | BH | Compound (2) | ET-1 | ET-2 +Liq | LiF/Al |
| Example B3 | HI | HAT -CN | HT-1 | HT-2 | BH | Compound (3) | ET-1 | ET-2 +Liq | LiF/Al |
| Example B4 | HI | HAT -CN | HT-1 | HT-2 | BH | Compound (4) | ET-1 | ET-2 +Liq | LiF/Al |
| Example B5 | HI | HAT -CN | HT-1 | HT-2 | BH | Compound (5) | ET-1 | ET-2 +Liq | LiF/Al |
| Example B6 | HI | HAT -CN | HT-1 | HT-2 | BH | Compound (6) | ET-1 | ET-2 +Liq | LiF/Al |
| Example B7 | HI | HAT -CN | HT-1 | HT-2 | BH | Compound (7) | ET-1 | ET-2 +Liq | LiF/Al |
| Example B8 | HI | HAT -CN | HT-1 | HT-2 | BH | Compound (8) | ET-1 | ET-2 +Liq | LiF/Al |
| Example B9 | HI | HAT -CN | HT-1 | HT-2 | BH | Compound (9) | ET-1 | ET-2 +Liq | LiF/Al |
| Example B10 | HI | HAT -CN | HT-1 | HT-2 | BH | Compound (10) | ET-1 | ET-2 +Liq | LiF/Al |
| Example B11 | HI | HAT -CN | HT-1 | HT-2 | BH | Compound (11) | ET-1 | ET-2 +Liq | LiF/Al |
| Example B12 | HI | HAT -CN | HT-1 | HT-2 | BH | Compound (12) | ET-1 | ET-2 +Liq | LiF/Al |
| Example B13 | HI | HAT -CN | HT-1 | HT-2 | BH | Compound (13) | ET-1 | ET-2 +Liq | LiF/Al |
| Example B14 | HI | HAT -CN | HT-1 | HT-2 | BH | Compound (15) | ET-1 | ET-2 +Liq | LiF/Al |
| Example B15 | HI | HAT -CN | HT-1 | HT-2 | BH | Compound (16) | ET-1 | ET-2 +Liq | LiF/Al |
| Example B16 | HI | HAT -CN | HT-1 | HT-2 | BH | Compound (18) | ET-1 | ET-2 +Liq | LiF/Al |
| Example B17 | HI | HAT -CN | HT-1 | HT-2 | BH | Compound (21) | ET-1 | ET-2 +Liq | LiF/Al |
| Example B18 | HI | HAT -CN | HT-1 | HT-2 | BH | Compound (22) | ET-1 | ET-2 +Liq | LiF/Al |
| Example B19 | HI | HAT -CN | HT-1 | HT-2 | BH | Compound (23) | ET-1 | ET-2 +Liq | LiF/Al |
| Example B20 | HI | HAT -CN | HT-1 | HT-2 | BH | Compound (24) | ET-1 | ET-2 +Liq | LiF/Al |

**[Table B-2]**

| | Hole injection layer 1 40 nm | Hole injection layer 2 5 nm | Hole transport layer 1 45 nm | Hole transport layer 2 10 nm | Luminescent layer 25 nm | | Electron transport layer 1 5 nm | Electron transport layer 2 25 nm | Negative electrode 1 nm/ 100 nm |
|---|---|---|---|---|---|---|---|---|---|
| | | | | | Host | Dopant | | | |
| Example B21 | HI | HAT -CN | HT-1 | HT-2 | BH | Compound (25) | ET-1 | ET-2 +Liq | LiF/Al |
| Example B22 | HI | HAT -CN | HT-1 | HT-2 | BH | Compound (26) | ET-1 | ET-2 +Liq | LiF/Al |
| Example B23 | HI | HAT -CN | HT-1 | HT-2 | BH | Compound (31) | ET-1 | ET-2 +Liq | LiF/Al |
| Example B24 | HI | HAT -CN | HT-1 | HT-2 | BH | Compound (32) | ET-1 | ET-2 +Liq | LiF/Al |
| Example B25 | HI | HAT -CN | HT-1 | HT-2 | BH | Compound (33) | ET-1 | ET-2 +Liq | LiF/Al |
| Example B26 | HI | HAT -CN | HT-1 | HT-2 | BH | Compound (34) | ET-1 | ET-2 +Liq | LiF/Al |
| Example B27 | HI | HAT -CN | HT-1 | HT-2 | BH | Compound (35) | ET-1 | ET-2 +Liq | LiF/Al |
| Example B28 | HI | HAT -CN | HT-1 | HT-2 | BH | Compound (40) | ET-1 | ET-2 +Liq | LiF/Al |
| Example B29 | HI | HAT -CN | HT-1 | HT-2 | BH | Compound (41) | ET-1 | ET-2 +Liq | LiF/Al |
| Example B30 | HI | HAT -CN | HT-1 | HT-2 | BH | Compound (45) | ET-1 | ET-2 +Liq | LiF/Al |
| Example B31 | HI | HAT -CN | HT-1 | HT-2 | BH | Compound (46) | ET-1 | ET-2 +Liq | LiF/Al |
| Example B32 | HI | HAT -CN | HT-1 | HT-2 | BH | Compound (47) | ET-1 | ET-2 +Liq | LiF/Al |
| Example B33 | HI | HAT -CN | HT-1 | HT-2 | BH | Compound (48) | ET-1 | ET-2 +Liq | LiF/Al |
| Example B34 | HI | HAT -CN | HT-1 | HT-2 | BH | Compound (49) | ET-1 | ET-2 +Liq | LiF/Al |
| Example B35 | HI | HAT -CN | HT-1 | HT-2 | BH | Compound (50) | ET-1 | ET-2 +Liq | LiF/Al |
| Example B36 | HI | HAT -CN | HT-1 | HT-2 | BH | Compound (51) | ET-1 | ET-2 +Liq | LiF/Al |
| Example B37 | HI | HAT -CN | HT-1 | HT-2 | BH | Compound (52) | ET-1 | ET-2 +Liq | LiF/Al |
| Example B38 | HI | HAT -CN | HT-1 | HT-2 | BH | Compound (55) | ET-1 | ET-2 +Liq | LiF/Al |
| Example B39 | HI | HAT -CN | HT-1 | HT-2 | BH | Compound (57) | ET-1 | ET-2 +Liq | LiF/Al |
| Example B40 | HI | HAT -CN | HT-1 | HT-2 | BH | Compound (59) | ET-1 | ET-2 +Liq | LiF/Al |
| Example B41 | HI | HAT -CN | HT-1 | HT-2 | BH | Compound (60) | ET-1 | ET-2 +Liq | LiF/Al |

**[Table B-3]**

| | Hole injection layer 1 40 nm | Hole injection layer 2 5 nm | Hole transport layer 1 45 nm | Hole transport layer 2 10 nm | Luminescent layer 25 nm | | Electron transport layer 1 5 nm | Electron transport layer 2 25 nm | Negative electrode 1 nm/ 100 nm |
|---|---|---|---|---|---|---|---|---|---|
| | | | | | Host | Dopant | | | |
| Example B42 | HI | HAT -CN | HT-1 | HT-2 | BH | Compound (64) | ET-1 | ET-2 +Liq | LiF/Al |
| Example B43 | HI | HAT -CN | HT-1 | HT-2 | BH | Compound (67) | ET-1 | ET-2 +Liq | LiF/Al |
| Example B44 | HI | HAT -CN | HT-1 | HT-2 | BH | Compound (68) | ET-1 | ET-2 +Liq | LiF/Al |
| Example B45 | HI | HAT -CN | HT-1 | HT-2 | BH | Compound (69) | ET-1 | ET-2 +Liq | LiF/Al |
| Example B46 | HI | HAT -CN | HT-1 | HT-2 | BH | Compound (70) | ET-1 | ET-2 +Liq | LiF/Al |
| Example B47 | HI | HAT -CN | HT-1 | HT-2 | BH | Compound (71) | ET-1 | ET-2 +Liq | LiF/Al |
| Example B48 | HI | HAT -CN | HT-1 | HT-2 | BH | Compound (72) | ET-1 | ET-2 +Liq | LiF/Al |
| Example B49 | HI | HAT -CN | HT-1 | HT-2 | BH | Compound (73) | ET-1 | ET-2 +Liq | LiF/Al |
| Example B50 | HI | HAT -CN | HT-1 | HT-2 | BH | Compound (74) | ET-1 | ET-2 +Liq | LiF/Al |
| Example B51 | HI | HAT -CN | HT-1 | HT-2 | BH | Compound (75) | ET-1 | ET-2 +Liq | LiF/Al |
| Example B52 | HI | HAT -CN | HT-1 | HT-2 | BH | Compound (76) | ET-1 | ET-2 +Liq | LiF/Al |

**[Table B-4]**

| | Hole injection layer 1 40 nm | Hole injection layer 2 5 nm | Hole transport layer 1 45 nm | Hole transport layer 2 10 nm | Luminescent layer 25 nm | | Electron transport layer 1 5 nm | Electron transport layer 2 25 nm | Negative electrode 1 nm/ 100 nm |
|---|---|---|---|---|---|---|---|---|---|
| | | | | | Host | Dopant | | | |
| Comparative Example B1 | HI | HAT -CN | HT-1 | HT-2 | BH | Comparative compound (1) | ET-1 | ET-2 +Liq | LiF/Al |
| Comparative Example B2 | HI | HAT -CN | HT-1 | HT-2 | BH | Comparative compound (2) | ET-1 | ET-2 +Liq | LiF/Al |
| Comparative Example B3 | HI | HAT -CN | HT-1 | HT-2 | BH | Comparative compound (3) | ET-1 | ET-2 +Liq | LiF/Al |
| Comparative Example B4 | HI | HAT -CN | HT-1 | HT-2 | BH | Comparative compound (4) | ET-1 | ET-2 +Liq | LiF/Al |
| Comparative Example B5 | HI | HAT -CN | HT-1 | HT-2 | BH | Comparative compound (5) | ET-1 | ET-2 +Liq | LiF/Al |

In Tables B-1 to B-4, the chemical structures of "HI", "HAT-CN", "HT-1", "HT-2", "BH", "ET-1", "ET-2", and "Liq" "comparative compound (1)" described in Korean Patent Application Publication No. 2022/010243, "comparative compound (2)" described in International Publication No. WO 2021/107699, "comparative compound (3)" described in International Publication No. WO 2021/107743, "comparative compound (4)" described in International Publication No. WO 2021/107743, and "comparative compound (5)" described in International Publication No. WO 2022/196612 will be shown below.

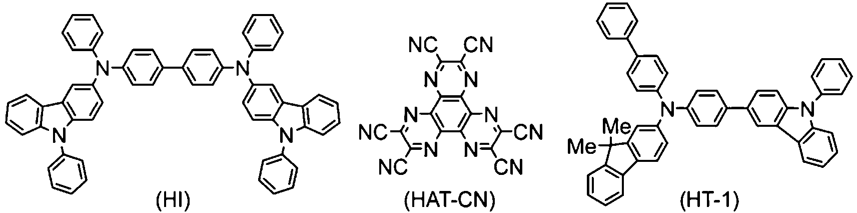

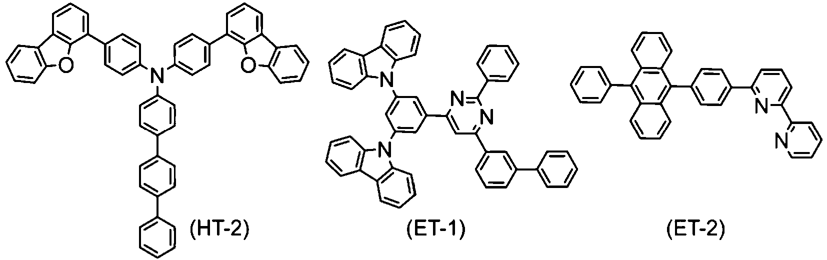

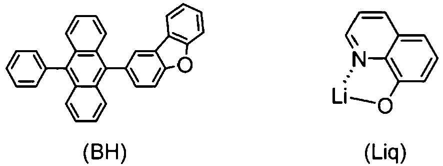

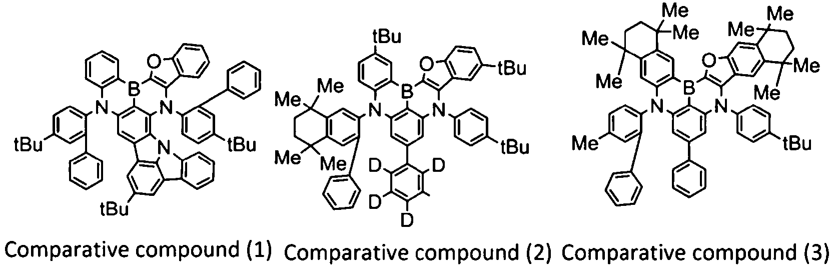

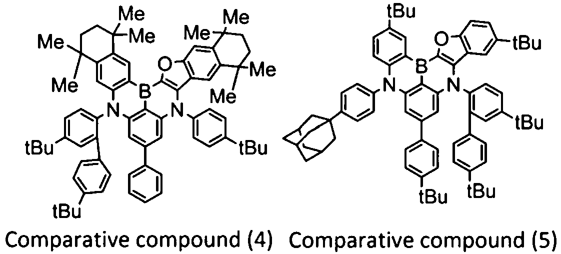

### <Device of Example B1>

A 26 mm × 28 mm × 0.7 mm glass substrate (manufactured by Opto Science, Inc.) on which an ITO film formed with a thickness of 180 nm by sputtering was polished into 150 nm was used as a transparent support substrate. This transparent support substrate was mounted to a substrate holder of a commercially available deposition apparatus (manufactured by Showa Shinku Co., Ltd.), and molybdenum boats for depositions respectively containing HI, HAT-CN, HT-1, HT-2, BH, the compound (1), ET-1, and ET-2 and aluminum nitride boats for depositions respectively containing Liq, LiF, and aluminum were attached to the apparatus.

The following respective layers were sequentially formed on the ITO film of the transparent support substrate. The pressure of a vacuum chamber was reduced to 5 × 10⁻⁴ Pa, and HI was first heated and deposited so as to attain a film thickness of 40 nm. Next, HAT-CN was heated and deposited so as to attain a film thickness of 5 nm. Next, HT-1 was heated and deposited so as to attain a film thickness of 45 nm. Next, HT-2 was heated and deposited so as to attain a film thickness of 10 nm to form hole layers consisting of 4 layers. Next, BH and the compound (1) were heated at the same time and deposited so as to attain a film thickness of 25 nm to form a luminescent layer. The deposition rates were adjusted such that the mass ratio between BH and the compound (1) was approximately 97:3. Further, ET-1 was heated and deposited so as to attain a film thickness of 5 nm. Next, ET-2 and Liq were heated at the same time and deposited so as to attain a film thickness of 25 nm to form electron layers consisting of 2 layers. The deposition rates were adjusted such that the mass ratio between ET-2 and Liq was approximately 50:50. The deposition rate of each layer was 0.01 to 1 nm/sec. Then, LiF was heated and deposited at a deposition rate of 0.01 to 0.1 nm/sec so as to attain a film thickness of 1 nm. Subsequently, aluminum was heated and deposited so as to attain a film thickness of 100 nm to form a negative electrode. In this way, an organic EL device was obtained.

### <Devices of Examples B2 to B52 and Comparative Example B1>

Organic EL devices of Examples B2 to B52 and Comparative Examples B1 to B5 were obtained in the same manner as in Example B1 except that each dopant material described in Tables B-1 to B-4 was used instead of the compound (1).

### <Evaluation of organic EL characteristics>

To the organic EL devices of Examples B1 to B52 and Comparative Examples B1 to B5, direct-current voltage was applied with the ITO electrode as a positive electrode and the LiF/aluminum electrode as a negative electrode. Drive voltage, external quantum efficiency, and device lifetime were measured at the time of luminescence of 1000 cd/m². The device lifetime is a time for which 95% or more brightness based on initial brightness is retained by continuous drive at the voltage at the time of luminescence of 1000 cd/m². The results are shown in Tables B-5 to B-7.

The quantum efficiency of the luminescent device includes internal quantum efficiency and external quantum efficiency. The internal quantum efficiency refers to the rate at which external energy injected as electrons (or holes) to the luminescent layer of the luminescent device is purely converted to photons. On the other hand, the external quantum efficiency is calculated on the basis of the amount of the photons released to the outside of the luminescent device. The external quantum efficiency is lower than the internal quantum efficiency because some photons generated in the luminescent layer are absorbed inside the luminescent device or continuously reflected and thereby not released to the outside of the luminescent device.

A method for measuring the external quantum efficiency is as follows: using Voltage/Current Generator R6144 manufactured by Advantest Corp., the device is allowed to emit luminescence by the application of voltage at which the brightness of the device is 1000 cd/m². Spectral radiance in the visible region from a direction perpendicular to the light-emitting face was measured using Spectroradiometer SR-3AR manufactured by TechnoOptis Co., Ltd. On the assumption that the light-emitting face is a perfectly diffusing surface, the measured value of spectral radiance of each wavelength component is divided by wavelength energy and multiplied by π, and the obtained numeric value is the number of photons at each wavelength. Subsequently, the numbers of photons in all wavelength regions observed were integrated, and the obtained value was regarded as the total number of photons released from the device. A numeric value obtained by dividing the applied current value by elementary charge is defined as the number of carriers injected to the device. The total number of photons released from the device is divided by the number of carriers injected to the device, and the resulting numeric value is the external quantum efficiency.

**[Table B-5]**

| | Dopant | Characteristics at time of luminescence at 1000 cd/m² | Device lifetime (hr) |
|---|---|---|---|
| | | External quantum efficiency (%) | |
| Example B1 | Compound (1) | 8.1 | 177 |
| Example B2 | Compound (2) | 8.0 | 169 |
| Example B3 | Compound (3) | 8.2 | 170 |
| Example B4 | Compound (4) | 8.5 | 188 |
| Example B5 | Compound (5) | 7.9 | 211 |
| Example B6 | Compound (6) | 8.2 | 198 |
| Example B7 | Compound (7) | 8.2 | 193 |
| Example B8 | Compound (8) | 8.4 | 222 |
| Example B9 | Compound (9) | 8.1 | 180 |
| Example B10 | Compound (10) | 8.2 | 217 |
| Example B11 | Compound (11) | 8.2 | 228 |
| Example B12 | Compound (12) | 8.1 | 235 |
| Example B13 | Compound (13) | 7.8 | 179 |
| Example B14 | Compound (15) | 8.2 | 170 |
| Example B15 | Compound (16) | 8.0 | 193 |
| Example B16 | Compound (18) | 8.3 | 222 |
| Example B17 | Compound (21) | 8.3 | 169 |
| Example B18 | Compound (22) | 8.1 | 188 |
| Example B19 | Compound (23) | 8.0 | 202 |
| Example B20 | Compound (24) | 7.9 | 193 |
| Example B21 | Compound (25) | 8.2 | 196 |
| Example B22 | Compound (26) | 8.3 | 172 |
| Example B23 | Compound (31) | 8.4 | 185 |
| Example B24 | Compound (32) | 8.1 | 212 |
| Example B25 | Compound (33) | 8.2 | 188 |
| Example B26 | Compound (34) | 8.3 | 205 |
| Example B27 | Compound (35) | 7.8 | 202 |
| Example B28 | Compound (40) | 8.2 | 201 |
| Example B29 | Compound (41) | 8.0 | 222 |
| Example B30 | Compound (45) | 7.9 | 169 |
| Example B31 | Compound (46) | 8.4 | 173 |
| Example B32 | Compound (47) | 8.1 | 182 |
| Example B33 | Compound (48) | 7.8 | 166 |
| Example B34 | Compound (49) | 7.9 | 177 |
| Example B35 | Compound (50) | 7.9 | 169 |
| Example B36 | Compound (51) | 8.1 | 255 |
| Example B37 | Compound (52) | 8.0 | 258 |
| Example B38 | Compound (55) | 8.0 | 288 |
| Example B39 | Compound (57) | 7.8 | 280 |
| Example B40 | Compound (59) | 8.1 | 277 |
| Example B41 | Compound (60) | 8.3 | 269 |

**[Table B-6]**

| | Dopant | Characteristics at time of luminescence at 1000 cd/m² | Device lifetime (hr) |
|---|---|---|---|
| | | External quantum efficiency (%) | |
| Example B42 | Compound (64) | 8.3 | 169 |
| Example B43 | Compound (67) | 8.5 | 192 |
| Example B44 | Compound (68) | 8.6 | 183 |
| Example B45 | Compound (69) | 8.4 | 157 |
| Example B46 | Compound (70) | 8.7 | 182 |
| Example B47 | Compound (71) | 8.5 | 179 |
| Example B48 | Compound (72) | 8.3 | 188 |
| Example B49 | Compound (73) | 8.4 | 182 |
| Example B50 | Compound (74) | 8.7 | 190 |
| Example B51 | Compound (75) | 8.4 | 269 |
| Example B52 | Compound (76) | 8.3 | 242 |

**[Table B-7]**

| | Dopant | Characteristics at time of luminescence at 1000 cd/m² | Device lifetime (hr) |
|---|---|---|---|
| | | External quantum efficiency (%) | |
| Comparative Example B1 | Comparative compound (1) | 6.3 | 129 |
| Comparative Example B2 | Comparative compound (2) | 6.2 | 113 |
| Comparative Example B3 | Comparative compound (3) | 5.9 | 107 |
| Comparative Example B4 | Comparative compound (4) | 5.8 | 105 |
| Comparative Example B5 | Comparative compound (5) | 6.0 | 92 |

As described above, some compounds according to the present invention were evaluated as materials for organic EL devices and found to be excellent materials. Other compounds that were not evaluated are compounds that also have the same basic skeleton thereas and have a similar structure as a whole. Those skilled in the art can understand that these compounds are also excellent materials for organic EL devices.

### Industrial Applicability

The polycyclic aromatic compound of the present invention is useful as a material for an organic device, particularly, a material for a luminescent layer intended for luminescent layer formation of an organic electroluminescent device. The polycyclic aromatic compound of the present invention can be used as a dopant for a luminescent layer to obtain an organic electroluminescent device having long lifetime, low drive voltage, and efficient luminescence, particularly, lifetime and efficient luminescence.

### Reference Signs List

- 100:: Organic electroluminescent device
- 101:: Substrate
- 102:: Positive electrode
- 103:: Hole injection layer
- 104:: Hole transport layer
- 105:: Luminescent layer
- 106:: Electron transport layer
- 107:: Electron injection layer
- 108:: Negative electrode

## Claims

1. A polycyclic aromatic compound represented by the following formula (A-1), or a multimer of the polycyclic aromatic compound having at least two unit structures represented by the formula (A-1): 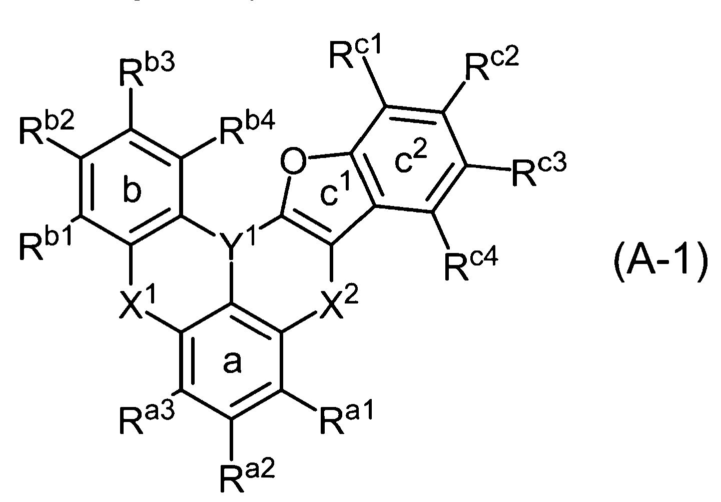 wherein
R^{a1} to R^{a3}, R^{b1} to R^{b4}, and R^{c1} to R^{c4} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group, and
two adjacent groups of R^{a1} to R^{a3}, R^{b1} to R^{b4}, and R^{c1} to R^{c4} are optionally bonded to each other to form an aryl ring or a heteroaryl ring, and at least one hydrogen atom of the formed aryl ring and heteroaryl ring is optionally replaced with substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
on the proviso that at least one of R^{a1} to R^{a3} is substituted aryl with substituted or unsubstituted diarylamino, substituted or unsubstituted carbazolyl, substituted or unsubstituted alkyl, or substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent;
Y¹ is B, P, P=O, P=S, Al, Ga, As, Si-R, or Ge-R, wherein the R moieties of the Si-R and the Ge-R are each independently substituted or unsubstituted aryl, substituted or unsubstituted heteroaryl, substituted or unsubstituted alkyl, or substituted or unsubstituted cycloalkyl;
X¹ and X² are each independently O, N-R, C(-R)₂, Si(-R)₂, S, or Se, wherein the R moiety of the N-R is hydrogen, aryl substituted by alkyl, substituted or unsubstituted heteroaryl, substituted or unsubstituted alkyl, substituted or unsubstituted cycloalkyl, or a group represented by the formula (G-1), the R moieties of the C(-R)₂ and the Si(-R)₂ are each independently hydrogen, substituted or unsubstituted aryl, substituted or unsubstituted heteroaryl, substituted or unsubstituted alkyl, or substituted or unsubstituted cycloalkyl, two R moieties of the C(-R)₂ and the Si(-R)₂ are optionally bonded to each other to form a ring, and the R moiety of the N-R and/or the R moiety of the C(-R)₂ is optionally bonded to the ring a and/or the ring b or to the ring a and/or the ring c² through a linking group,
on the proviso that at least one of X¹ and X² is N-R, wherein the R moiety of the N-R is a group represented by the formula (G-1): 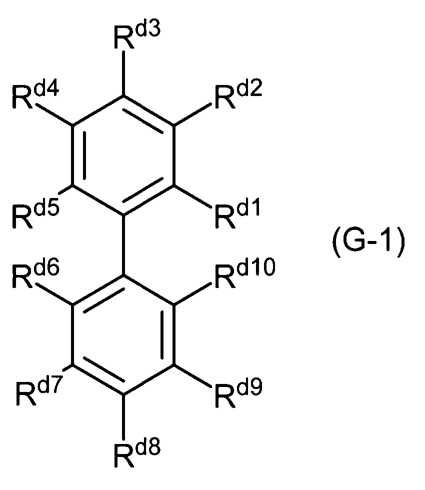 wherein
R^{d1} to R^{d10} are each independently hydrogen, substituted or unsubstituted aryl, substituted or unsubstituted heteroaryl, substituted or unsubstituted diarylamino, substituted or unsubstituted diheteroarylamino, substituted or unsubstituted arylheteroarylamino, substituted or unsubstituted diarylboryl, substituted or unsubstituted alkyl, substituted or unsubstituted cycloalkyl, substituted or unsubstituted alkenyl, substituted or unsubstituted alkoxy, substituted or unsubstituted aryloxy, substituted or unsubstituted arylthio, or substituted silyl, wherein two aryl moieties of the diarylamino are optionally bonded to each other via a linking group, two heteroaryl moieties of the diheteroarylamino are optionally bonded to each other via a linking group, the aryl and heteroaryl moieties of the arylheteroarylamino are optionally bonded to each other via a linking group, and two aryl moieties of the diarylboryl are optionally bonded to each other via a linking group,
two adjacent groups of R^{d1} to R^{d10} are optionally bonded to each other to form a cycloalkane-condensed structure, and at least one hydrogen atom of the cycloalkane is optionally replaced,
on the proviso that at least one of R^{d6} to R^{d10} is alkyl, or two adjacent groups of Rd⁶ to R^{d10} are bonded to each other to form a cycloalkane-condensed structure, and
any one of R^{d1} to R^{d5} is a bond to a nitrogen atom;
in the compound or the unit structure represented by the formula (A-1), at least one of the ring a, the ring b, the ring c², the aryl ring, and the heteroaryl ring is optionally condensed with at least one cycloalkane, at least one hydrogen atom in the cycloalkane is optionally replaced, and at least one -CH₂- moiety in the cycloalkane is optionally substituted by -O-;
at least one hydrogen atom in the compound or the unit structure represented by the formula (A-1) is optionally replaced with cyano or halogen; and
in the compound or the unit structure represented by the formula (A-1), at least one hydrogen atom is optionally replaced with deuterium, at least one nitrogen atom is optionally replaced with nitrogen-15 (¹⁵N), at least one sulfur atom is optionally replaced with sulfur-33 (³³S), sulfur-34 (³⁴S), or sulfur-36 (³⁶S), at least one oxygen atom is optionally replaced with oxygen-17 (¹⁷O) or oxygen-18 (¹⁸O), at least one carbon atom is optionally replaced with carbon-13 (¹³C), and at least one boron atom is optionally replaced with boron-11 (¹¹B).

2. The polycyclic aromatic compound or the multimer thereof according to claim 1, wherein the formula (G-1) represents a group represented by any of the formula (G-2) to the formula (G-21): 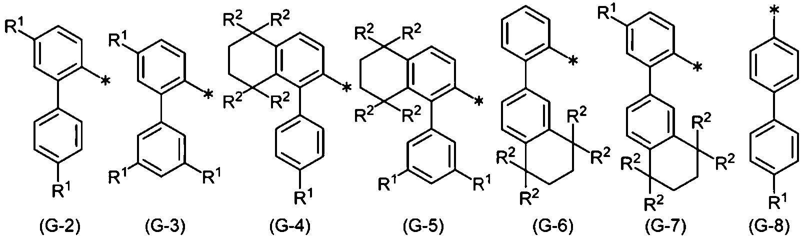 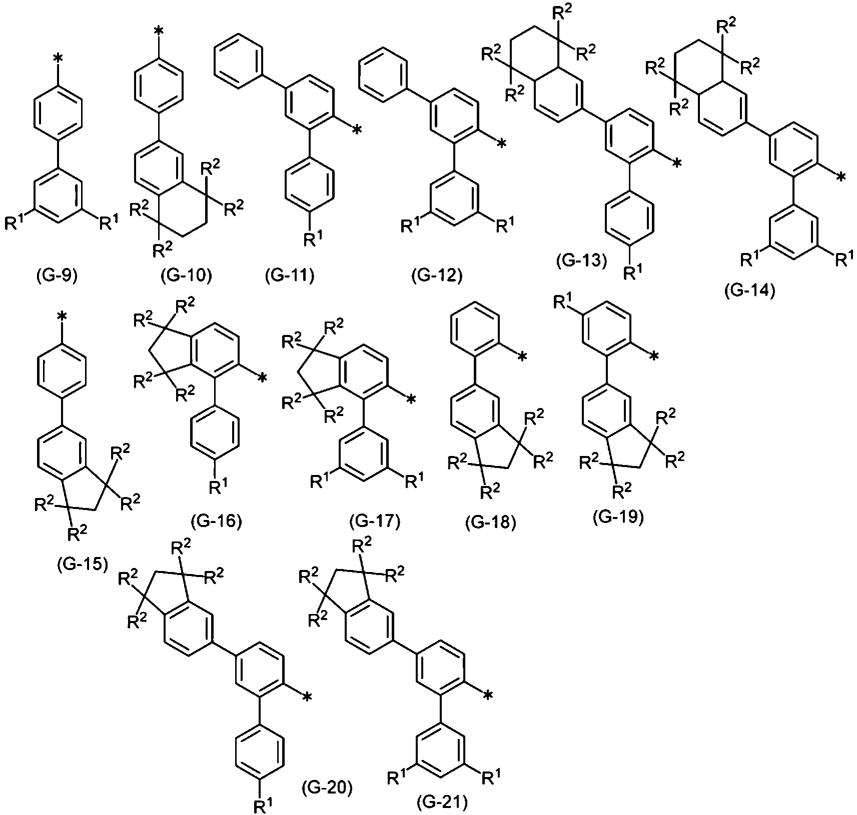 wherein
each R¹ is independently alkyl,
each R² is independently hydrogen or alkyl, and
* is a bond to a nitrogen atom.

3. The polycyclic aromatic compound or the multimer thereof according to claim 1, wherein the formula (A-1) is represented by any of the following formulas (A-2) to (A-12): 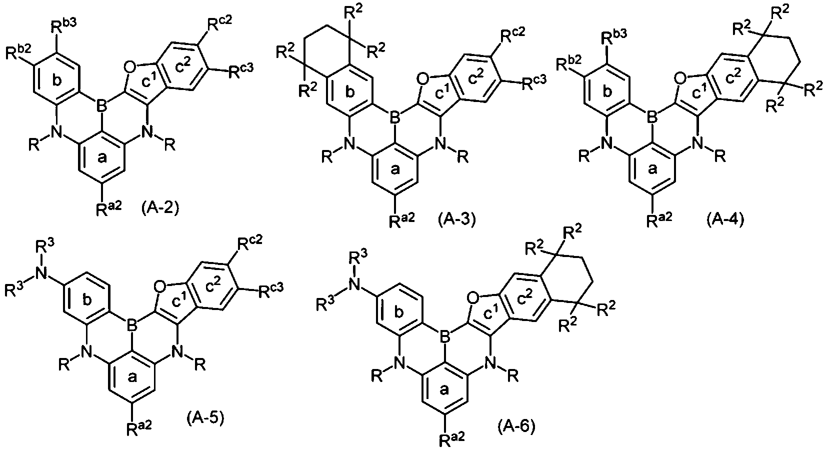 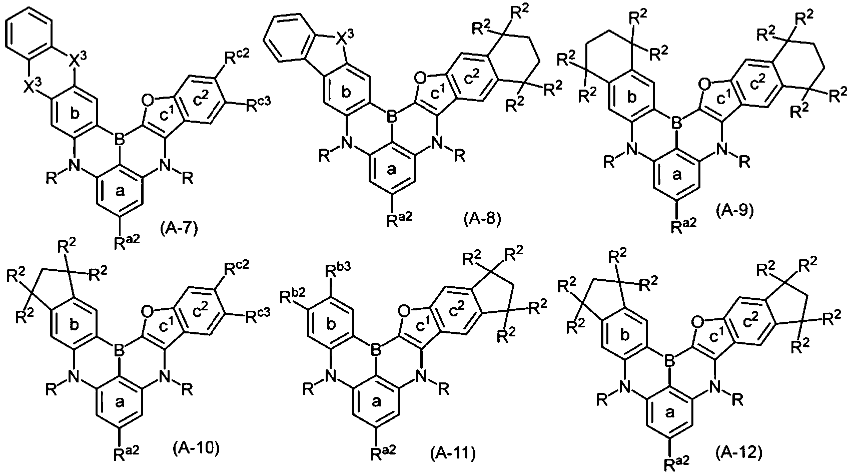 wherein
R^{a2} is substituted aryl with substituted or unsubstituted diarylamino, substituted or unsubstituted carbazolyl, substituted or unsubstituted alkyl, substituted or unsubstituted cycloalkyl as a substituent, or is substituted heteroaryl with substituted or unsubstituted diarylamino, substituted or unsubstituted carbazolyl, substituted or unsubstituted alkyl, or substituted or unsubstituted cycloalkyl as a substituent, wherein the aryl ring of the substituted aryl or the heteroaryl ring of the substituted heteroaryl is optionally condensed with at least one cycloalkane, and at least one hydrogen atom in the cycloalkane is optionally replaced,
R^{b2} and R^{b3} or R^{c2} and R^{c3} are each independently hydrogen, substituted or unsubstituted alkyl, or substituted or unsubstituted cycloalkyl,
one of two R moieties is a group represented by the formula (G-1), and the other moiety is aryl substituted by alkyl, substituted or unsubstituted heteroaryl, aryl condensed with cycloalkane, heteroaryl condensed with cycloalkane, or a group represented by the formula (G-1),
each R² is independently hydrogen or alkyl,
each R³ is independently substituted or unsubstituted aryl or substituted or unsubstituted heteroaryl,
each X³ is independently O, N-R⁴, or C(-R⁴)₂, and
each R⁴ is independently alkyl or substituted or unsubstituted aryl.

4. The polycyclic aromatic compound or the multimer thereof according to claim 3, wherein
in the formulas (A-2) to (A-12),
R^{a2} is diarylamino optionally substituted by methyl, t-amyl, or t-butyl, or substituted aryl with alkyl as a substituent,
one of R^{b2} and R^{b3} is hydrogen, and the other moiety is methyl, t-butyl, or t-amyl,
one of R^{c2} and R^{c3} is hydrogen, and the other moiety is methyl, t-butyl, adamantyl, or 3,5-dimethyl-1-adamantyl,
one of two R moieties is a group represented by the following formula (G-1), and the other moiety is aryl substituted by alkyl, aryl condensed with cycloalkane, or a group represented by the formula (G-1),
each R² is independently methyl, and
each R³ is independently a group represented by any of the following formulas (R³-1) to (R³-11): 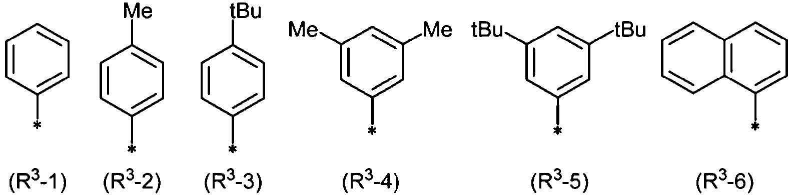 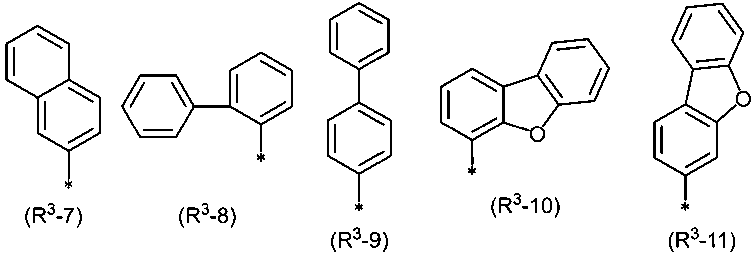 wherein * represents a bond to a nitrogen atom, and
X³ is O, N-bis(4-t-butylphenyl), or C(Me)₂.

5. The polycyclic aromatic compound or the multimer thereof according to claim 1, wherein the polycyclic aromatic compound is represented by any one of the following formulas: 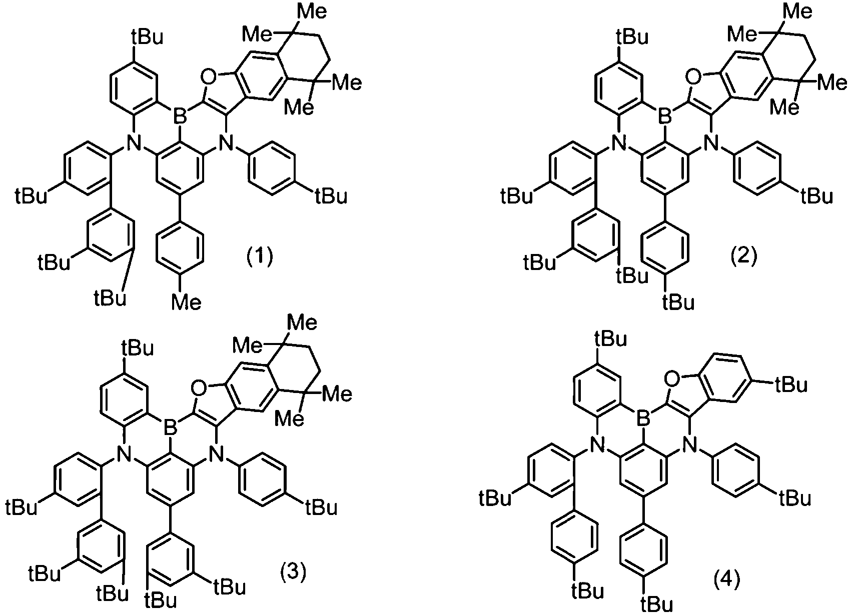 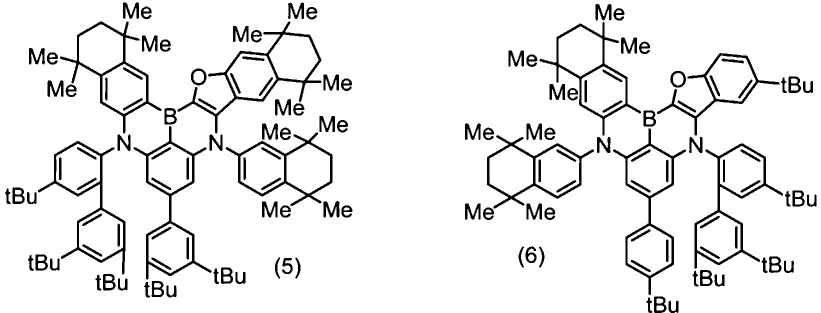 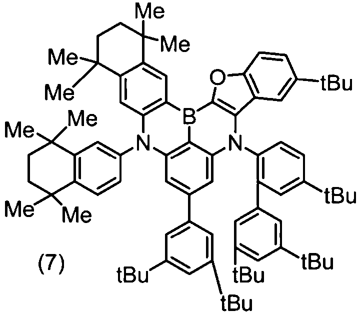 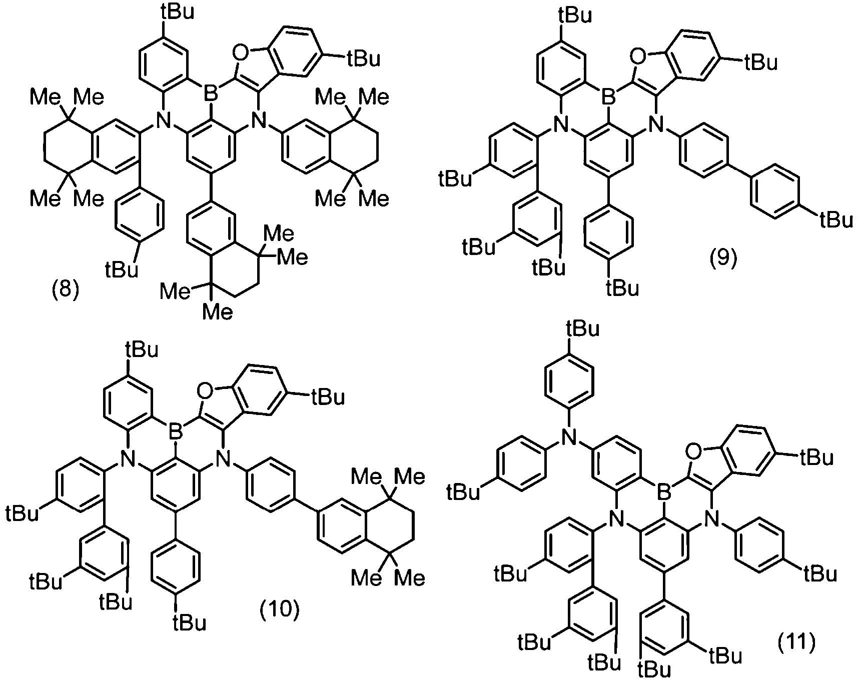 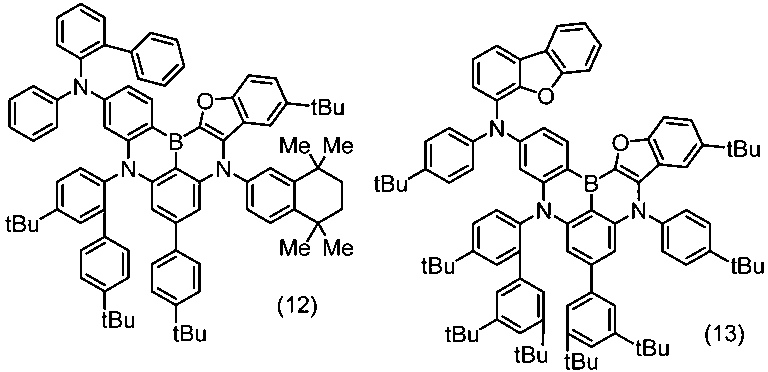 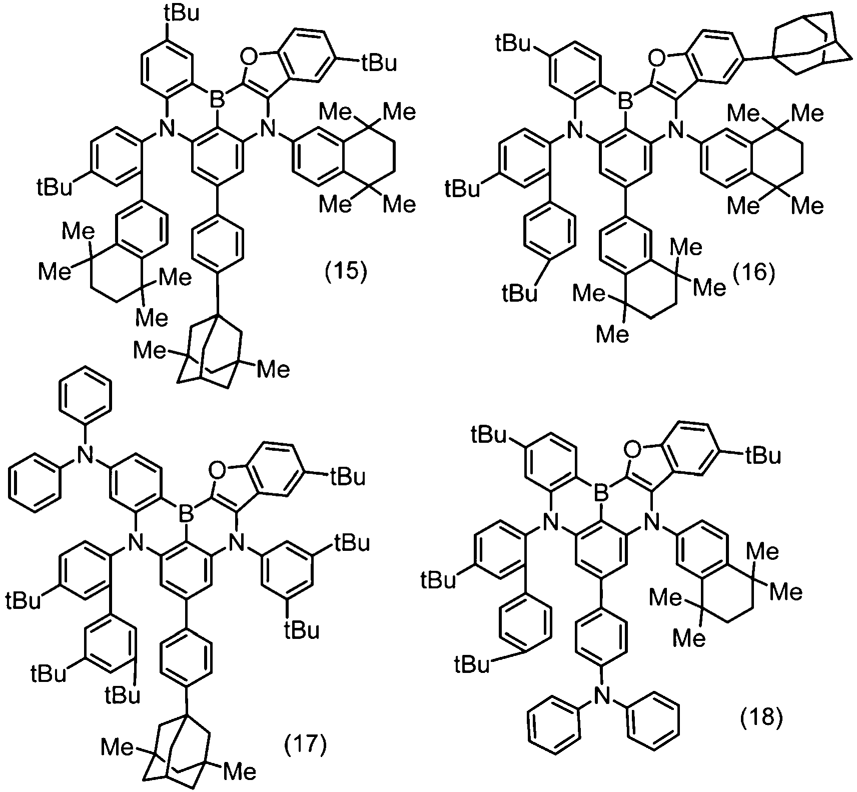 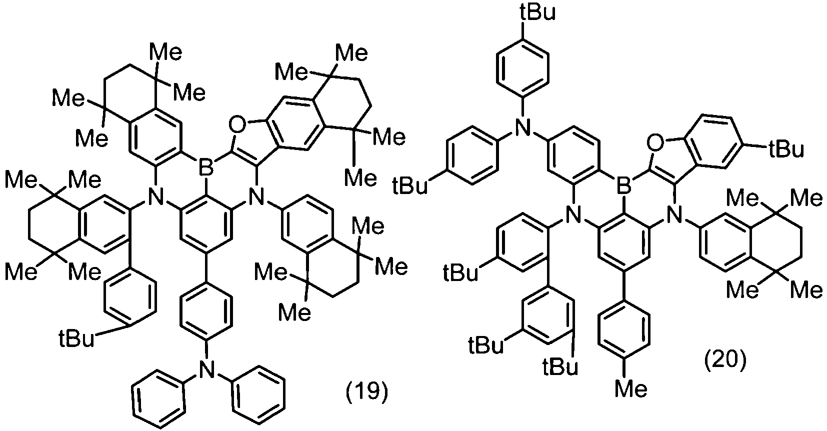 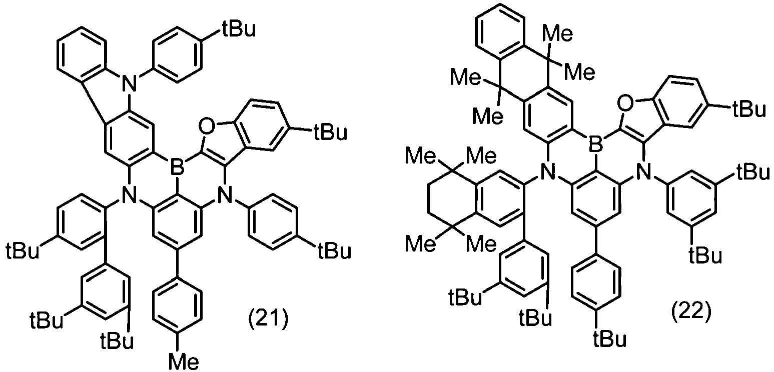 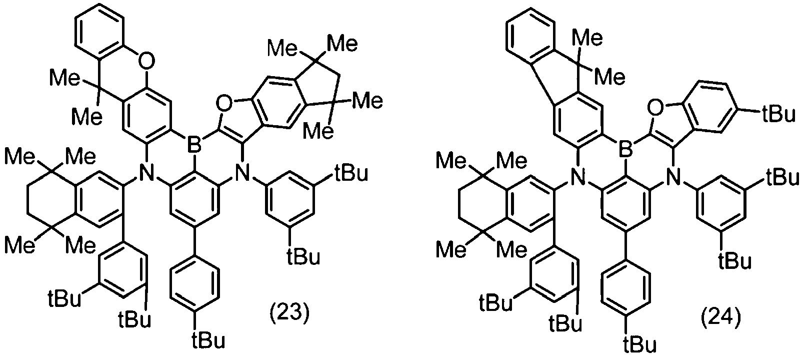 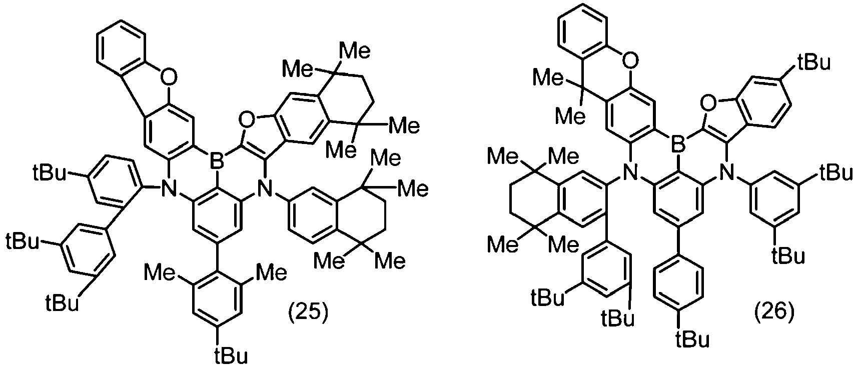 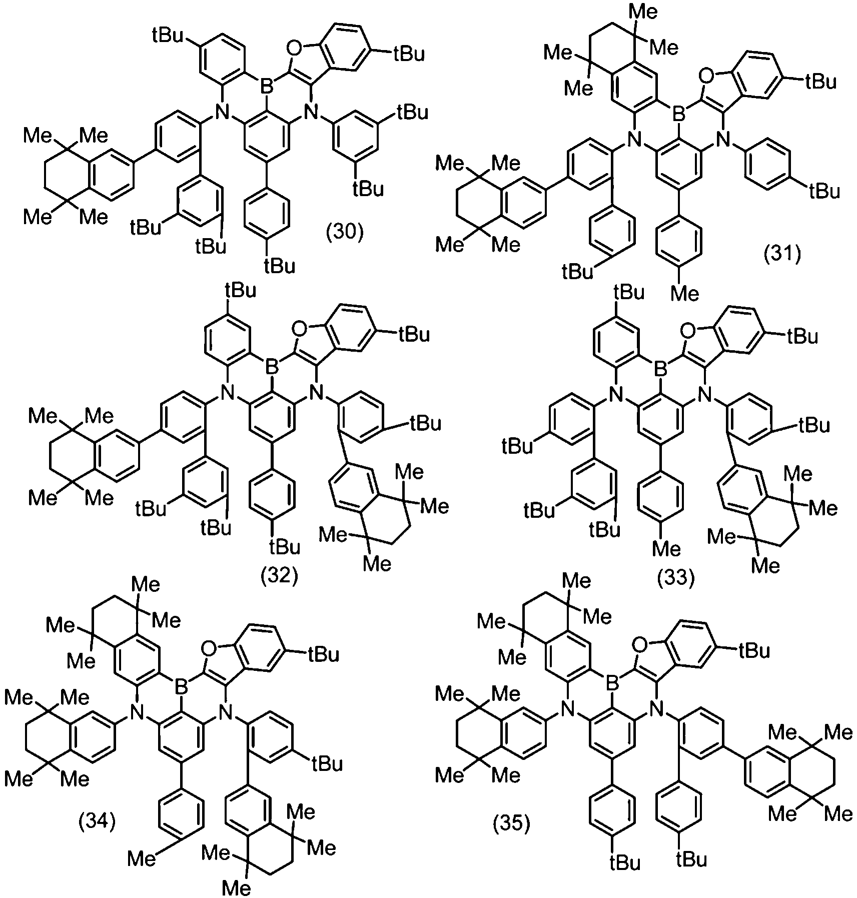 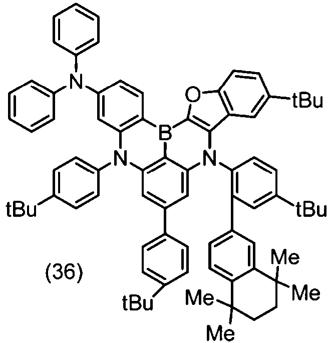 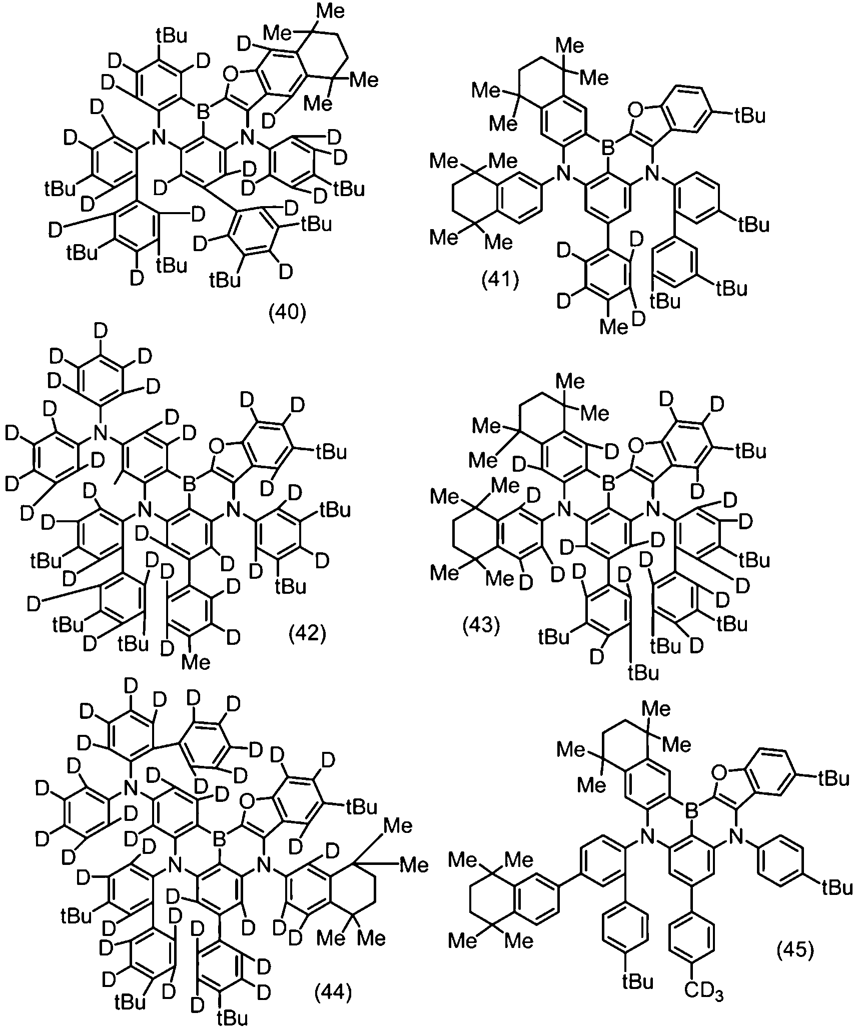 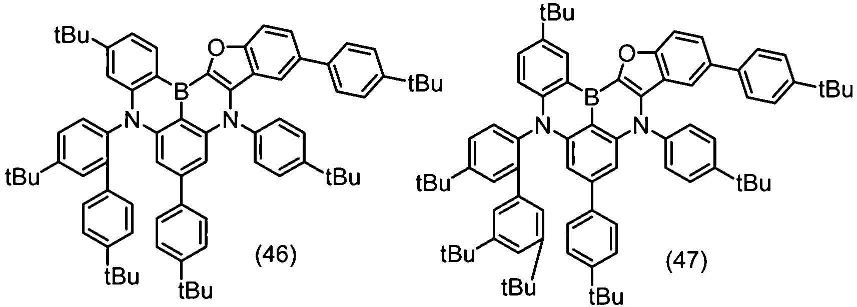 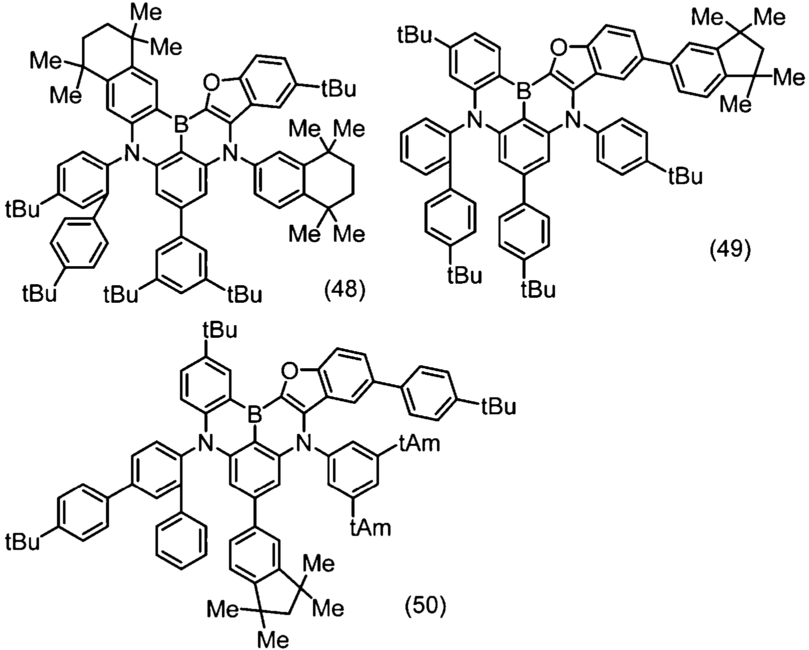 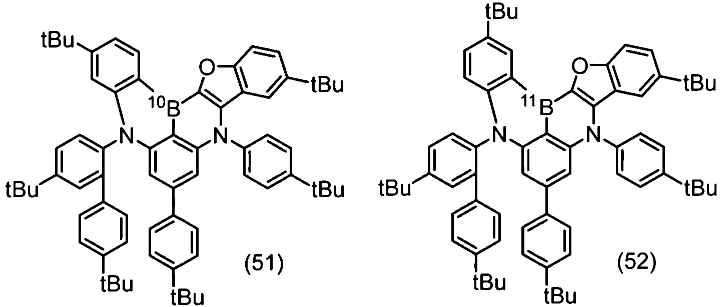 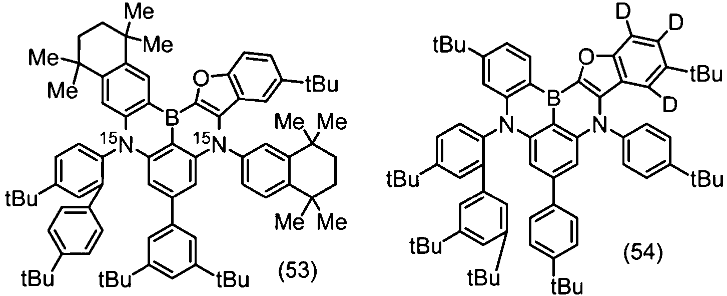 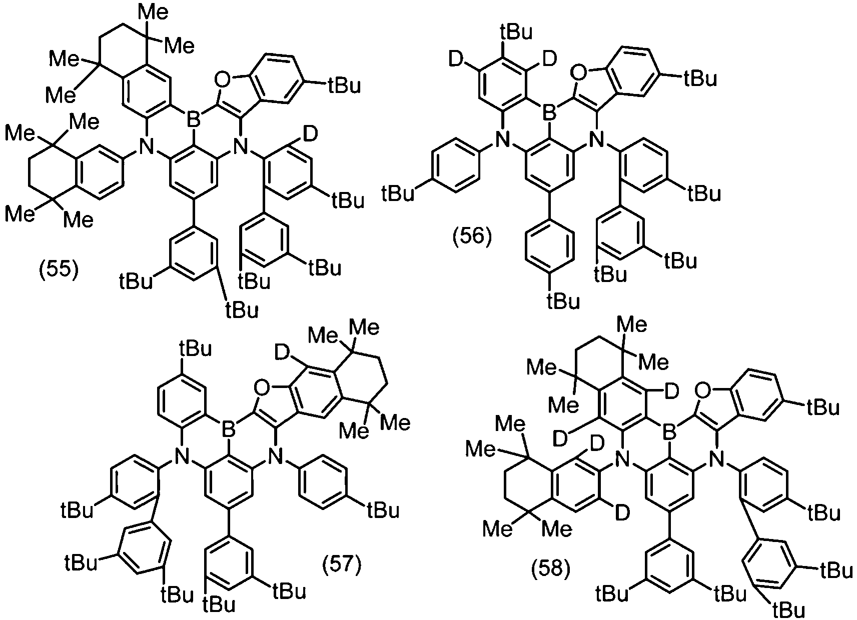 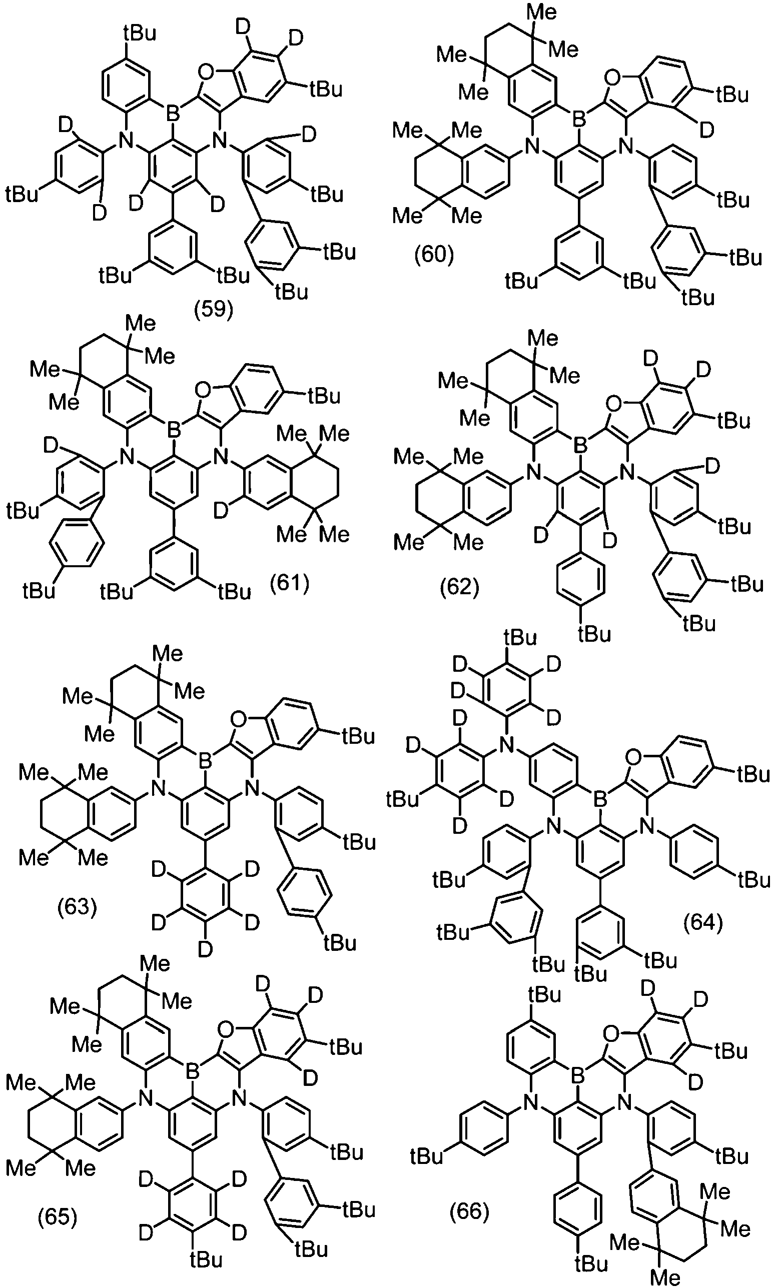 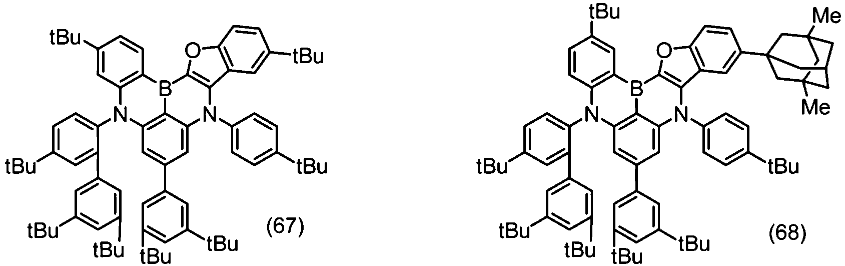 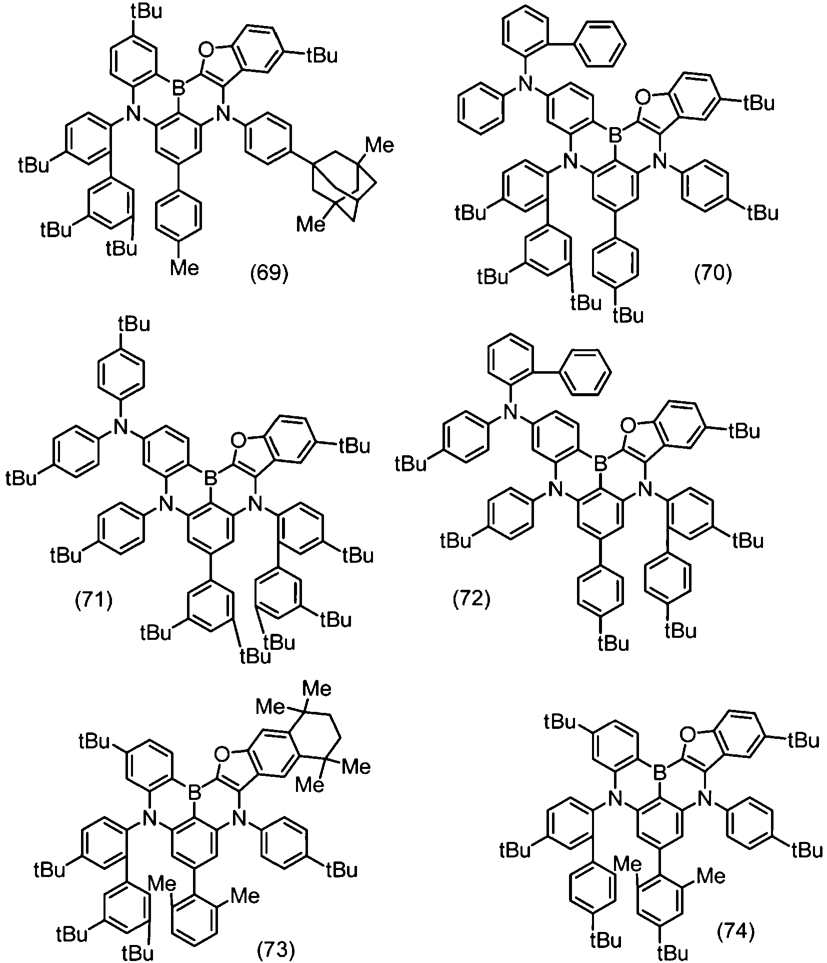 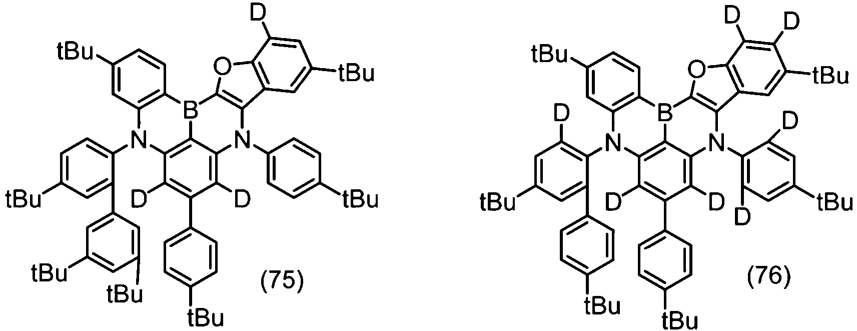 wherein Me is methyl, tBu is t-butyl, t-Am is t-amyl, and D is deuterium.

6. The polycyclic aromatic compound or the multimer thereof according to claim 5, wherein the polycyclic aromatic compound is represented by any one of the formulas (1) to (13), the formulas (15) and (16), the formula (18), the formulas (21) to (26), the formulas (31) to (35), the formulas (40) and (41), the formulas (45) to (52), the formula (55), the formula (57), the formula (59), the formula (60), the formula (64), and the formulas (67) to (76).

7. A material for an organic device, comprising a polycyclic aromatic compound or a multimer thereof according to any one of claims 1 to 6.

8. The material for an organic device according to claim 7, wherein the material is a material for an organic electroluminescent device, a material for an organic field-effect transistor, a material for an organic photovoltaic, or a material for a wavelength conversion filter.

9. The material for an organic device according to claim 8, wherein the material for an organic electroluminescent device is a material for a luminescent layer.

10. An organic electroluminescent device having a pair of electrodes consisting of a positive electrode and a negative electrode, and an organic layer containing a polycyclic aromatic compound or a multimer thereof according to any one of claims 1 to 6, the organic layer being disposed between the pair of electrodes.

11. The organic electroluminescent device according to claim 10, wherein the organic layer is a luminescent layer.

12. The organic electroluminescent device according to claim 11, wherein the luminescent layer comprises a dopant which is the polycyclic aromatic compound or the multimer thereof according to any one of claims 1 to 6, and a host.

13. The organic electroluminescent device according to claim 12, wherein the host is an anthracene compound, a fluorene compound, or a dibenzochrysene compound.

14. A display or a lighting comprising an organic electroluminescent device according to claim 10.

15. A wavelength conversion filter comprising a material for a wavelength conversion filter according to claim 8.
